# EUROPEAN PATENT SPECIFICATION

(11) **EP 4 008 758 B1**
(45) Date of publication and mention of the grant of the patent: **06.09.2023**
(21) Application number: 21206644.3
(22) Date of filing: 05.11.2021
(51) Int. Cl.: C09K 11/06, C07F 15/00, C07B 59/00, C07F 5/02

(54) **ORGANOMETALLIC COMPOUND, LIGHT-EMITTING DEVICE INCLUDING ORGANOMETALLIC COMPOUND, AND ELECTRONIC APPARATUS INCLUDING LIGHT-EMITTING DEVICE**
ORGANOMETALLISCHE VERBINDUNG, LICHTEMITTIERENDE VORRICHTUNG MIT ORGANOMETALLISCHER VERBINDUNG UND ELEKTRONISCHE VORRICHTUNG MIT EINER LICHTEMITTIERENDEN VORRICHTUNG
COMPOSÉ ORGANOMÉTALLIQUE, DISPOSITIF ÉLECTROLUMINESCENT LE COMPRENANT ET APPAREIL ÉLECTRONIQUE COMPRENANT LE DISPOSITIF ÉLECTROLUMINESCENT

(30) Priority: 02.12.2020 KR 20200166929
(43) Date of publication of application: 08.06.2022
(73) Proprietor: Samsung Display Co., Ltd., Gyeonggi-do 17113 (KR)
(72) Inventor: KO, Soobyung, 17113 Yongin-si (KR); HAN, Junghoon, 17113 Yongin-si (KR); LEE, Hyunjung, 17113 Yongin-si (KR); KANG, Iljoon, 17113 Yongin-si (KR); CHO, Dahye, 17113 Yongin-si (KR)
(74) Representative: Marks & Clerk LLP

(56) References cited:
- EP-A1- 3 508 491
- EP-A2- 2 711 999
- AKKURT MEHMET ET AL: "Chlorido[1-phenyl-3-(2,3,5,6-tetramethylb enzyl)benzimidazol-2-ylidene]silver(I)", ACTA CRYSTALLOGRAPHICA SECTION C. CRYSTAL STRUCTURE COMMUNICATIONS, vol. 68, no. 5, 15 May 2012 (2012-05-15), pages m590-m591, XP055923405, DK ISSN: 0108-2701, DOI: 10.1107/S1600536812012998

## Description

### BACKGROUND

### 1. Field

One or more embodiments of the present disclosure are directed toward an organometallic compound, a light-emitting device including the organometallic compound, and an electronic apparatus including the light-emitting device.

### 2. Description of the Related Art

Light-emitting devices are self-emission devices that have wide viewing angles, high contrast ratios, short response times, and excellent characteristics in terms of brightness, driving voltage, and/or response speed.

Light-emitting devices may include a first electrode on a substrate, and a hole transport region, an emission layer, an electron transport region, and a second electrode sequentially stacked on the first electrode. Holes provided from the first electrode may move toward the emission layer through the hole transport region, and electrons provided from the second electrode may move toward the emission layer through the electron transport region. Carriers, such as holes and electrons, may then recombine in the emission layer to produce excitons. These excitons transition from an excited state to a ground state to thereby generate light.

EP3508491A1 discloses a light-emitting device comprising an organometallic compound which is a metal complex with an imidazole ring coordinating via the C atom in position 2 to the central metal, comprising 3 further cyclic groups CY2, CY3, CY4; CY2 and CY3 being connected to one another via a bridge.

### SUMMARY

One or more aspects of embodiments of the present disclosure are directed toward a novel organometallic compound, a light-emitting device including the organometallic compound, and an electronic apparatus including the light-emitting device.

According to one or more embodiments, an organometallic compound is represented by Formula 1.

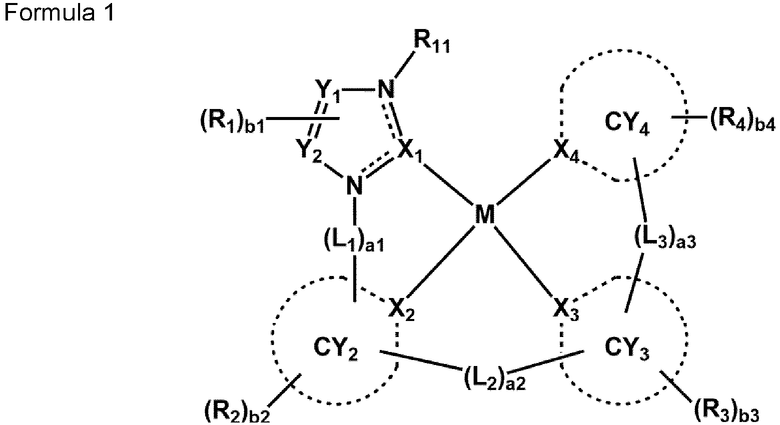

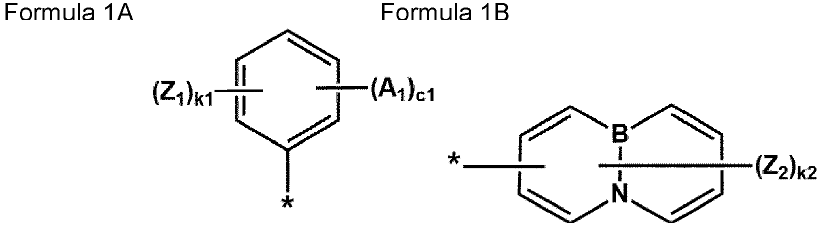

In Formulae 1, 1A, and 1B,
M is platinum (Pt), palladium (Pd), nickel (Ni), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), or thulium (Tm),
X₁ is C, and a bond between X₁ and M is a coordinate bond,
X₂ to X₄, Y₁, and Y₂ are each independently C or N,
one of a bond between X₂ and M, a bond between X₃ and M, and a bond between X₄ and M is a coordinate bond, and the other two bonds are each a covalent bond,
CY₂ to CY₄ are each independently a C₃-C₆₀ carbocyclic group or a C₁-C₆₀ heterocyclic group,
L₁ to L₃ are each independently a single bond, *-O-*', *-S-*', *-Se-*', *-S(=O)₂-*', *-C(R₅)(R₆)-*', *-C(R₅)=*', *=C(R₅)-*', *-C(R₅)=C(R₆)-*', *-C(=O)-*', *-C(=S)-*', *-C≡C-*', *-B(R₅)-*', *-N(R₅)-*', *-P(R₅)-*', *-Si(R₅)(R₆)-*', *-P(=O)(R₅)-*', or *-Ge(R₅)(R₆)-*',
a1 to a3 are each independently an integer from 1 to 3,
R₁ to R₆ and R₁₁ are each independently a group represented by Formula 1A, hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
at least two groups of R₁ in a number of b1, R₂ in a number of b2, R₃ in a number of b3, R₄ in a number of b4, R₅, or R₆ are optionally bound to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
at least one of R₁₁, R₁ in a number of b1, R₂ in a number of b2, R₃ in a number of b3, and R₄ in a number of b4 is a group represented by Formula 1A,
b1 is 1 or 2,
b2 to b4 are each independently an integer from 1 to 10,
A₁ is a group represented by Formula 1B,
c1 is an integer from 1 to 5,
Z₁ and Z₂ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
k1 is an integer from 0 to 4,
k2 is an integer from 1 to 7,
* and *' each indicate a binding site to an adjacent atom, and
R₁₀ₐ is
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(O₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof, or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃, and Q₃₁ to Q₃₃ are each independently hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

According to one or more embodiments, a light-emitting device includes a first electrode, a second electrode facing the first electrode, and an interlayer between the first electrode and the second electrode, the interlayer including an emission layer, wherein the light-emitting device includes the organometallic compound represented by Formula 1.

According to one or more embodiments, an electronic apparatus includes the light-emitting device.

At least some of the above and other features of the present invention are set out in the claims.

### BRIEF DESCRIPTION OF THE DRAWINGS

The above and other aspects, features, and advantages of embodiments of the disclosure will be more apparent from the following description taken in conjunction with the accompanying drawings, in which:
FIG. 1 is a schematic cross-sectional view of a light-emitting device according to one or more embodiments;
FIG. 2 is a schematic cross-sectional view of an electronic apparatus according to one or more embodiments; and
FIG. 3 is a schematic cross-sectional view of an electronic apparatus according to one or more other embodiments.

### DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. As used herein, expressions such as "at least one of", "one of", and "selected from", when preceding a list of elements, modify the entire list of elements and do not modify the individual elements of the list. For example, the expression "at least one of a, b and c" indicates only a, only b, only c, both a and b, both a and c, both b and c, all of a, b, and c, or variations thereof. Further, the use of "may" when describing embodiments of the present disclosure refers to "one or more embodiments of the present disclosure".

As used herein, the singular forms "a," "an," and "the" are intended to include the plural forms as well, unless the context clearly indicates otherwise.

It will be further understood that the terms "includes," "including," "comprises," and/or "comprising," when used in this specification, specify the presence of stated features, steps, operations, elements, and/or components, but do not preclude the presence or addition of one or more other features, steps, operations, elements, components, and/or groups thereof.

As used herein, the terms "use," "using," and "used" may be considered synonymous with the terms "utilize," "utilizing," and "utilized," respectively.

It will be understood that when an element is referred to as being "on," "connected to," or "coupled to" another element, it may be directly on, connected, or coupled to the other element or one or more intervening elements may also be present. When an element is referred to as being "directly on," "directly connected to," or "directly coupled to" another element, there are no intervening elements present. As used herein, the terms "substantially", "about", and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

An organometallic compound is represented by Formula 1:

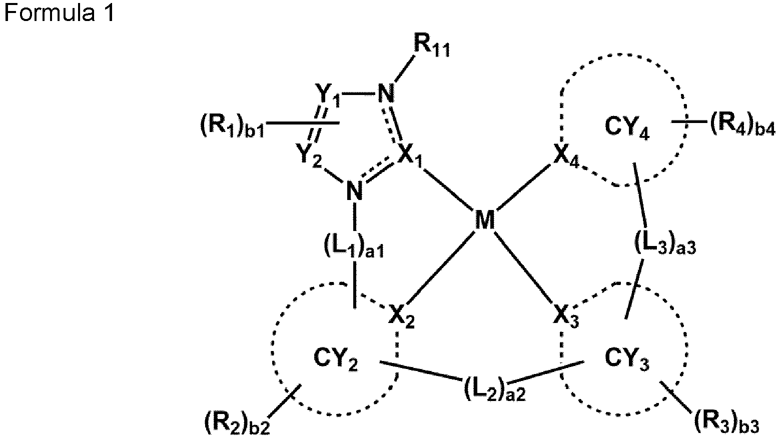

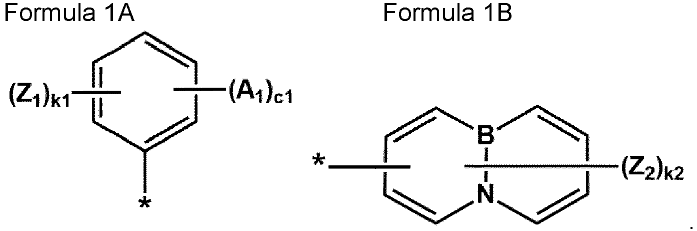

In Formula 1, M is platinum (Pt), palladium (Pd), nickel (Ni), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), or thulium (Tm).

In one or more embodiments, in Formula 1, M may be Pt, Pd, Ni, Au, Ag, or Cu, but embodiments are not limited thereto. For example, M may be Pt, Pd, or Au. For example, M may be Pt.

In Formula 1, X₁ is C, and a bond between X₁ and M is a coordinate bond.

In Formula 1, X₂ to X₄ are each independently be C or N, one of a bond between X₂ and M, a bond between X₃ and M, and a bond between X₄ and M is a coordinate bond, and the other two bonds are each a covalent bond.

For example, in Formula 1, X₂ may be C, X₃ may be C, X₄ may be N; X₂ may be C, X₃ may be N, and X₄ may be C; or X₂ may be N, X₃ may be C, and X₄ may be C, but embodiments are not limited thereto.

In one or more embodiments, in Formula 1, X₂ may be C, X₃ may be C, X₄ may be N, a bond between X₂ and M, and a bond between X₃ and M may each be a covalent bond, and a bond between X₄ and M may be a coordinate bond.

In Formula 1, Y₁ and Y₂ are each independently C or N.

In one or more embodiments, Y₁ and Y₂ may each be C.

In Formula 1, CY₂ to CY₄ are each independently a C₃-C₆₀ carbocyclic group or a C₁-C₆₀ heterocyclic group. In one or more embodiments, CY₂ to CY₄ may each independently be a C₃-C₃₀ carbocyclic group or a C₁-C₂₀ heterocyclic group.

In one or more embodiments, CY₂ to CY₄ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a tetrazole group, a benzopyrazole group, a benzimidazole group, a benzotriazole, a benzoxazole group, a benzothiazole group, a benzoxadiazole group, a benzothiadiazole group, an indazole group, an imidazopyridine group, an imidazopyrimidine group, an imidazopyrazine group, an imidazopyridazine group, a pyrazolopyridine group, a pyrazolopyrimidine group, a pyrazolopyrazine group, a pyrazolopyridazine group, a 5,6,7,8-tetrahydroisoquinoline group, or a 5,6,7,8-tetrahydroquinoline group.

In one or more embodiments, in Formula 1, CY₂ may be a group represented by one of Formulae CY2-1 to CY2-9,
CY₃ may be a group represented by one of Formulae CY3-1 to CY3-10,
CY₄ may be a group represented by one of Formulae CY4-1 to CY4-9, or
any combination thereof: 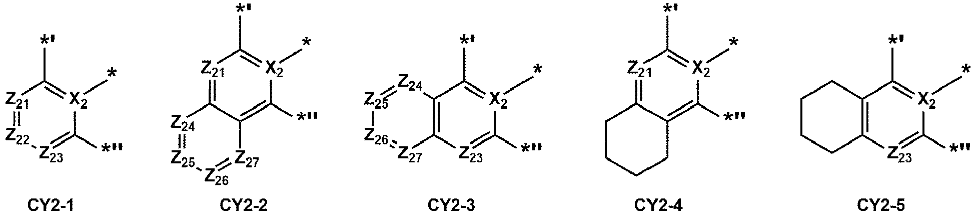 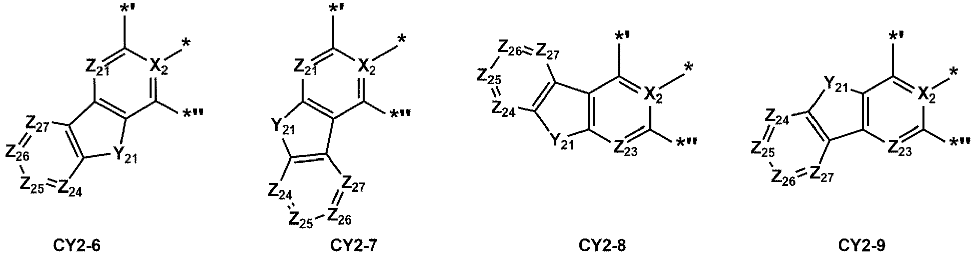 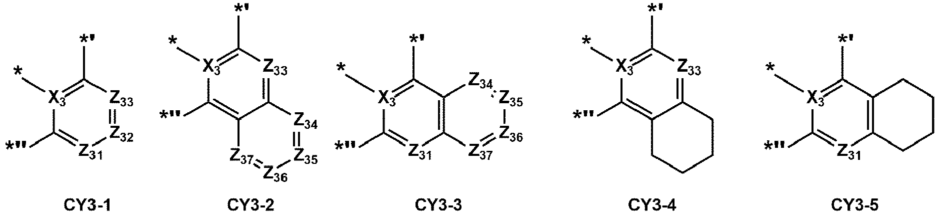 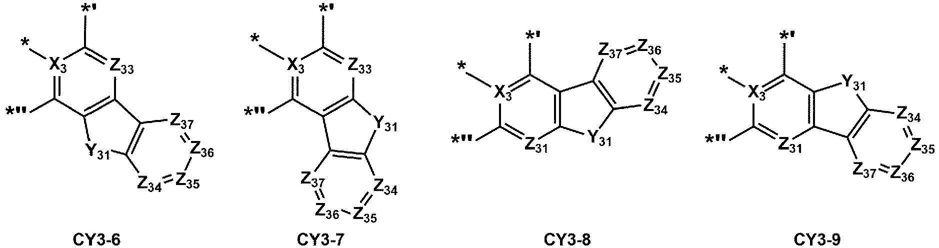 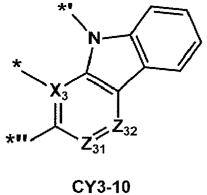 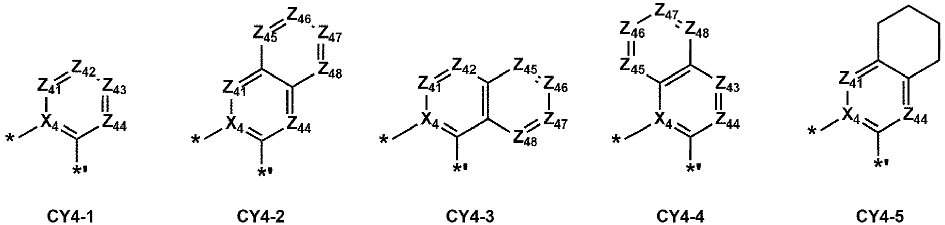 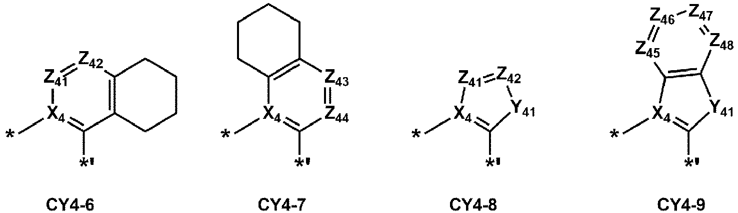 wherein, in Formulae CY2-1 to CY2-9, CY3-1 to CY3-10, and CY4-1 to CY4-9,
   Z₂₁ to Z₂₇, Z₃₁ to Z₃₇, and Z₄₁ to Z₄₈ are each independently C or N,
   Y₂₁, Y₃₁, and Y₄₁ are each independently N, O, S, C, or Si,
   X₂ to X₄ are respectively understood by referring to the descriptions of X₂ to X₄ provided herein,
   * indicates a binding site to M, and
   *' and *" each indicate a binding site to an adjacent atom.

In Formula 1, L₁ to L₃ are each independently a single bond, *-O-*', *-S-*', *-Se-*', *_S(=O)₂₋*' *-C(R₅)(R₆)-*', *-C(R₅)=*', *=C(R₅)-*', *-C(R₅)=C(R₆)-*', *-C(=O)-*', *-C(=S)-*', *-C≡C-*', *-B(R₅)-*', *-N(R₅)-*', *-P(R₅)-*', *-Si(R₅)(R₆)-*', *-P(=O)(R₅)-*', or*-Ge(R₅)(R₆)-*',
a1 to a3 are each independently an integer from 1 to 3.

In one or more embodiments, in Formula 1, L₁ may be a single bond, L₂ may be *-O-*' or *-S-*', and L₃ may be *-N(R₅)-*'. In one or more embodiments, in Formula 1, L₁ may be a single bond, L₂ may be *-O-*', and L₃ may be *-N(R₅)-*'.

For example, L₁ may be a single bond, L₂ may be *-O-*' or *-S-*', L₃ may be *-N(R₅)-*', and a1 to a3 may each be 1. For example, L₁ may be a single bond, L₂ may be *-O-*', L₃ may be *-N(R₅)-*', and a1 to a3 may each be 1.

In Formula 1, R₁ to R₆ and R₁₁ are each independently a group represented by Formula 1A, hydrogen, deuterium, -F, -Cl, -Br, -I, a hydroxyl group, a cyano group, a nitro group, a C₁-C₆₀ (*e.g*. C₁-C₂₀) alkyl group unsubstituted or substituted with at least one R₁₀ₐ, a C₂-C₆₀ (*e.g*. C₂-C₂₀) alkenyl group unsubstituted or substituted with at least one R₁₀ₐ, a C₂-C₆₀ (*e.g*. C₂-C₂₀) alkynyl group unsubstituted or substituted with at least one R₁₀ₐ, a C₁-C₆₀ (*e.g*. C₁-C₂₀) alkoxy group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g*. C₁-C₂₀) heterocyclic group unsubstituted or substituted with at least one R₁₀ₐ, a C₆-C₆₀ (*e.g*. C₆-C₃₀) aryloxy group unsubstituted or substituted with at least one R₁₀ₐ, a C₆-C₆₀ (*e.g*. C₆-C₃₀) arylthio group unsubstituted or substituted with at least one R₁₀ₐ, -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
at least two groups of R₁ in a number of b1, R₂ in a number of b2, R₃ in a number of b3, R₄ in a number of b4, R₅, and R₆ are optionally bound to each other to form a C₃-C₆₀ (*e.g*. C₃-C₃₀) carbocyclic group unsubstituted or substituted with at least one R₁₀ₐ or a C₁-C₆₀ (*e.g*. C₁-C₂₀) heterocyclic group unsubstituted or substituted with at least one R₁₀ₐ,
at least one of R₁₁, R₁ in a number of b1, R₂ in a number of b2, R₃ in a number of b3, and R₄ in a number of b4 is a group represented by Formula 1A, b1 may be 1 or 2, and b2 to b4 may each independently be an integer from 1 to 10,
R₁₀ₐ may be:
   deuterium, -F, -Cl, -Br, -I, a hydroxyl group, a cyano group, or a nitro group;
   a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
   a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, - Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
   wherein Q₁ to Q₃, Q₁₁ to Q₁₃, Q₂₁ to Q₂₃, and Q₃₁ to Q₃₃ may each independently be hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In one or more embodiments, in Formula 1, R₁ to R₆ and R₁₁ may each independently be:
a group represented by Formula 1A, hydrogen, deuterium, -F, -Cl, -Br, -I, - CH₂D, -CHD₂, -CD₃, -CH₂F, -CHF₂, -CF₃, a hydroxyl group, a cyano group, or a nitro group;
a C₁-C₆₀ (*e.g*. C₁-C₂₀) alkyl group or a C₁-C₆₀ (*e.g*. C₁-C₂₀) alkoxy group, each unsubstituted or substituted with deuterium, -F, -Cl, -Br, -I, -CH₂D, -CHD₂, -CD₃, - CH₂F, -CHF₂, -CF₃, a hydroxyl group, a cyano group, a nitro group, a cyclopentyl group, a cyclohexyl group, a cycloheptyl group, an adamantyl group, a norbornyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, an adamantyl group, a norbornyl group, a norbornenyl group, a cyclopentenyl group, a cyclohexenyl group, a cycloheptenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, or an indolocarbazolyl group, each unsubstituted or substituted with deuterium, -F, -Cl, - Br, -I, -CH₂D, -CHD₂, -CD₃, -CH₂F, -CHF₂, -CF₃, a hydroxyl group, a cyano group, a nitro group, a C₁-C₆₀ (*e.g.* C₁-C₂₀) alkyl group, a C₁-C₆₀ (*e.g*. C₁-C₂₀) alkoxy group, a cyclopentyl group, a cyclohexyl group, a cycloheptyl group, an adamantyl group, a norbornyl group, a norbornenyl group, a cyclopentenyl group, a cyclohexenyl group, a cycloheptenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, an indolocarbazolyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), - P(=O)(Q₃₁)(Q₃₂), or any combination thereof; or
-Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
wherein Q₁ to Q₃ and Q₃₁ to Q₃₃ are respectively understood by referring to the descriptions of Q₁ to Q₃ and Q₃₁ to Q₃₃ provided herein.

In one or more embodiments, in Formula 1, R₁ to R₆ and R₁₁ may each independently be:
a group represented by Formula 1A, hydrogen, deuterium, -F, -Cl, -Br, -I, - CH₂D, -CHD₂, -CD₃, -CH₂F, -CHF₂, -CF₃, a hydroxyl group, a cyano group, a nitro group, a methyl group, an ethyl group, a propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, a tert-hexyl group, or a group represented by one selected from the group consisting of Formulae 9-1 to 9-31 and 10-1 to 10-7: 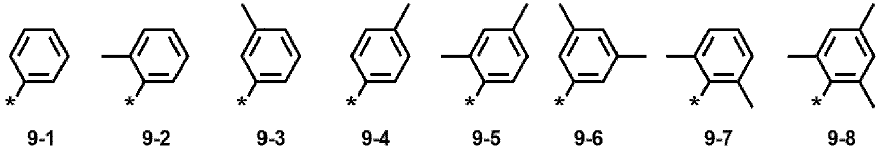 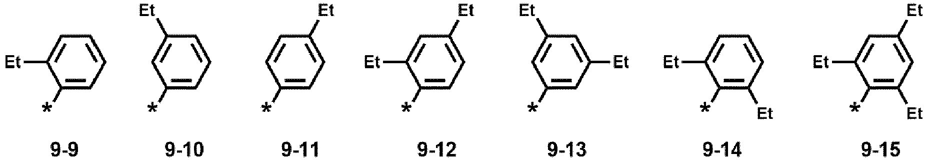 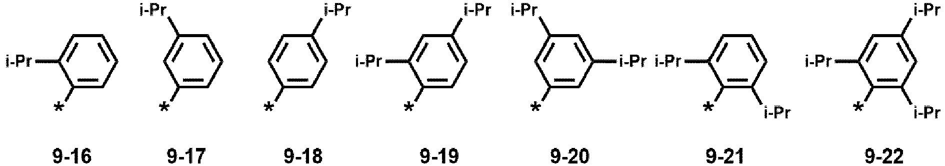 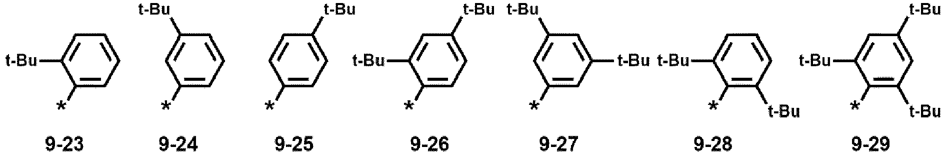 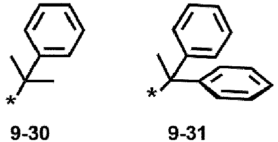 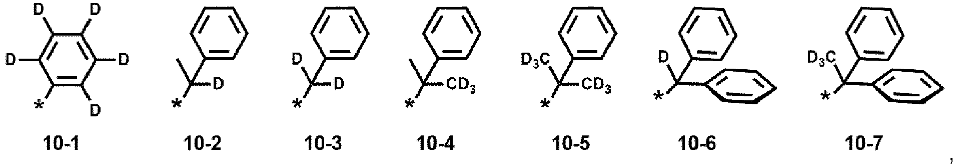 wherein, in Formulae 9-1 to 9-31 and 10-1 to 10-7,
"Et" represents an ethyl group,
"i-Pr" represents an iso-propyl group,
"t-Bu" represents a tert-butyl group,
"D" represents deuterium, and
* indicates a binding site to an adjacent atom.

In one or more embodiments, in Formula 1, R₁₁ may be a group represented by Formula 1A.

In Formulae 1A and 1B, Z₁ and Z₂ are each independently hydrogen, deuterium, -F, -Cl, -Br, -I, a hydroxyl group, a cyano group, a nitro group, a C₁-C₆₀ (*e.g*. C₁-C₂₀) alkyl group unsubstituted or substituted with at least one R₁₀ₐ, a C₂-C₆₆ (*e.g*. C₂-C₂₀) alkenyl group unsubstituted or substituted with at least one R₁₀ₐ, a C₂-C₆₆ (*e.g*. C₂-C₂₀) alkynyl group unsubstituted or substituted with at least one R₁₀ₐ, a C₁-C₆₀ (*e.g*. C₁-C₂₀) alkoxy group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g*. C₁-C₂₀) heterocyclic group unsubstituted or substituted with at least one R₁₀ₐ, a C₆-C₆₀ (*e.g*. C₆-C₃₀) aryloxy group unsubstituted or substituted with at least one R₁₀ₐ, a C₆-C₆₀ (*e.g.* C₆-C₃₀) arylthio group unsubstituted or substituted with at least one R₁₀ₐ, - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
k1 is an integer from 0 to 4, and
k2 is an integer from 1 to 7.

In Formula 1A, A₁ is a group represented by Formula 1B.

In Formula 1A, c1 indicates the number of A₁(s), and c1 is an integer from 1 to 5.

In some embodiments, the group represented by Formula 1A may be represented by one of Formulae 1A-1 to 1A-14: 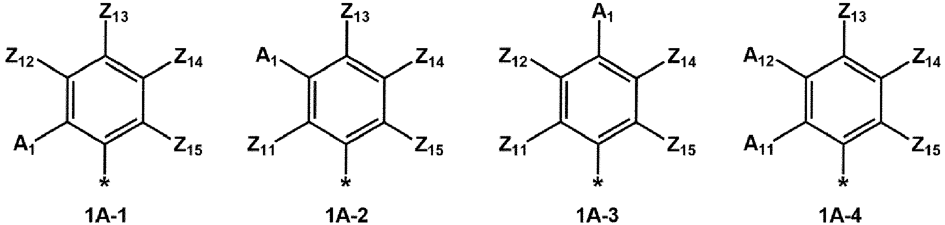 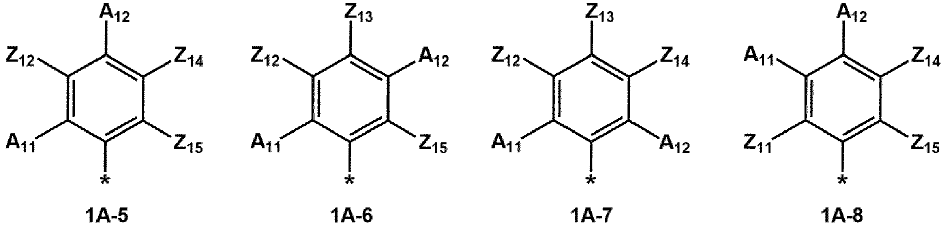 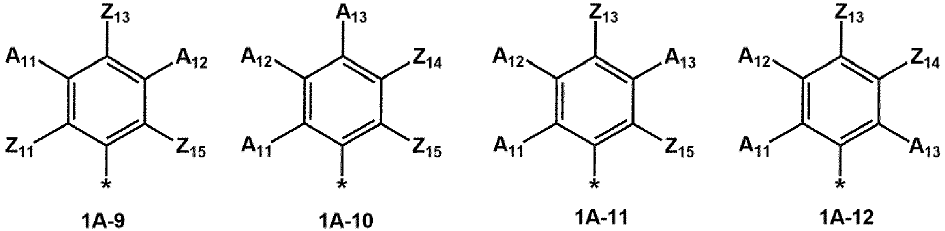 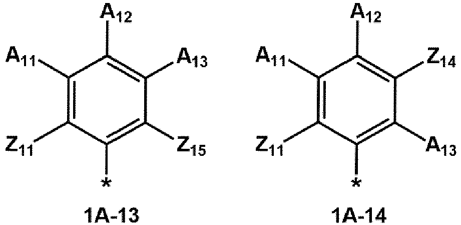 wherein, in Formulae 1A-1 to 1A-14,
Z₁₁ to Z₁₅ are each independently understood by referring to the description of Z₁ provided herein,
A₁₁ to A₁₃ are each independently substantially the same as described herein with reference to A₁,
A₁ is understood by referring to the description of A₁ in Formula 1A, and
* indicates a binding site to an adjacent atom.

In one or more embodiments, in Formulae 1A-1 to 1A-14, Z₁₁ to Z₁₅ may each independently be hydrogen, deuterium, -F, -Cl, -Br, -I, -CH₂D, -CHD₂, -CD₃, - CH₂F, -CHF₂, -CF₃, a hydroxyl group, a cyano group, a nitro group, a methyl group, an ethyl group, a propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, or a tert-hexyl group.

In one or more embodiments, the group represented by Formula 1A may be a group represented by Formula 1A-7-1: 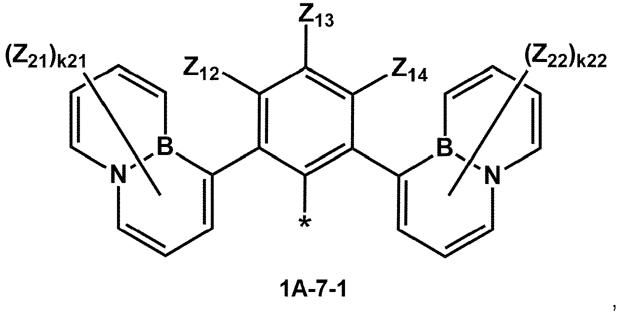 wherein, in Formula 1A-7-1,
Z₁₂ to Z₁₄ are each independently understood by referring to the description of Z₁ provided herein,
Z₂₁ and Z₂₂ are each independently understood by referring to the description of Z₂ provided herein,
k21 and k22 are each independently an integer from 1 to 7, and
* indicates a binding site to an adjacent atom.

In one or more embodiments, in Formula 1A-7-1,
Z₁₂ to Z₁₄ may each independently be hydrogen, deuterium, -F, -Cl, -Br, -I, - CH₂D, -CHD₂, -CD₃, -CH₂F, -CHF₂, -CF₃, a hydroxyl group, a cyano group, a nitro group, a methyl group, an ethyl group, a propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, or a tert-hexyl group, and
Z₂₁ and Z₂₂ may each be hydrogen.

In one or more embodiments, in Formula 1, at least one of R₁ in a number of b1, R₂ in a number of b2, R₃ in a number of b3, R₄ in a number of b4, R₅, R₆, and R₁₁ may be deuterium, -CH₂D, -CHD₂, -CD₃, a phenyl group substituted with at least one deuterium, or a group represented by one of Formulae 10-2 to 10-7: 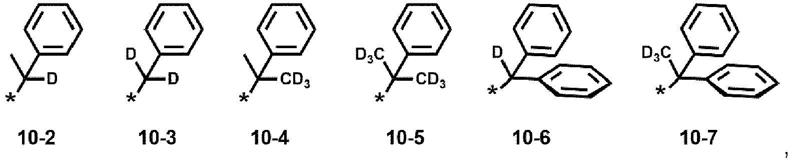 wherein, in Formulae 10-2 to 10-7,
"D" represents deuterium, and
* indicates a binding site to an adjacent atom.

In one or more embodiments, a moiety represented by 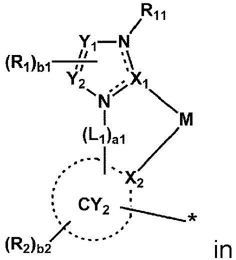 Formula 1 may be a group represented by Formula L1-1 or Formula L1-2: 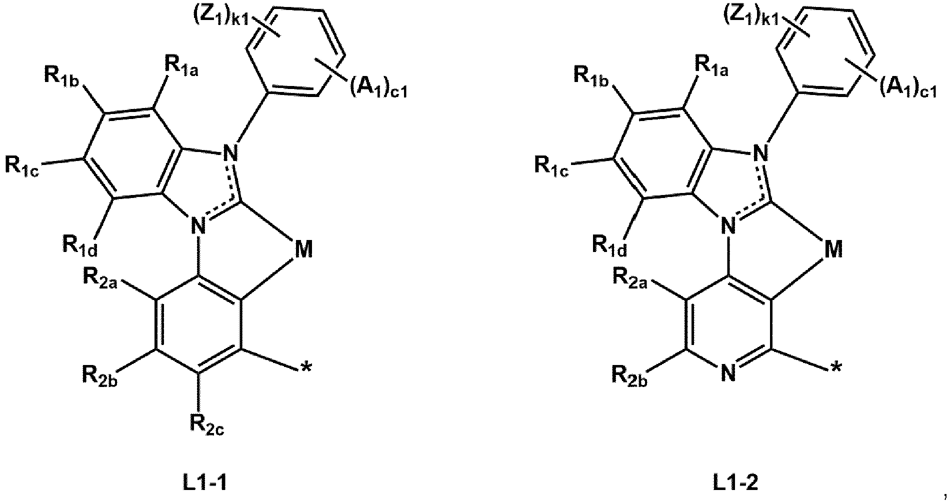 wherein, in Formulae L1-1 and L1-2,
R₁ₐ to R_{1d} are each independently understood by referring to the description of R₁ provided herein,
R₂ₐ to R_{2c} are each independently understood by referring to the description of R₂ provided herein,
M, A₁, c1, Z₁, and k1 are respectively understood by referring to the descriptions of M, A₁, c1, Z₁, and k1 provided herein, and
* indicates a binding site to L₂.

In one or more embodiments, a moiety represented by 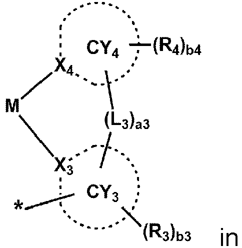 Formula 1 may be a group represented by Formula L2-1 or Formula L2-2: 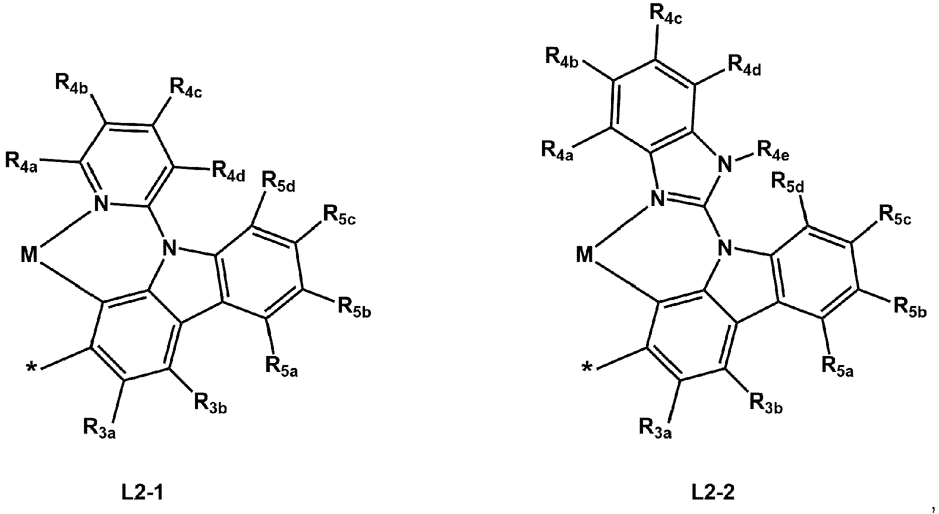 wherein, in Formulae L2-1 and L2-2,
R₃ₐ and R_{3b} are each independently understood by referring to the description of R₃ provided herein,
R₄ₐ to R₄ₑ are each independently understood by referring to the description of R₄ provided herein,
R₅ₐ to R_{5d} are each independently understood by referring to the description of R₁₀ₐ provided herein,
M is understood by referring to the description of M in Formula 1, and
* indicates a binding site to L₂.

In one embodiment, the organometallic compound may be represented by any one of Formulae 1-1 to 1-4: 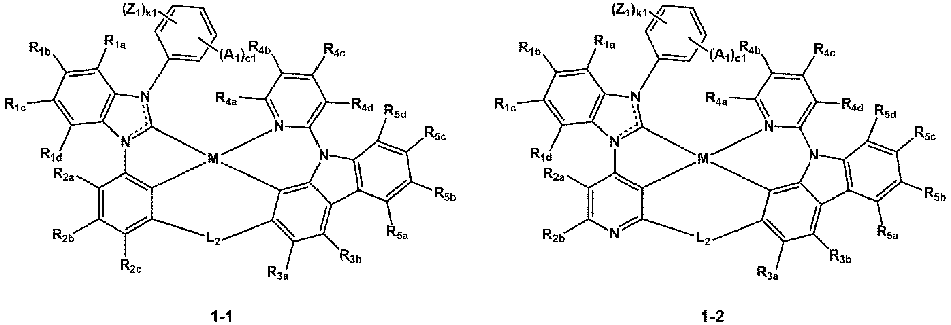 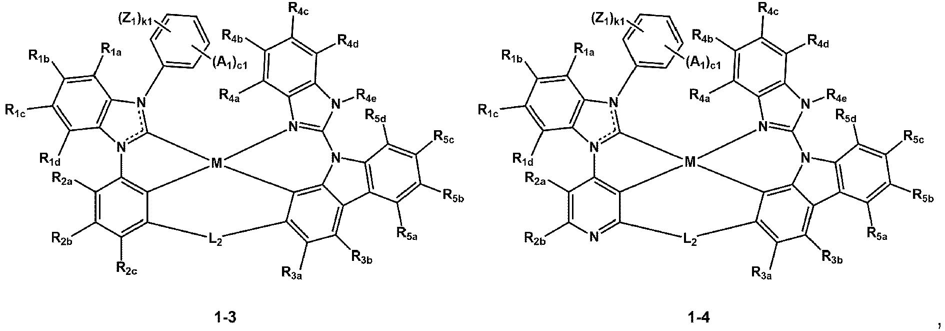 wherein, in Formulae 1-1 to 1-4,
M, L₂, A₁, c1, Z₁, and k1 are respectively understood by referring to the descriptions of M, L₂, A₁, c1, Z₁, and k1 provided herein,
R₁ₐ to R_{1d} are each independently understood by referring to the description of R₁ provided herein,
R₂ₐ to R_{2c} are each independently understood by referring to the description of R₂ provided herein,
R₃ₐ and R_{3b} are each independently understood by referring to the description of R₃ provided herein,
R₄ₐ to R₄ₑ are each independently understood by referring to the description of R₄ provided herein, and
R₅ₐ to R_{5d} are each independently understood by referring to the description of R₁₀ₐ provided herein.

In one or more embodiments, in Formulae 1-1 to 1-4, R₁ₐ to R_{1d}, R₂ₐ to R_{2c}, R₃ₐ, R_{3b}, R₄ₐ to R₄ₑ, and R₅ₐ to R_{5d} may each independently be hydrogen, deuterium, - F, -Cl, -Br, -I, -CH₂D, -CHD₂, -CD₃, -CH₂F, -CHF₂, -CF₃, a hydroxyl group, a cyano group, a nitro group, a methyl group, an ethyl group, a propyl group, an iso-propyl group, an n-butyl group, an iso-butyl group, a sec-butyl group, a tert-butyl group, an n-pentyl group, a tert-pentyl group, a neo-pentyl group, an iso-pentyl group, a sec-pentyl group, a 3-pentyl group, a sec-isopentyl group, an n-hexyl group, an iso-hexyl group, a sec-hexyl group, a tert-hexyl group, or a group represented by one selected from the group consisting of Formulae 9-1 to 9-31 and 10-1 to 10-7: 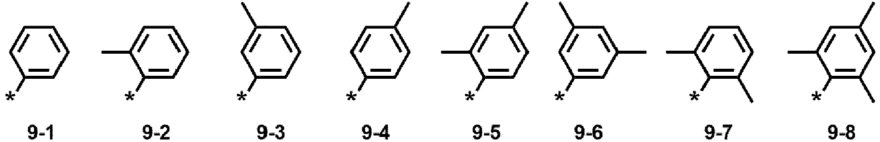 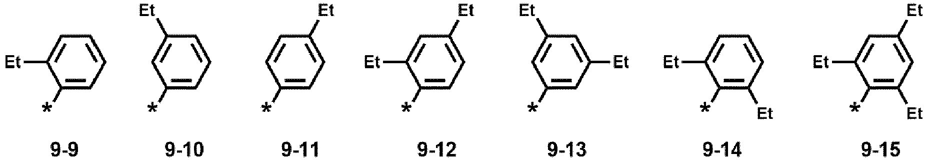 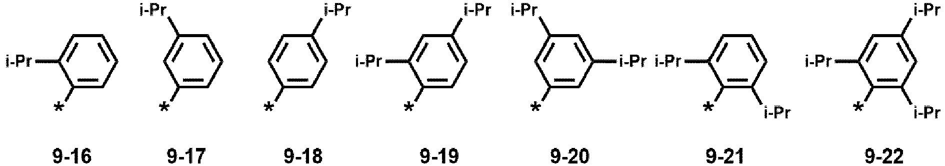 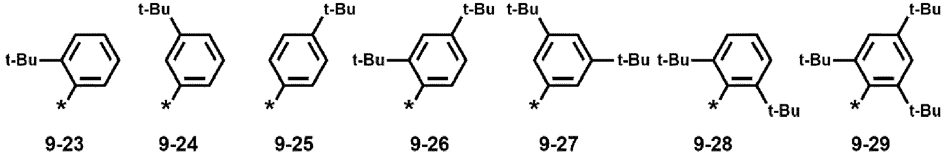 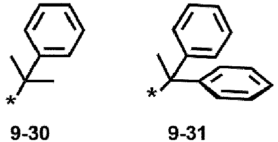 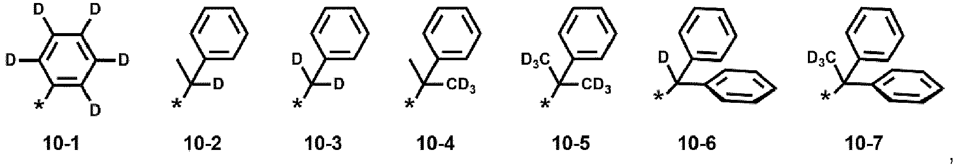 wherein, in Formulae 9-1 to 9-31 and 10-1 to 10-7,
"Et" represents an ethyl group,
"i-Pr" represents an iso-propyl group,
"t-Bu" represents a tert-butyl group,
"D" represents deuterium, and
* indicates a binding site to an adjacent atom.

In some embodiments, in Formula 1-1 to 1-4, at least one of R₁ₐ to R_{1d}, R₂ₐ to R_{2c}, R₃ₐ, R_{3b}, R₄ₐ to R₄ₑ, and R₅ₐ to R_{5d} may be represented by deuterium, -CH₂D, - CHD₂, -CD₃, or a group represented by one of Formulae 10-1 to 10-7: 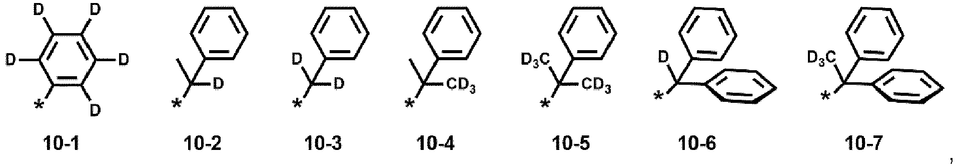 wherein, in Formulae 10-1 to 10-7,
"D" represents deuterium, and
* indicates a binding site to an adjacent atom.

In one or more embodiments, the organometallic compound may be one of Compounds BD01 to BD210: 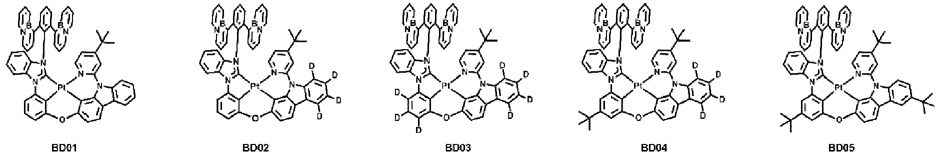 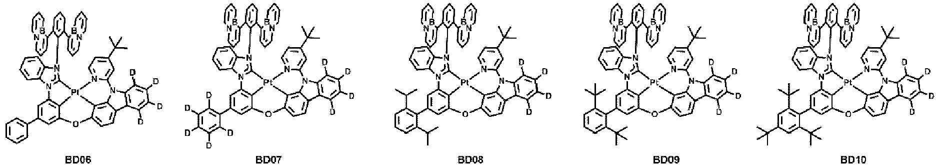 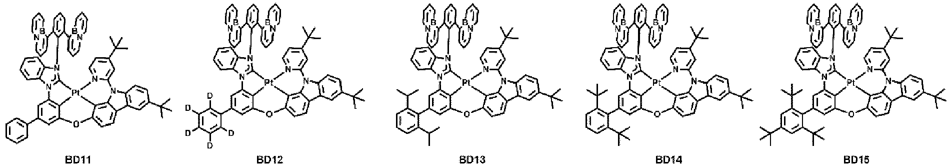 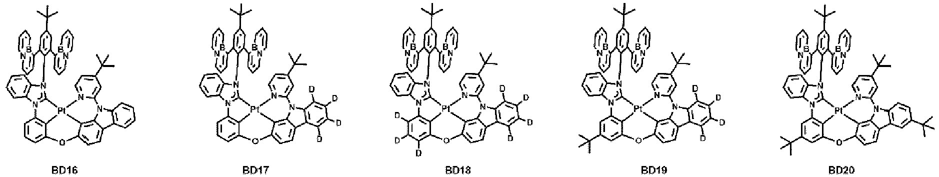 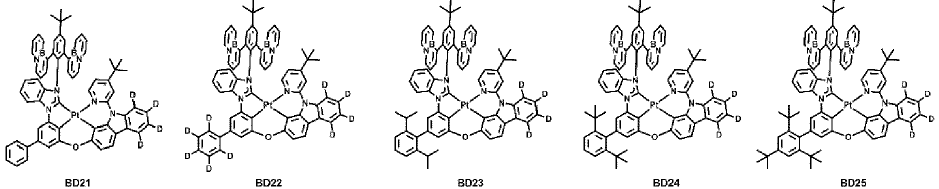 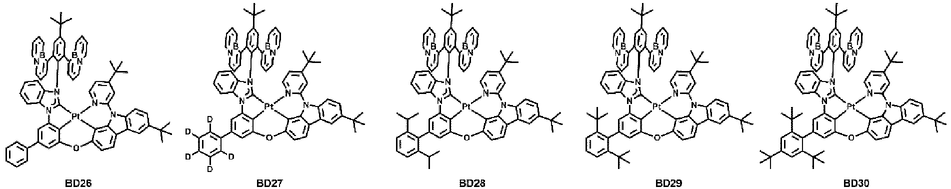 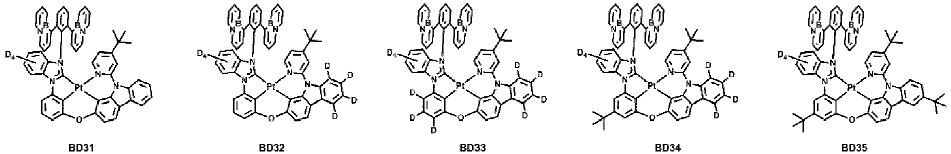 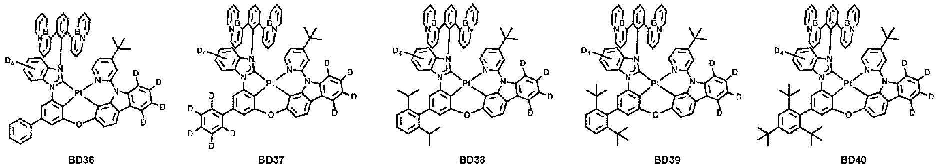 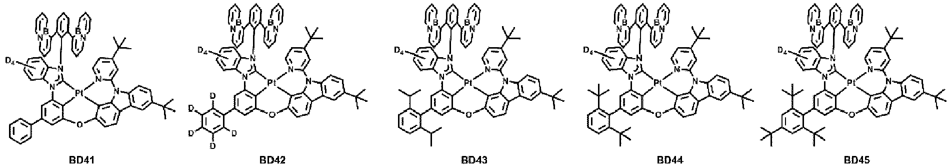 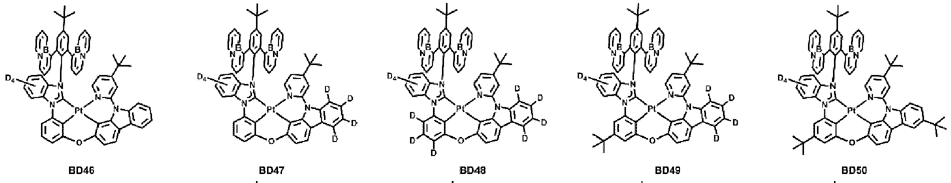 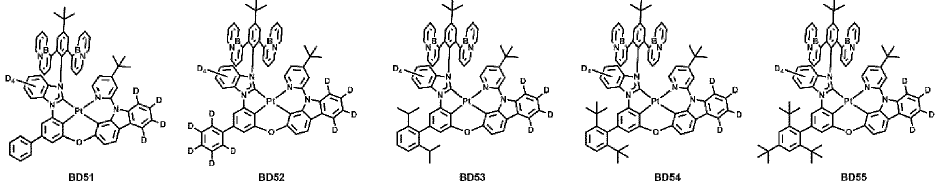 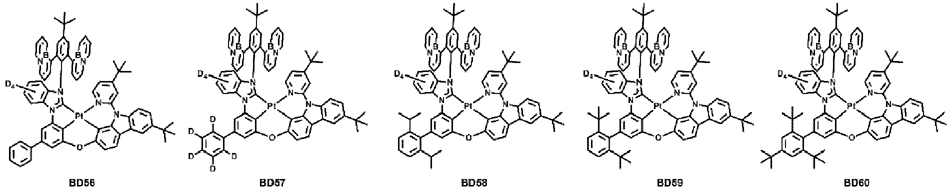 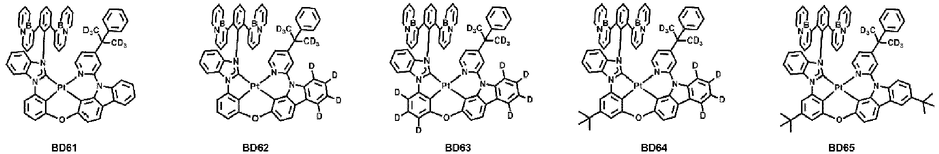 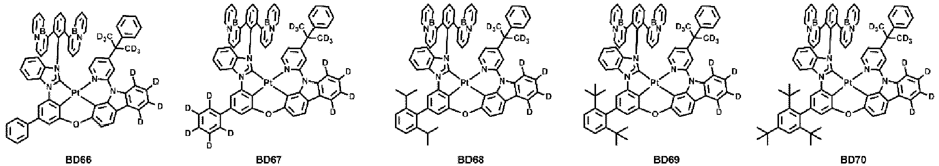 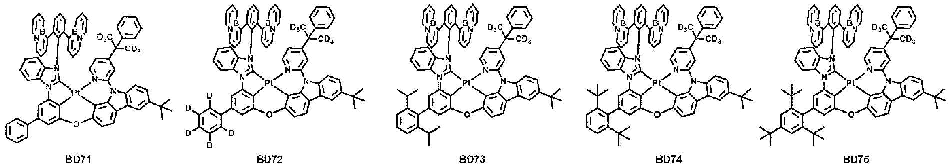 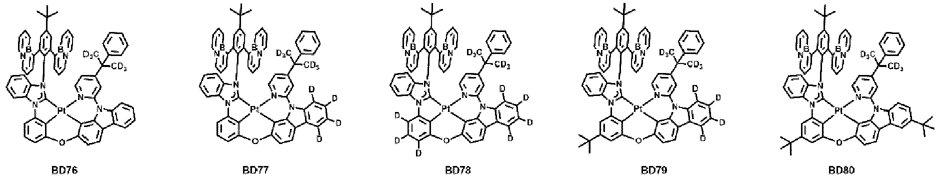 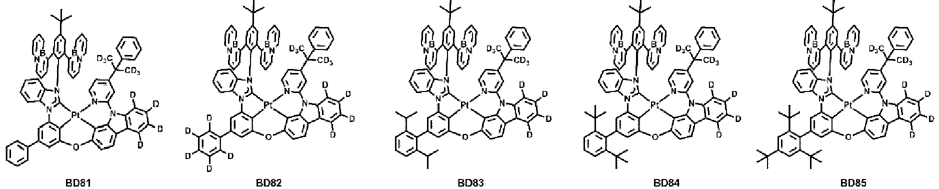 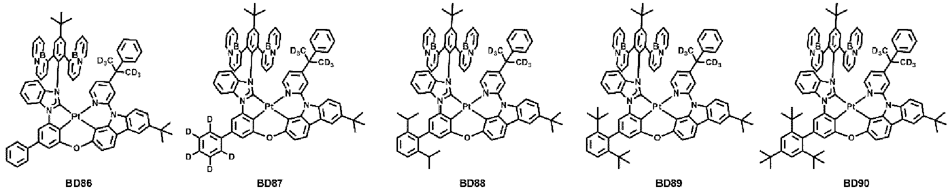 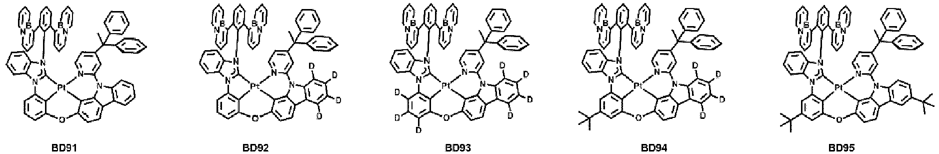 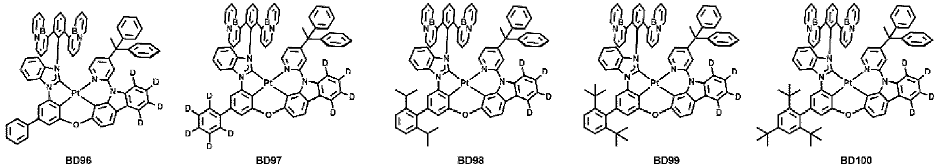 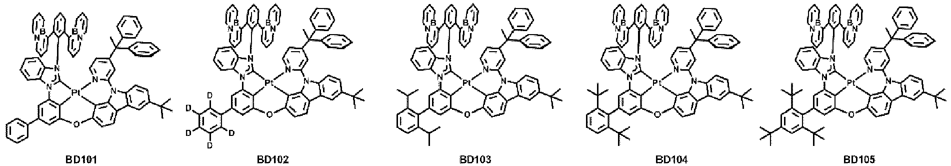 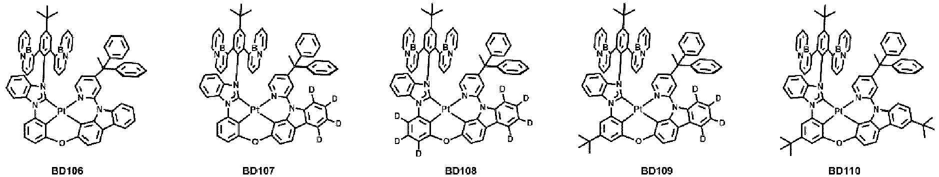 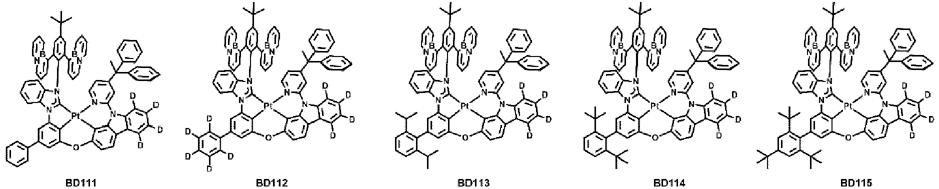 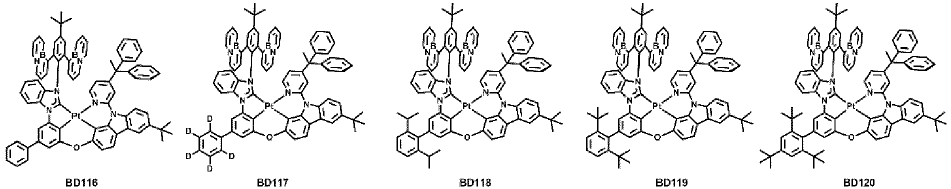 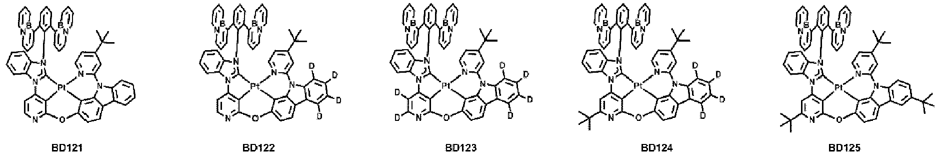 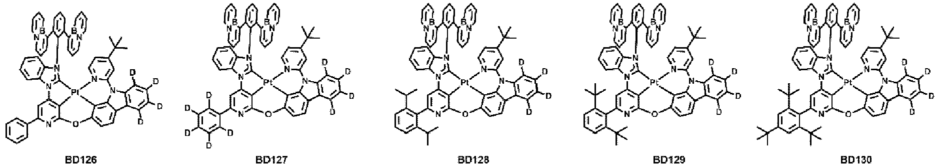 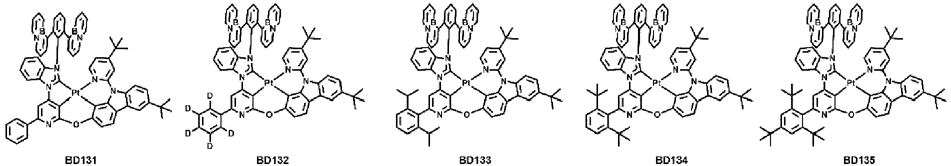 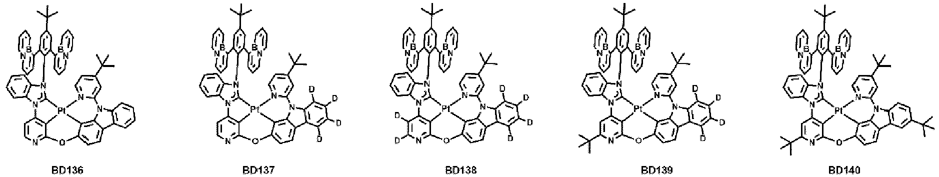 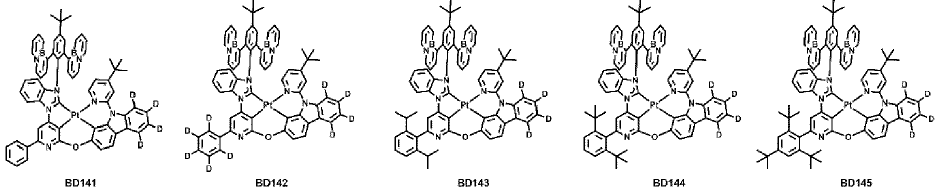 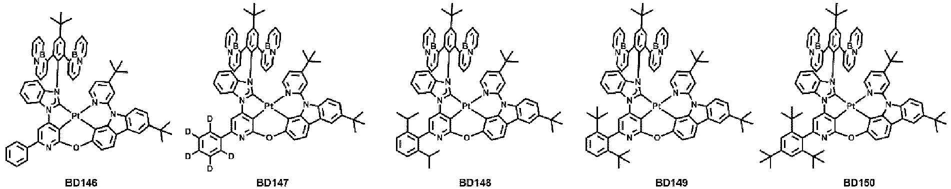 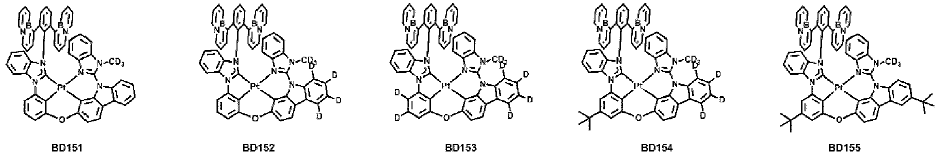 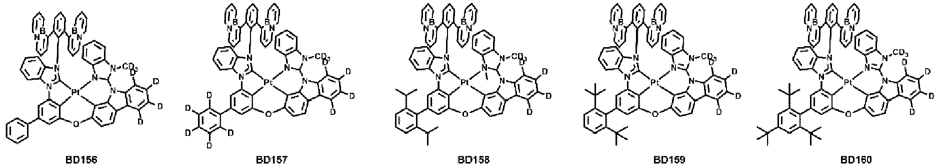 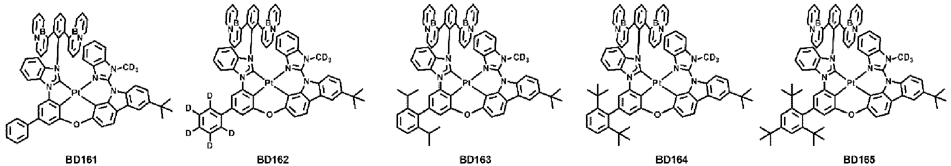 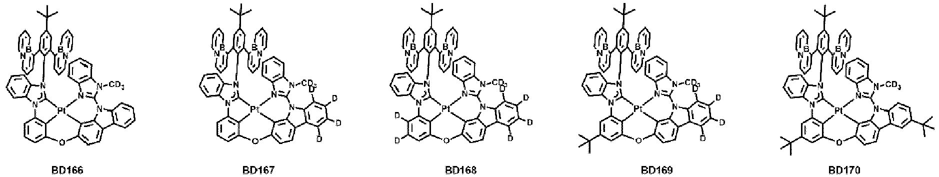 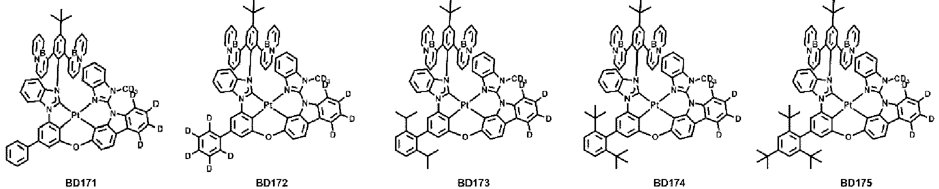 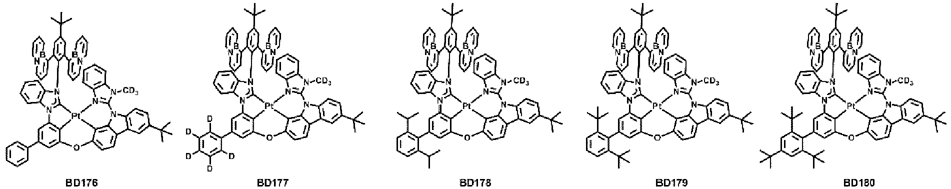 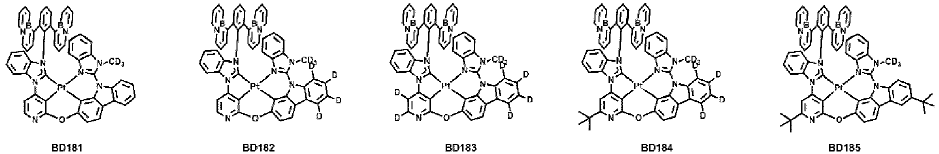 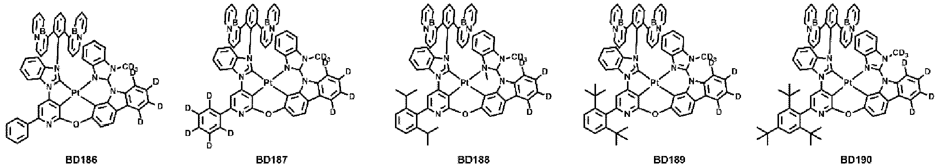 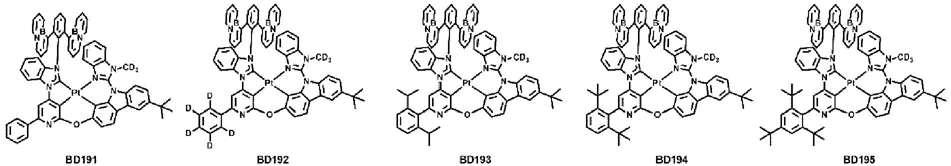 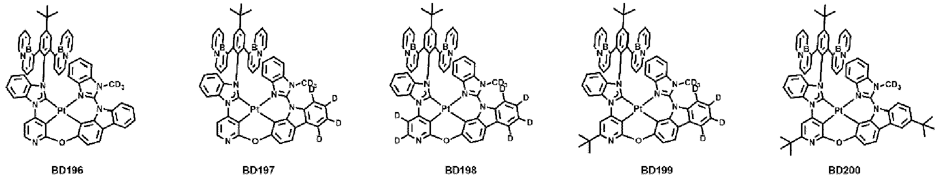 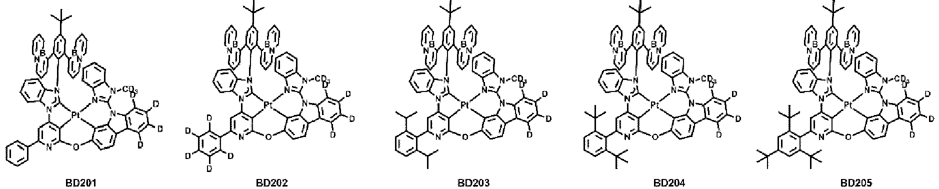 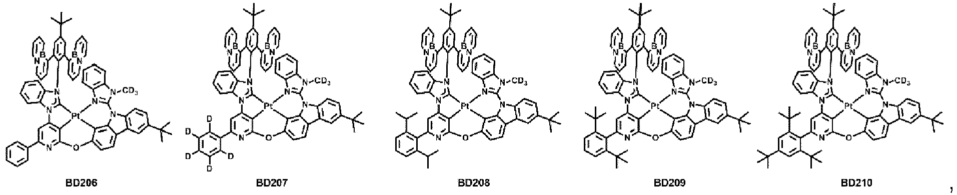 wherein, in Compounds BD01 to BD210, D₄ (d₄) indicates substitution with four deuteriums (D).

In the organometallic compound represented by Formula 1, a triplet (T1) energy level of the A₁ group represented by Formula 1B may be about 0.01 eV or higher than a triplet energy level of another moiety in the molecule. Because a bulky group such as a group represented by Formula 1A is substituted on the ligand, the group represented by Formula 1A may induce steric hindrance to thereby suppress or reduce substituent rotation and maintain structural rigidity of the molecule. Accordingly, when the organometallic compound is used as a dopant, intermolecular interaction between homogeneous or heterogeneous molecules may be suppressed or reduced to thereby suppress or reduce self-aggregation or aggregation with a host material. Due to such a structural characteristic, two types (or kinds) of energy transfer, including metal to ligand charge transfer (³MLCT) and intraligand charge transfer (³ILCT), may be activated. Accordingly, a light-emitting device including the organometallic compound may have improved efficiency and lifespan.

In addition, the organometallic compound represented by Formula 1 may include at least one carbon-deuterium (C-D) bond. A C-D bond may have a short bonding length, as compared with a C-H bond, and the binding energy may increase about 13 kcal/mol. Thus, the internal energy of the organometallic compound may decrease, and stability of the complex molecule may improve. Accordingly, upon energy transition in the molecule, nonradiative transition may be prevented or reduced to thereby improve a photoluminescence quantum yield (PLQY).

In the organometallic compound represented by Formula 1, a carbene-containing ligand and the group represented by Formula 1A may be disposed (e.g., positioned) to be substantially perpendicular to a carbene-containing core. Thus, the overall molecular conjugation may be broken or decreased. Accordingly, an emission wavelength may be blue-shifted, and thus, when the organometallic compound is applied to a light-emitting device, the light-emitting device may emit deep-blue light. Accordingly, the light-emitting device may exhibit improved colorimetric purity and color reproducibility.

Therefore, an electronic device, e.g., a light-emitting device, including the organometallic compound may have a low driving voltage, high efficiency, long lifespan, and/or high colorimetric purity.

Methods of synthesizing the organometallic compound represented by Formula 1 may be easily understood to those of ordinary skill in the art by referring to Synthesis Examples and Examples described herein.

At least one of the organometallic compounds represented by Formula 1 may be used in a light-emitting device (e.g., an organic light-emitting device).

According to one or more embodiments, a light-emitting device includes a first electrode; a second electrode facing the first electrode; an interlayer located between the first electrode and the second electrode and including an emission layer and the organometallic compound represented by Formula 1.

In some embodiments,
the first electrode of the light-emitting device may be an anode,
the second electrode of the light-emitting device may be a cathode,
the interlayer may further include a hole transport region located between the first electrode and the emission layer, and an electron transport region located between the emission layer and the second electrode,
the hole transport region may include a hole injection layer, a hole transport layer, an emission auxiliary layer, an electron blocking layer, or any combination thereof, and
the electron transport region may include a buffer layer, a hole blocking layer, an electron control layer, an electron transport layer, an electron injection layer, or any combination thereof.

In one or more embodiments, the organometallic compound may be included in an interlayer, e.g., an emission layer, of the light-emitting device.

In one or more embodiments, the emission layer may include a host and a dopant, and the dopant may include the organometallic compound. For example, the organometallic compound may serve as an emission layer dopant. A content (e.g., amount) of the dopant in the emission layer may be in a range of about 0.1 parts to about 49.99 parts by weight, based on 100 parts by weight of the emission layer.

The emission layer may emit red light, green light, blue light, and/or white light. In some embodiments, the emission layer may emit blue light. Blue light having a maximum emission wavelength in a range of about 440 nm to about 475 nm may be emitted from the emission layer. A bottom emission-based CIE_{X} color-coordinate of the blue light may be in a range of about 0.13 to about 0.14, and a CIE_{y} color-coordinate may be in a range of about 0.06 to about 0.25, but embodiments are not limited thereto.

In one or more embodiments, the host may include different types (or kinds) of hosts. In some embodiments, the host may include a hole transporting host and an electron transporting host.

In one or more embodiments, the host may include an electron transporting host represented by Formula 2, a hole transporting host represented by Formula 3, or any combination thereof: 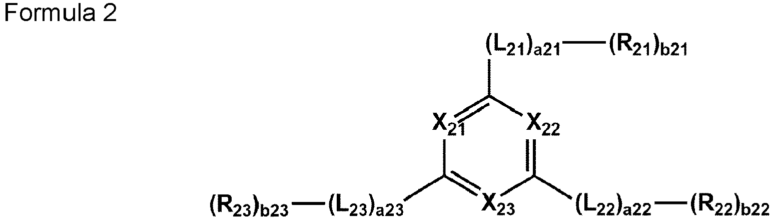 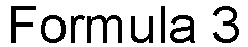 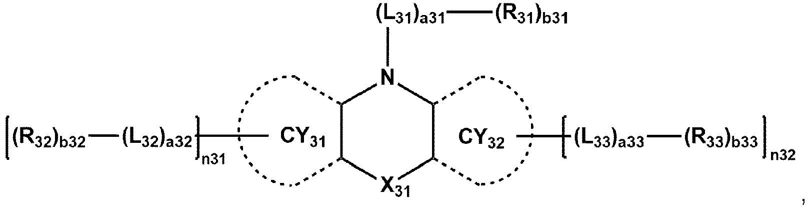 wherein, in Formulae 2 and 3,
X₂₁ is N or C-(L₂₄)ₐ₂₄-(R₂₄)_{b24}, X₂₂ is N or C-(L₂₅)ₐ₂₅-(R₂₅)_{b25}, and X₂₃ is N or C-(L₂₆)ₐ₂₆-(R₂₆)_{b26},
X₃₁ is selected from a single bond, O, S, N(R₃₄), C(R₃₄)(R₃₅), and Si(R₃₄)(R₃₅),
CY₃₁ and CY₃₂ are each independently a C₃-C₆₀ (*e.g*. C₃-C₃₀) carbocyclic group or a C₁-C₆₀ (*e.g*. C₁-C₂₀) heterocyclic group,
L₂₁ to L₂₆ and L₃₁ to L₃₃ are each independently a C₃-C₆₀ (*e.g*. C₃-C₃₀) carbocyclic group unsubstituted or substituted with at least one R₁₀ₐ or a C₁-C₆₀ (*e.g*. C₁-C₂₀) heterocyclic group unsubstituted or substituted with at least one R₁₀ₐ,
a21 to a26 and a31 to a33 are each independently an integer from 0 to 5,
R₂₁ to R₂₆ and R₃₁ to R₃₅ are each independently hydrogen, deuterium, -F, - Cl, -Br, -I, a hydroxyl group, a cyano group, a nitro group, a C₁-C₆₀ (*e.g*. C₁-C₂₀) alkyl group unsubstituted or substituted with at least one R₁₀ₐ, a C₂-C₆₆ (*e.g*. C₂-C₂₀) alkenyl group unsubstituted or substituted with at least one R₁₀ₐ, a C₂-C₆₆ (*e.g*. C₂-C₂₀) alkynyl group unsubstituted or substituted with at least one R₁₀ₐ, a C₁-C₆₀ (*e.g*. C₁-C₂₀) alkoxy group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g*. C₁-C₂₀) heterocyclic group unsubstituted or substituted with at least one R₁₀ₐ, a C₆-C₆₀ (*e.g*. C₆-C₃₀) aryloxy group unsubstituted or substituted with at least one R₁₀ₐ, a C₆-C₆₀ (*e.g*. C₆-C₃₀) arylthio group unsubstituted or substituted with at least one R₁₀ₐ, - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
b21 to b26, b31 to b33, n31, and n32 are each independently an integer from 1 to 5, and
R₁₀ₐ and Q₁ to Q₃ are respectively understood by referring to the descriptions of R₁₀ₐ and Q₁ to Q₃ provided herein.

In Formula 2, when a21 is 0, (L₂₁)ₐ₂₁ may be a single bond, when a22 is 0, (L₂₂)ₐ₂₂ may be a single bond, when a23 is 0, (L₂₃)ₐ₂₃ may be a single bond, when a24 is 0, (L₂₄)ₐ₂₄ may be a single bond, when a25 is 0, (L₂₅)ₐ₂₅ may be a single bond, and when a26 is 0, (L₂₆)ₐ₂₆ may be a single bond.

In some embodiments, in Formula 2, a21 to a26 may each independently be 0 or 1.

In one or more embodiments, in Formula 2, L₂₁ to L₂₆ may each independently be a phenylene group unsubstituted or substituted with at least one R₁₀ₐ.

In some embodiments, in Formula 3, CY₃₁ and CY₃₂ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, but embodiments are not limited thereto.

In one or more embodiments, in Formulae 2 and 3, R₂₁ to R₂₆ and R₃₁ to R₃₅ may each independently be:
hydrogen, deuterium, -F, -Cl, -Br, -I, -CH₂D, -CHD₂, -CD₃, -CH₂F, -CHF₂, - CF₃, a hydroxyl group, a cyano group, or a nitro group;
a C₁-C₆₀ (*e.g*. C₁-C₂₀) alkyl group or a C₁-C₆₀ (*e.g*. C₁-C₂₀) alkoxy group, each unsubstituted or substituted with deuterium, -F, -Cl, -Br, -I, -CH₂D, -CHD₂, -CD₃, - CH₂F, -CHF₂, -CF₃, a hydroxyl group, a cyano group, a nitro group, a cyclopentyl group, a cyclohexyl group, a cycloheptyl group, an adamantyl group, a norbornyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, an adamantyl group, a norbornyl group, a norbornenyl group, a cyclopentenyl group, a cyclohexenyl group, a cycloheptenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, or an indolocarbazolyl group, each unsubstituted or substituted with deuterium, -F, -Cl, - Br, -I, -CH₂D, -CHD₂, -CD₃, -CH₂F, -CHF₂, -CF₃, a hydroxyl group, a cyano group, a nitro group, a C₁-C₆₀ (*e.g*. C₁-C₂₀) alkyl group, a C₁-C₆₀ (*e.g*. C₁-C₂₀) alkoxy group, a cyclopentyl group, a cyclohexyl group, a cycloheptyl group, an adamantyl group, a norbornyl group, a norbornenyl group, a cyclopentenyl group, a cyclohexenyl group, a cycloheptenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, an indolocarbazolyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), - P(=O)(Q₃₁)(Q₃₂), or any combination thereof; or
-Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
wherein Q₁ to Q₃ and Q₃₁ to Q₃₃ may respectively be understood by referring to the descriptions of Q₁ to Q₃ and Q₃₁ to Q₃₃ provided herein.

In some embodiments, in Formula 2, R₂₁ to R₂₆ may each independently be:
a phenyl group or a carbazolyl group, each unsubstituted or substituted with a C₁-C₁₀ alkyl group, a phenyl group, a carbazolyl group, -Si(Q₃₁)(Q₃₂)(Q₃₃), or any combination thereof; or
-Si(Q₁)(Q₂)(Q₃),
wherein Q₁ to Q₃ and Q₃₁ to Q₃₃ may respectively be understood by referring to the descriptions of Q₁ to Q₃ and Q₃₁ to Q₃₃ provided herein.

In one or more embodiments, in Formula 2, at least one of R₂₁ in a number of b21, R₂₂ in a number of b22, and R₂₃ in a number of b23 may be: a phenyl group, a carbazolyl group, each unsubstituted or substituted with a phenyl group, a carbazolyl group, Si(Q₁)(Q₂)(Q₃), or any combination thereof.

In one or more embodiments, the electron transporting host represented by Formula 2 may include at least one deuterium. In some embodiments, at least one selected from R₂₁ to R₂₆ may be deuterium, or at least one selected from L₂₁ to L₂₆ and R₂₁ to R₂₆ may be substituted with at least one deuterium.

In one or more embodiments, the hole transporting host represented by Formula 3 may include at least one deuterium. In some embodiments, at least one selected from R₃₁ to R₃₅ may be deuterium, or at least one selected from L₃₁ to L₃₃ and R₃₁ to R₃₅ may be substituted with at least one deuterium.

For example, the electron transporting host represented by Formula 2 may be one of Compounds ETH1 to ETH16, and the hole transporting host represented by Formula 3 may be one of Compounds HTH1 to HTH16, but embodiments are not limited thereto:

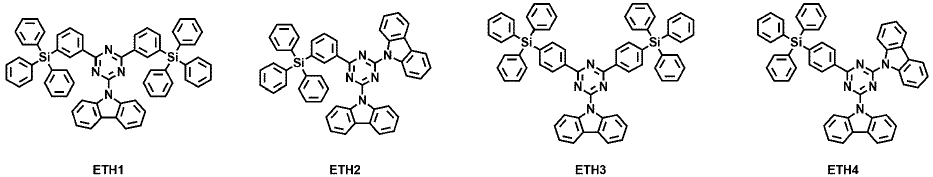

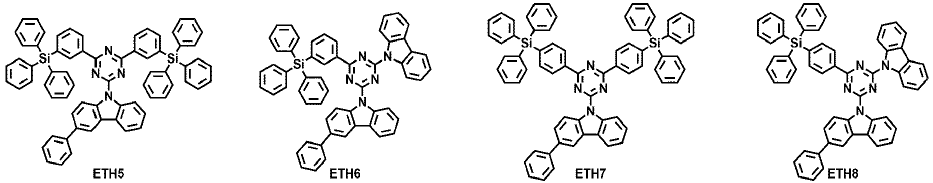

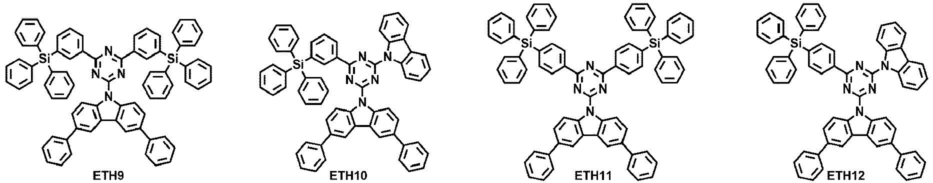

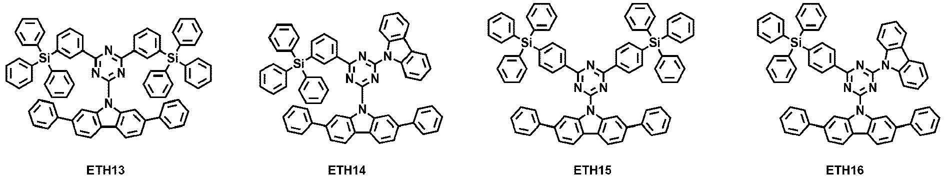

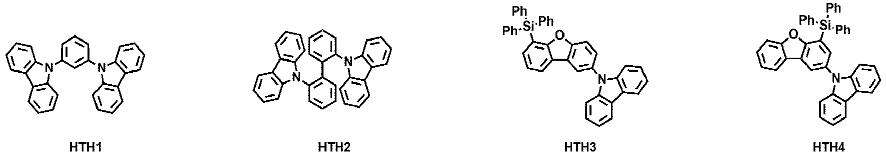

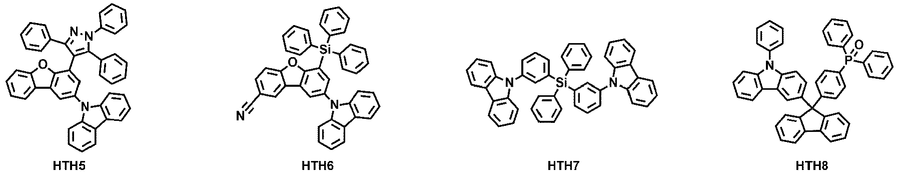

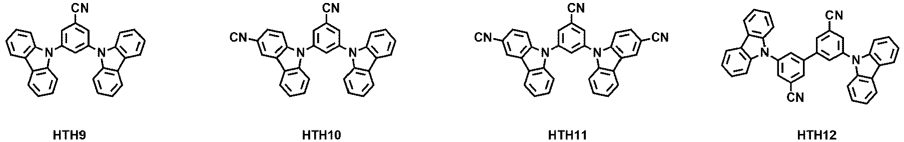

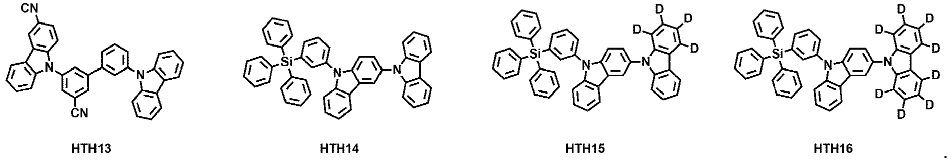

The electron transporting host represented by Formula 2 and the hole transporting host represented by Formula 3 may form an exciplex.

In one or more embodiments, the host may include the electron transporting host represented by Formula 2 and the hole transporting host represented by Formula 3. In this embodiment, the electron transporting host and the hole transporting host may form an exciplex. Thus, when the electron transporting host and the hole transporting host are used as co-hosts in the emission layer, a light-emitting device may have high efficiency and long lifespan.

A content ratio of the electron transporting host to the hole transporting host in the emission layer may be in a range of about 90:10 to about 10:90, for example, about 80:20 to about 20:80, or for example, about 70:30 to about 30:70, but embodiments are not limited thereto.

In one or more embodiments, the dopant may further include a delayed fluorescent material.

For example, the delayed fluorescent material may be a compound represented by Formula 4: 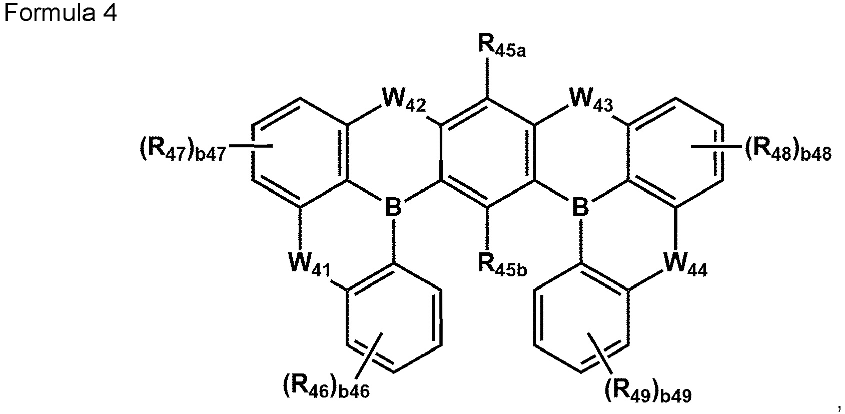 wherein, in Formula 4,
W₄₁ is O, S, N(R₄₁ₐ) or C(R₄₁ₐ)(R_{41b}), W₄₂ is O, S, N(R₄₂ₐ), or C(R₄₂ₐ)(R_{42b}), W₄₃ is O, S, N(R₄₃ₐ), or C(R₄₃ₐ)(R_{43b}), and W₄₄ is O, S, N(R₄₄ₐ), or C(R₄₄ₐ)(R_{44b}),
R₄₁ₐ, R_{41b}, R₄₂ₐ, R_{42b}, R₄₃ₐ, R_{43b}, R₄₄ₐ, R_{44b}, R₄₅ₐ, R_{45b}, R₄₆, R₄₇, R₄₈, and R₄₉ are each independently hydrogen, deuterium, -F, -Cl, -Br, -I, a hydroxyl group, a cyano group, a nitro group, a C₁-C₆₀ (*e.g*. C₁-C₂₀) alkyl group unsubstituted or substituted with at least one R₁₀ₐ, a C₂-C₆₆ (*e.g*. C₂-C₂₀) alkenyl group unsubstituted or substituted with at least one R₁₀ₐ, a C₂-C₆₆ (*e.g*. C₂-C₂₀) alkynyl group unsubstituted or substituted with at least one R₁₀ₐ, a C₁-C₆₀ (*e.g*. C₁-C₂₀) alkoxy group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g*. C₁-C₂₀) heterocyclic group unsubstituted or substituted with at least one R₁₀ₐ, a C₆-C₆₀ (*e.g*. C₆-C₃₀) aryloxy group unsubstituted or substituted with at least one R₁₀ₐ, a C₆-C₆₀ (*e.g*. C₆-C₃₀) arylthio group unsubstituted or substituted with at least one R₁₀ₐ, -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
b46 and b49 are each independently an integer from 1 to 4,
b47 and b48 are each independently an integer from 1 to 3,
R₁₀ₐ and Q₁ to Q₃ may respectively be understood by referring to the descriptions of R₁₀ₐ and Q₁ to Q₃ provided herein.

An excited triplet energy level of the organometallic compound represented by Formula 1 and an excited triplet energy level of the compound represented by Formula 4 may be small such that dexter energy transition may occur.

A difference between an excited triplet energy level of the compound represented by Formula 4 and an excited singlet energy level thereof may be very small (e.g., about 0.3 eV or less). Thus, due to reverse intersystem crossing (RISC) mechanism, excitons of the excited triplet energy level may be transferred to excitons of the excited singlet energy level.

Accordingly, in a case of a light-emitting device further including the compound represented by Formula 4 according to one or more embodiments, excited triplet excitons transitioned from the organometallic compound may not be quenched and may be transitioned to an excited singlet state, and then transitioned to a ground state. Thus, an (organic) light-emitting device having high efficiency and long lifespan may be manufactured.

In one or more embodiments, the compound represented by Formula 4 may be a fluorescence emitter. For example, the compound represented by Formula 4 may be a delayed fluorescence dopant.

In one or more embodiments, W₄₁ may be N(R₄₁ₐ), W₄₂ may be N(R₄₂ₐ), W₄₃ may be N(R₄₃ₐ), and/or W₄₄ may be N(R₄₄ₐ). For example, W₄₁ may be N(R₄₁ₐ), and W₄₂ may be N(R₄₂ₐ). For example, W₄₁ may be N(R₄₁ₐ), W₄₂ may be N(R₄₂ₐ), and W₄₃ may be N(R₄₃ₐ). For example, W₄₁ may be N(R₄₁ₐ), W₄₂ may be N(R₄₂ₐ), and W₄₄ may be N(R₄₄ₐ). For example, W₄₂ may be N(R₄₂ₐ), W₄₃ may be N(R₄₃ₐ), and W₄₄ may be N(R₄₄ₐ). For example, W₄₁ may be N(R₄₁ₐ), W₄₂ may be N(R₄₂ₐ), W₄₃ may be N(R₄₃ₐ), and W₄₄ may be N(R₄₄ₐ).

In one or more embodiments, R₄₇ and R₄₈ may each be -N(Q₁)(Q₂), wherein Q₁ and Q₂ may each independently be a C₆-C₆₀ (*e.g*. C₆-C₃₀) aryl group unsubstituted or substituted with deuterium, -F, a cyano group, a C₁-C₁₀ alkyl group, a phenyl group, a biphenyl group, or any combination thereof, and b47 and b48 may each be 1.

For example, the compound represented by Formula 4 may be one of Compounds DFD1 to DFD12, but embodiments are not limited thereto:

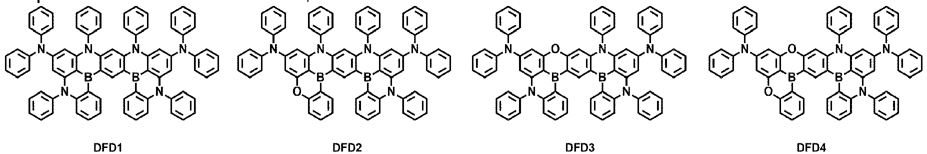

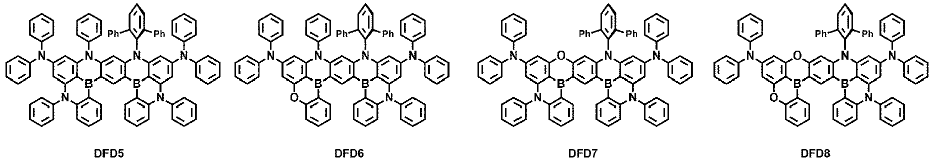

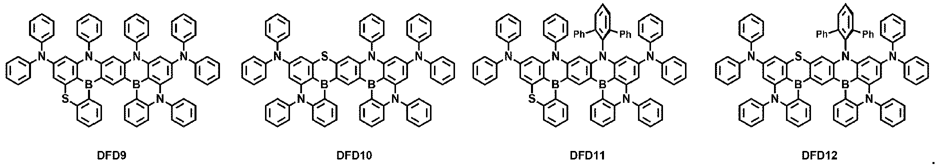

In one or more embodiments, the light-emitting device may include at least one of a first capping layer located outside the first electrode and a second capping layer located outside the second electrode. In some embodiments, the at least one of the first capping layer and the second capping layer may include the organometallic compound represented by Formula 1. The first capping layer and the second capping layer may respectively be understood by referring to the descriptions of the first capping layer and the second capping layer provided herein.

In some embodiments, the at least one of the first capping layer and the second capping layer may have a refractive index of about 1.6 or higher at a wavelength of 589 nanometers (nm).

The expression that an "(interlayer and/or a capping layer) includes at least one organometallic compound" as used herein may be construed as meaning that the "(interlayer and/or the capping layer) may include one organometallic compound of Formula 1 or two or more different organometallic compounds of Formula 1".

For example, Compound BD01 may only be included in the interlayer as the organometallic compound. In this embodiment, Compound BD01 may be included in the emission layer of the light-emitting device. In some embodiments, Compounds BD01 and BD02 may be included in the interlayer as the organometallic compounds. In this embodiment, Compounds BD01 and BD02 may be included in the same layer (for example, both Compounds BD01 and BD02 may be included in an emission layer) or in different layers (for example, Compound BD01 may be included in an emission layer, and Compound BD02 may be included in an electron transport region).

According to one or more embodiments, an electronic apparatus may include the light-emitting device. The electronic apparatus may further include a thin-film transistor. In some embodiments, the electronic apparatus may further include a thin-film transistor including a source electrode and a drain electrode, and a first electrode of the light-emitting device may be electrically connected (e.g., electrically coupled) to the source electrode or the drain electrode. The electronic apparatus may further include a color filter, a color-conversion layer, a touchscreen layer, a polarization layer, or any combination thereof. The electronic apparatus may be understood by referring to the description of the electronic apparatus provided herein.

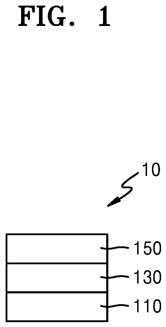

### Description of FIG. 1

FIG. 1 is a schematic view of a light-emitting device 10 according to one or more embodiments. The light-emitting device 10 includes a first electrode 110, an interlayer 130, and a second electrode 150.

Hereinafter, the structure of the light-emitting device 10 according to one or more embodiments and a method of manufacturing the light-emitting device 10 according to one or more embodiments will be described in connection with FIG. 1.

### First electrode 110

In FIG. 1, a substrate may be additionally located under the first electrode 110 or above the second electrode 150. The substrate may be a glass substrate and/or a plastic substrate. The substrate may be a flexible substrate including plastic having excellent (or suitable) heat resistance and durability, for example, polyimide, polyethylene terephthalate (PET), polycarbonate, polyethylene naphthalate, polyarylate (PAR), polyetherimide, or any combination thereof.

The first electrode 110 may be formed by depositing or sputtering, on the substrate, a material for forming the first electrode 110. When the first electrode 110 is an anode, a high work function material that may easily inject holes may be used as a material for a first electrode.

The first electrode 110 may be a reflective electrode, a semi-transmissive electrode, or a transmissive electrode. When the first electrode 110 is a transmissive electrode, a material for forming the first electrode 110 may be indium tin oxide (ITO), indium zinc oxide (IZO), tin oxide (SnO₂), zinc oxide (ZnO), or any combinations thereof. In some embodiments, when the first electrode 110 is a semi-transmissive electrode or a reflective electrode, magnesium (Mg), silver (Ag), aluminum (Al), aluminum-lithium (Al-Li), calcium (Ca), magnesium-indium (Mg-In), magnesium-silver (Mg-Ag), or any combination thereof may be used as a material for forming the first electrode 110.

The first electrode 110 may have a single-layered structure including (e.g., consisting of) a single layer or a multi-layered structure including two or more layers. In some embodiments, the first electrode 110 may have a triple-layered structure of ITO/Ag/ITO.

### Interlayer 130

The interlayer 130 is on the first electrode 110. The interlayer 130 includes an emission layer.

The interlayer 130 may further include a hole transport region between the first electrode 110 and the emission layer and an electron transport region between the emission layer and the second electrode 150.

The interlayer 130 may further include metal-containing compounds such as organometallic compounds, inorganic materials such as quantum dots, and/or the like, in addition to one or more suitable organic materials.

The interlayer 130 may include: i) at least two emitting units sequentially stacked between the first electrode 110 and the second electrode 150; and ii) a charge-generation layer located between the at least two emitting units. When the interlayer 130 includes the at least two emitting units and the charge generation layer, the light-emitting device 10 may be a tandem light-emitting device.

### Hole transport region in interlayer 130

The hole transport region may have i) a single-layered structure including (e.g., consisting of) a single layer including (e.g., consisting of) a single material, ii) a single-layered structure including (e.g., consisting of) a single layer including a plurality of different materials, or iii) a multi-layered structure having a plurality of layers including a plurality of different materials.

The hole transport region may include a hole injection layer, a hole transport layer, an emission auxiliary layer, an electron blocking layer, or a combination thereof.

For example, the hole transport region may have a multi-layered structure, e.g., a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein the layers of each structure are sequentially stacked on the first electrode 110 in each stated order.

The hole transport region may include the compound represented by Formula 201, the compound represented by Formula 202, or any combination thereof: 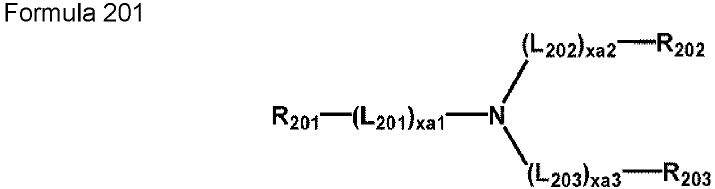 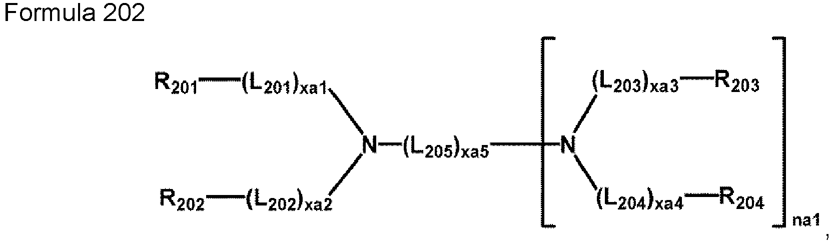 wherein, in Formulae 201 and 202,
L₂₀₁ to L₂₀₄ may each independently be a C₃-C₆₀ (*e.g*. C₃-C₃₀) carbocyclic group unsubstituted or substituted with at least one R₁₀ₐ or a C₁-C₆₀ (*e.g*. C₁-C₂₀) heterocyclic group unsubstituted or substituted with at least one R₁₀ₐ,
L₂₀₅ may be *-O-*', *-S-*', *-N(Q₂₀₁)-*', a C₁-C₂₀ (*e.g.* C₁-C₁₀) alkylene group unsubstituted or substituted with at least one R₁₀ₐ, a C₂-C₂₀ (*e.g*. C₂-C₁₀) alkenylene group unsubstituted or substituted with at least one R₁₀ₐ, a C₃-C₆₀ (*e.g*. C₃-C₃₀) carbocyclic group unsubstituted or substituted with at least one R₁₀ₐ, or a C₁-C₆₀ (*e.g*. C₁-C₂₀) heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ (*e.g*. C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
R₂₀₁ and R₂₀₂ may optionally be bound to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ (*e.g*. C₈-C₃₀) polycyclic group (e.g., a carbazole group and/or the like) unsubstituted or substituted with at least one R₁₀ₐ (e.g., Compound HT16 described herein),
R₂₀₃ and R₂₀₄ may optionally be bound to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ (*e.g*. C₈-C₃₀) polycyclic group unsubstituted or substituted with at least one R₁₀ₐ,
na1 may be an integer from 1 to 4.

In some embodiments, Formulae 201 and 202 may each include at least one of the groups represented by Formulae CY201 to CY217: 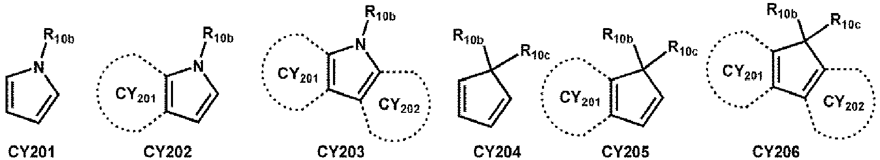 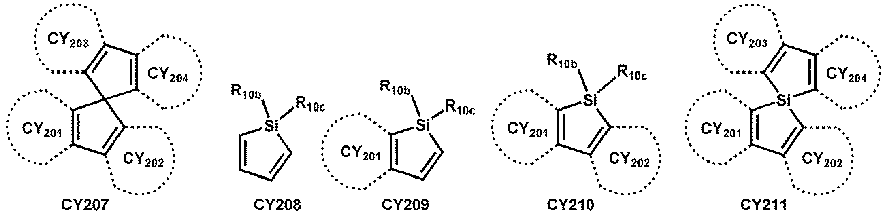 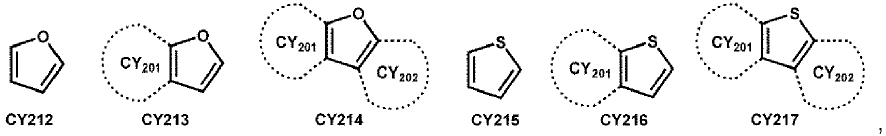 wherein, in Formulae CY201 to CY217, R_{10b} and R_{10c} may each be understood by referring to the descriptions of R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In some embodiments, in Formulae CY201 to CY217, ring CY₂₀₁ to ring CY₂₀₄ may each independently be a benzene group, a naphthalene group, a phenanthrene group, or an anthracene group.

In one or more embodiments, Formulae 201 and 202 may each include at least one of the groups represented by Formula CY201 to CY203.

In one or more embodiments, Formula 201 may include at least one of groups represented by Formulae CY201 to CY203 and at least one of the groups represented by Formulae CY204 to CY217.

In one or more embodiments, in Formula 201, xa1 may be 1, R₂₀₁ may be a group represented by any one of Formulae CY201 to CY203, xa2 may be 0, and R₂₀₂ may be a group represented by Formulae CY204 to CY207.

In one or more embodiments, Formula 201 and 202 may each not include groups represented by Formulae CY201 to CY203.

In one or more embodiments, Formula 201 and 202 may each not include groups represented by Formulae CY201 to CY203, and include at least one of the groups represented by Formulae CY204 to CY217.

In one or more embodiments, Formula 201 and 202 may each not include groups represented by Formulae CY201 to CY217.

In some embodiments, the hole transport region may include one of Compounds HT1 to HT46, m-MTDATA, TDATA, 2-TNATA, NPB (NPD), β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphorsulfonic acid (PANI/CSA), polyaniline/poly(4-styrenesulfonate (PANI/PSS), or any combination thereof:

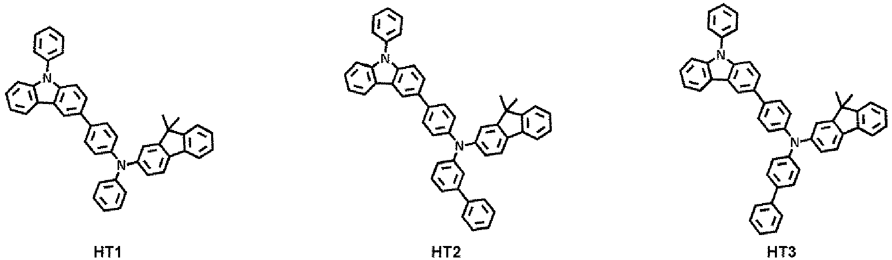

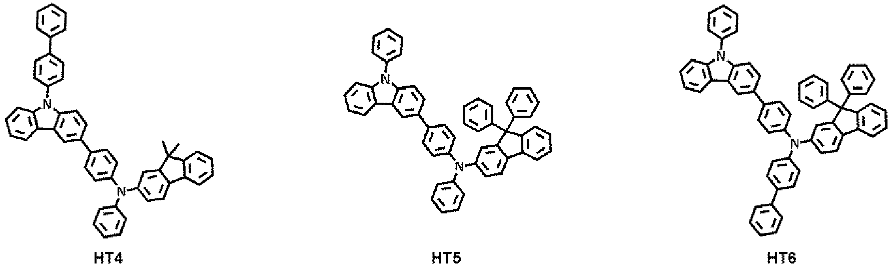

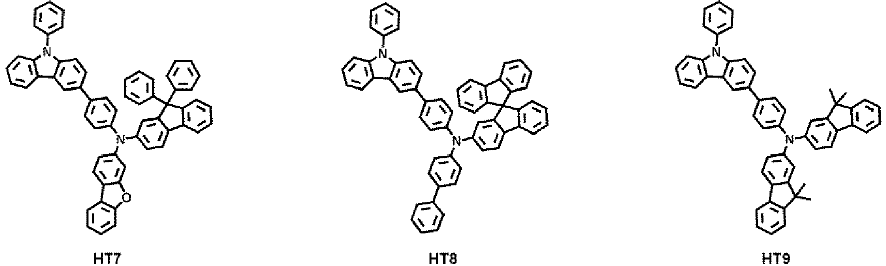

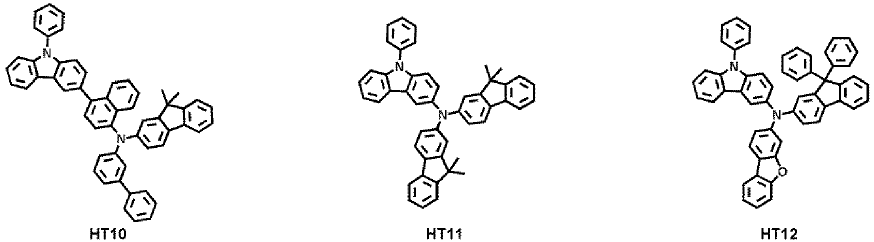

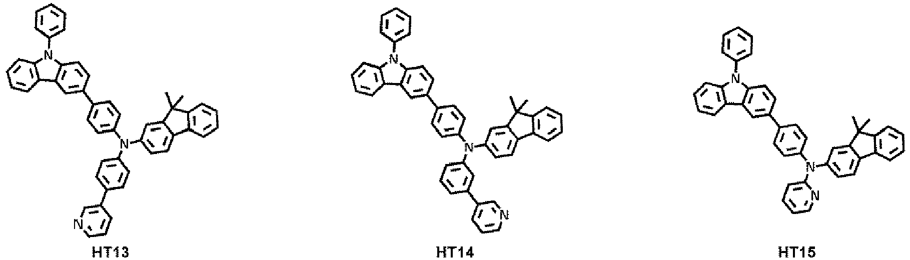

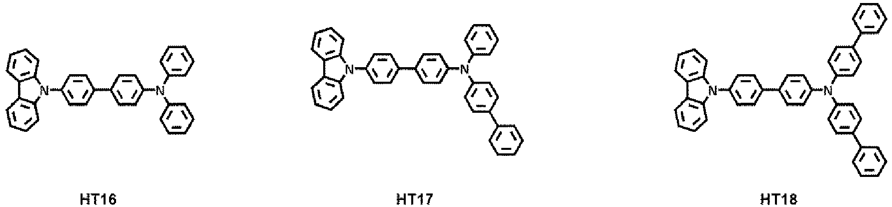

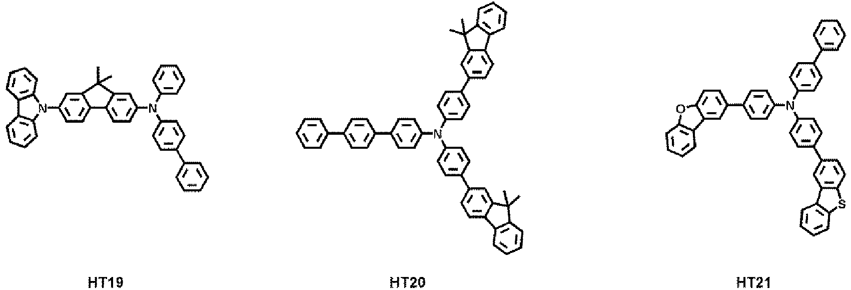

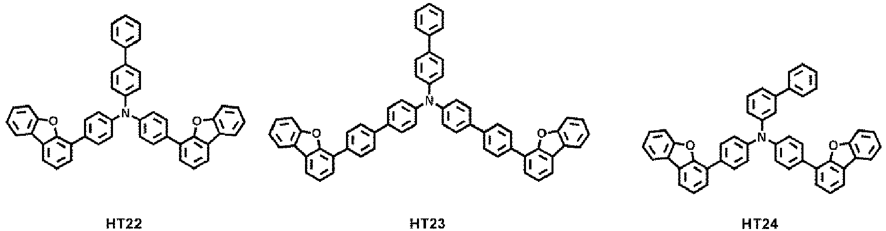

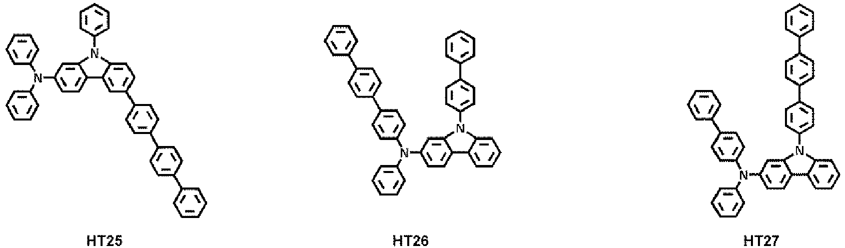

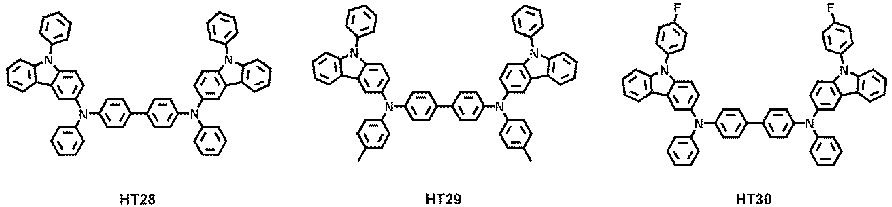

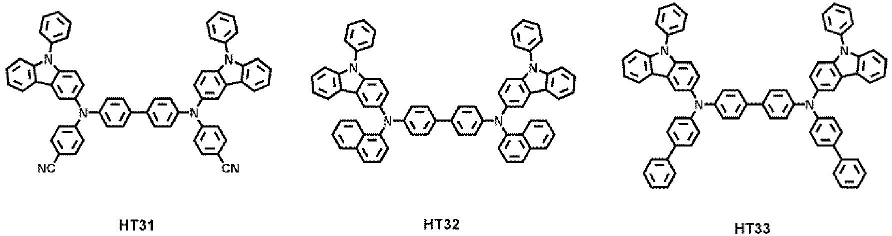

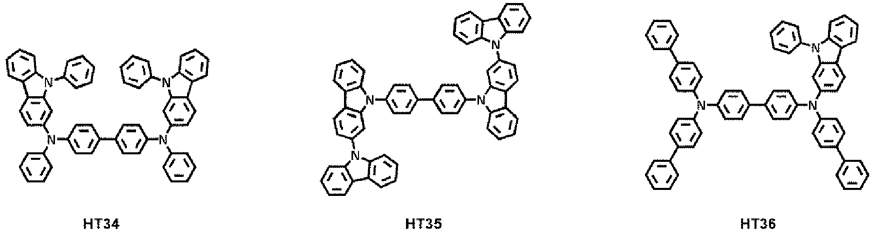

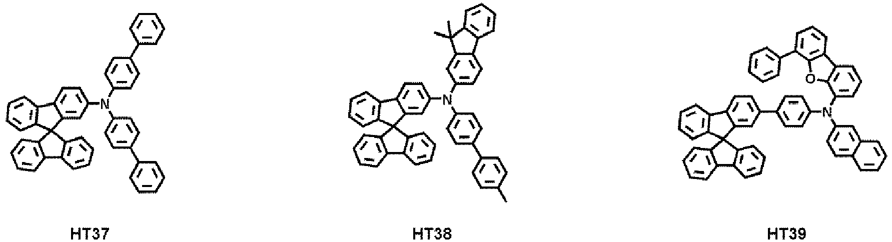

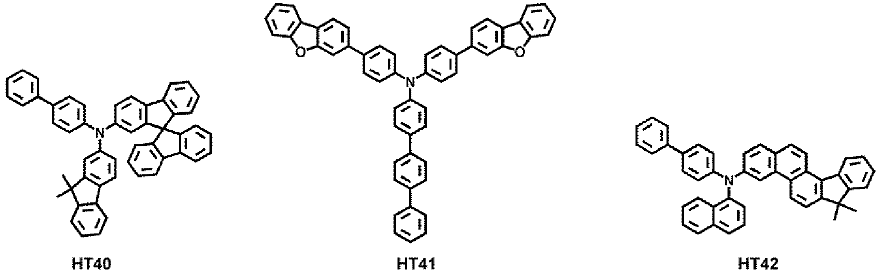

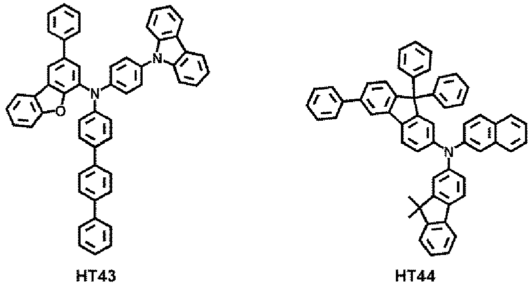

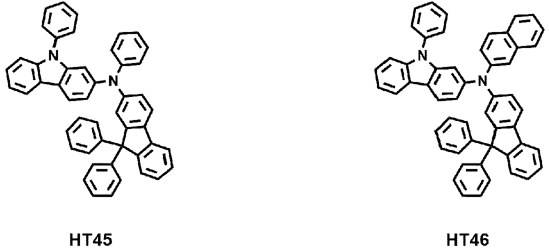

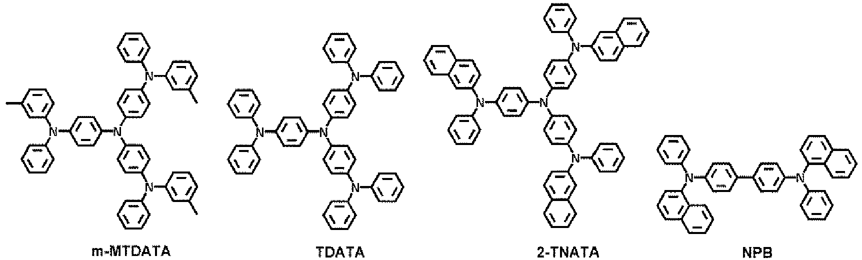

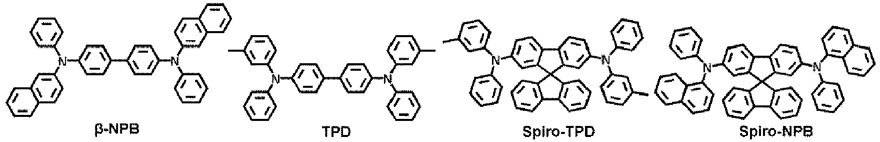

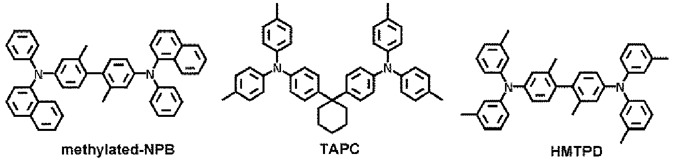

The thickness of the hole transport region may be in a range of about 50 Angstroms (Å) to about 10,000 Å, for example, about 100 Å to about 7,000 Å, about 100 Å to about 5,000 Å, about 100 Å to about 4,000 Å or about 100 Å to about 1,000 Å. When the hole transport region includes a hole injection layer, a hole transport layer, or any combination thereof, the thickness of the hole injection layer may be in a range of about 100 Å to about 9,000 Å, for example, about 100 Å to about 7,000 Å, about 100 Å to about 5,000 Å, about 100 Å to about 3,000 Å, about 100 Å to about 2,000 Å, about 100 Å to about 1,000 Å or about 500 Å to about 700 Å, and the thickness of the hole transport layer may be in a range of about 50 Å to about 2,000 Å, for example, about 100 Å to about 1,500 Å or about 200 Å to about 400 Å. When the thicknesses of the hole transport region, the hole injection layer, and the hole transport layer are within any of these ranges, excellent (or improved) hole transport characteristics may be obtained without a substantial increase in driving voltage.

The emission auxiliary layer may increase light emission efficiency by compensating for an optical resonance distance according to the wavelength of light emitted by an emission layer. The electron blocking layer may reduce or eliminate the flow of electrons from an electron transport region. The emission auxiliary layer and the electron blocking layer may each independently include any of the aforementioned materials.

### p-dopant

The hole transport region may include a charge generating material, as well as the aforementioned materials, to improve conductive properties of the hole transport region. The charge generating material may be substantially homogeneously or nonhomogeneously dispersed (for example, as a single layer consisting of charge generating material) in the hole transport region.

The charge generating material may include, for example, a p-dopant.

In some embodiments, a lowest unoccupied molecular orbital (LUMO) energy level of the p-dopant may be about -3.5 eV or less.

In some embodiments, the p-dopant may include a quinone derivative, a cyano group-containing compound, elements EL1 and/or EL2-containing compound, or any combination thereof.

Examples of the quinone derivative may include TCNQ, F4-TCNQ, and the like.

Examples of the cyano group-containing compound may include HAT-CN, a compound represented by Formula 221, and the like: 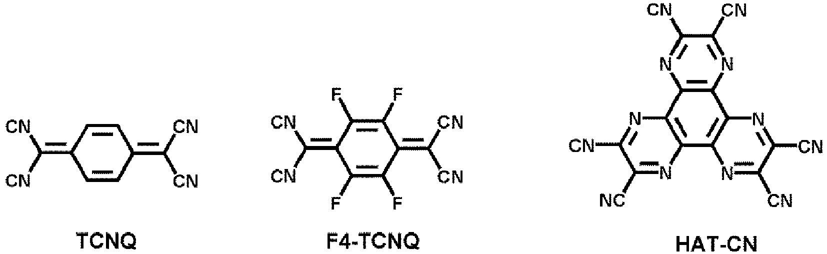 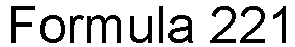 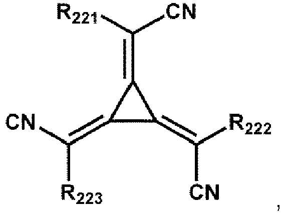 wherein, in Formula 221,
R₂₂₁ to R₂₂₃ may each independently be a C₃-C₆₀ (*e.g*. C₃-C₃₀) carbocyclic group unsubstituted or substituted with at least one R₁₀ₐ or a C₁-C₆₀ (*e.g*. C₁-C₂₀) heterocyclic group unsubstituted or substituted with at least one R₁₀ₐ, and
at least one of R₂₂₁ to R₂₂₃ may each independently be: a C₃-C₆₀ (*e.g*. C₃-C₃₆) carbocyclic group or a C₁-C₆₀ (*e.g*. C₁-C₂₀) heterocyclic group, each independently substituted with a cyano group; -F; -Cl; -Br; -I; a C₁-C₂₀ (*e.g*. C₁-C₁₀) alkyl group substituted with a cyano group, -F, -Cl, -Br, -I, or any combination thereof; or any combination thereof.

In the elements EL1 and/or EL2-containing compound, element EL1 may be metal, metalloid, or a combination thereof, and element EL2 may be non-metal, metalloid, or a combination thereof.

Examples of the metal may include: an alkali metal (e.g., lithium (Li), sodium (Na), potassium (K), rubidium (Rb), cesium (Cs), and/or the like); an alkaline earth metal (e.g., beryllium (Be), magnesium (Mg), calcium (Ca), strontium (Sr), barium (Ba), and/or the like); a transition metal (e.g., titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), and/or the like); post-transition metal (e.g., zinc (Zn), indium (In), tin (Sn), and/or the like); a lanthanide metal (e.g., lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), and/or the like); and/or the like.

Examples of the metalloid may include silicon (Si), antimony (Sb), tellurium (Te), and/or the like.

Examples of the non-metal may include oxygen (O), halogen (e.g., F, Cl, Br, I, and/or the like), and/or the like.

For example, the elements EL1 and/or EL2-containing compound may include a metal oxide, a metal halide (e.g., metal fluoride, metal chloride, metal bromide, metal iodide, and/or the like), a metalloid halide (e.g., a metalloid fluoride, a metalloid chloride, a metalloid bromide, a metalloid iodide, and/or the like), a metal telluride, or any combination thereof.

Examples of the metal oxide may include tungsten oxide (e.g., WO, W₂O₃, WO₂, WO₃, W₂O₅, and/or the like), vanadium oxide (e.g., VO, V₂O₃, VO₂, V₂O₅, and/or the like), molybdenum oxide (MoO, Mo₂O₃, MoO₂, MoOs, Mo₂O₅, and/or the like), rhenium oxide (e.g., ReOs, and/or the like), and the like.

Examples of the metal halide may include alkali metal halide, alkaline earth metal halide, transition metal halide, post-transition metal halide, lanthanide metal halide, and the like.

Examples of the alkali metal halide may include LiF, NaF, KF, RbF, CsF, LiCl, NaCl, KCl, RbCl, CsCl, LiBr, NaBr, KBr, RbBr, CsBr, Lil, Nal, KI, Rbl, Csl, and the like.

Examples of the alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, and the like.

Examples of the transition metal halide may include titanium halide (e.g., TiF₄, TiCl₄, TiBr₄, TiI₄, and/or the like), zirconium halide (e.g., ZrF₄, ZrCl₄, ZrBr₄, ZrI₄, and/or the like), hafnium halide (e.g., HfF₄, HfCl₄, HfBr₄, HfI₄, and/or the like), vanadium halide (e.g., VF₃, VCl₃, VBr₃, VI₃, and/or the like), niobium halide (e.g., NbF₃, NbCl₃, NbBr₃, NbI₃, and/or the like), tantalum halide (e.g., TaF₃, TaCl₃, TaBr₃, TaI₃, and/or the like), chromium halide (e.g., CrF₃, CrCl₃, CrBr₃, CrI₃, and/or the like), molybdenum halide (e.g., MoF₃, MoCl₃, MoBr₃, MoI₃, and/or the like), tungsten halide (e.g., WF₃, WCl₃, WBr₃, WI₃, and/or the like), manganese halide (e.g., MnF₂, MnCl₂, MnBr₂, MnI₂, and/or the like), technetium halide (e.g., TcF₂, TcCl₂, TcBr₂, TcI₂, and/or the like), rhenium halide (e.g., ReF₂, ReCl₂, ReBr₂, ReI₂, and/or the like), iron halide (e.g., FeF₂, FeCl₂, FeBr₂, FeI₂, and/or the like), ruthenium halide (e.g., RuF₂, RuCl₂, RuBr₂, RuI₂, and/or the like), osmium halide (e.g., OsF₂, OsCl₂, OsBr₂, OsI₂, and/or the like), cobalt halide (e.g., CoF₂, CoCl₂, CoBr₂, CoI₂, and/or the like), rhodium halide (e.g., RhF₂, RhCl₂, RhBr₂, RhI₂, and/or the like), iridium halide (e.g., IrF₂, IrCl₂, IrBr₂, IrI₂, and/or the like), nickel halide (e.g., NiF₂, NiCl₂, NiBr₂, NiI₂, and/or the like), palladium halide (e.g., PdF₂, PdCl₂, PdBr₂, PdI₂, and/or the like), platinum halide (e.g., PtF₂, PtCl₂, PtBr₂, PtI₂, and/or the like), copper halide (e.g., CuF, CuCl, CuBr, Cul, and/or the like), silver halide (e.g., AgF, AgCl, AgBr, Agl, and/or the like), gold halide (e.g., AuF, AuCl, AuBr, Aul, and/or the like), and the like.

Examples of the post-transition metal halide may include zinc halide (e.g., ZnF₂, ZnCl₂, ZnBr₂, ZnI₂, and/or the like), indium halide (e.g., InI₃ and/or the like), tin halide (e.g., SnI₂ and/or the like), and the like.

Examples of the lanthanide metal halide may include YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, SmI₃, and the like.

Examples of the metalloid halide may include antimony halide (e.g., SbCl₅ and/or the like) and the like.

Examples of the metal telluride may include alkali metal telluride (e.g., Li₂Te, Na₂Te, K₂Te, Rb₂Te, Cs₂Te, and/or the like), alkaline earth metal telluride (e.g., BeTe, MgTe, CaTe, SrTe, BaTe, and/or the like), transition metal telluride (e.g., TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, and/or the like), post-transition metal telluride (e.g., ZnTe and/or the like), lanthanide metal telluride (e.g., LaTe, CeTe, PrTe, NdTe, PmTe, EuTe, GdTe, TbTe, DyTe, HoTe, ErTe, TmTe, YbTe, LuTe, and/or the like), and the like.

### Emission layer in interlayer 130

When the light-emitting device 10 is a full color light-emitting device, the emission layer may be patterned into a red emission layer, a green emission layer, and/or a blue emission layer, according to a sub-pixel. In one or more embodiments, the emission layer may have a stacked structure. The stacked structure may include two or more layers selected from a red emission layer, a green emission layer, and a blue emission layer. The two or more layers may be in direct contact with each other. In some embodiments, the two or more layers may be separated from each other. In one or more embodiments, the emission layer may include two or more materials. The two or more materials may include a red light-emitting material, a green light-emitting material, and/or a blue light-emitting material. The two or more materials may be mixed with each other in a single layer. The two or more materials mixed with each other in the single layer may emit white light.

The emission layer may include a host and a dopant. The dopant may be a phosphorescent dopant, a fluorescent dopant, or any combination thereof.

In one or more embodiments, the host may include the electron transporting host represented by Formula 2, the hole transporting host represented by Formula 3, or any combination thereof.

The dopant may include the organometallic compound represented by Formula 1. In some embodiments, the dopant may further include the compound represented by Formula 4.

The amount of the dopant in the emission layer may be in a range of about 0.01 parts to about 15 parts by weight based on 100 parts by weight of the host.

In some embodiments, the emission layer may include a quantum dot.

The emission layer may include a delayed fluorescence material. The delayed fluorescence material may serve as a host or a dopant in the emission layer.

The thickness of the emission layer may be in a range of about 100 Å to about 1,000 Å, and in some embodiments, about 200 Å to about 600 Å. When the thickness of the emission layer is within any of these ranges, improved luminescence characteristics may be obtained without a substantial increase in driving voltage.

### Host

The host may include the electron transporting host represented by Formula 2, the hole transporting host represented by Formula 3, or the compound represented by Formula 301:

Formula 301 [Ar₃₀₁]_{xb11}-[(L₃₀₁)_{xb1}-R₃₀₁]_{xb21},

wherein, in Formula 301,
Ar₃₀₁ and L₃₀₁ may each independently be a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ (*e.g.* C₁-C₂₀) alkyl group unsubstituted or substituted with at least one R₁₀ₐ, a C₂-C₆₀ (*e.g.* C₂-C₂₀) alkenyl group unsubstituted or substituted with at least one R₁₀ₐ, a C₂-C₆₀ (*e.g.* C₂-C₂₀) alkynyl group unsubstituted or substituted with at least one R₁₀ₐ, a C₁-C₆₀ (*e.g.* C₁-C₂₀) alkoxy group unsubstituted or substituted with at least one R₁₀ₐ, a C₃-C₆₀ (*e.g.* C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, -Si(Q₃₀₁)(Q₃₀₂)(Q₃₀₃), -N(Q₃₀₁)(Q₃₀₂), -B(Q₃₀₁)(Q₃₀₂), - C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ may each be understood by referring to the description of Q₁ provided herein.

In some embodiments, when xb11 in Formula 301 is 2 or greater, at least two Ar₃₀₁(s) may be bound via a single bond.

In some embodiments, the host may include a compound represented by Formula 301-1, a compound represented by Formula 301-2, or any combination thereof: 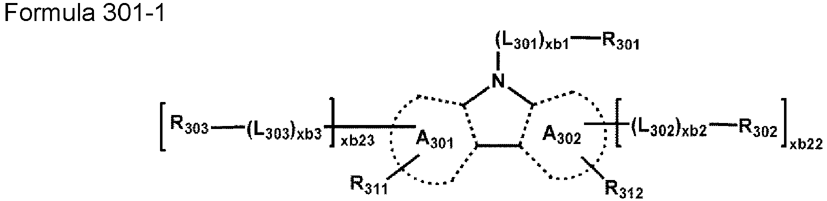 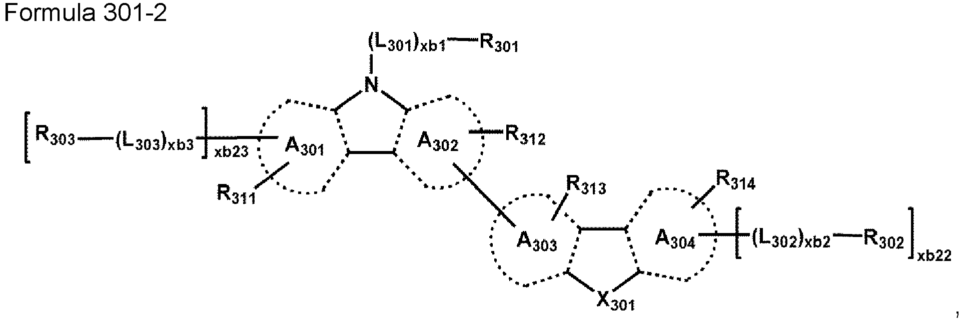 wherein, in Formulae 301-1 to 301-2,
ring A₃₀₁ to ring A₃₀₄ may each independently be a C₃-C₆₀ (*e.g.* C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may respectively be understood by referring to the descriptions of L₃₀₁, xb1, and R₃₀₁ provided herein,
L₃₀₂ to L₃₀₄ may each be understood by referring to the description of L₃₀₁ provided herein,
xb2 to xb4 may each be understood by referring to the descriptions of xb1 provided herein, and
R₃₀₂ to R₃₀₅ and R₃₁₁ to R₃₁₄ may each be understood by referring to the descriptions of R₃₀₁ provided herein.

In some embodiments, the host may include an alkaline earth metal complex. For example, the host may include a Be complex (e.g., Compound H55), a Mg complex, a Zn complex, or any combination thereof.

In some embodiments, the host may include one of Compounds H1 to H124, 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or any combination thereof:

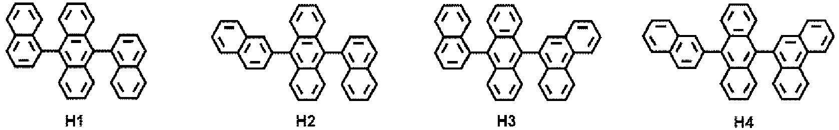

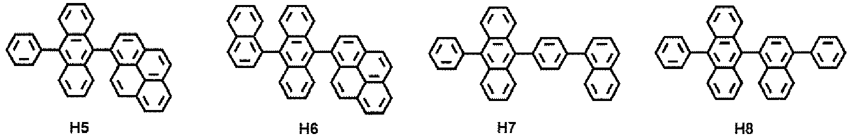

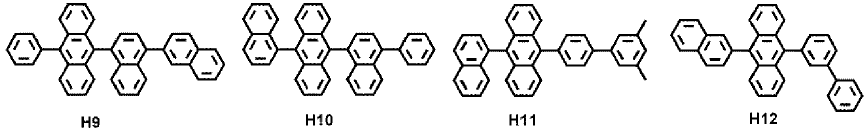

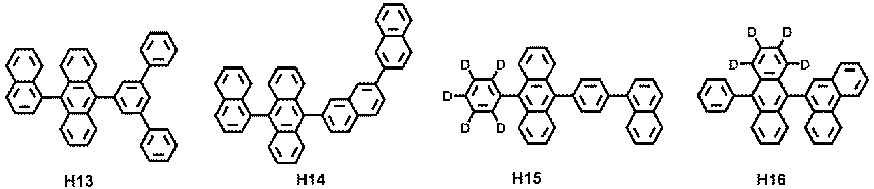

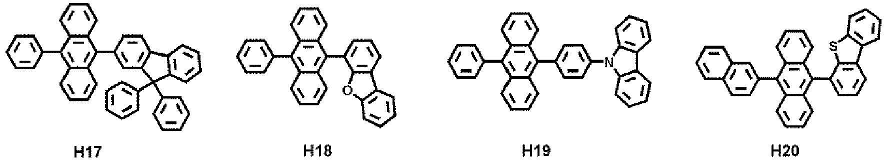

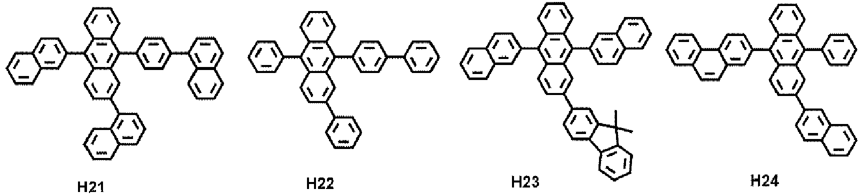

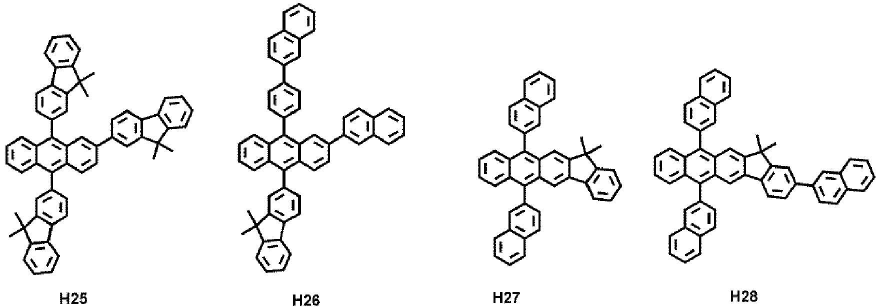

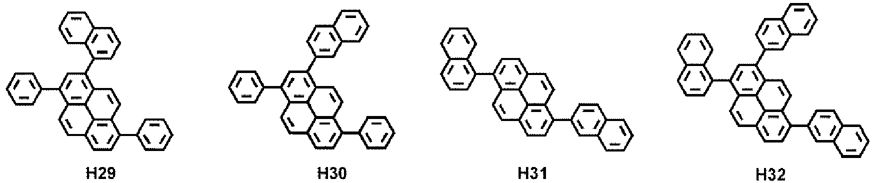

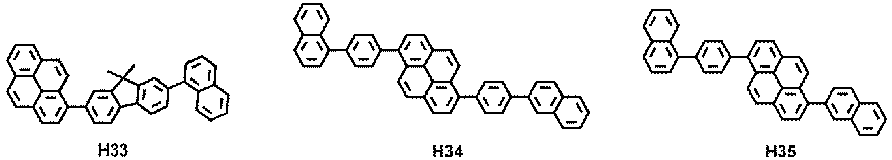

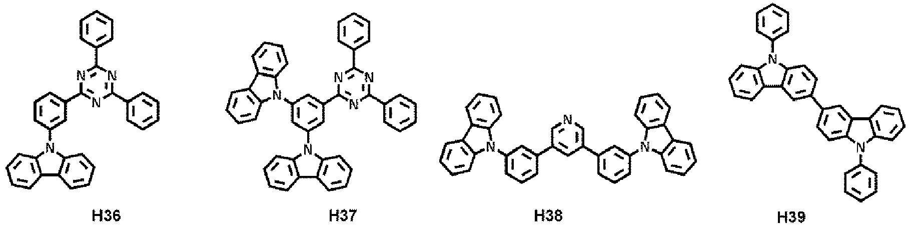

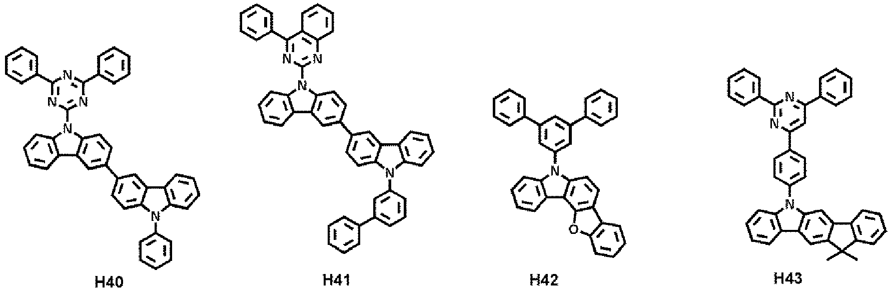

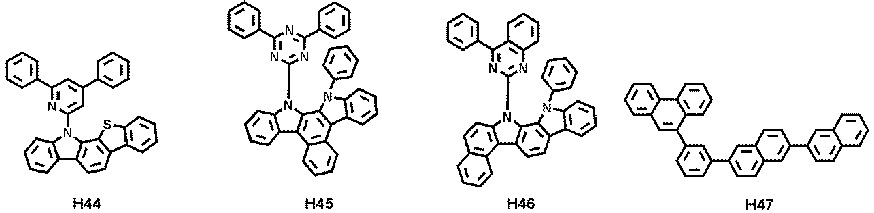

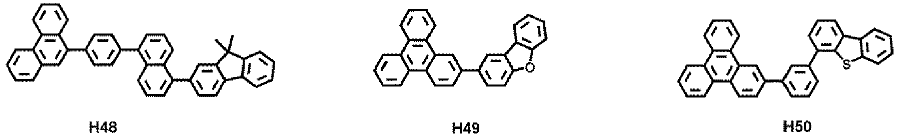

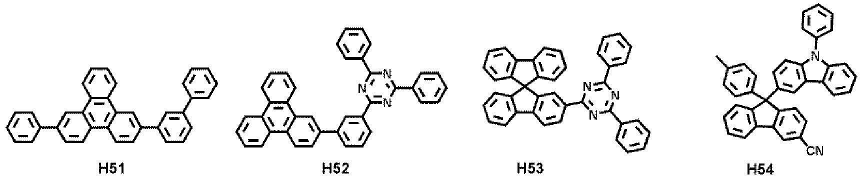

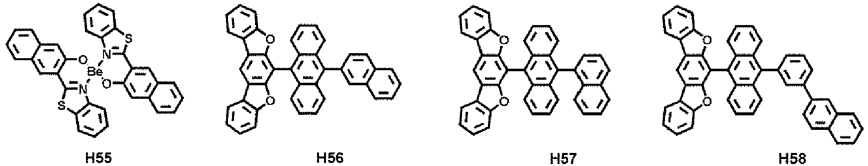

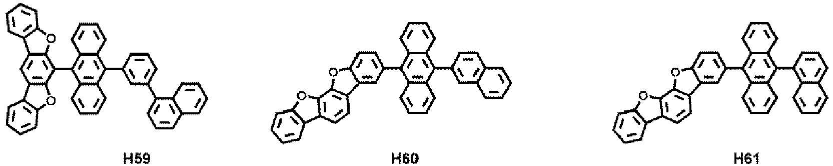

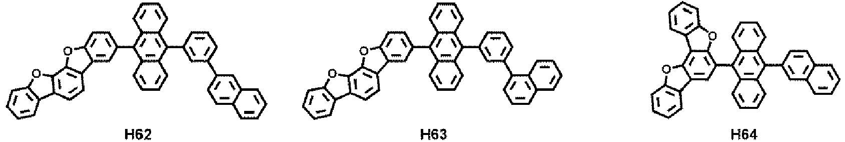

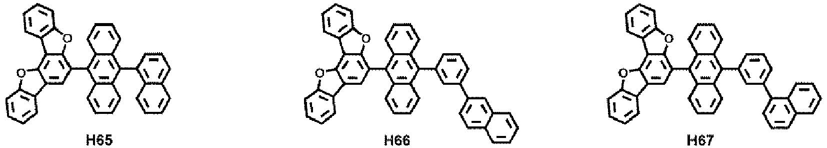

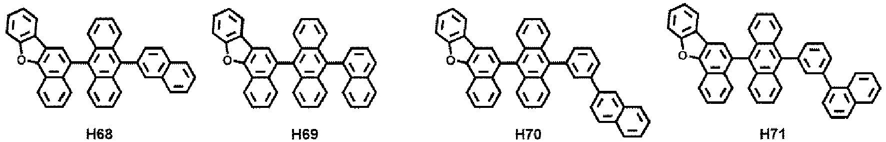

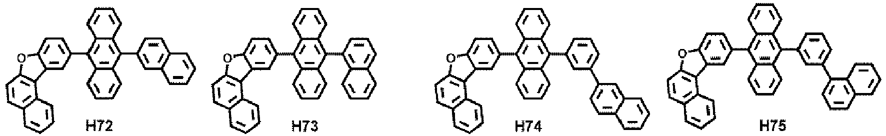

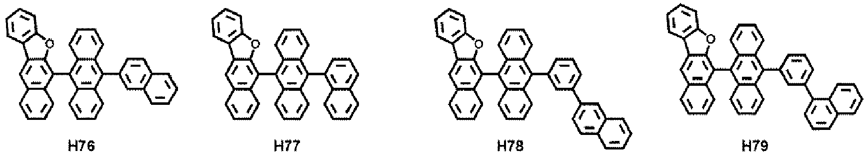

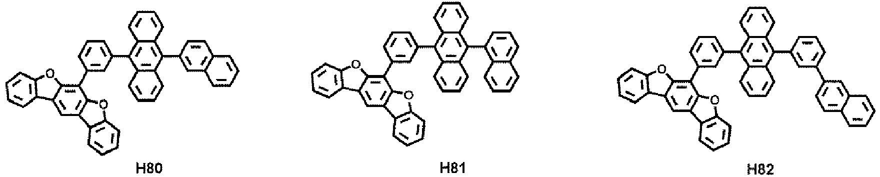

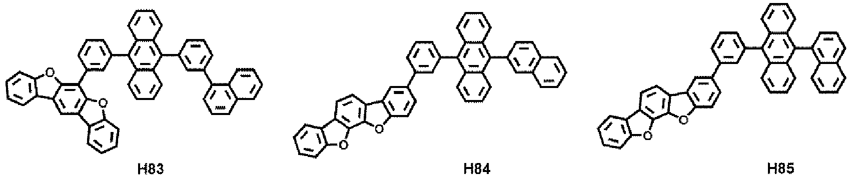

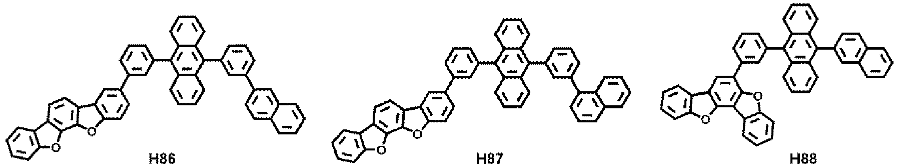

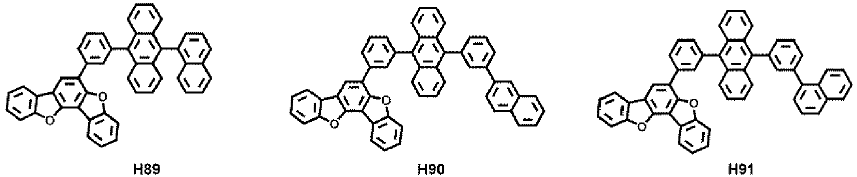

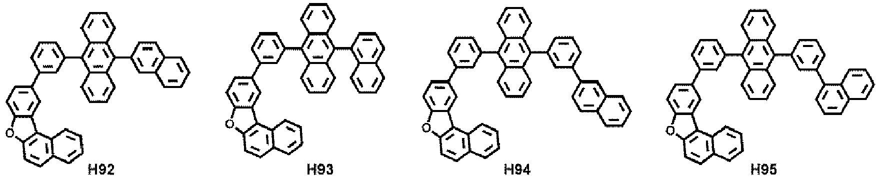

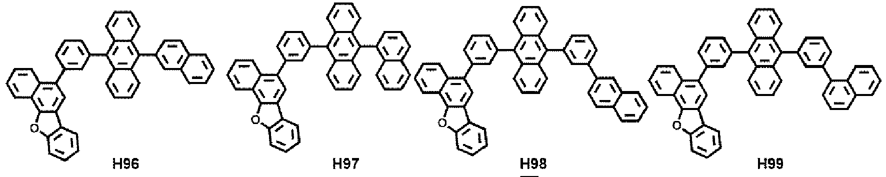

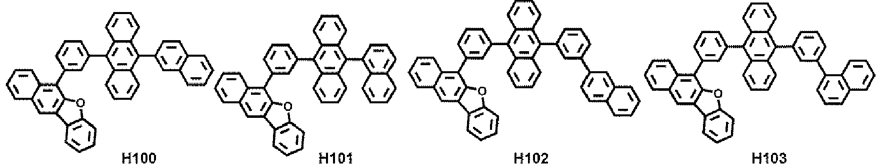

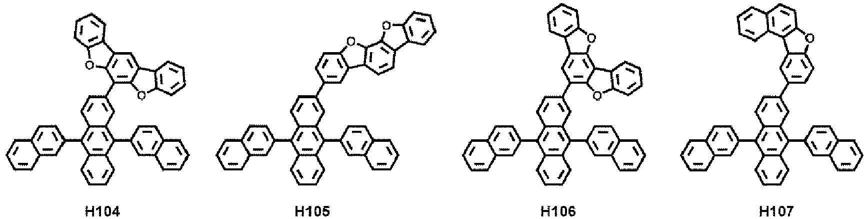

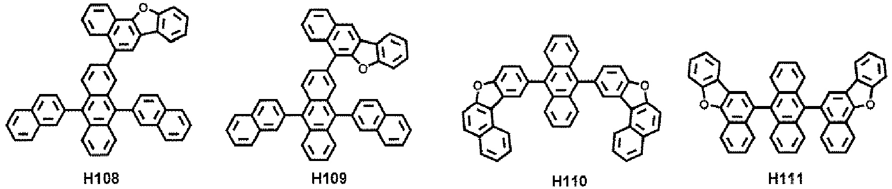

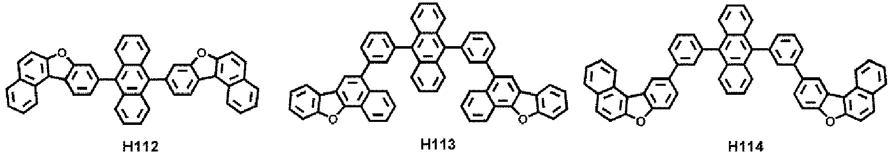

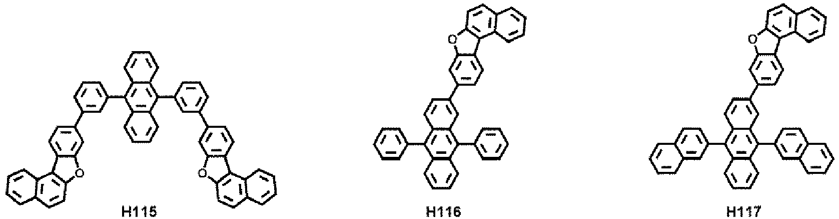

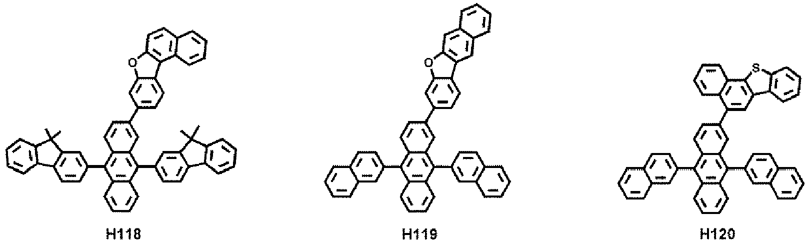

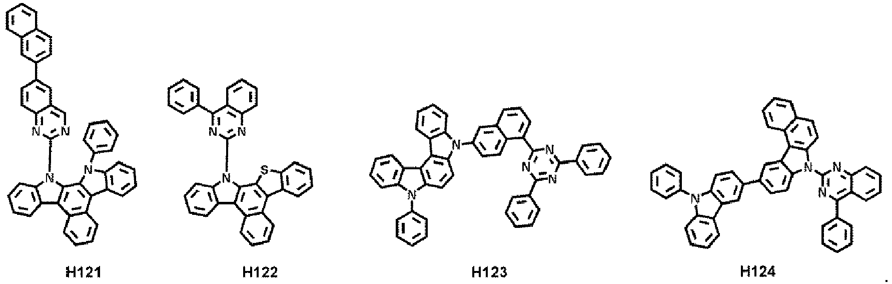

### Phosphorescent dopant

The phosphorescent dopant may include the organometallic compound represented by Formula 1 described herein.

### Fluorescent dopant

The fluorescent dopant may include an amine group-containing compound, a styryl group-containing compound, or any combination thereof.

In some embodiments, the fluorescent dopant may include a compound represented by Formula 501: 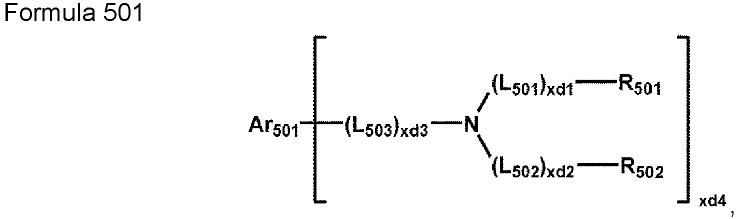 wherein, in Formula 501,
Ar₅₀₁, L₅₀₁ to L₅₀₃, R₅₀₁, and R₅₀₂ may each independently be a C₃-C₆₀ (*e.g.* C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
xd1 to xd3 may each independently be 0, 1, 2, or 3, and
xd4 may be 1, 2, 3, 4, 5, or 6.

In some embodiments, in Formula 501, Ar₅₀₁ may include a condensed ring group (e.g., an anthracene group, a chrysene group, or a pyrene group) in which at least three monocyclic groups are condensed.

In some embodiments, xd4 in Formula 501 may be 2.

In some embodiments, the fluorescent dopant may include one of Compounds FD1 to FD36, DPVBi, DPAVBi, or any combination thereof:

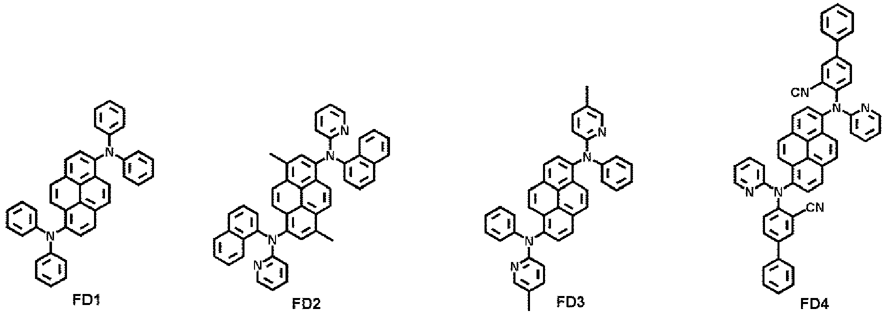

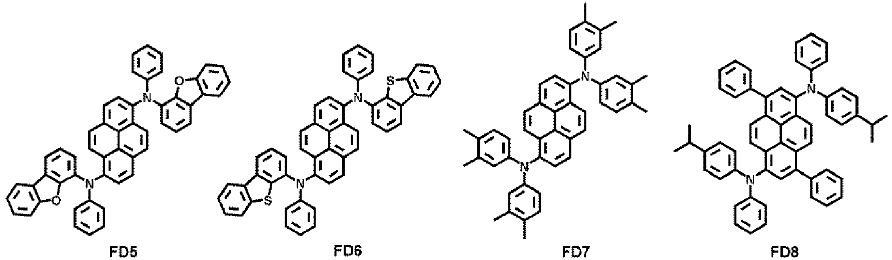

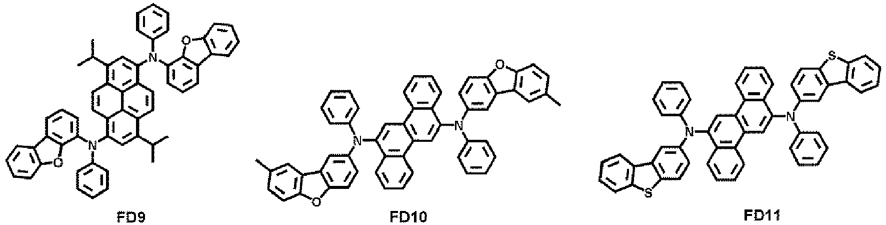

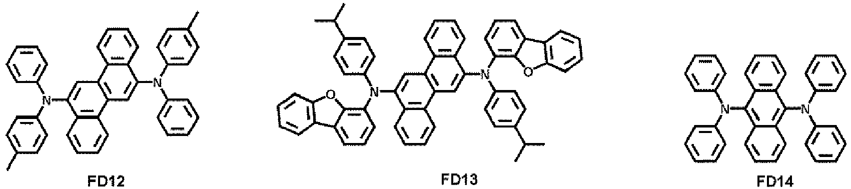

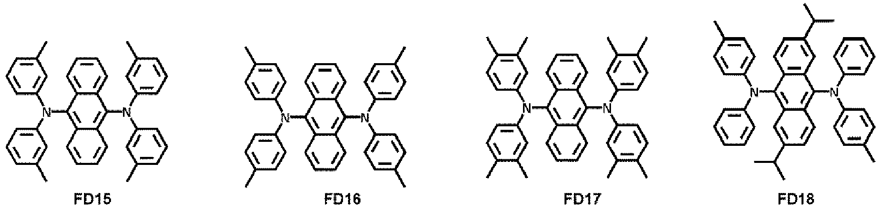

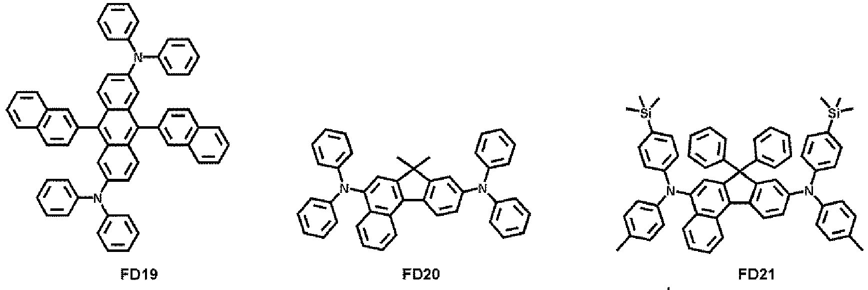

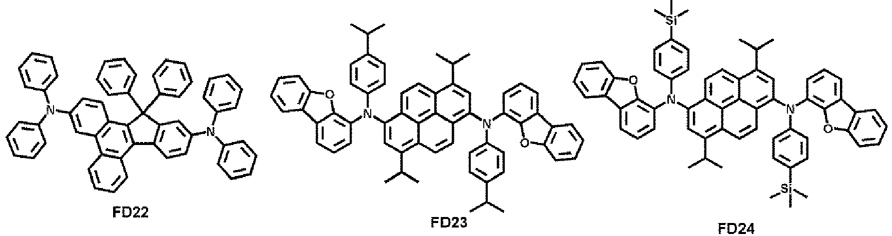

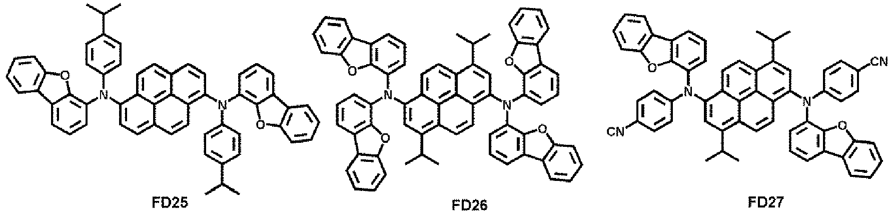

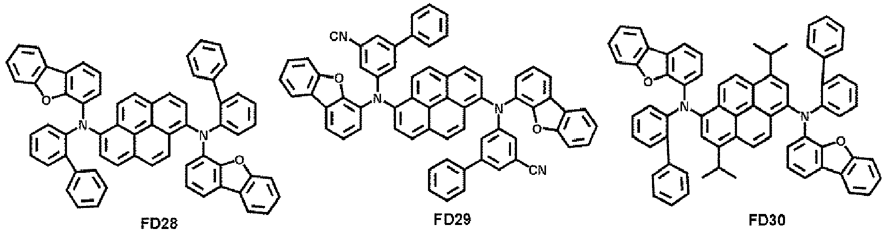

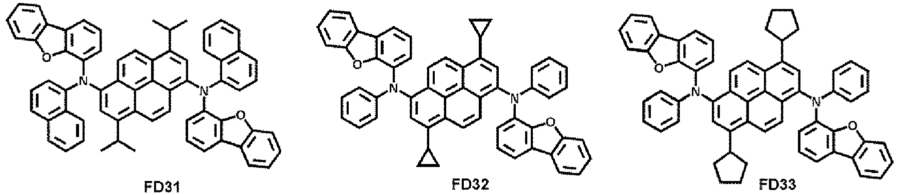

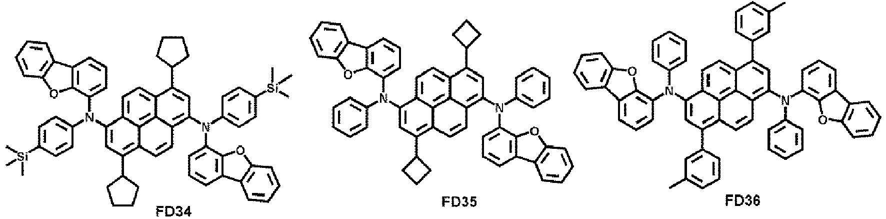

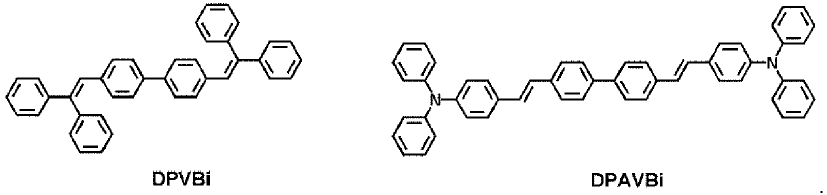

### Delayed fluorescence material

The emission layer may include a delayed fluorescence material.

The delayed fluorescence material described herein may be any suitable compound that may emit delayed fluorescence according to a delayed fluorescence emission mechanism.

The delayed fluorescence material included in the emission layer may serve as a host or a dopant, depending on types (or kinds) of other materials included in the emission layer.

In some embodiments, a difference between a triplet energy level (eV) of the delayed fluorescence material and a singlet energy level (eV) of the delayed fluorescence material may be about 0 eV or greater and about 0.5 eV or less. When the difference between a triplet energy level (eV) of the delayed fluorescence material and a singlet energy level (eV) of the delayed fluorescence material is within this range, up-conversion from a triplet state to a singlet state in the delayed fluorescence material may effectively (or suitably) occur, thus improving luminescence efficiency and/or the like of the light-emitting device 10.

In some embodiments, the delayed fluorescence material may include: i) a material including at least one electron donor (e.g., a π electron-rich C₃-C₆₀ (*e.g*. C₃-C₃₀) cyclic group such as a carbazole group and/or the like) and at least one electron acceptor (e.g., a sulfoxide group, a cyano group, a π electron-deficient nitrogen-containing C₁-C₆₀ (*e.g.* C₁-C₃₀) cyclic group, and/or the like), ii) a material including a C₆-C₆₀ (*e.g.* C₈-C₃₀) polycyclic group including at least two cyclic groups condensed to each other and sharing boron (B), and/or the like.

Examples of the delayed fluorescence material may include Compounds DF1 to DF9:

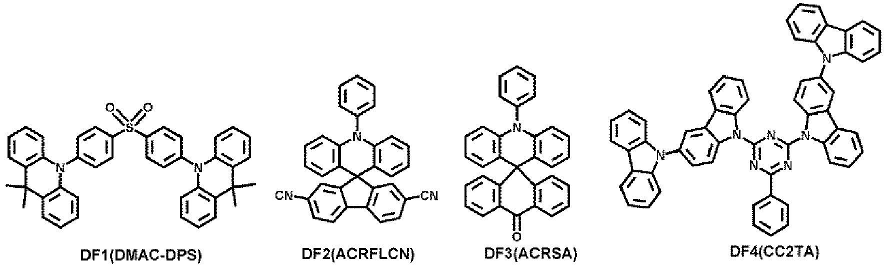

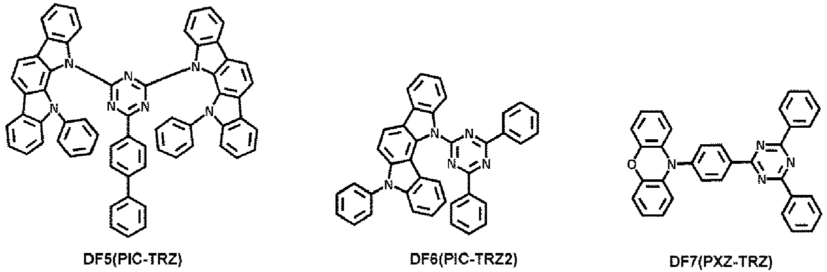

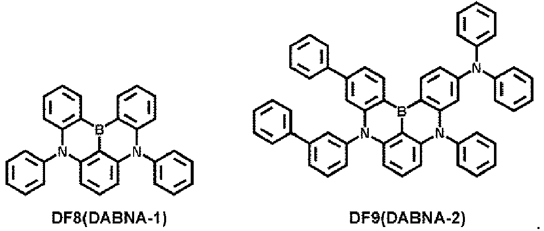

### Quantum dot

The emission layer may include quantum dots.

The term "quantum dot" as used herein refers to a crystal of a semiconductor compound and may include any suitable material capable of emitting a light of emission wavelengths of various lengths according to the size of the crystal.

The diameter of the quantum dot may be, for example, in a range of about 1 nm to about 10 nm.

Quantum dots may be synthesized by a wet chemical process, a metal organic chemical vapor deposition process, a molecular beam epitaxy process, or any similar suitable process.

The wet chemical process is a method of growing a quantum dot particle crystal by mixing a precursor material with an organic solvent. When the crystal grows, the organic solvent may naturally serve as a dispersant coordinated on the surface of the quantum dot crystal and control the growth of the crystal. Thus, the wet chemical process may be easier than the vapor deposition process such as the metal organic chemical vapor deposition (MOCVD) process or the molecular beam epitaxy (MBE) process. Further, the growth of quantum dot particles may be controlled with a lower manufacturing cost.

The quantum dot may include a group II-VI semiconductor compound; a group III-V semiconductor compound; a group III-VI semiconductor compound; a group I-III-VI semiconductor compound; a group IV-VI semiconductor compound; a group IV element, a group IV compound; or any combination thereof.

Examples of the group II-VI semiconductor compound may include a binary compound such as CdS, CdSe, CdTe, ZnS, ZnSe, ZnTe, ZnO, HgS, HgSe, HgTe, MgSe, and/or MgS; a ternary compound such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, and/or MgZnS; a quaternary compound such as CdZnSeS, CdZnSeTe, CdZnSTe, CdHgSeS, CdHgSeTe, CdHgSTe, HgZnSeS, HgZnSeTe, and/or HgZnSTe; and any combination thereof.

Examples of the group III-V semiconductor compound may include a binary compound such as GaN, GaP, GaAs, GaSb, AIN, AIP, AlAs, AlSb, InN, InP, InAs, and/or InSb; a ternary compound such as GaNP, GaNAs, GaNSb, GaPAs, GaPSb, AlNP, AlNAs, AlNSb, AlPAs, AlPSb, InGaP, InNP, InAIP, InNAs, InNSb, InPAs, and/or InPSb; a quaternary compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, and/or InAlPSb; and any combination thereof. In some embodiments, the group III-V semiconductor compound may further include a group II element. Examples of the group III-V semiconductor compound further including the group II element may include InZnP, InGaZnP, InAlZnP, and the like.

Examples of the group III-VI semiconductor compound may include a binary compound such as GaS, GaSe, Ga₂Se₃, GaTe, InS, In₂S₃, InSe, In₂Se₃, InTe, and/or the like; a ternary compound such as InGaS₃, InGaSe₃, and/or the like; and any combination thereof.

Examples of the group I-III-VI semiconductor compound may include a ternary compound such as AgInS, AgInS₂, CuInS, CuInS₂, CuGaO₂, AgGaO₂, AgAlO₂, or any combination thereof.

Examples of the group IV-VI semiconductor compound may include a binary compound such as SnS, SnSe, SnTe, PbS, PbSe, and/or PbTe; a ternary compound such as SnSeS, SnSeTe, SnSTe, PbSeS, PbSeTe, PbSTe, SnPbS, SnPbSe, and/or SnPbTe; a quaternary compound such as SnPbSSe, SnPbSeTe, and/or SnPbSTe; and any combination thereof.

The group IV element and the group IV compound may be an elementary substance such as Si and/or Ge; a binary compound such as SiC and/or SiGe; or any combination thereof.

Individual elements included in the multi-element compound, such as a binary compound, a ternary compound, and/or a quaternary compound, may be present in a particle thereof at a uniform or non-uniform concentration.

The quantum dot may have a single structure in which the concentration of each element included in the quantum dot is uniform (or substantially uniform), or a core-shell double structure. In some embodiments, materials included in the core may be different from materials included in the shell.

The shell of the quantum dot may serve as a protective layer for preventing or reducing chemical denaturation of the core to maintain semiconductor characteristics and/or as a charging layer for imparting electrophoretic characteristics to the quantum dot. The shell may be monolayer or multilayer. An interface between a core and a shell may have a concentration gradient where a concentration of elements present in the shell decreases toward the core.

Examples of the shell of the quantum dot include a metal oxide, a nonmetal oxide, a semiconductor compound, and a combination thereof. Examples of the metal oxide and the nonmetal oxide may include: a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO; a ternary compound such as MgAl₂O₄, CoFe₂O₄, NiFe₂O₄, and/or CoMn₂O₄; and any combination thereof. Examples of the semiconductor compound may include a group II-VI semiconductor compound; a group III-V semiconductor compound; a group III-VI semiconductor compound; a group I-III-VI semiconductor compound; a group IV-VI semiconductor compound; and any combination thereof. In some embodiments, the semiconductor compound may be CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AIP, AlSb, or any combination thereof.

The quantum dot may have a full width of half maximum (FWHM) of a spectrum of an emission wavelength of about 45 nm or less, about 40 nm or less, or about 30 nm or less. When the FWHM of the quantum dot is within any of these ranges, color purity or color reproducibility may be improved. In addition, because light emitted through the quantum dot is emitted in all directions, an optical viewing angle may be improved.

In one or more embodiments, the quantum dot may be, for example, a spherical, pyramidal, multi-arm, and/or cubic nanoparticle, nanotube, nanowire, nanofiber, and/or nanoplate.

By adjusting the size of the quantum dot, the energy band gap may also be adjusted, thereby obtaining light of various wavelengths in the quantum dot emission layer. By using quantum dots of various sizes, a light-emitting device that may emit light of various wavelengths may be realized. In some embodiments, the size of the quantum dot may be selected such that the quantum dot may emit red, green, and/or blue light. In addition, the size of the quantum dot may be selected such that the quantum dot may emit white light by combining light of various colors.

### Electron transport region in interlayer 130

The electron transport region may have i) a single-layered structure including (e.g., consisting of) a single layer including (e.g., consisting of) a single material, ii) a single-layered structure including (e.g., consisting of) a single layer including a plurality of different materials, or iii) a multi-layered structure having a plurality of layers including a plurality of different materials.

The electron transport region may include a buffer layer, a hole blocking layer, an electron control layer, an electron transport layer, and/or an electron injection layer.

In some embodiments, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein the layers of each structure are sequentially stacked on the emission layer in each stated order.

The electron transport region (e.g., a buffer layer, a hole blocking layer, an electron control layer, and/or an electron transport layer in the electron transport region) may include a metal-free compound including at least one π electron-deficient nitrogen-containing C₁-C₆₀ (*e.g.* C₁-C₃₀) cyclic group.

In some embodiments, the electron transport region may include a compound represented by Formula 601:

Formula 601 [Ar₆₀₁]ₓₑ₁₁-[(L₆₀₁)ₓₑ₁-R₆₀₁]ₓₑ₂₁,

wherein, in Formula 601,
Ar₆₀₁ and L₆₀₁ may each independently be a C₃-C₆₀ (*e.g.* C₃-C₃₀) carbocyclic group unsubstituted or substituted with at least one R₁₀ₐ and/or a C₁-C₆₀ (*e.g.* C₁-C₂₀) heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ (*e.g.* C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, -Si(Q₆₀₁)(Q₆₀₂)(Q₆₀₃), -C(=O)(Q₆₀₁), - S(=O)₂(Q₆₀₁), and/or -P(=O)(Q₆₀₁)(Q₆₀₂),
Q₆₀₁ to Q₆₀₃ may each be understood by referring to the description of Q₁ provided herein,
xe21 may be 1, 2, 3, 4, or 5, and
at least one of Ar₆₀₁, L₆₀₁, and R₆₀₁ may each independently be a π electron-deficient nitrogen-containing C₁-C₆₀ (*e.g.* C₁-C₃₀) cyclic group unsubstituted or substituted with at least one R₁₀ₐ.

In some embodiments, when xe11 in Formula 601 is 2 or greater, at least two Ar₆₀₁(s) may be bound via a single bond.

In some embodiments, in Formula 601, Ar₆₀₁ may be a substituted or unsubstituted anthracene group.

In some embodiments, the electron transport region may include a compound represented by Formula 601-1: 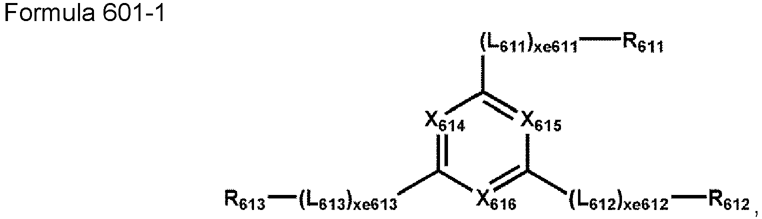 wherein, in Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
L₆₁₁ to L₆₁₃ may each be understood by referring to the description of L₆₀₁ provided herein,
xe611 to xe613 may each be understood by referring to the description of xe1 provided herein,
R₆₁₁ to R₆₁₃ may each be understood by referring to the description of R₆₀₁ provided herein, and
R₆₁₄ to R₆₁₆ may each independently be hydrogen, deuterium, -F, -Cl, -Br, -I, a hydroxyl group, a cyano group, a nitro group, a C₁-C₂₀ (*e.g*. C₁-C₁₀) alkyl group, a C₁-C₂₀ (*e.g*. C₁-C₁₀) alkoxy group, a C₃-C₆₀ (*e.g.* C₃-C₃₀) carbocyclic group unsubstituted or substituted with at least one R₁₀ₐ, and/or a C₁-C₆₀ (*e.g.* C₁-C₂₀) heterocyclic group unsubstituted or substituted with at least one R₁₀ₐ.

For example, in Formulae 601 and 601-1, xe1 and xe611 to xe613 may each independently be 0, 1, or 2.

The electron transport region may include one of Compounds ET1 to ET45, 2,9-dimethyl-4,7-diphenyl-1,10-phenanthroline (BCP), 4,7-diphenyl-1,10-phenanthroline (Bphen), Alq₃, BAlq, TAZ, NTAZ, or any combination thereof:

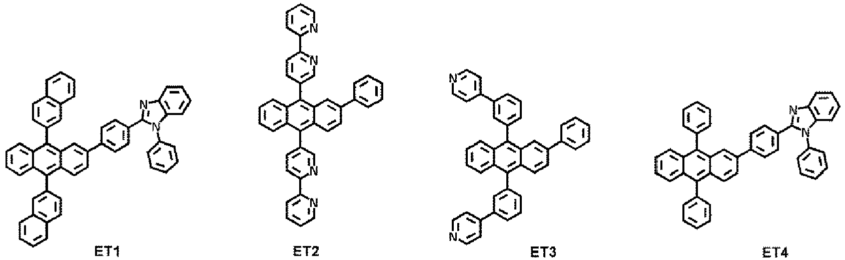

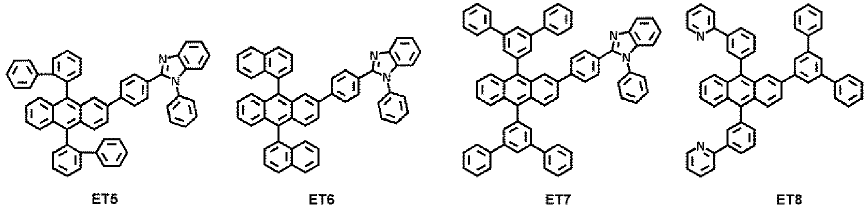

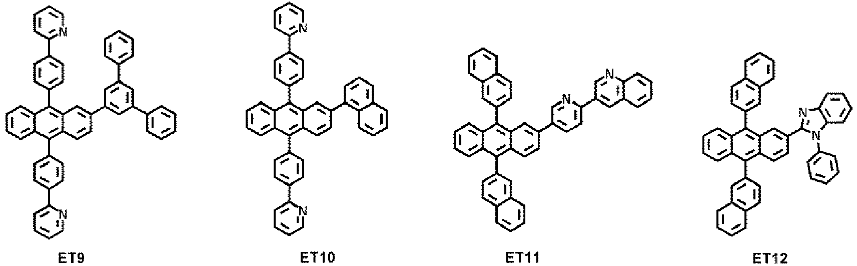

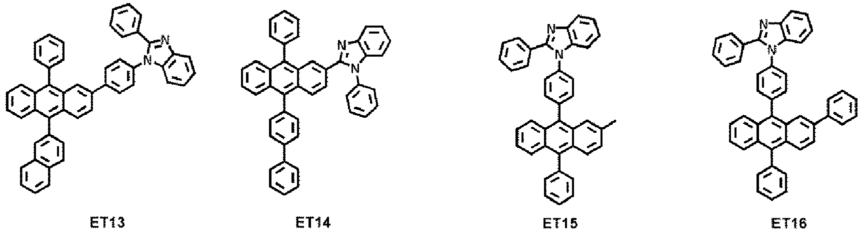

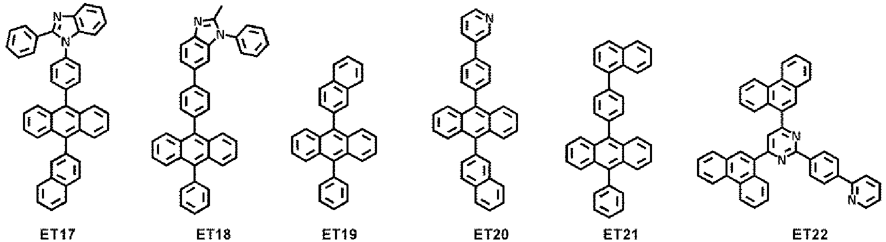

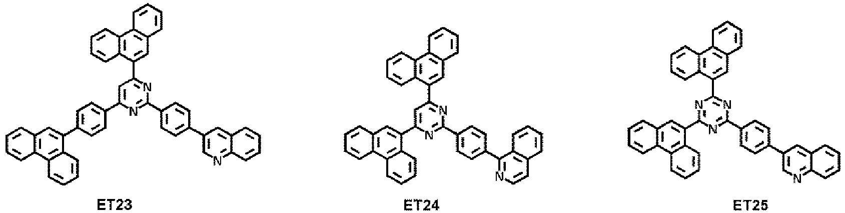

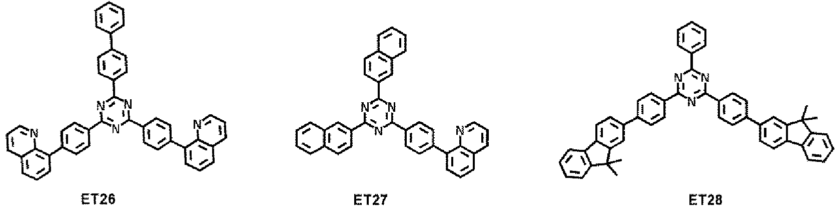

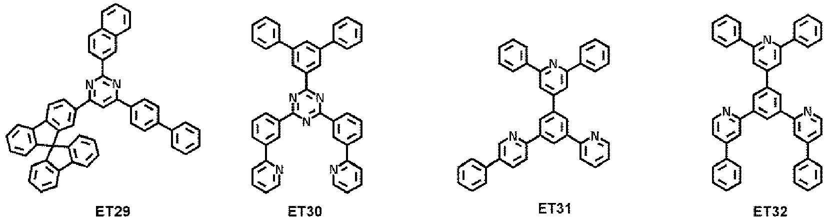

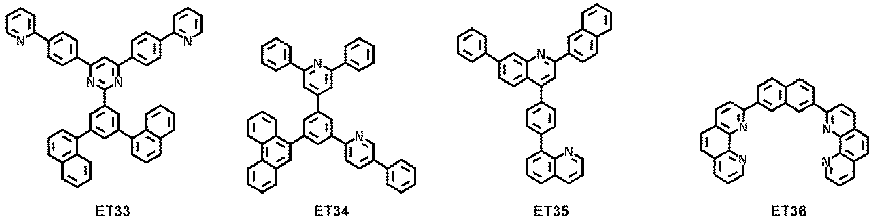

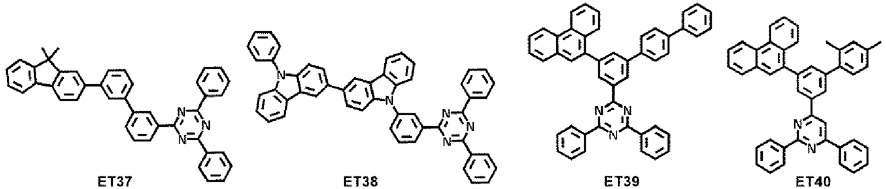

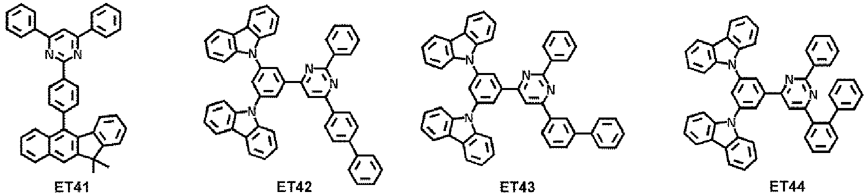

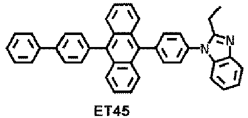

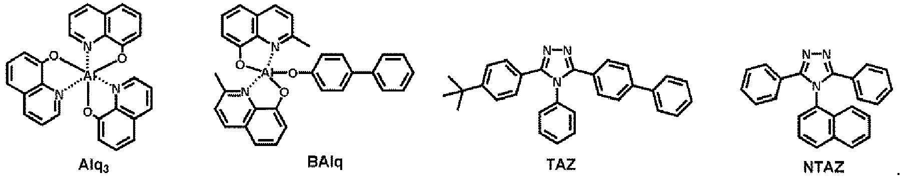

The thickness of the electron transport region may be in a range of about 50 Angstroms (Å) to about 5,000 Å, for example, about 100 Å to about 4,000 Å or about 100 Å to about 1,000 Å. When the electron transport region includes a buffer layer, a hole blocking layer, an electron control layer, an electron transport layer, or any combination thereof, the thicknesses of the buffer layer, the hole blocking layer, or the electron control layer may each independently be in a range of about 20 Å to about 1,000 Å, for example, about 20 Å to about 700 Å, about 20 Å to about 500 Å, about 20 Å to about 400 Å, about 30 Å to about 400 Å or about 30 Å to about 300 Å, and the thickness of the electron transport layer may be in a range of about 100 Å to about 1,000 Å, for example, about 100 Å to about 700 Å, about 100 Å to about 600 Å, about 150 Å to about 600 Å, about 150 Å to about 500 Å or about 300 Å to about 500 Å. When the thicknesses of the buffer layer, the hole blocking layer, the electron control layer, the electron transport layer, and/or the electron transport region are each within these ranges, excellent (or improved) electron transport characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or any combination thereof. A metal ion of the alkali metal complex may be a lithium (Li) ion, a sodium (Na) ion, a potassium (K) ion, a rubidium (Rb) ion, and/or a cesium (Cs) ion. A metal ion of the alkaline earth metal complex may be a beryllium (Be) ion, a magnesium (Mg) ion, a calcium (Ca) ion, a strontium (Sr) ion, and/or a barium (Ba) ion. A ligand coordinated with the metal ion of the alkali metal complex and the alkaline earth metal complex may each independently be hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

For example, the metal-containing material may include a Li complex. The Li complex may include, e.g., Compound ET-D1 (LiQ) and/or Compound ET-D2:

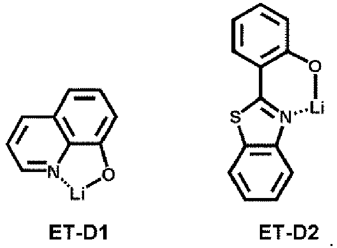

The electron transport region may include an electron injection layer that facilitates injection of electrons from the second electrode 150. The electron injection layer may be in direct contact with the second electrode 150.

The electron injection layer may have i) a single-layered structure including (e.g., consisting of) a single layer including (e.g., consisting of) a single material, ii) a single-layered structure including (e.g., consisting of) a single layer including a plurality of different materials, or iii) a multi-layered structure having a plurality of layers including a plurality of different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may be Li, Na, K, Rb, Cs or any combination thereof. The alkaline earth metal may be Mg, Ca, Sr, Ba, or any combination thereof. The rare earth metal may be Sc, Y, Ce, Tb, Yb, Gd, or any combination thereof.

The alkali metal-containing compound, the alkaline earth metal-containing compound, and the rare earth metal-containing compound may each independently be oxides, halides (e.g., fluorides, chlorides, bromides, and/or iodides), tellurides, or any combination thereof of the alkali metal, the alkaline earth metal, and the rare earth metal, respectively.

The alkali metal-containing compound may be alkali metal oxides (such as Li₂O, Cs₂O, and/or K₂O), alkali metal halides (such as LiF, NaF, CsF, KF, Lil, Nal, Csl, and/or KI), or any combination thereof. The alkaline earth-metal-containing compound may include alkaline earth-metal oxides, such as BaO, SrO, CaO, BaₓSr₁₋ₓO (wherein x is a real number satisfying 0<x<1), and/or BaₓCa₁₋ₓO (wherein x is a real number satisfying 0<x<1). The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In some embodiments, the rare earth metal-containing compound may include a lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and the like.

The alkali metal complex, the alkaline earth metal complex, and the rare earth metal complex may include: i) one of ions of the alkali metal, alkaline earth metal, and rare earth metal described above, respectively, and ii) a ligand bound to the metal ion, e.g., hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

The electron injection layer may include (e.g., may consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In some embodiments, the electron injection layer may further include an organic material (e.g., a compound represented by Formula 601).

In some embodiments, the electron injection layer may include (e.g., may consist of) i) an alkali metal-containing compound (e.g., alkali metal halide), or ii) a) an alkali metal-containing compound (e.g., alkali metal halide); and b) an alkali metal, an alkaline earth metal, a rare earth metal, or any combination thereof. In some embodiments, the electron injection layer may be a KI:Yb co-deposition layer, a RbI:Yb co-deposition layer, and/or the like.

When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth metal complex, the rare earth metal complex, or any combination thereof may be homogeneously or non-homogeneously dispersed in a matrix including the organic material.

The thickness of the electron injection layer may be in a range of about 1 Å to about 100 Å, and in some embodiments, about 3 Å to about 90 Å or about 3 Å to about 20 Å. When the thickness of the electron injection layer is within any of these ranges, excellent (or improved) electron injection characteristics may be obtained without a substantial increase in driving voltage.

### Second electrode 150

The second electrode 150 is on the interlayer 130. In one or more embodiments, the second electrode 150 may be a cathode that is an electron injection electrode. In this embodiment, a material for forming the second electrode 150 may be a material having a low work function, for example, a metal, an alloy, an electrically conductive compound, or any combination thereof.

The second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure, or a multi-layered structure including two or more layers.

### Capping layer

A first capping layer may be located outside the first electrode 110, and/or a second capping layer may be located outside the second electrode 150. In some embodiments, the light-emitting device 10 may have a structure in which the first capping layer, the first electrode 110, the interlayer 130, and the second electrode 150 are sequentially stacked in this stated order, a structure in which the first electrode 110, the interlayer 130, the second electrode 150, and the second capping layer are sequentially stacked in this stated order, or a structure in which the first capping layer, the first electrode 110, the interlayer 130, the second electrode 150, and the second capping layer are sequentially stacked in this stated order.

In the light-emitting device 10, light emitted from the emission layer in the interlayer 130 may pass through the first electrode 110 (which may be a semi-transmissive electrode or a transmissive electrode) and through the first capping layer to the outside, and/or may pass through the second electrode 150 (which may be a semi-transmissive electrode or a transmissive electrode) and through the second capping layer to the outside.

The first capping layer and the second capping layer may improve the external luminescence efficiency based on the principle of constructive interference. Accordingly, the optical extraction efficiency of the light-emitting device 10 may be increased, thus improving luminescence efficiency of the light-emitting device 10.

The first capping layer and the second capping layer may each include a material having a refractive index of about 1.6 or higher (at 589 nm).

The first capping layer and the second capping layer may each independently be an organic capping layer including an organic material, an inorganic capping layer including an inorganic material, and/or a composite capping layer including an organic material and an inorganic material.

At least one of the first capping layer and the second capping layer may each independently include carbocyclic compound(s), heterocyclic compound(s), amine group-containing compound(s), porphine derivative(s), phthalocyanine derivative(s), naphthalocyanine derivative(s), alkali metal complex(es), alkaline earth metal complex(es), or any combination thereof. The carbocyclic compound, the heterocyclic compound, and the amine group-containing compound may each independently be optionally substituted with a substituent of O, N, S, Se, Si, F, Cl, Br, I, or any combination thereof. In some embodiments, at least one of the first capping layer and the second capping layer may each independently include an amine group-containing compound.

In some embodiments, at least one of the first capping layer and the second capping layer may each independently include the compound represented by Formula 201, the compound represented by Formula 202, or any combination thereof.

In one or more embodiments, at least one of the first capping layer and the second capping layer may each independently include one of Compounds HT28 to HT33, one of Compounds CP1 to CP6, β-NPB, or any combination thereof:

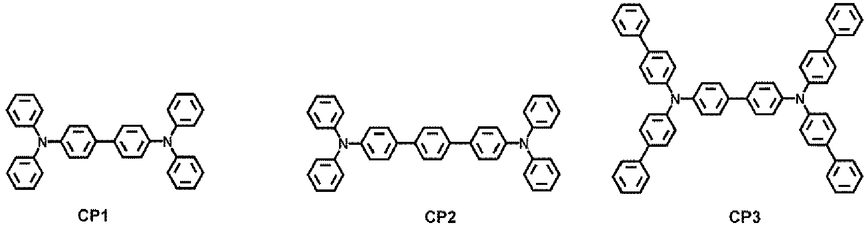

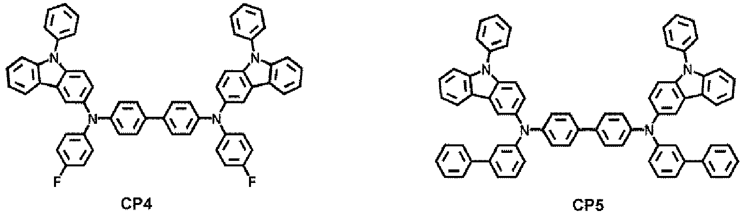

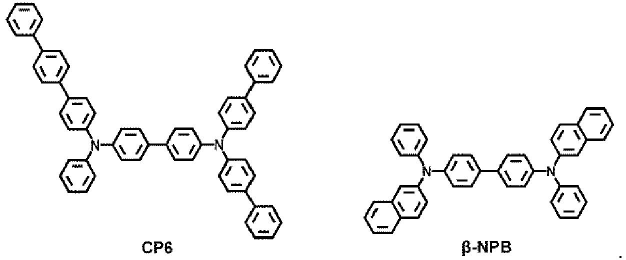

### Electronic apparatus

The light-emitting device may be included in one or more suitable electronic apparatuses. In some embodiments, an electronic apparatus including the light-emitting device may be an emission apparatus and/or an authentication apparatus.

The electronic apparatus (e.g., an emission apparatus) may further include, in addition to the light-emitting device, i) a color filter, ii) a color-conversion layer, or iii) a color filter and a color-conversion layer. The color filter and/or the color-conversion layer may be disposed (e.g., positioned) in at least one traveling direction of light emitted from the light-emitting device. For example, light emitted from the light-emitting device may be blue light or white light. The light-emitting device may be understood by referring to the descriptions provided herein. In some embodiments, the color-conversion layer may include quantum dots. The quantum dot may be, for example, the quantum dot described herein.

The electronic apparatus may include a first substrate. The first substrate may include a plurality of sub-pixel areas, the color filter may include a plurality of color filter areas respectively corresponding to the plurality of sub-pixel areas, and the color-conversion layer may include a plurality of color-conversion areas respectively corresponding to the plurality of sub-pixel areas.

A pixel defining film may be located between the plurality of sub-pixel areas to define each sub-pixel area.

The color filter may further include a plurality of color filter areas and light-blocking patterns between the plurality of color filter areas, and the color-conversion layer may further include a plurality of color-conversion areas and light-blocking patterns between the plurality of color-conversion areas.

The plurality of color filter areas (or the plurality of color-conversion areas) may include: a first area emitting (e.g., to emit) first color light; a second area emitting (e.g., to emit) second color light; and/or a third area emitting (e.g., to emit) third color light, and the first color light, the second color light, and/or the third color light may have different maximum emission wavelengths. In some embodiments, the first color light may be red light, the second color light may be green light, and the third color light may be blue light. In some embodiments, the plurality of color filter areas (or the plurality of color-conversion areas) may include quantum dots. In some embodiments, the first area may include red quantum dots, the second area may include green quantum dots, and the third area may not include a quantum dot. The quantum dot may be understood by referring to the description of the quantum dot provided herein. The first area, the second area, and/or the third area may further include a scatterer.

In some embodiments, the light-emitting device may emit first light, the first area may absorb the first light to emit 1-1 color light, the second area may absorb the first light to emit 2-1 color light, and the third area may absorb the first light to emit 3-1 color light. In this embodiment, the 1-1 color light, the 2-1 color light, and the 3-1 color light may each have a different maximum emission wavelength. In some embodiments, the first light may be blue light, the 1-1 color light may be red light, the 2-1 color light may be green light, and the 3-1 light may be blue light.

The electronic apparatus may further include a thin-film transistor, in addition to the light-emitting device. The thin-film transistor may include a source electrode, a drain electrode, and an active layer, wherein one of the source electrode and the drain electrode may be electrically connected (e.g., electrically coupled) to one of the first electrode and the second electrode of the light-emitting device.

The thin-film transistor may further include a gate electrode, a gate insulating film, and/or the like.

The active layer may include a crystalline silicon, an amorphous silicon, an organic semiconductor, and/or an oxide semiconductor.

The electronic apparatus may further include an encapsulation unit for sealing the light-emitting device. The encapsulation unit may be located between the color filter and/or the color-conversion layer and the light-emitting device. The encapsulation unit may allow light to pass to the outside from the light-emitting device, and may at the same time (e.g., concurrently) prevent or reduce the permeation of air and moisture into the light-emitting device. The encapsulation unit may be a sealing substrate including a transparent glass and/or a plastic substrate. The encapsulation unit may be a thin-film encapsulating layer including at least one organic layer and/or at least one inorganic layer. When the encapsulation unit is a thin film encapsulating layer, the electronic apparatus may be flexible.

In addition to the color filter and/or the color-conversion layer, various functional layers may be disposed (e.g., provided) on the encapsulation unit depending on the use of an electronic apparatus. Examples of the functional layer may include a touch screen layer, a polarization layer, and the like. The touch screen layer may be a resistive touch screen layer, a capacitive touch screen layer, and/or an infrared beam touch screen layer. The authentication apparatus may be, for example, a biometric authentication apparatus that identifies an individual according biometric information (e.g., a fingertip, a pupil, and/or the like).

The authentication apparatus may further include a biometric information collecting unit, in addition to the light-emitting device described above.

The electronic apparatus may be applicable to various suitable displays, an optical source, lighting, a personal computer (e.g., a mobile personal computer), a cellphone, a digital camera, an electronic note, an electronic dictionary, an electronic game console, a medical device (e.g., an electronic thermometer, a blood pressure meter, a glucometer, a pulse measuring device, a pulse wave measuring device, an electrocardiograph recorder, an ultrasonic diagnosis device, an endoscope display device), a fish finder, various measurement devices, gauges (e.g., gauges of an automobile, an airplane, a ship), a projector, without limitation.

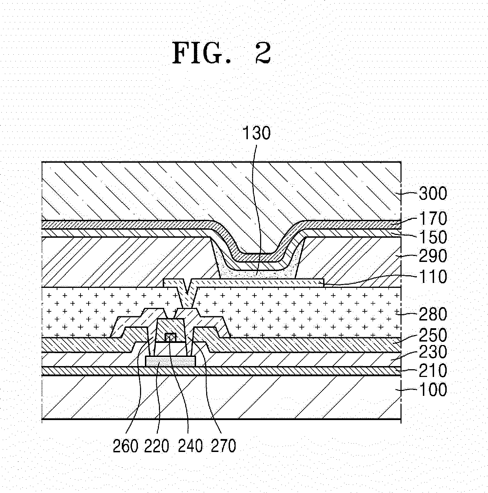

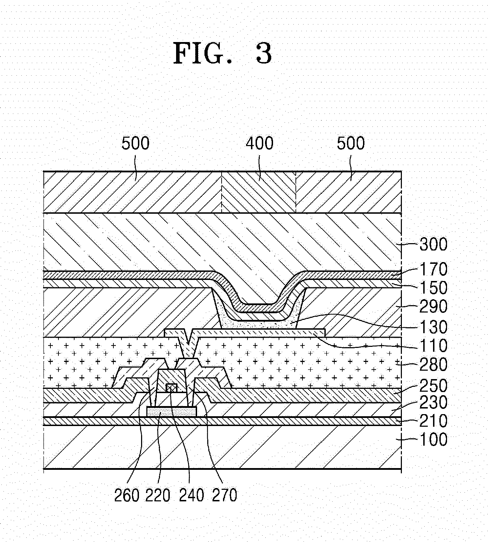

### Descriptions of FIGS. 2 and 3

FIG. 2 is a schematic cross-sectional view of a light-emitting apparatus according to one or more embodiments.

A light-emitting apparatus in FIG. 2 may include a substrate 100, a thin-film transistor, a light-emitting device, and an encapsulation unit 300 sealing the light-emitting device.

The substrate 100 may be a flexible substrate, a glass substrate, and/or a metal substrate. A buffer layer 210 may be on the substrate 100. The buffer layer 210 may prevent or reduce penetration of impurities through the substrate 100, and may provide a flat surface on the substrate 100.

A thin-film transistor may be on the buffer layer 210. The thin-film transistor may include an active layer 220, a gate electrode 240, a source electrode 260, and a drain electrode 270.

The active layer 220 may include an inorganic semiconductor such as silicon and/or polysilicon, an organic semiconductor, and/or an oxide semiconductor, and may include a source area, a drain area, and a channel area.

A gate insulating film 230 for insulating the active layer 220 and the gate electrode 240 may be on the active layer 220, and the gate electrode 240 may be on the gate insulating film 230.

An interlayer insulating film 250 may be on the gate electrode 240. The interlayer insulating film 250 may be between the gate electrode 240 and the source electrode 260 and between the gate electrode 240 and the drain electrode 270 to provide insulation therebetween.

The source electrode 260 and the drain electrode 270 may be on the interlayer insulating film 250. The interlayer insulating film 250 and the gate insulating film 230 may be formed to expose the source area and the drain area of the active layer 220, and the source electrode 260 and the drain electrode 270 may be adjacent to the exposed source area and the exposed drain area of the active layer 220.

Such a thin-film transistor may be electrically connected (e.g., electrically coupled) to a light-emitting device to drive the light-emitting device and may be protected by a passivation layer 280. The passivation layer 280 may include an inorganic insulating film, an organic insulating film, or a combination thereof. A light-emitting device may be on the passivation layer 280. The light-emitting device includes a first electrode 110, an interlayer 130, and a second electrode 150.

The first electrode 110 may be on the passivation layer 280. The passivation layer 280 may not fully cover the drain electrode 270 and may expose a specific or set area of the drain electrode 270, and the first electrode 110 may be disposed to connect (e.g., to electrically couple) to the exposed drain electrode 270.

A pixel-defining film 290 may be on the first electrode 110. The pixel-defining film 290 may expose a specific or set area of the first electrode 110, and the interlayer 130 may be formed in the exposed area. The pixel-defining film 290 may include one or more suitable organic insulating materials, inorganic insulating materials, and/or organic/inorganic composite insulating materials. In some embodiments, the pixel-defining film 290 may be a polyimide and/or a polyacryl organic film. In one or more embodiments, some or more layers of the interlayer 130 may extend to the upper portion of the pixel-defining film 290 and may be disposed in the form of a common layer.

The second electrode 150 may be on the interlayer 130, and a capping layer 170 may be additionally formed on the second electrode 150. The capping layer 170 may be formed to cover the second electrode 150.

The encapsulation unit 300 may be on the capping layer 170. The encapsulation unit 300 may be on the light-emitting device to protect a light-emitting device from moisture and/or oxygen. The encapsulation unit 300 may include: an inorganic film including silicon nitride (SiNₓ), silicon oxide (SiOₓ), indium tin oxide, indium zinc oxide, or any combination thereof; an organic film including polyethylene terephthalate, polyethylene naphthalate, polycarbonate, polyimide, polyethylene sulfonate, polyoxy methylene, polyaryllate, hexamethyl disiloxane, an acrylic resin (e.g., polymethyl methacrylate, polyacrylic acid, and/or the like), an epoxy resin (e.g., aliphatic glycidyl ether (AGE) and/or the like), or any combination thereof; or a combination of the inorganic film and the organic film.

FIG. 3 is a schematic cross-sectional view of another light-emitting apparatus according to one or more embodiments.

The emission apparatus (e.g., the light-emitting apparatus) shown in FIG. 3 may be substantially identical to the emission apparatus (e.g., the light-emitting apparatus) shown in FIG. 2, except that a light-shielding pattern 500 and a functional area 400 are additionally located on the encapsulation unit 300. The functional area 400 may be i) a color filter area, ii) a color-conversion area, or iii) a combination of a color filter area and a color-conversion area. In some embodiments, the light-emitting device shown in FIG. 3 included in the emission apparatus may be a tandem light-emitting device.

### Manufacturing method

The layers constituting the hole transport region, the emission layer, and the layers constituting the electron transport region may each independently be formed in a set or specific region by using one or more suitable methods such as vacuum deposition, spin coating, casting, Langmuir-Blodgett (LB) deposition, ink-jet printing, laser printing, and/or laser-induced thermal imaging.

When layers constituting the hole transport region, the emission layer, and layers constituting the electron transport region are each independently formed by vacuum-deposition, the vacuum-deposition may be performed at a deposition temperature in a range of about 100 °C to about 500 °C, at a vacuum degree in a range of about 10⁻⁸ torr to about 10⁻³ torr, and at a deposition rate in a range of about 0.01 Angstroms per second (Å/sec) to about 100 Å/sec, depending on the material to be included in each layer and the structure of each layer to be formed.

### General definitions of terms

The term "C₃-C₆₀ carbocyclic group" as used herein refers to a cyclic group consisting of carbon atoms only and having 3 to 60 carbon atoms. The term "C₁-C₆₀ heterocyclic group" as used herein refers to a cyclic group having 1 to 60 carbon atoms, in addition to a heteroatom other than carbon atoms. The C₃-C₆₀ carbocyclic group and the C₁-C₆₀ heterocyclic group may each independently be a monocyclic group consisting of one ring or a polycyclic group in which at least two rings are condensed. For example, the number of ring-forming atoms in the C₁-C₆₀ heterocyclic group may be in a range of 3 to 61.

The term "cyclic group" as used herein may include the C₃-C₆₀ carbocyclic group and the C₁-C₆₀ heterocyclic group.

The term "π electron-rich C₃-C₆₀ cyclic group" refers to a cyclic group having 3 to 60 carbon atoms and not including *-N=*' as a ring-forming moiety. The term "π electron-deficient nitrogen-containing C₁-C₆₀ cyclic group" as used herein refers to a heterocyclic group having 1 to 60 carbon atoms and *-N=*' as a ring-forming moiety.

In some embodiments,
the C₃-C₆₀ carbocyclic group may be i) a T1 group or ii) a group in which at least two T1 groups are condensed (for example, the C₃-C₆₀ carbocyclic group may be a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, and/or an indenoanthracene group),
the C₁-C₆₀ heterocyclic group may be i) a T2 group, ii) a group in which at least two T2 groups are condensed, or iii) a group in which at least one T2 group is condensed with at least one T1 group (for example, the C₁-C₆₀ heterocyclic group may be a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonapthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
the π electron-rich C₃-C₆₀ cyclic group may be i) a T1 group, ii) a condensed group in which at least two T1 groups are condensed, iii) a T3 group, iv) a condensed group in which at least two T3 groups are condensed, or v) a condensed group in which at least one T3 group is condensed with at least one T1 group (for example, the π electron-rich C₃-C₆₀ cyclic group may be a C₃-C₆₀ carbocyclic group, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonapthothiophene group, a benzonaphthosilole group, a benzofurodibenzofuran group, a benzofurodibenzothiophene group, a benzothienodibenzothiophene group, and/or the like), and
the π electron-deficient nitrogen-containing C₁-C₆₀ cyclic group may be i) a T4 group, ii) a group in which at least twos T4 groups are condensed, iii) a group in which at least one T4 group is condensed with at least one T1 group, iv) a group in which at least one T4 group is condensed with at least one T3 group, or v) a group in which at least one T4 group, at least one T1 group, and at least one T3 group are condensed (for example, the π electron-deficient nitrogen-containing C₁-C₆₀ cyclic group may be a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
wherein the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, and/or a benzene group,
the T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, and/or a tetrazine group,
the T3 group may be a furan group, a thiophene group, a 1H-pyrrole group, a silole group, and/or a borole group, and
the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, and/or a tetrazine group.

The "cyclic group", "C₃-C₆₀ carbocyclic group", "C₁-C₆₀ heterocyclic group", "π electron-rich C₃-C₆₀ cyclic group", and/or "π electron-deficient nitrogen-containing C₁-C₆₀ cyclic group" as used herein may each independently be a group condensed with any suitable cyclic group, a monovalent group, and/or a polyvalent group (e.g., a divalent group, a trivalent group, a quadvalent group, or the like), depending on the structure of the formula to which the respective term is applied. For example, a "benzene group" may be a benzo group, a phenyl group, a phenylene group, and/or the like, and this may be understood by one of ordinary skill in the art, depending on the structure of the formula including the "benzene group".

Examples of the monovalent C₃-C₆₀ carbocyclic group and the monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the divalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a divalent non-aromatic condensed heteropolycyclic group.

The term "C₁-C₆₀ alkyl group" as used herein refers to a linear or branched aliphatic saturated hydrocarbon monovalent group having 1 to 60 carbon atoms, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group. The term "C₁-C₆₀ alkylene group" as used herein refers to a divalent group having the same structure as the C₁-C₆₀ alkyl group. Corresponding definitions apply to other ranges given for the number of carbon atoms in an alkyl/alkylene group.

The term "C₂-C₆₀ alkenyl group" as used herein refers to a monovalent hydrocarbon group having at least one carbon-carbon double bond in the middle and/or at either terminus of the C₂-C₆₀ alkyl group. Examples thereof include an ethenyl group, a propenyl group, and a butenyl group. The term "C₂-C₆₀ alkenylene group" as used herein refers to a divalent group having the same structure as the C₂-C₆₀ alkenyl group. Corresponding definitions apply to other ranges given for the number of carbon atoms in an alkenyl/alkenylene group.

The term "C₂-C₆₀ alkynyl group" as used herein refers to a monovalent hydrocarbon group having at least one carbon-carbon triple bond in the middle and/or at either terminus of the C₂-C₆₀ alkyl group. Examples thereof include an ethynyl group and a propynyl group. The term "C₂-C₆₀ alkynylene group" as used herein refers to a divalent group having the same structure as the C₂-C₆₀ alkynyl group. Corresponding definitions apply to other ranges given for the number of carbon atoms in an alkynyl/alkynylene group.

The term "C₁-C₆₀ alkoxy group" as used herein refers to a monovalent group represented by -OA₁₀₁ (wherein A₁₀₁ is the C₁-C₆₀ alkyl group). Examples thereof include a methoxy group, an ethoxy group, and an isopropyloxy group. Corresponding definitions apply to other ranges given for the number of carbon atoms in an alkoxy group.

The term "C₃-C₁₀ cycloalkyl group" as used herein refers to a monovalent saturated hydrocarbon monocyclic group including 3 to 10 carbon atoms. Examples of the C₃-C₁₀ cycloalkyl group as used herein include a cyclopropyl group, a cyclobutyl group, a cyclopentyl group, a cyclohexyl group, a cycloheptyl group, a cyclooctyl group, an adamantyl group, a norbornyl (bicyclo[2.2.1]heptyl) group, a bicyclo[1.1.1]pentyl group, a bicyclo[2.1.1]hexyl group, and a bicyclo[2.2.2]octyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent cyclic group including at least one heteroatom other than carbon atoms as a ring-forming atom and having 1 to 10 carbon atoms. Examples thereof include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent cyclic group that has 3 to 10 carbon atoms and at least one carbon-carbon double bond in its ring, and is not aromatic. Examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group including at least one heteroatom other than carbon atoms as a ring-forming atom, 1 to 10 carbon atoms, and at least one double bond in its ring. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms. Examples of the C₆-C₆₀ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. The term "C₆-C₆₀ arylene group" as used herein refers to a divalent group having the same structure as the C₆-C₆₀ aryl group. When the C₆-C₆₀ aryl group and the C₆-C₆₀ arylene group each independently include two or more rings, the respective rings may be fused. Corresponding definitions apply to other ranges given for the number of carbon atoms in an aryl/arylene group.

The term "C₁-C₆₀ heteroaryl group" as used herein refers to a monovalent group having a heterocyclic aromatic system further including at least one heteroatom other than carbon atoms as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. The term "C₁-C₆₀ heteroarylene group" as used herein refers to a divalent group having the same structure as the C₁-C₆₀ heteroaryl group. When the C₁-C₆₀ heteroaryl group and the C₁-C₆₀ heteroarylene group each independently include two or more rings, the respective rings may be fused. Corresponding definitions apply to other ranges given for the number of carbon atoms in an heteroaryl/heteroarylene group.

The term "monovalent non-aromatic condensed polycyclic group" as used herein refers to a monovalent group that has two or more rings condensed and only carbon atoms (e.g., 8 to 60 carbon atoms) as ring forming atoms, wherein the molecular structure when considered as a whole is non-aromatic. Examples of the monovalent non-aromatic condensed polycyclic group include an indenyl group, a fluorenyl group, a spiro-bifluorenyl group, a benzofluorenyl group, an indenophenanthrenyl group, and an indenoanthracenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and at least one heteroatom other than carbon atoms (e.g., 1 to 60 carbon atoms), as a ring-forming atom, wherein the molecular structure when considered as a whole is non-aromatic. Examples of the monovalent non-aromatic condensed heteropolycyclic group include a 9,10-dihydroacridinyl group and a 9H-xanthenyl group. The term "divalent non-aromatic condensed heteropolycyclic group" as used herein refers to a divalent group having substantially the same structure as the monovalent non-aromatic condensed heteropolycyclic group.

The term "C₆-C₆₀ aryloxy group" as used herein refers to a monovalent group represented by -OA₁₀₂ (wherein A₁₀₂ is the C₆-C₆₀ aryl group). The term "C₆-C₆₀ arylthio group" as used herein refers to a monovalent group represented by -SA₁₀₃ (wherein A₁₀₃ is the C₆-C₆₀ aryl group). Corresponding definitions apply to other ranges given for the number of carbon atoms in an aryloxy group and an arylthio group.

The term "R₁₀ₐ" as used herein may be:
deuterium (-D), -F, -Cl, -Br, -I, a hydroxyl group, a cyano group, or a nitro group;
a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, or a C₁-C₆₀ (*e.g.* C₁-C₂₀) alkoxy group, each unsubstituted or substituted with deuterium, -F, -Cl, -Br, -I, a hydroxyl group, a cyano group, a nitro group, a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₆-C₆₀ (*e.g.* C₆-C₃₀) arylthio group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or any combination thereof;
a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, or a C₆-C₆₀ (*e.g.* C₆-C₃₀) arylthio group, each unsubstituted or substituted with deuterium, -F, -Cl, -Br, -I, a hydroxyl group, a cyano group, a nitro group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₆-C₆₀ (*e.g.* C₆-C₃₀) arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃, and Q₃₁ to Q₃₃ may each independently be hydrogen; deuterium; -F; -Cl; -Br; -I; a hydroxyl group; a cyano group; a nitro group; a C₁-C₆₀ (*e.g.* C₁-C₂₀) alkyl group; a C₂-C₆₀ (*e.g.* C₂-C₂₀) alkenyl group; a C₂-C₆₀ (*e.g.* C₂-C₂₀) alkynyl group; a C₁-C₆₀ (*e.g.* C₁-C₂₀) alkoxy group; or a C₃-C₆₀ (*e.g.* C₃-C₃₀) carbocyclic group or a C₁-C₆₀ (*e.g.* C₁-C₂₀) heterocyclic group, each unsubstituted or substituted with deuterium, -F, a cyano group, a C₁-C₆₀ (*e.g.* C₁-C₂₀) alkyl group, a C₁-C₆₀ (*e.g.* C₁-C₂₀) alkoxy group, a phenyl group, a biphenyl group, or any combination thereof.

The term "heteroatom" as used herein refers to any atom other than a carbon atom. Examples of the heteroatom may include O, S, N, P, Si, B, Ge, Se, and any combination thereof.

"Ph" used herein represents a phenyl group, "Me" used herein represents a methyl group, "Et" used herein represents an ethyl group, "t-Bu", "^{tert}Bu", "tert-Bu" or "Bu^{t}" used herein represents a tert-butyl group, and "OMe" used herein represents a methoxy group.

The term "biphenyl group" as used herein may refer to a phenyl group substituted with a phenyl group. For example, the "biphenyl group" may be "a substituted phenyl group" having a "C₆-C₆₀ aryl group" as a substituent.

The term "terphenyl group" as used herein may refer to a phenyl group substituted with biphenyl group. For example, the "terphenyl group" may be "a substituted phenyl group" having a "C₆-C₆₀ aryl group substituted with a C₆-C₆₀ aryl group" as a substituent.

The symbols *, *' and *" as used herein, unless defined otherwise, refer to a binding site to an adjacent atom in a corresponding formula.

Hereinafter, compounds and a light-emitting device according to one or more embodiments will be described in more detail with reference to Synthesis Examples and Examples. The wording "B was used instead of A" used in describing Synthesis Examples means that an amount of B used was identical to an amount of A used in terms of molar equivalents.

### Synthesis Examples

Compounds 1 to 6 used in the Synthesis Examples are as follows:

| | |
|---|---|
| 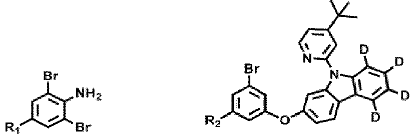 | |
| (1) R₁ = H | (3) R₂ = *tert*-Bu |
| (2) R₁ = *tert*-Bu | (4) R₂ = H |
| | (5) R₂ = phenyl-*d*₅ |
| | (6) R₂ = 1,3,5-tri-*^{tert}*Bu-phenyl |

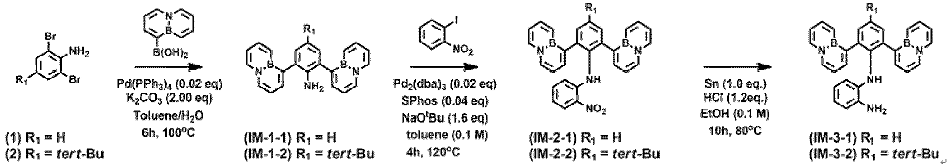

### Synthesis Example 1: Synthesis of Intermediate (IM-1-1)

11.5 grams (g) of 2,6-dibromoaniline (Compound 1) (45.7 millimole (mmol)), 1.1 g of Pd(PPh₃)₄ (0.9 mmol), K₂CO₃ (137.1 mmol), and 8.7 g of [1,2]azaborinino[1,2-a][1,2]azaborinin-1-ylboronic acid (50.3 mmol) were added to a reaction vessel, and suspended in 300 milliliters (mL) of toluene and 100 mL of H₂O, followed by heating at a temperature of 100 °C for 6 hours. Once the reaction was complete, the temperature was lowered to room temperature, and 300 mL of distilled water was added thereto. Then, an organic layer was extracted therefrom using ethyl acetate, and the extracted organic layer was washed with saturated NaCl aqueous solution, followed by drying using sodium sulfate. The resulting product was subjected to column chromatography to thereby obtain 11.9 g (34.3 mmol) of Intermediate IM-1-1 (yield: 75 %).

### Synthesis Example 2: Synthesis of Intermediate (IM-1-2)

13.5 g of Intermediate IM-1-2 (33.4 mmol) was synthesized in substantially the same manner as in Synthesis of Intermediate IM-1-1, except that 2,6-dibromo-4-(tert-butyl)aniline (Compound 2) was used instead of 2,6-dibromoaniline (Compound 1) (yield: 73 %).

### Synthesis Example 3: Synthesis of Intermediate (IM-2-1)

11.9 g of Intermediate IM-1-1 (34.3 mmol), 9.4 g of 1-iodo-2-nitrobenzene (37.7 mmol), 0.6 g of Pd₂(dba)₃ (0.69 mmol), 0.6 g of SPhos (1.37 mmol), and 5.3 g of NaO*^{tert}*Bu(NaO^{t}Bu) (54.9 mmol) were added to a reaction vessel and suspended in 343 mL of toluene, followed by heating at a temperature of 120 °C for 4 hours. Once the reaction was complete, the temperature was lowered to room temperature, and 300 mL of distilled water was added thereto. Then, an organic layer was extracted therefrom using ethyl acetate, and the extracted organic layer was washed with saturated NaCl aqueous solution, followed by drying using sodium sulfate. The resulting product was subjected to column chromatography to thereby obtain 12.5 g (26.8 mmol) of Intermediate IM-2-1 (yield: 78 %).

### Synthesis Example 4: Synthesis of Intermediate (IM-2-2)

13.1 g of Intermediate IM-2-2 (25.0 mmol) was synthesized in substantially the same manner as in Synthesis of Intermediate IM-2-1, except that Intermediate IM-1-2 was used instead of Intermediate IM-1-1 (yield: 73 %).

### Synthesis Example 5: Synthesis of Intermediate (IM-3-1)

12.5 g of Intermediate IM-2-1 (26.8 mmol) and 3.2 g of Sn (26.8 mmol) were added to a reaction vessel and suspended in 268 mL of ethanol, followed by adding 3.2 mL of HCl (37 %) dropwise thereto and heating at 80 °C for 10 hours. Once the reaction was complete, the temperature was lowered to room temperature, and 300 mL of distilled water was added thereto. Then, an organic layer was extracted therefrom using ethyl acetate, and the extracted organic layer was washed with saturated NaCl aqueous solution, followed by drying using sodium sulfate. The resulting product was subjected to column chromatography to thereby obtain 9.4 g (21.4 mmol) of Intermediate IM-3-1 (yield: 80 %).

### Synthesis Example 6: Synthesis of Intermediate (IM-3-2)

10.3 g of Intermediate IM-3-2 (20.9 mmol) was synthesized in substantially the same manner as in Synthesis of Intermediate IM-3-1, except that Intermediate IM-2-2 was used instead of Intermediate IM-2-1 (yield: 78%).

| | |
|---|---|
| 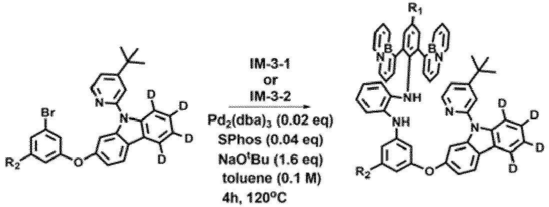 | |
| (3) R₂ = *tert*-Bu | (IM-4-1) R₁ = H, R₂ = tert-Bu |
| (4) R₂ = H | (IM-4-2) R₁ = *tert*-Bu, R₂ = tert-Bu |
| (5) R₂ = phenyl-*d*₅ | (IM-4-3) R₁ = *tert*-Bu, R₂ = H |
| (6) R₂ = 1,3,5- tri-*^{tert}*Bu-phenyl | (IM-4-4) R₁ = *tert*-Bu, R₂ = phenyl-d₅ |
| | (IM-4-5) R₁ = H, R₂ = 1,3,5-tri-*^{tert}*Bu-phenyl |
| | (IM-4-6) R₁ = *tert*-Bu, R₂ = 1,3,5-tri-*^{tert}*Bu-phenyl |

### Synthesis Example 7: Synthesis of Intermediate (IM-4-1)

5.0 g of Intermediate IM-3-1 (11.4 mmol), 6.1 g of 2-(3-bromo-5-(*tert-*butyl)phenoxy)-9-(4-(tert-butyl)pyridin-2-yl)-9H-carbazole-5,6,7,8-*d*₄ (Compound 3) (11.4 mmol), 0.2 g of Pd₂(dba)₃ (0.2 mmol), 1.9 g of SPhos (4.6 mmol), and 1.7 g of NaO*^{tert}*Bu (18.2 mmol) were added to a reaction vessel and suspended in 114 mL of toluene, followed by heating at a temperature of 120 °C for 4 hours. Once the reaction was complete, the temperature was lowered to room temperature, and 300 mL of distilled water was added thereto. Then, an organic layer was extracted therefrom using ethyl acetate, and the extracted organic layer was washed with saturated NaCl aqueous solution, followed by drying using sodium sulfate. The resulting product was subjected to column chromatography to thereby obtain 7.6 g (8.6 mmol) of Intermediate IM-4-1 (yield: 75 %).

### Synthesis Example 8: Synthesis of Intermediate (IM-4-2)

7.8 g of Intermediate IM-4-2 (8.3 mmol) was synthesized in substantially the same manner as in Synthesis of Intermediate IM-4-1, except that Intermediate IM-3-2 was used instead of Intermediate IM-3-1 (yield: 73 %).

### Synthesis Example 9: Synthesis of Intermediate (IM-4-3)

13.5 g of Intermediate IM-4-3 (15.2 mmol) was synthesized in substantially the same manner as in Synthesis of Intermediate IM-4-2, except that 2-(3-bromophenoxy)-9-(4-(*tert*-butyl)pyridin-2-yl)-9H-carbazole-5,6,7,8-*d*₄ (Compound 4), instead of Compound 3, was reacted with Intermediate IM-3-2 (yield: 75 %).

### Synthesis Example 10: Synthesis of Intermediate (IM-4-4)

8.2 g of Intermediate IM-4-4 (8.4 mmol) was synthesized in substantially the same manner as in Synthesis of Intermediate IM-4-3, except that 2-((5-bromo-[1,1'-biphenyl]-3-yl-2',3',4',5',6'-d₅)oxy)-9-(4-(*tert*-butyl)py-ridin-2-yl)-9H-carbazole-5,6,7,8-*d*₄ (Compound 5), instead of Compound 4, was reacted with Intermediate IM-3-2 (yield: 74 %).

### Synthesis Example 11: Synthesis of Intermediate (IM-4-5)

8.4 g of Intermediate IM-4-5 (7.8 mmol) was synthesized in substantially the same manner as in Synthesis of Intermediate IM-4-4, except that 2-((5-bromo-2',4',6'-tri-tert-butyl-[1,1'-biphenyl]-3-yl)oxy)-9-(4-(tert-butyl)-pyridin-2-yl)-9H-carbazole-5,6,7,8-*d*₄ (Compound 6), instead of Compound 5, was reacted with Intermediate IM-3-1, instead of Intermediate IM-3-2 (yield: 68 %).

### Synthesis Example 12: Synthesis of Intermediate (IM-4-6)

8.4 g of Intermediate IM-4-6 (7.4 mmol) was synthesized in substantially the same manner as in Synthesis of Intermediate IM-4-5, except that 2-((5-bromo-2',4',6'-tri-tert-butyl-[1,1'-biphenyl]-3-yl)oxy)-9-(4-(tert-butyl)-pyridin-2-yl) -9H-carbazole-5,6,7,8-*d*₄ (Compound 6) was reacted with Intermediate IM-3-2 instead of Intermediate IM-3-1 (yield: 65 %).

| | |
|---|---|
| 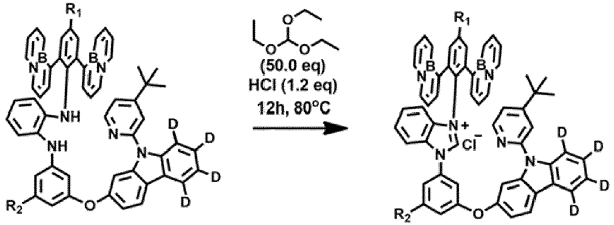 | |
| (IM-4-1) R₁ = H, R₂ = *tert*-Bu | (IM-5-1) R₁ = H, R₂ = *tert*-Bu |
| (IM-4-2) R₁ = *tert*-Bu, R₂ = *tert*-Bu | (IM-5-2) R₁ = *tert*-Bu, R₂ = *tert*-Bu |
| (IM-4-3) R₁ = *tert*-Bu, R₂ = H | (IM-5-3) R₁ = *tert*-Bu, R₂ = H |
| (IM-4-4) R₁ = *tert*-Bu, R₂ = phenyl-d₅ | (IM-5-4) R₁ = *tert*-Bu, R₂ = phenyl-*d*₅ |
| (IM-4-5) R₁ = H, R₂ = 1,3,5-tri-*^{tert}*Bu-phenyl | (IM-5-5) R₁ = H, R₂ = 1,3,5-tri-*^{tert}*Bu-phenyl |
| (IM-4-6) R₁ = *tert*-Bu, R₂ = 1,3,5- tri-*^{tert}*Bu-phenyl | (IM-5-6) R₁ = *tert*-Bu, R₂ = 1,3,5-tri-*^{tert}*Bu-phenyl |

### Synthesis Example 13: Synthesis of Intermediate (IM-5-1)

7.6 g of Intermediate IM-4-1 (8.6 mmol), 86 mL of triethyl orthoformate (516 mmol), and 1.0 mL of HCl (37 %) (10.3 mmol) were added to a reaction vessel, followed by heating at a temperature of 80 °C for 12 hours. Once the reaction was complete, the temperature was cooled to room temperature, and the resulting solid was filtered and washed using ether. Then, the washed solid was dried to thereby obtain 7.2 g (7.7 mmol) of Intermediate IM-5-1 at a yield of 90 %.

### Synthesis Example 14: Synthesis of Intermediates IM-5-2 to IM-5-6

7.3 g of Intermediate IM-5-2 (7.4 mmol), 6.9 g of Intermediate IM-5-3 (7.4 mmol), 7.4 g of Intermediate IM-5-4 (7.3 mmol), 8.0 g of Intermediate IM-5-5 (7.1 mmol), and 8.4 g of Intermediate IM-5-6 (7.1 mmol) were respectively synthesized in substantially the same manner as in Synthesis of Intermediate IM-5-1, except that Intermediate IM-4-2, Intermediate IM-4-3, Intermediate IM-4-4, Intermediate IM-4-5, and Intermediate IM-4-6 were respectively used instead of Intermediate IM-4-1, at a yield of 86 %, 86 %, 85 %, 83 %, and 82 %, respectively.

| | |
|---|---|
| 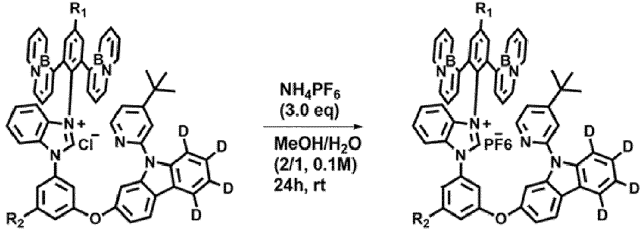 | |
| (IM-5-1) R₁ = H, R₂ = *tert*-Bu | (IM-6-1) R₁ = H, R₂ = *tert*-Bu |
| (IM-5-2) R₁ = *tert*-Bu, R₂ = *tert*-Bu | (IM-6-2) R₁ = *tert*-Bu, R₂ = *tert*-Bu |
| (IM-5-3) R₁ = *tert*-Bu, R₂ = H | (IM-6-3) R₁ = *tert*-Bu, R₂ = H |
| (IM-5-4) R₁ = *tert*-Bu, R₂ = phenyl-d₅ | (IM-6-4) R₁ = *tert*-Bu, R₂ = phenyl-*d*₅ |
| (IM-5-5) R₁ = H, R₂ = 1,3,5- tri-*^{tert}*Bu-phenyl | (IM-6-5) R₁ = H, R₂ = 1,3,5-tri-*^{tert}*Bu-phenyl |
| (IM-5-6) R₁ = *tert*-Bu, R₂ = 1,3,5-tri-*^{tert}*Bu-phenyl | (IM-6-6) R₁ = *tert*-Bu, R₂ = 1,3,5- tri -*^{tert}*Bu-phenyl |

### Synthesis Example 15: Synthesis of Intermediate (IM-6-1)

7.2 g of Intermediate IM-5-1 (7.7 mmol) and 3.8 g of NH₄PF₆ (23.1 mmol) were added to a reaction vessel, followed by suspension in a mixture solution of 100 mL of methanol and 50 mL of water and stirring at room temperature for 24 hours. Once the reaction was complete, the resulting solid was filtered and washed using ether. Then, the washed solid was dried to thereby obtain 7.0 g (6.9 mmol) of Intermediate IM-6-1 at a yield of 90 %.

### Synthesis Example 16: Synthesis of Intermediates IM-6-2 to IM-6-6

7.6 g of Intermediate IM-6-2 (6.9 mmol), 6.9 g of Intermediate IM-6-3 (6.8 mmol), 8.0 g of Intermediate IM-6-4 (7.1 mmol), 8.5 g of Intermediate IM-6-5 (6.9 mmol), and 8.8 g of Intermediate IM-6-6 (6.8 mmol) were respectively synthesized in substantially the same manner as in Synthesis of Intermediate IM-6-1, except that Intermediate IM-5-2, Intermediate IM-5-3, Intermediate IM-5-4, Intermediate IM-5-5, and Intermediate IM-5-6 were respectively used instead of Intermediate IM-5-1, at a yield of 90 %, 88 %, 92 %, 90 %, and 89 %, respectively.

| | |
|---|---|
| 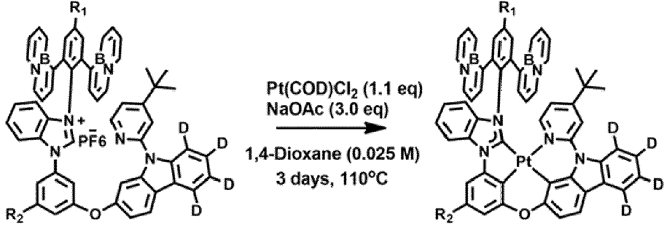 | |
| (IM-6-1) R₁ = H, R₂ = *tert*-Bu | (BD04) R₁ = H, R₂ = *tert*-Bu |
| (IM-6-2) R₁ = *tert*-Bu, R₂ = *tert*-Bu | (BD19) R₁ = *tert*-Bu, R₂ = *tert*-Bu |
| (IM-6-3) R₁ = *tert*-Bu, R₂ = H | (BD17) R₁ = *tert*-Bu, R₂ = H |
| (IM-6-4) R₁ = *tert*-Bu, R₂ = phenyl-d₅ | (BD22) R₁ = *tert*-Bu, R₂ = phenyl-d₅ |
| (IM-6-5) R₁ = H, R₂ = 1,3,5- tri-*^{tert}*Bu-phenyl | (BD10) R₁ = H, R₂ = 1,3,5-tri-*^{tert}*Bu-phenyl |
| (IM-6-6) R₁ = *tert*-Bu, R₂ = 1,3,5-tri-*^{tert}*Bu-phenyl | (BD25) R₁ = *tert*-Bu, R₂ = 1,3,5-tri-*^{tert}*Bu-phenyl |

### Synthesis Example 17: Synthesis of Compound BD04

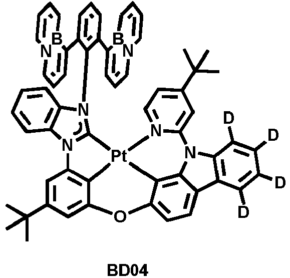

7.0 g of Intermediate IM-6-1 (6.9 mmol), 2.8 g of dichloro(1,5-cyclooctadiene)platinum (7.6 mmol), and 1.7 g of NaOAc (20.7 mmol) were suspended in 150 mL of 1,4-dioxane, followed by heating at a temperature of 110 °C for 72 hours. Once the reaction was complete, the temperature was cooled to room temperature, 150 mL of distilled water was added thereto, and an organic layer was extracted therefrom using ethyl acetate, and the extracted organic layer was washed using NaCl aqueous solution and dried using MgSO₄. The resulting product was subjected to column chromatography to thereby obtain 2.6 g (2.4 mmol) of Compound BD04 (yield: 35 %).

### Synthesis Example 18: Synthesis of Compound BD19

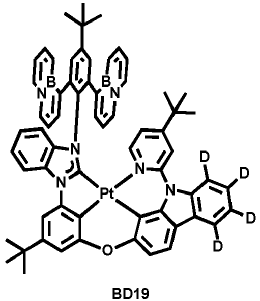

2.8 g of Compound BD19 (2.4 mmol) was synthesized in substantially the same manner as in Synthesis of Compound BD04, except that Intermediate IM-6-2 was used instead of Intermediate IM-6-1 (yield: 35 %).

### Synthesis Example 19: Synthesis of Compound BD17

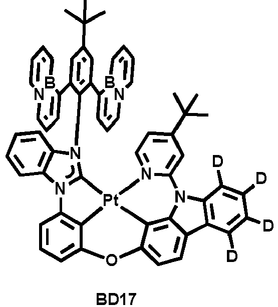

2.4 g of Compound BD17 (2.2 mmol) was synthesized in substantially the same manner as in Synthesis of Compound BD04, except that Intermediate IM-6-3 was used instead of Intermediate IM-6-1 (yield: 32 %).

### Synthesis Example 20: Synthesis of Compound BD22

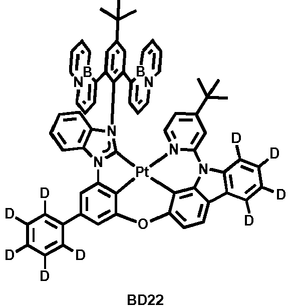

2.9 g of Compound BD22 (2.5 mmol) was synthesized in substantially the same manner as in Synthesis of Compound BD04, except that Intermediate IM-6-4 was used instead of Intermediate IM-6-1 (yield: 36 %).

### Synthesis Example 21: Synthesis of Compound BD10

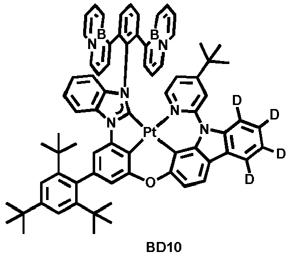

2.9 g of Compound BD10 (2.3 mmol) was synthesized in substantially the same manner as in Synthesis of Compound BD04, except that Intermediate IM-6-5 was used instead of Intermediate IM-6-1 (yield: 34 %).

### Synthesis Example 22: Synthesis of Compound BD25

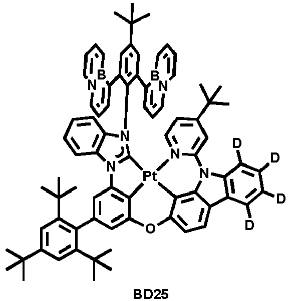

3.2 g of Compound BD25 (2.4 mmol) was synthesized in substantially the same manner as in Synthesis of Compound BD04, except that Intermediate IM-6-6 was used instead of Intermediate IM-6-1 (yield: 35 %).

Compounds synthesized in Synthesis Examples 17 to 22 were identified by ¹H nuclear magnetic resonance (NMR) and matrix-assisted laser desorption/ionization mass spectrometry time-of-flight mass spectroscopy (MALDI-TOF MS). The results thereof are shown in Table 1.

Methods of synthesizing compounds other than the compounds synthesized in Synthesis Examples 17 to 22 may be easily understood by those skilled in the art by referring to the synthesis pathways and raw materials described above.

**Table 1**

| Compo und | ¹H NMR (CDCl₃, 500 MHz) | MALDI-TOF MS [M⁺] | |
|---|---|---|---|
| | | found | calc. |
| BD04 | *δ* 9.01 (*d*, *³J_{H-H}* = 6.3 Hz, 1H), 8.08 (s, 1H), 7.86 (*d*, *³J_{H-H}* = 8.3 Hz, 1H), 7.64 (*d*, *³J_{H-H}* = 8.3 Hz, 1H), 7.60-7.40 (m, 3H), 7.32 (*d*, *³J_{H-H}* = 8.2 Hz, 1H), 7.24-7.22 (m, 3H), 7.15-7.00 (m, 2H), 6.89 (*d*, *³J_{H-H}* = 8.2 Hz, 1H), 6.86-6.65 (m, 7H), 6.37 (*dd, ³J_{H-H}* = 8.1 Hz, 2H), 6.19 (*dd*, *³J_{H-H}* = 6.3 Hz, *⁴J_{H-H}* = 1.7 Hz, 1H), 6.16 (*dd, ³J_{H-H}* = 8.1 Hz, 2H), 5.32 (*dd, ³J_{H-H}* = 8.1 Hz, 2H), 1.42 (s, 9H), 1.29 (s, 9H). | 1091.41 34 | 1091.41 31 |
| BD19 | *δ* 9.03 (*d*, *³J_{H-H}* = 6.3 Hz, 1H), 8.01 (s, 1H), 7.86 (*d*, *³J_{H-H}* = 8.3 Hz, 1H), 7.64 (*d*, *³J_{H-H}* = 8.3 Hz, 1H), 7.60-7.40 (m, 2H), 7.32 (*d*, *³J_{H-H}* = 8.2 Hz, 1H), 7.24-7.22 (m, 3H), 7.15-7.00 (m, 2H), 6.89 (*d*, *³J_{H-H}* = 8.2 Hz, 1H), 6.86-6.65 (m, 7H), 6.37 (*dd, ³J_{H-H}* = 8.1 Hz, 2H), 6.19 (*dd, ³J_{H-H}* = 6.3 Hz, *⁴J_{H-H}* = 1.7 Hz, 1H), 6.16 (*dd, ³J_{H-H}* = 8.1 Hz, 2H), 5.32 (*dd, ³J_{H-H}* = 8.1 Hz, 2H), 1.42 (s, 9H), 1.31 (s, 9H), 1.29 (s, 9H). | 1147.47 61 | 1147.47 57 |
| BD17 | *δ* 9.10 (*d*, *³J_{H-H}* = 6.3 Hz, 1H), 8.12 (s, 1H), 7.88 (*d*, *³J_{H-H}* = 8.3 Hz, 1H), 7.63 (*d*, *³J_{H-H}* = 8.3 Hz, 1H), 7.62-7.41 (m, 3H), 7.31 (*d, ³J_{H-H}* = 8.2 Hz, 1H), 7.24-7.22 (m, 3H), 7.16-7.01 (m, 2H), 6.87 (*d, ³J_{H-H}* = 8.2 Hz, 1H), 6.86-6.65 (m, 7H), 6.36 (*dd*, *³J_{H-H}* = 8.1 Hz, 2H), 6.18 (*dd*, *³J_{H-H}* = 6.3 Hz, *⁴J_{H-H}* = 1.7 Hz, 1H), 6.15 *(dd, ³J_{H-H}* = 8.1 Hz, 2H), 5.34 (*dd*, *³J_{H-H}* = 8.1 Hz, 2H), 1.31 (s, 9H), 1.29 (s, 9H). | 1091.41 36 | 1091.41 31 |
| BD22 | *δ* 9.00 (*d*, *³J_{H-H}* = 6.3 Hz, 1H), 8.03 (s, 1H), 7.87 (*d*, *³J_{H-H}* = 8.3 Hz, 1H), 7.65 (*d*, *³J_{H-H}* = 8.3 Hz, 1H), 7.58-7.38 (m, 2H), 7.30 (*d*, *³J_{H-H}* = 8.2 Hz, 1H), 7.26-7.23 (m, 3H), 7.16-7.01 (m, 2H), 6.87 (*d*, *³J_{H-H}* = 8.2 Hz, 1H), 6.87-6.64 (m, 7H), 6.36 (*dd, ³J_{H-H}* = 8.1 Hz, 2H), 6.18 (*dd*, *³J_{H-H}* = 6.3 Hz, *⁴J_{H-H}* = 1.7 Hz, 1H), 6.14 (*dd*, *³J_{H-H}* = 8.1 Hz, 2H), 5.31 (*dd*, *³J_{H-H}* = 8.1 Hz, 2H), 1.42 (s, 9H), 1.30 (s, 9H). | 1172.47 63 | 1172.47 58 |
| BD10 | *δ* 9.01 (*d*, *³J_{H-H}* = 6.3 Hz, 1H), 8.08 (s, 1H), 7.84 (*d*, *³J_{H-H}* = 8.3 Hz, 1H), 7.64 (*d*, *³J_{H-H}* = 8.3 Hz, 1H), 7.60-7.41 (m, 2H), 7.29 (*d*, *³J_{H-H}* = 8.2 Hz, 1H), 7.28-7.21 (m, 4H), 7.16-7.00 (m, 4H), 6.89 (*d*, *³J_{H-H}* = 8.2 Hz, 1H), 6.85-6.63 (m, 7H), 6.33 (*dd, ³J_{H-H}* = 8.1 Hz, 2H), 6.18 (*dd, ³J_{H-H}* = 6.3 Hz, *⁴J_{H-H}* = 1.7 Hz, 1H), 6.12 (*dd, ³J_{H-H}* = 8.1 Hz, 2H), 5.26 (*dd, ³J_{H-H}* = 8.1 Hz, 2H), 1.35 (s, 18H), 1.31 (s, 9H), 1.30 (s, 9H). | 1279.57 01 | 1279.56 96 |
| BD25 | *δ* 9.12 (*d*, *³J_{H-H}* = 6.3 Hz, 1H), 8.02 (s, 1H), 7.86 (*d*, *³J_{H-H}* = 8.3 Hz, 1H), 7.64 (*d*, *³J_{H-H}* = 8.3 Hz, 1H), 7.60-7.41 (m, 2H), 7.29 (*d*, *³J_{H-H}* = 8.2 Hz, 1H), 7.27-7.22 (m, 3H), 7.16-7.00 (m, 4H), 6.88 (*d*, *³J_{H-H}* = 8.2 Hz, 1H), 6.86-6.64 (m, 7H), 6.32 (*dd*, *³J_{H-H}* = 8.1 Hz, 2H), 6.17 (*dd, ³J_{H-H}* = 6.3 Hz, *⁴J_{H-H}* = 1.7 Hz, 1H), 6.11 (*dd*, *³J_{H-H}* = 8.1 Hz, 2H), 5.28 (*dd, ³J_{H-H}* = 8.1 Hz, 2H), 1.42 (s, 9H), 1.35 (s, 18H), 1.31 (s, 9H), 1.30 (s, 9H). | 1335.63 25 | 1335.63 22 |

### Examples

### Example 1

A Corning 15 Ohms per square centimeter (Ω/cm²) (1,200 Å) ITO glass substrate was cut to a size of 50 millimeters (mm)×50 mm×0.7 mm, sonicated in isopropyl alcohol and pure water for 5 minutes in each solvent, and cleaned by exposure to ultraviolet rays with ozone to use the glass substrate as an anode. Then, the glass substrate was mounted onto a vacuum-deposition apparatus. 2-TNATA was vacuum-deposited on the glass substrate to form a hole injection layer having a thickness of 600 Å. Then, 4,4'-bis[N-(1-naphthyl)-N-phenylamino]biphenyl (NPB) was vacuum-deposited on the hole injection layer to form a hole transport layer having a thickness of about 300 Å. Compound ETH1 and Compound HTH15 were mixed at a weight ratio of 3:7 as a mixture host to be deposited on the hole transport layer, Compound BD04 was used as a dopant (dopant 13 wt%), and ETH1, HTH15, and BD04 were co-deposited to form an emission layer to a thickness of 400 Å. Subsequently, HBL-1 was vacuum-deposited to a thickness of 50 Å to form a hole blocking layer. Alq₃ was deposited on the hole blocking layer as an electron transport layer to a thickness of 300 Å, LiF was deposited on the electron transport layer to a thickness of 10 Å as an electron injection layer, Al was vacuum-deposited to a thickness of 3,000 Å to form a LiF/AI cathode, thereby completing the manufacture of a light-emitting device.

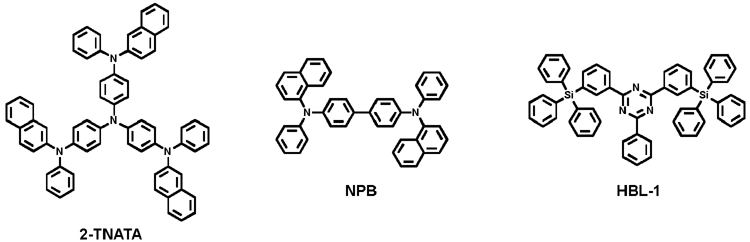

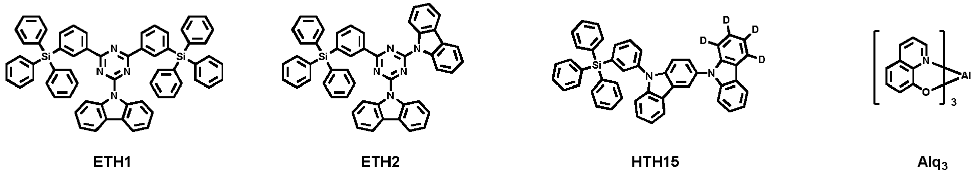

### Example 2

A light-emitting device was manufactured in substantially the same manner as in Example 1, except that ETH2 and HTH15 were used as a mixture host at a weight ratio of 3:7 to form an emission layer.

### Example 3

A light-emitting device was manufactured in substantially the same manner as in Example 1, except that ETH2 and HTH15 were used as a mixture host at a weight ratio of 3:7 to form an emission layer, and BD19 was used instead of BD04.

### Example 4

A light-emitting device was manufactured in substantially the same manner as in Example 1, except that ETH2 and HTH15 were used as a mixture host at a weight ratio of 3:7 to form an emission layer, and BD17 was used instead of BD04.

### Example 5

A light-emitting device was manufactured in substantially the same manner as in Example 1, except that ETH2 and HTH15 were used as a mixture host at a weight ratio of 3:7 to form an emission layer, and BD22 was used instead of BD04.

### Example 6

A light-emitting device was manufactured in substantially the same manner as in Example 1, except that ETH2 and HTH15 were used as a mixture host at a weight ratio of 3:7 to form an emission layer, and BD10 was used instead of BD04.

### Example 7

A light-emitting device was manufactured in substantially the same manner as in Example 1, except that ETH2 and HTH15 were used as a mixture host at a weight ratio of 3:7 to form an emission layer, and BD25 was used instead of BD04.

### Example 8

A light-emitting device was manufactured in substantially the same manner as in Example 1, except that ETH2 and HTH15 were mixed as a mixture host at a weight ratio of 3:7 to form an emission layer, and BD17 (13 wt%) and a delayed fluorescence dopant DFD7 (0.4 wt%), instead of BD04, were co-deposited to form an emission layer having a thickness of 400 Å.

### Comparative Example 1

A light-emitting device was manufactured in substantially the same manner as in Example 1, except that Compound BD-CE1 was used instead of Compound BD04 to form an emission layer.

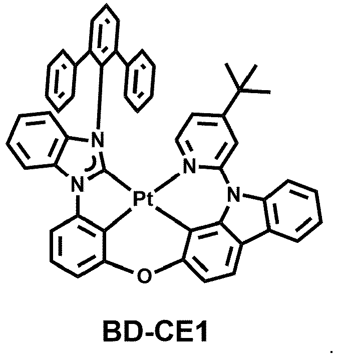

### Comparative Example 2

A light-emitting device was manufactured in substantially the same manner as in Example 1, except that Compound BD-CE2 was used instead of Compound BD04 to form an emission layer.

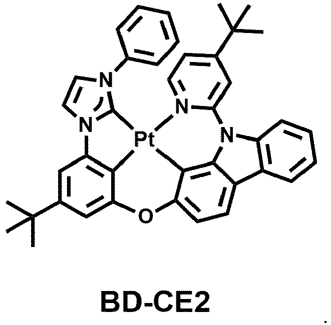

### Comparative Example 3

A light-emitting device was manufactured in substantially the same manner as in Example 1, except that Compound BD-CE3 was used instead of Compound BD04 to form an emission layer.

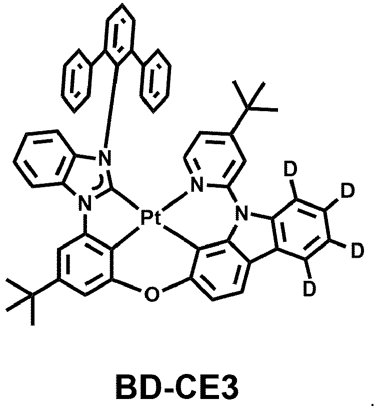

### Comparative Example 4

A light-emitting device was manufactured in substantially the same manner as in Example 1, except that Compound BD-CE4 was used instead of Compound BD04 to form an emission layer.

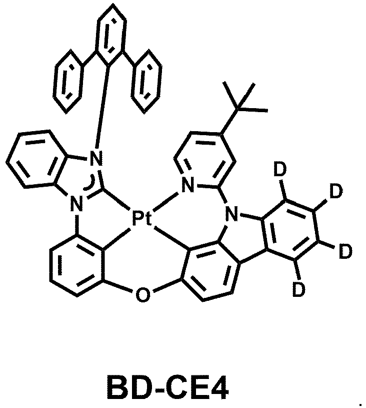

The driving voltage, color coordinates, luminescence efficiency, color-conversion efficiency (luminescence efficiency/ClE_{y}), maximum emission wavelength (nm), and lifespan (T95) at luminance of 1,000 cd/m² of the light-emitting devices manufactured in Examples 1 to 8 and Comparative Examples 1 to 4 were measured by using Keithley source-measure unit (SMU) 236 and a luminance meter PR650. The results thereof are shown in Table 2. In Table 2, the lifespan (T95) indicates a time (in hours) that it took for the luminance of each light-emitting device to decline to 95 % of its initial luminance under the same condition.

**Table 2**

| | Luminance (cd/m²) | Driving voltage (V) | CIE_{(x,y)} | Luminescence efficiency (cd/A) | Color-conversion efficiency (cd/A/y) | Maximum emission wavelength (nm) | Lifespan (T95, hour) |
|---|---|---|---|---|---|---|---|
| Example 1 | 1,000 | 4.9 | (0.134, 0.181) | 22.1 | 122.3 | 462 | 121.0 |
| Example 2 | 1,000 | 4.9 | (0.134, 0.181) | 22.1 | 122.3 | 462 | 140.0 |
| Example 3 | 1,000 | 4.8 | (0.135, 0.177) | 22.5 | 127.1 | 463 | 156.0 |
| Example 4 | 1,000 | 4.6 | (0.135, 0.183) | 23.3 | 127.8 | 463 | 170.2 |
| Example 5 | 1,000 | 4.6 | (0.135, 0.56) | 21.4 | 137.1 | 461 | 133.0 |
| Example 6 | 1,000 | 4.7 | (0.134, 0.171) | 23.6 | 138.1 | 461 | 135.0 |
| Example 7 | 1,000 | 4.7 | (0.134, 0.171) | 23.6 | 138.1 | 461 | 148.3 |
| Example 8 | 1,000 | 4.3 | (0.135, 0.135) | 20.7 | 152.9 | 461 | 200.4 |
| Comparative Example 1 | 1,000 | 4.7 | (0.134, 0.193) | 22.9 | 118.5 | 462 | 45.0 |
| Comparative Example 2 | 1,000 | 4.3 | (0.199, 0.290) | 26.8 | 92.4 | 463 | 4.0 |
| Comparative Example 3 | 1,000 | 4.7 | (0.136, 0.205) | 24.6 | 120.6 | 464 | 35.0 |
| Comparative Example 4 | 1,000 | 4.7 | (0.134, 0.194) | 23.3 | 115.6 | 462 | 28.0 |

As shown in Table 2, the light-emitting devices of Examples 1 to 8 were each found to exhibit excellent color-conversion efficiency and long lifespan in a blue emission area, as compared with the light-emitting devices of Comparative Examples 1 to 4.

When the compound according to one or more embodiments is used in a light-emitting device, the light-emitting device may have excellent (desired) driving voltage, efficiency, colorimetric purity, and/or lifespan.

As apparent from the foregoing description, a light-emitting device including the organometallic compound may have a low driving voltage, high efficiency, high colorimetric purity, and long lifespan.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims and their equivalents.

## Claims

1. A light-emitting device comprising:
a first electrode;
a second electrode facing the first electrode; and
an interlayer between the first electrode and the second electrode, the interlayer comprising an emission layer,
wherein the light-emitting device comprises an organometallic compound represented by Formula 1: 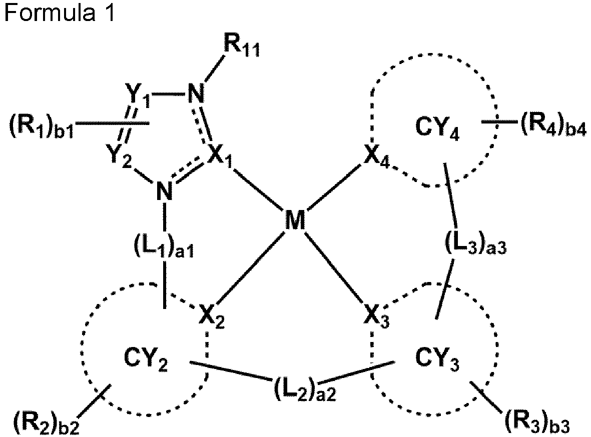 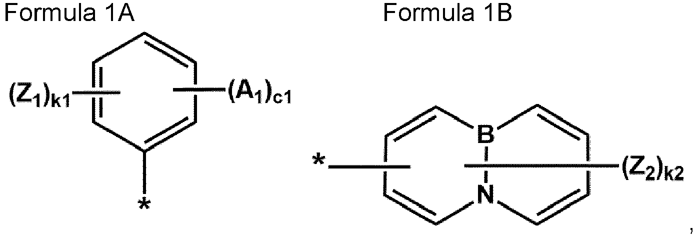 wherein in Formulae 1, 1A, and 1B,
M is platinum (Pt), palladium (Pd), copper (Cu), nickel (Ni), silver (Ag), gold (Au), rhodium (Rh), iridium (Ir), ruthenium (Ru), osmium (Os), titanium (Ti), zirconium (Zr), hafnium (Hf), europium (Eu), terbium (Tb), or thulium (Tm),
X₁ is C, and a bond between X₁ and M is a coordinate bond,
X₂ to X₄, Y₁, and Y₂ are each independently C or N,
one of a bond between X₂ and M, a bond between X₃ and M, and a bond between X₄ and M is a coordinate bond, and the other two bonds are each a covalent bond,
CY₂ to CY₄ are each independently a C₃-C₆₀ carbocyclic group or a C₁-C₆₀ heterocyclic group,
L₁ to L₃ are each independently a single bond, *-O-*', *-S-*', *-Se-*', *-S(=O)₂-*', *-C(R₅)(R₆)-*', -C(R₅)=*', *=C(R₅)-*', *-C(R₅)=C(R₆)-*', *-C(=O)-*', *-C(=S)-*', *-C≡C-*', *-B(R₅)-*', *-N(R₅)-*', *-P(R₅)-*', *-Si(R₅)(R₆)-*', *-P(=O)(R₅)-*', or *-Ge(R₅)(R₆)-*',
a1 to a3 are each independently an integer from 1 to 3,
R₁ to R₆ and R₁₁ are each independently a group represented by Formula 1A, hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
at least two groups of R₁ in a number of b1, R₂ in a number of b2, R₃ in a number of b3, R₄ in a number of b4, R₅, and R₆ are optionally bound to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
at least one of R₁₁, R₁ in a number of b1, R₂ in a number of b2, R₃ in a number of b3, and R₄ in a number of b4 is a group represented by Formula 1A,
b1 is 1 or 2,
b2 to b4 are each independently an integer from 1 to 10,
A₁ is a group represented by Formula 1B,
c1 is an integer from 1 to 5,
Z₁ and Z₂ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
k1 is an integer from 0 to 4,
k2 is an integer from 1 to 7,
* and *' each indicate a binding site to an adjacent atom, and
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, - Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃i)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
wherein Q₁ to Q₃, Q₁₁ to Q₁₃, Q₂₁ to Q₂₃, and Q₃₁ to Q₃₃ are each independently hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

2. The light-emitting device of claim 1, wherein the first electrode is an anode,
the second electrode is a cathode,
the interlayer further comprises a hole transport region between the first electrode and the emission layer, and an electron transport region between the emission layer and the second electrode,
the hole transport region comprises a hole injection layer, a hole transport layer, an emission auxiliary layer, an electron blocking layer, or any combination thereof, and
the electron transport region comprises a buffer layer, a hole blocking layer, an electron control layer, an electron transport layer, an electron injection layer, or a combination thereof.

3. The light-emitting device of claim 1 or claim 2, wherein
the emission layer comprises the organometallic compound represented by Formula 1.

4. The light-emitting device of any one of claims 1 to 3, wherein
the emission layer comprises a host and a dopant, and
the dopant comprises the organometallic compound represented by Formula 1.

5. The light-emitting device of claim 4, wherein
the host comprises a hole transporting host and an electron transporting host.

6. The light-emitting device of claim 4, wherein
the host comprises an electron transporting host represented by Formula 2 and a hole transporting host represented by Formula 3: 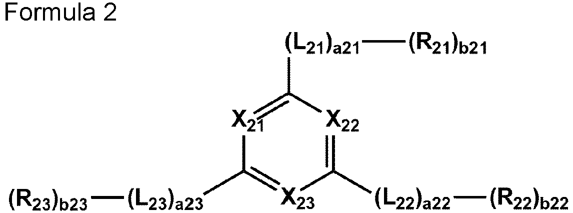 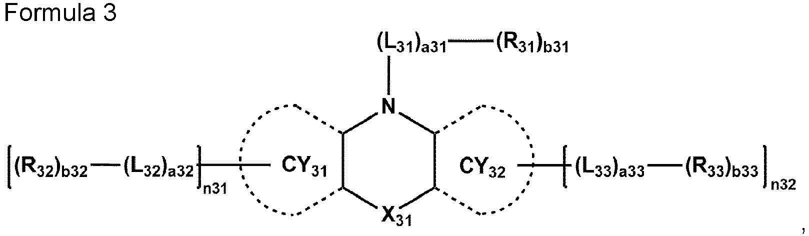 and wherein, in Formula 2 and Formula 3,
X₂₁ is N or C-(L₂₄)ₐ₂₄-(R₂₄)_{b24}, X₂₂ is N or C-(L₂₅)ₐ₂₅-(R₂₅)_{b25}, and X₂₃ is N or C-(L₂₆)ₐ₂₆-(R₂₆)_{b26},
X₃₁ is selected from a single bond, O, S, N(R₃₄), C(R₃₄)(R₃₅), and Si(R₃₄)(R₃₅),
CY₃₁ and CY₃₂ are each independently a C₃-C₆₀ carbocyclic group or a C₁-C₆₀ heterocyclic group,
L₂₁ to L₂₆ and L₃₁ to L₃₃ are each independently a C₃-C₆₀ carbocyclic group unsubstituted or substituted with at least one R₁₀ₐ or a C₁-C₆₀ heterocyclic group unsubstituted or substituted with at least one R₁₀ₐ,
a21 to a26 and a31 to a33 are each independently an integer from 0 to 5,
R₂₁ to R₂₆ and R₃₁ to R₃₅ are each independently hydrogen, deuterium, -F, -Cl, - Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
b21 to b26, b31 to b33, n31, and n32 are each independently an integer from 1 to 5, and
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, - Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃i)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
wherein Q₁ to Q₃, Q₁₁ to Q₁₃, Q₂₁ to Q₂₃, and Q₃₁ to Q₃₃ are each independently hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

7. The light-emitting device of any one of claims 1 to 6, wherein
the light-emitting device further comprises at least one selected from a first capping layer outside the first electrode and a second capping layer outside the second electrode, and the at least one selected from the first capping layer and the second capping layer has a refractive index of about 1.6 or higher at a wavelength of 589 nanometers (nm).

8. An electronic apparatus comprising the light-emitting device of any one of claims 1 to 7, optionally wherein the electronic apparatus further comprises a color filter, a color-conversion layer, a touchscreen layer, a polarization layer, or any combination thereof.

9. An organometallic compound represented by Formula 1: 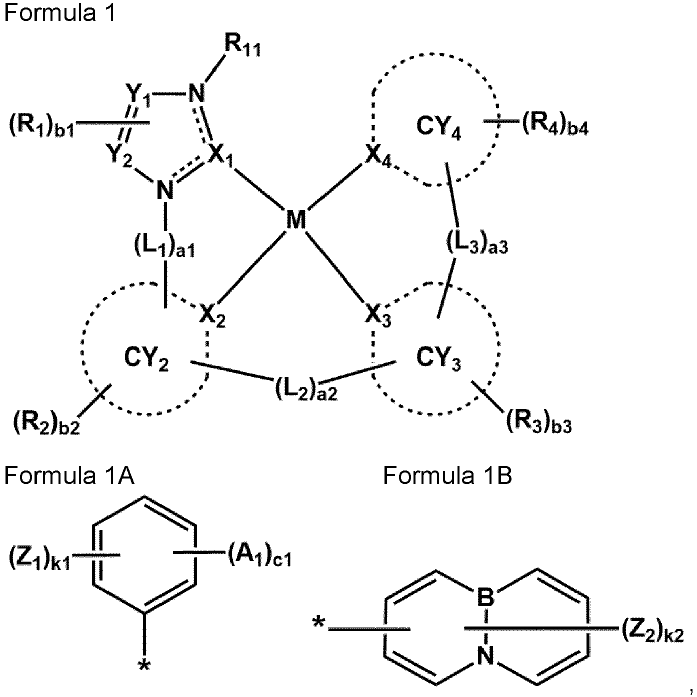 wherein in Formulae 1, 1A, and 1B,
M is platinum (Pt), palladium (Pd), nickel (Ni), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), or thulium (Tm),
X₁ is C, and a bond between X₁ and M is a coordinate bond,
X₂ to X₄, Y₁, and Y₂ are each independently C or N,
one of a bond between X₂ and M, a bond between X₃ and M, and a bond between X₄ and M is a coordinate bond, and the other two bonds are each a covalent bond,
CY₂ to CY₄ are each independently a C₃-C₆₀ carbocyclic group or a C₁-C₆₀ heterocyclic group,
L₁ to L₃ are each independently a single bond, *-O-*', *-S-*', *-Se-*', *-S(=O)₂-*', *-C(R₅)(R₆)-*', *-C(R₅)=*', *=C(R₅)-*', *-C(R₅)=C(R₆)-*', *-C(=O)-*', *-C(=S)-*', *-C≡C-*', *-B(R₅)-*', *-N(R₅)-*', *-P(R₅)-*', *-Si(R₅)(R₆)-*', *-P(=O)(R₅)-*', or *-Ge(R₅)(R₆)-*',
a1 to a3 are each independently an integer from 1 to 3,
R₁ to R₆ and R₁₁ are each independently a group represented by Formula 1A, hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
at least two groups of R₁ in a number of b1, R₂ in a number of b2, R₃ in a number of b3, R₄ in a number of b4, R₅, and R₆ are optionally bound to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
at least one of R₁₁, R₁ in a number of b1, R₂ in a number of b2, R₃ in a number of b3, and R₄ in a number of b4 is a group represented by Formula 1A,
b1 is 1 or 2,
b2 to b4 are each independently an integer from 1 to 10,
A₁ is a group represented by Formula 1B,
c1 is an integer from 1 to 5,
Z₁ and Z₂ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
k1 is an integer from 0 to 4,
k2 is an integer from 1 to 7,
* and *' each indicate a binding site to an adjacent atom, and
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, - Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
wherein Q₁ to Q₃, Q₁₁ to Q₁₃, Q₂₁ to Q₂₃, and Q₃₁ to Q₃₃ are each independently hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

10. The organometallic compound of claim 9, wherein
CY₂ is a group represented by one of Formulae CY2-1 to CY2-9,
CY₃ is a group represented by one of Formulae CY3-1 to CY3-10, and/or
CY₄ is a group represented by one of Formulae CY4-1 to CY4-9: 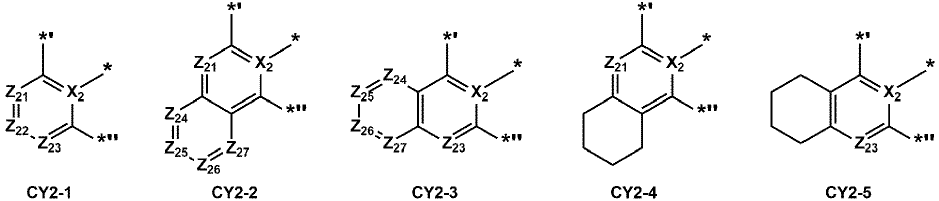 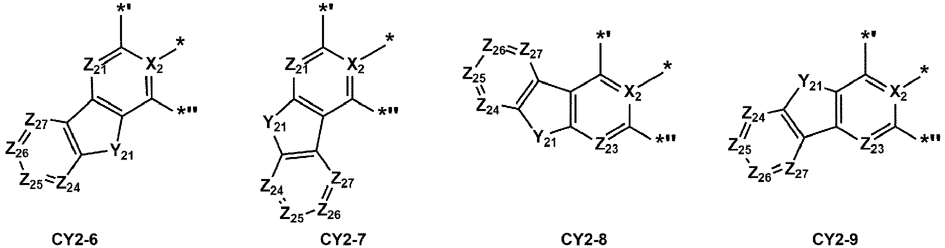 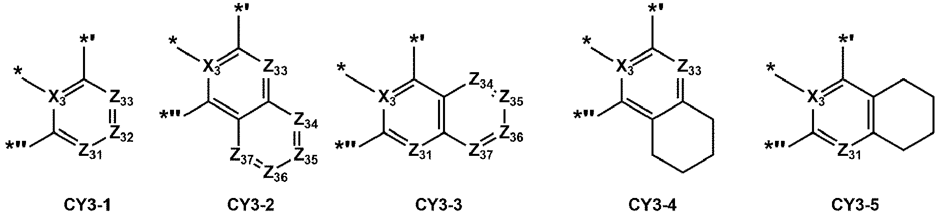 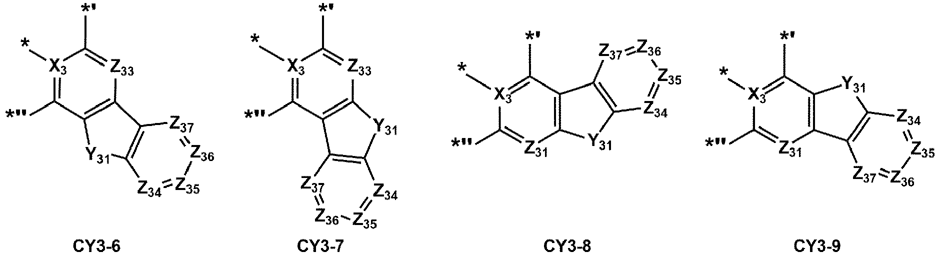 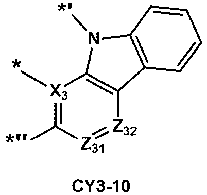 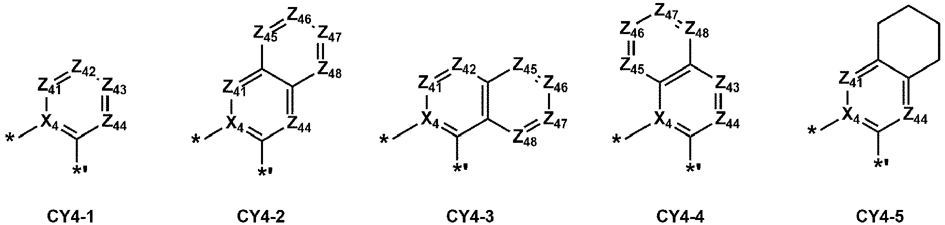 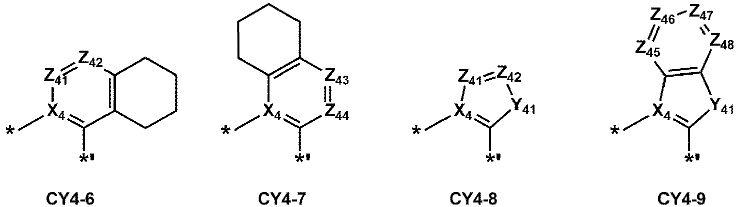
and wherein, in Formulae CY2-1 to CY2-9, CY3-1 to CY3-10, and CY4-1 to CY4-9,
Z₂₁ to Z₂₇, Z₃₁ to Z₃₇, and Z₄₁ to Z₄₈ are each independently C or N, Y₂₁, Y₃₁, and Y₄₁ are each independently N, O, S, C, or Si,
X₂ to X₄ are respectively understood by referring to the descriptions of X₂ to X₄ in Formula 1,
* indicates a binding site to M, and
*' and *" each indicate a binding site to an adjacent atom.

11. The organometallic compound of claim 9 or claim 10, wherein:
(i) L₁ is a single bond, L₂ is *-O-*' or *-S-*', and L₃ is *-N(Rs)-*'; and/or
(ii) the group represented by Formula 1A is represented by one of Formulae 1A-1 to 1A-14: 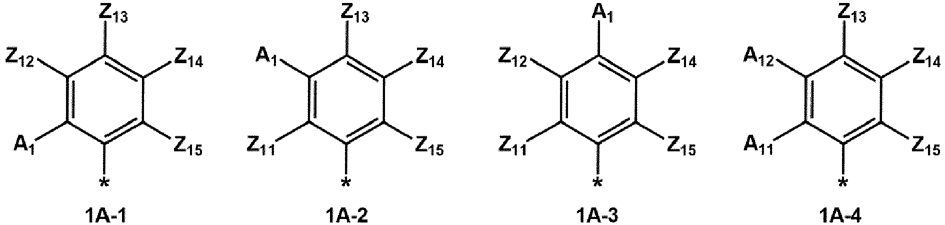 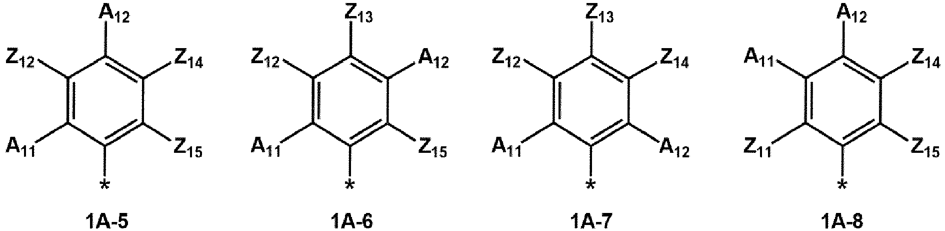 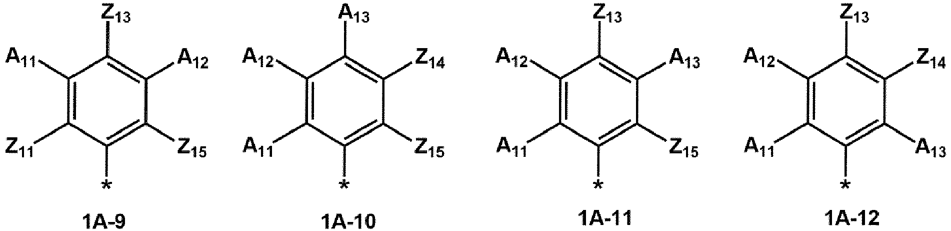 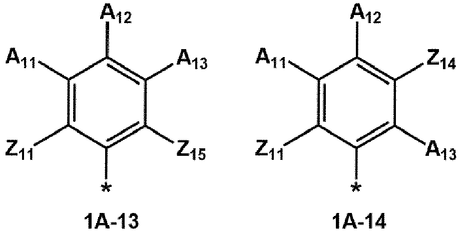 and wherein, in Formulae 1A-1 to 1A-14,
Z₁₁ to Z₁₅ are each independently understood by referring to the description of Z₁ in Formula 1A,
A₁₁ to A₁₃ are each independently understood by referring to the description of A₁ in Formula 1A,
A₁ is understood by referring to the description of A₁ in Formula 1A, and
* indicates a binding site to an adjacent atom.

12. The organometallic compound of any one of claims 9 to 11, wherein the group represented by Formula 1A is represented by Formula 1A-7-1: 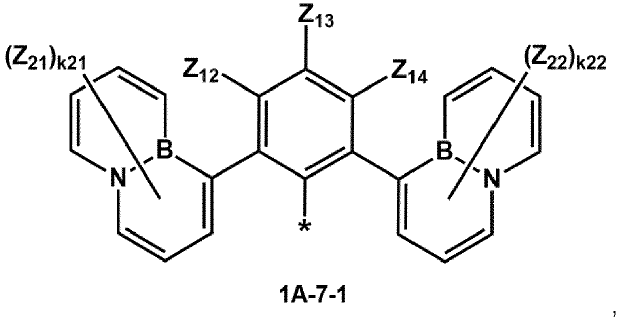 and wherein, in Formula 1A-7-1,
Z₁₂ to Z₁₄ are each independently understood by referring to the description of Z₁ in Formula 1A,
Z₂₁ and Z₂₂ are each independently understood by referring to the description of Z₂ in Formula 1B,
k21 and k22 are each independently an integer from 1 to 7, and
* indicates a binding site to an adjacent atom.

13. The organometallic compound of any one of claims 9 to 12, wherein:
(i) at least one of R₁ in a number of b1, R₂ in a number of b2, R₃ in a number of b3, R₄ in a number of b4, R₅, R₆, and R₁₁ is deuterium, -CH₂D, -CHD₂, -CD₃, a phenyl group substituted with at least one deuterium, or a group represented by one of Formulae 10-2 to 10-7: 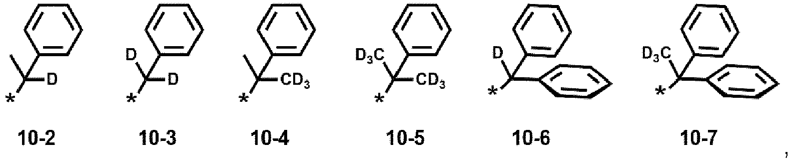 and wherein, in Formulae 10-2 to 10-7,
"D" represents deuterium, and
* indicates a binding site to an adjacent atom; and/or
(ii) a moiety represented by 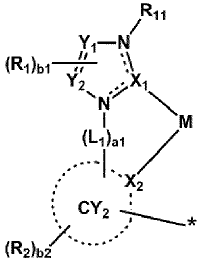 in Formula 1 is a group represented by Formula L1-1 or L1-2: 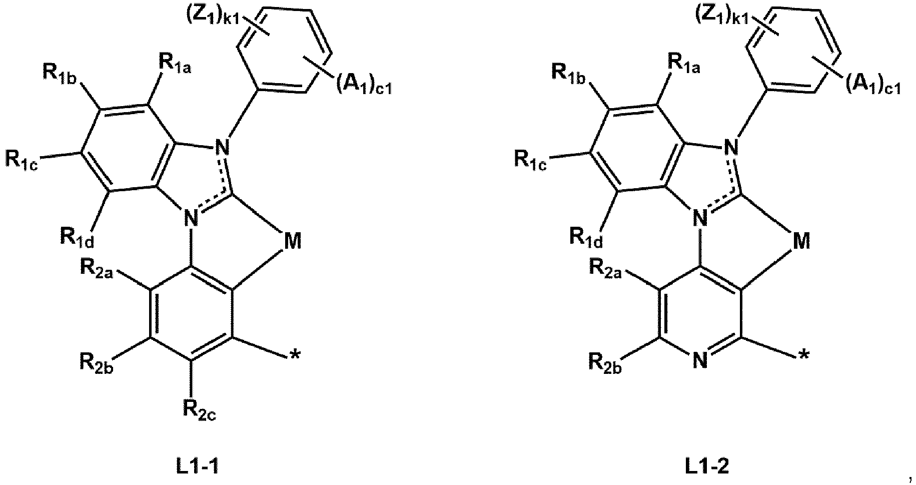 and wherein, in Formulae L1-1 and L1-2,
R₁ₐ to R_{1d} are each independently understood by referring to the description of R₁ in Formula 1,
R₂ₐ to R_{2c} are each independently understood by referring to the description of R₂ in Formula 1,
M, A₁, c1, Z₁, and k1 are respectively understood by referring to the descriptions of M, A₁, c1, Z₁, and k1 in Formulae 1 and 1A, and
* indicates a binding site to L₂; and/or
(iii) a moiety represented by 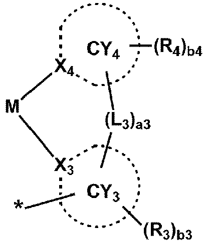 in Formula 1 is a group represented by Formula L2-1 or Formula L2-2: 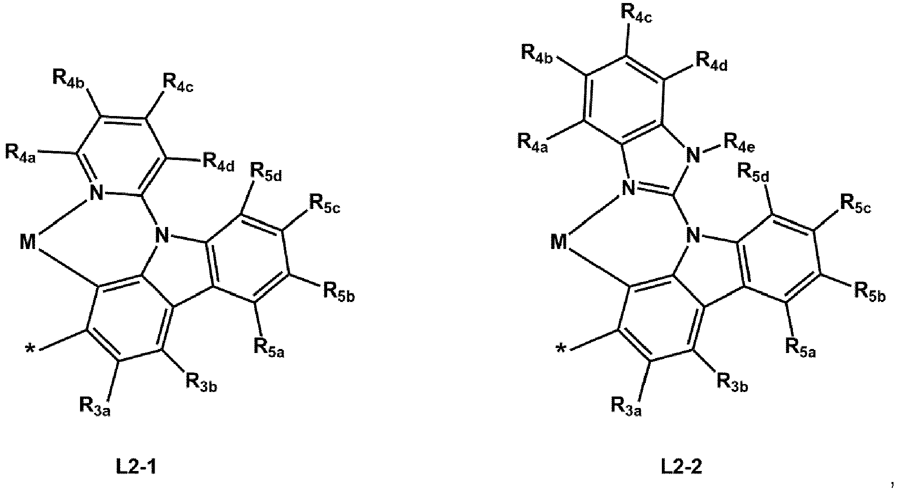 and wherein, in Formulae L2-1 and L2-2,
R₃ₐ and R_{3b} are each independently understood by referring to the description of R₃ in Formula 1,
R₄ₐ to R₄ₑ are each independently understood by referring to the description of R₄ in Formula 1,
R₅ₐ to R_{5d} are each independently understood by referring to the description of R₁₀ₐ in Formula 1,
M is understood by referring to the description of M in Formula 1, and
* indicates a binding site to L₂.

14. The organometallic compound of any one of claims 9 to 13, wherein the organometallic compound is represented by any one selected from Formulae 1-1 to 1-4: 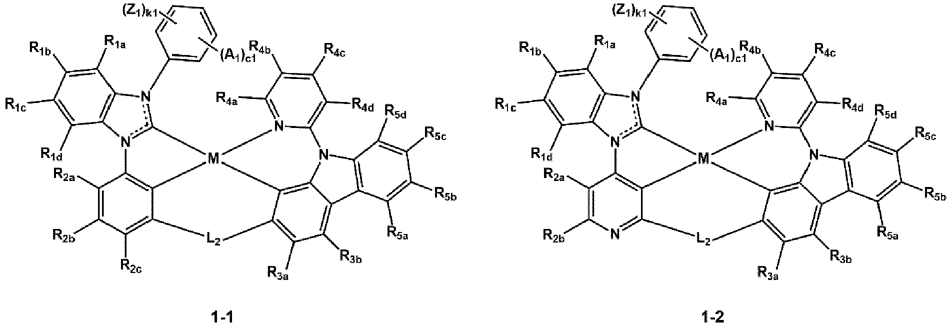 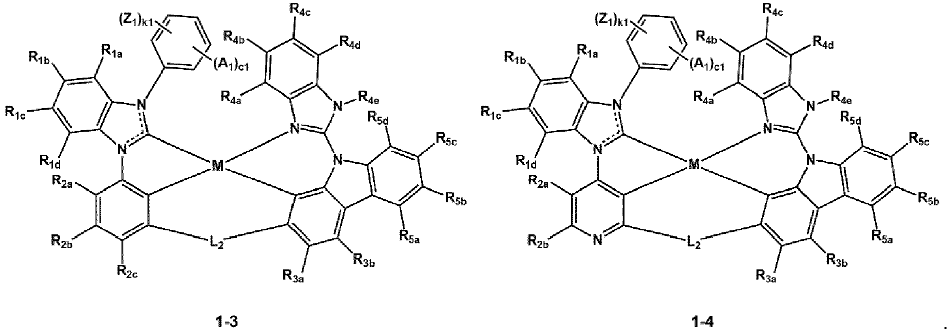 wherein, in Formulae 1-1 to 1-4,
M, L₂, A₁, c1, Z₁, and k1 are respectively understood by referring to the descriptions of M, L₂, A₁, c1, Z₁, and k1 in Formulae 1 and 1A,
R₁ₐ to R_{1d}, R₂ₐ to R_{2c}, R₃ₐ, R_{3b}, R₄ₐ to R₄ₑ, and R₅ₐ to R_{5d} are each independently hydrogen, deuterium, -F, -Cl, -Br, -I, -CH₂D, -CHD₂, -CD₃, -CH₂F, -CHF₂, -CF₃, a hydroxyl group, a cyano group, a nitro group, a methyl group, an ethyl group, a propyl group, an iso-propyl group, an n-butyl group, an iso-butyl group, a sec-butyl group, a tert-butyl group, an n-pentyl group, a tert-pentyl group, a neo-pentyl group, an isopentyl group, a sec-pentyl group, a 3-pentyl group, a sec-isopentyl group, an n-hexyl group, an iso-hexyl group, a sec-hexyl group, a tert-hexyl group, or a group represented by one selected from the group consisting of Formulae 9-1 to 9-31 and 10-1 to 10-7: 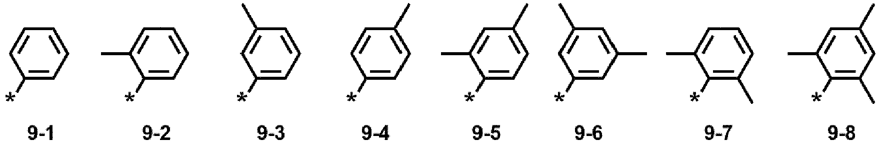 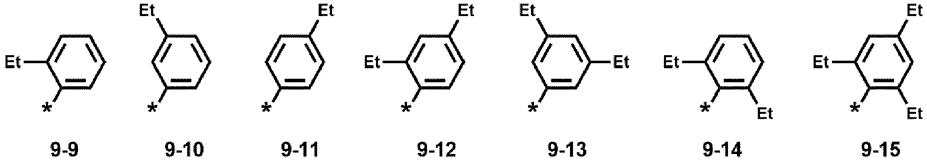 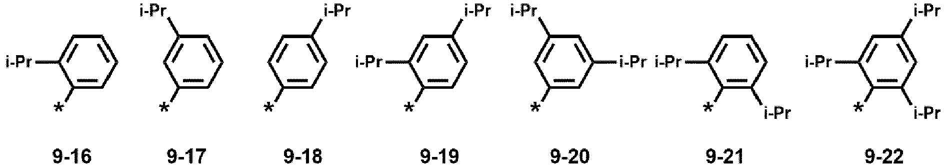 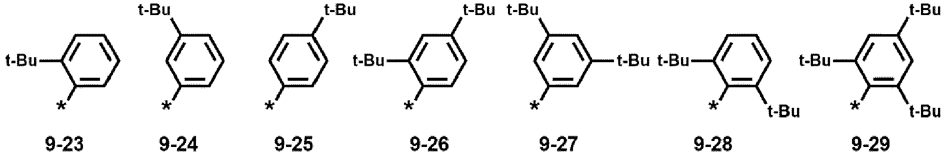 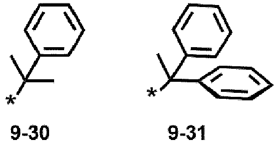 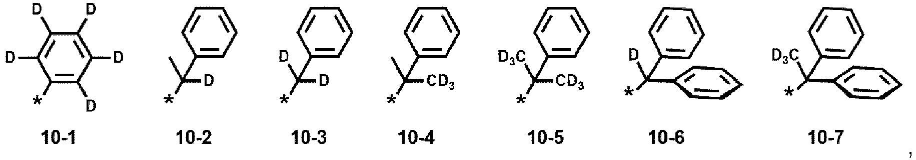 and wherein, in Formulae 9-1 to 9-31 and 10-1 to 10-7,
"Et" represents an ethyl group,
"i-Pr" represents an iso-propyl group,
"t-Bu" represents a tert-butyl group,
"D" represents deuterium, and
* indicates a binding site to an adjacent atom, optionally wherein, in Formulae 1-1 to 1-4, at least one of R₁ₐ to R_{1d}, R₂ₐ to R_{2c}, R₃ₐ, R_{3b}, R₄ₐ to R₄ₑ, and R₅ₐ to R_{5d} is deuterium, -CH₂D, -CHD₂, -CD₃, or a group represented by one of Formulae 10-1 to 10-7: 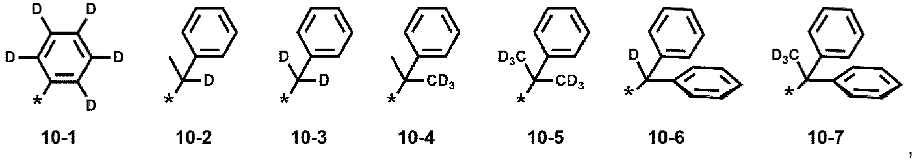 and
wherein, in Formulae 10-1 to 10-7,
"D" represents deuterium, and
* indicates a binding site to an adjacent atom.

15. The organometallic compound of claim 9, wherein the organometallic compound is represented by one of Compounds BD01 to BD210: 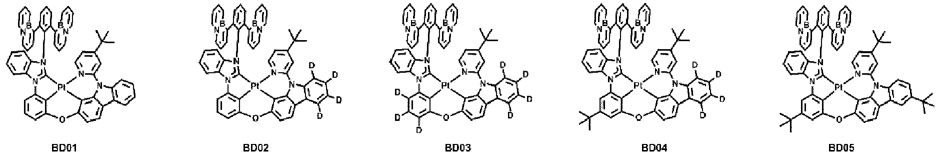 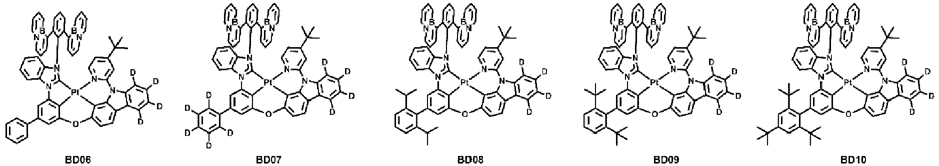 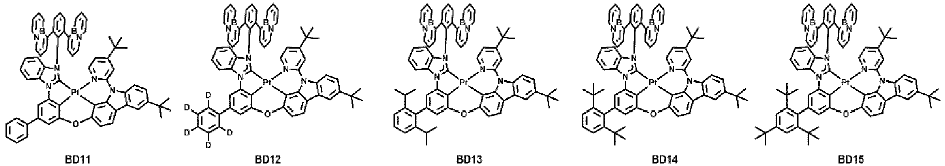 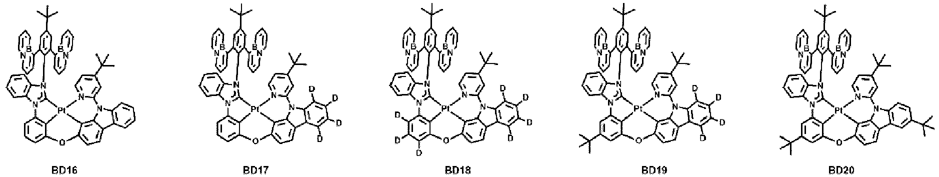 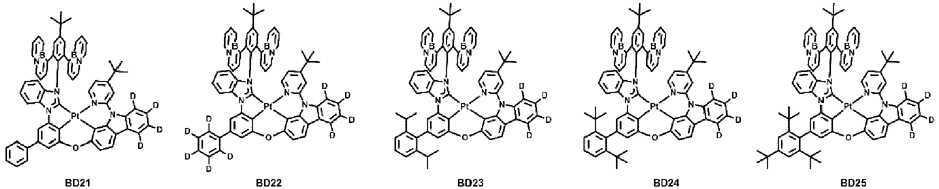 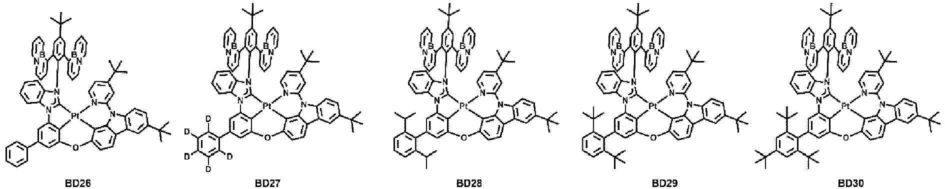 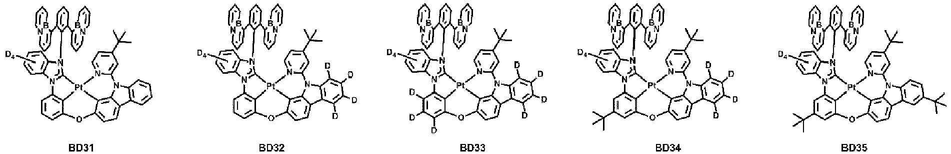 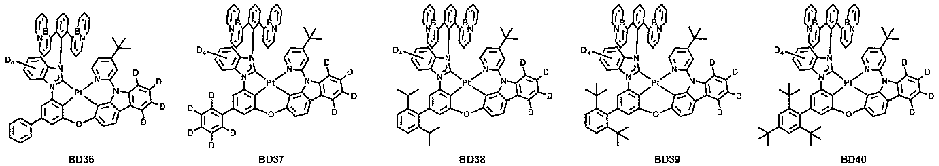 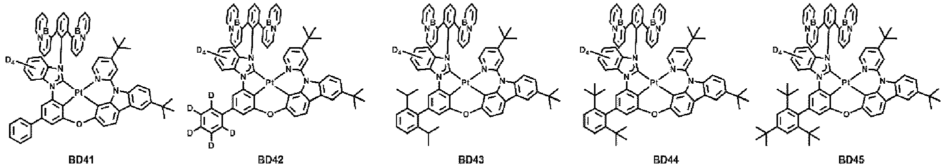 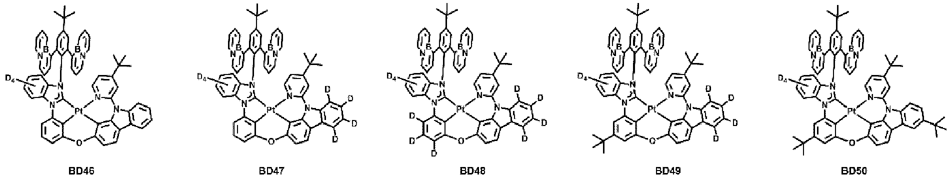 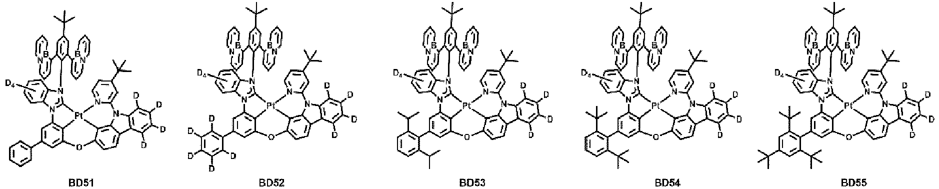 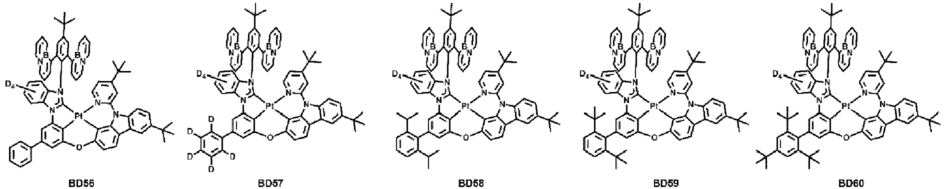 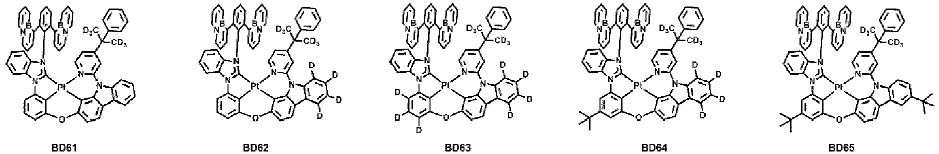 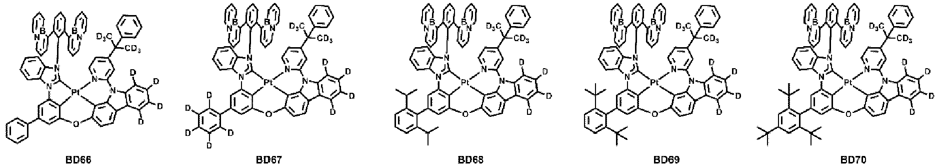 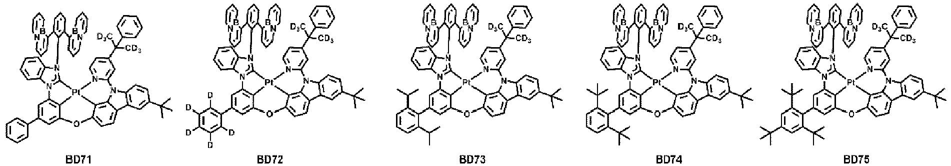 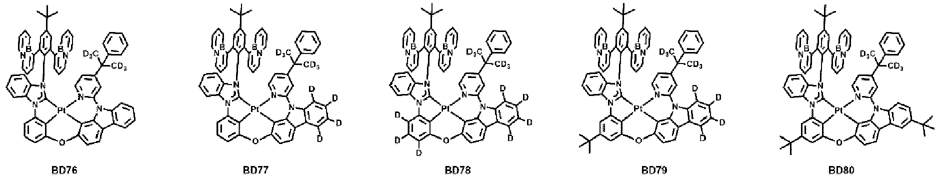 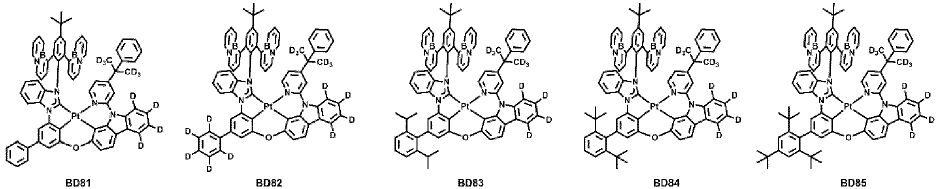 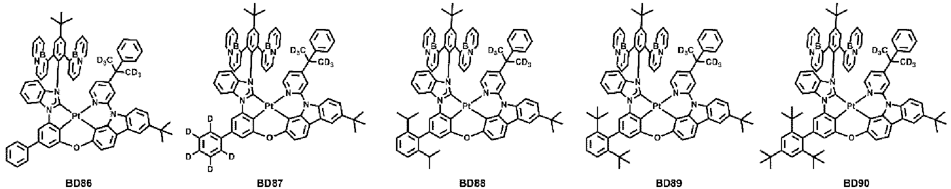 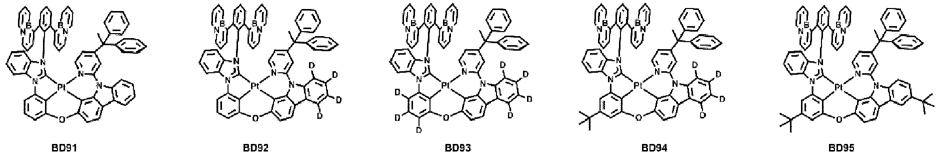 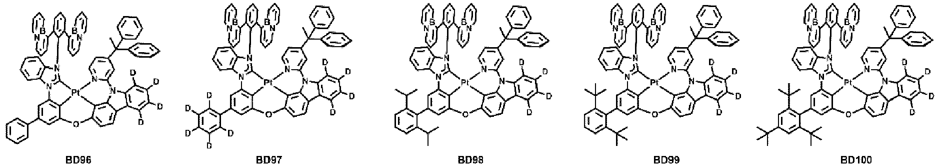 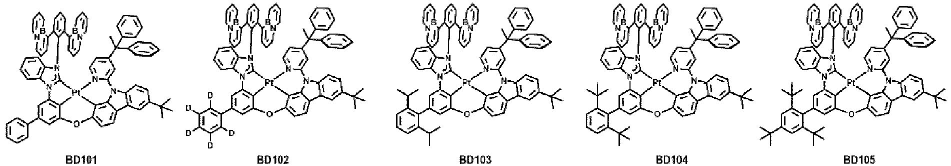 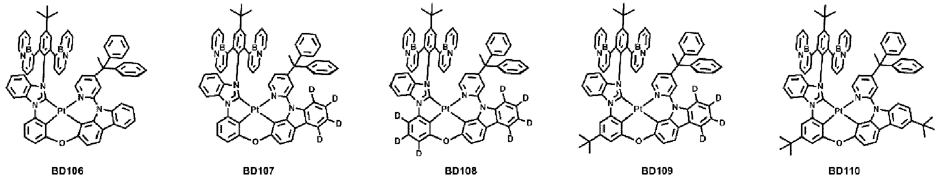 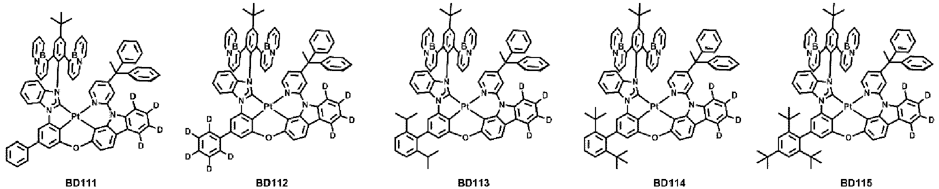 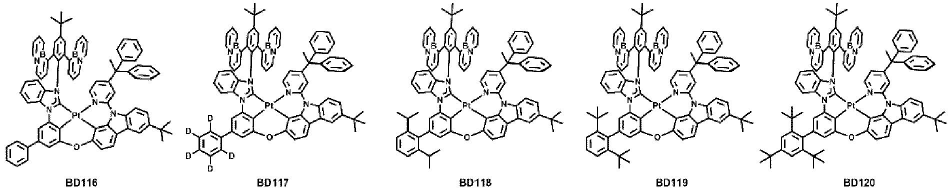 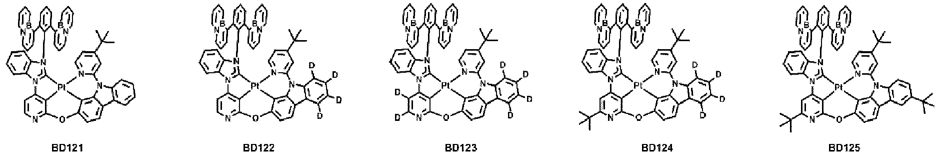 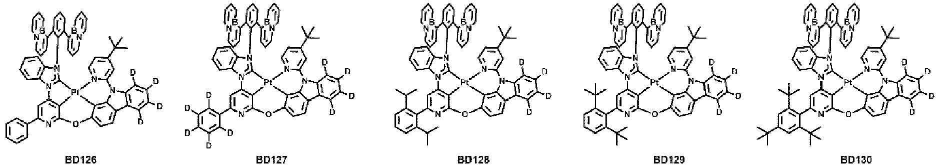 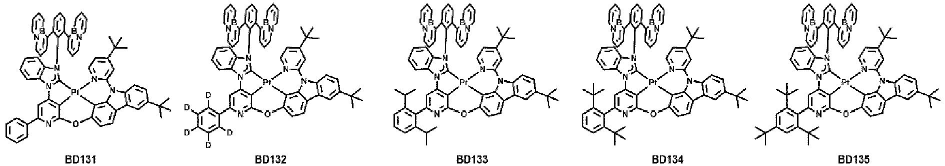 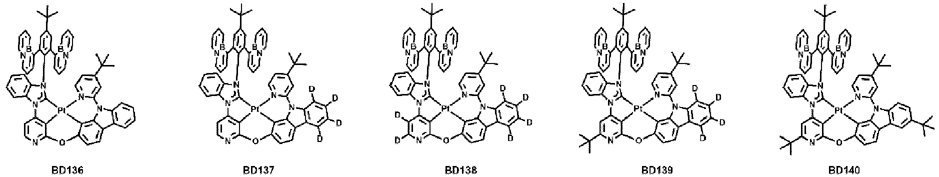 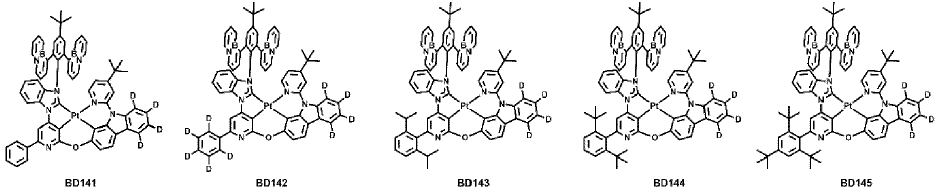 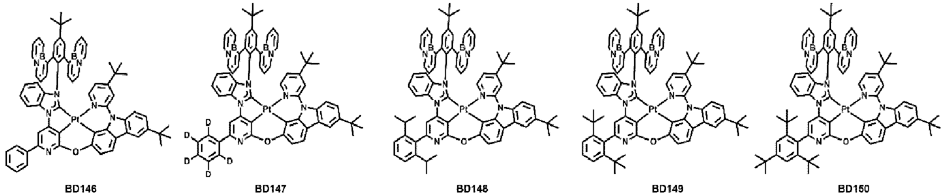 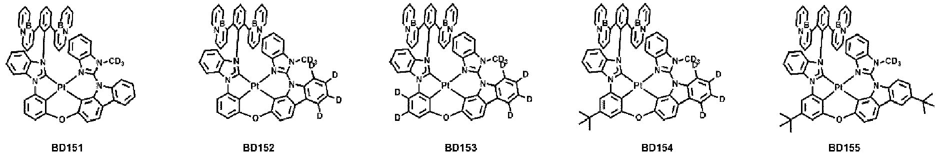 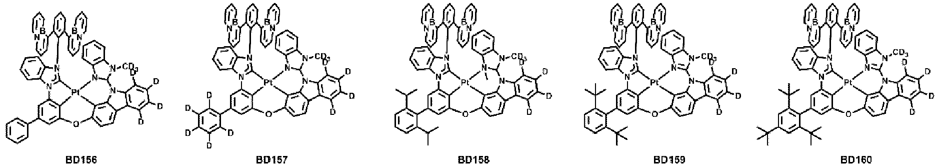 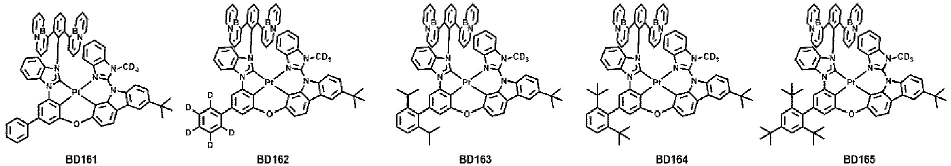 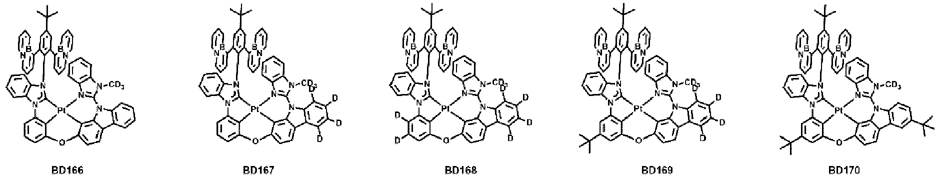 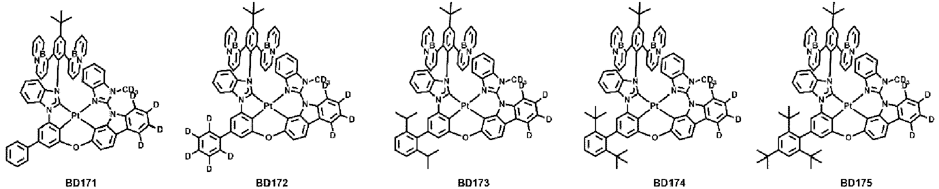 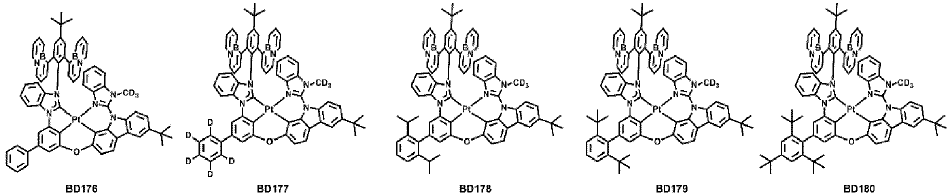 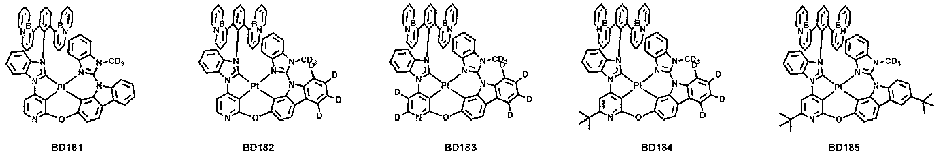 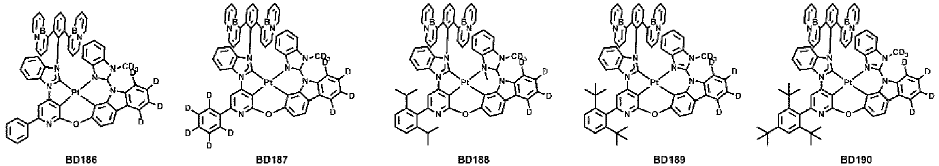 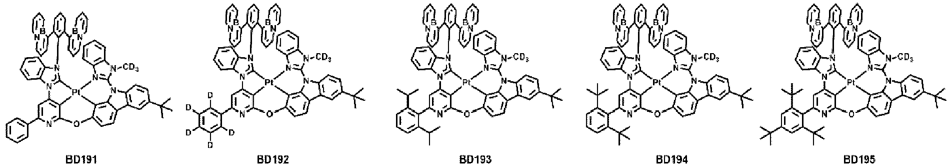 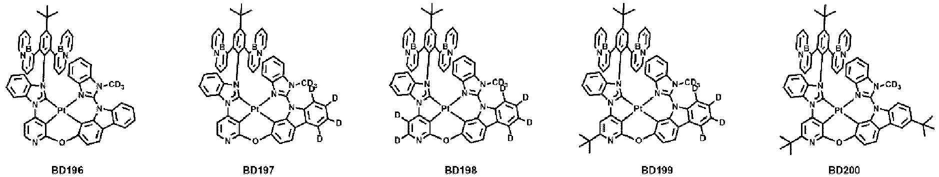 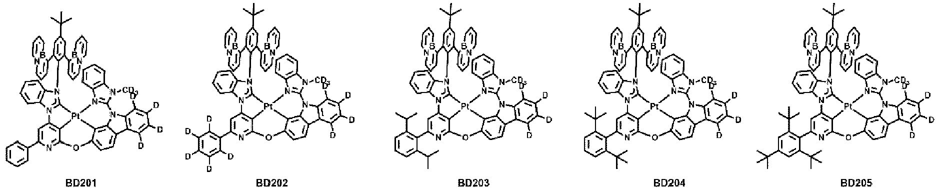 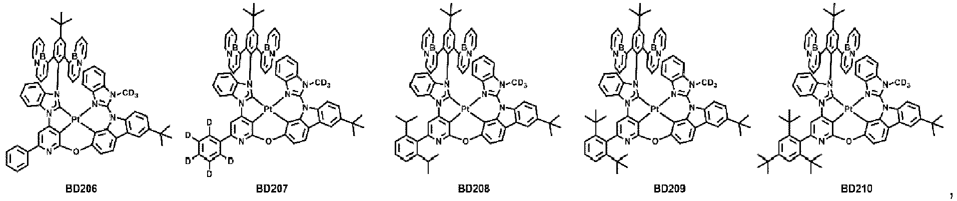 and wherein, in Compounds BD01 to BD210, D₄ indicates substitution with four deuteriums (D).

## Patentansprüche

1. Lichtemittierende Vorrichtung umfassend:
eine erste Elektrode;
eine zweite Elektrode, die der ersten Elektrode zugewandt ist; und
eine Zwischenschicht zwischen der ersten Elektrode und der zweiten Elektrode, wobei die Zwischenschicht eine Emissionsschicht umfasst,
wobei die lichtemittierende Vorrichtung eine durch die Formel 1 dargestellte organometallische Verbindung umfasst: 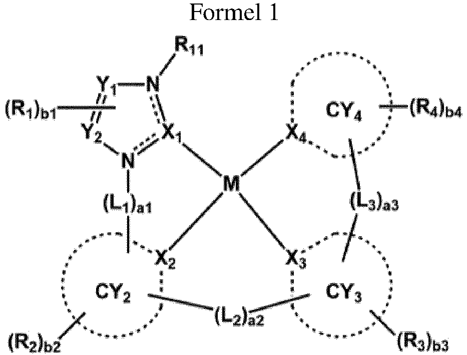 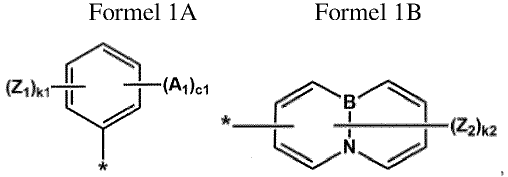 wobei in Formeln 1, 1A und 1B,
M Platin (Pt), Palladium (Pd), Kupfer (Cu), Nickel (Ni), Silber (Ag), Gold (Au), Rhodium (Rh), Iridium (Ir), Ruthenium (Ru), Osmium (Os), Titan (Ti), Zirkonium (Zr), Hafnium (Hf), Europium (Eu), Terbium (Tb) oder Thulium (Tm) ist,
X₁ C ist und eine Bindung zwischen X₁ und M eine koordinative Bindung ist,
X₂ bis X₄, Y₁ und Y₂ jeweils unabhängig C oder N sind,
eine von einer Bindung zwischen X₂ und M, einer Bindung zwischen X₃ und M und einer Bindung zwischen X₄ und M eine koordinative Bindung ist und die zwei anderen Bindungen jeweils eine kovalente Bindung sind,
CY₂ bis CY₄ jeweils unabhängig eine C₃-C₆₀-carbocyclische Gruppe oder eine C₁-C₆₀-heterocyclische Gruppe sind,
L₁ bis L₃ jeweils unabhängig eine Einfachbindung, *-O-*', *-S-*', *-Se-*', *-S(=O)₂-^{∗}', *-C(R₅)(R₆)-*', ^{∗}-C(R₅)=^{∗}', *=C(R₅)-*', *-C(R₅)=C(R₆)-*', *-C(=O)-*', ^{∗}-C(=S)-^{∗}', *-C≡C-*', ^{∗}-B(R₅)-^{∗}', *-N(R₅)-*', *-P(R₅)-*', ^{∗}-Si(R₅)(R₆)-^{∗}', ^{∗}-P(=O)(R₅)-^{∗}' oder ^{∗}-Ge(R₅)(R₆)-^{∗}' sind,
a1 bis a3 jeweils unabhängig eine ganze Zahl von 1 bis 3 sind,
R₁ bis R₆ und R₁₁ jeweils unabhängig eine durch Formel 1A dargestellte Gruppe, Wasserstoff, Deuterium, -F, -Cl, -Br, -I, eine Hydroxylgruppe, eine Cyanogruppe, eine Nitrogruppe, eine C₁-C₆₀-Alkylgruppe, unsubstituiert oder substituiert mit mindestens einem R₁₀ₐ, eine C₂-C₆₀-Alkenylgruppe, unsubstituiert oder substituiert mit mindestens einem R₁₀ₐ, eine C₂-C₆₀-Alkinylgruppe, unsubstituiert oder substituiert mit mindestens einem R₁₀ₐ, eine C₁-C₆₀-Alkoxygruppe, unsubstituiert oder substituiert mit mindestens einem R₁₀ₐ, eine C₃-C₆₀-carbocyclische Gruppe, unsubstituiert oder substituiert mit mindestens einem R₁₀ₐ, eine C₁-C₆₀-heterocyclische Gruppe, unsubstituiert oder substituiert mit mindestens einem R₁₀ₐ, eine C₆-C₆₀-Aryloxygruppe, unsubstituiert oder substituiert mit mindestens einem R₁₀ₐ, eine C₆-C₆₀-Arylthiogruppe, unsubstituiert oder substituiert mit mindestens einem R₁₀ₐ, -Si(Q₁)(Q₂)(Q₃), -N(Q₁)(Q₂), -B(Q₁)(Q₂), -C(=O)(Q₁), -S(=O)₂(Q₁) oder -P(=O)(Q₁)(Q₂), sind,
mindestens zwei Gruppen von R₁ in einer Anzahl von b1, R₂ in einer Anzahl von b2, R₃ in einer Anzahl von b3, R₄ in einer Anzahl von b4, R₅ und R₆ optional aneinander gebunden sind, um eine C₃-C₆₀-carbocyclische Gruppe, unsubstituiert oder substituiert mit mindestens einem R₁₀ₐ, oder eine C₁-C₆₀-heterocyclische Gruppe, unsubstituiert oder substituiert mit mindestens einem R₁₀ₐ, zu bilden,
mindestens einer von R₁₁, R₁ in einer Anzahl von b1, R₂ in einer Anzahl von b2, R₃ in einer Anzahl von b3 und R₄ in einer Anzahl von b4, eine durch Formel 1A dargestellte Gruppe ist,
b1 1 oder 2 ist,
b2 bis b4 jeweils unabhängig eine ganze Zahl von 1 bis 10 sind,
A₁ eine durch Formel 1B dargestellte Gruppe ist,
c1 eine ganze Zahl von 1 bis 5 ist,
Z₁ und Z₂ jeweils unabhängig Wasserstoff, Deuterium, -F, -Cl, -Br, -I, eine Hydroxylgruppe, eine Cyanogruppe, eine Nitrogruppe, eine C₁-C₆₀-Alkylgruppe, unsubstituiert oder substituiert mit mindestens einem R₁₀ₐ, eine C₂-C₆₀-Alkenylgruppe, unsubstituiert oder substituiert mit mindestens einem R₁₀ₐ, eine C₂-C₆₀-Alkinylgruppe, unsubstituiert oder substituiert mit mindestens einem R₁₀ₐ, eine C₁-C₆₀-Alkoxygruppe, unsubstituiert oder substituiert mit mindestens einem R₁₀ₐ, eine C₃-C₆₀-carbocyclische Gruppe, unsubstituiert oder substituiert mit mindestens einem R₁₀ₐ, eine C₁-C₆₀-heterocyclische Gruppe, unsubstituiert oder substituiert mit mindestens einem R₁₀ₐ, eine C₆-C₆₀-Aryloxygruppe, unsubstituiert oder substituiert mit mindestens einem R₁₀ₐ, eine C₆-C₆₀-Arylthiogruppe, unsubstituiert oder substituiert mit mindestens einem R₁₀ₐ, -Si(Q₁)(Q₂)(Q₃), -N(Q₁)(Q₂), -B(Q₁)(Q₂), -C(=O)(Q₁), -S(=O)₂(Q₁) oder -P(=O)(Q₁)(Q₂) sind,
k1 eine ganze Zahl von 0 bis 4 ist,
k2 eine ganze Zahl von 1 bis 7 ist,
*und*' jeweils eine Bindungsstelle zu einem benachbarten Atom bezeichnen, und
R₁₀ₐ ist:
Deuterium, -F, -Cl, -Br, -I, eine Hydroxylgruppe, eine Cyanogruppe oder eine Nitrogruppe;
eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils unsubstituiert oder substituiert mit Deuterium, - F, -Cl, -Br, -I, einer Hydroxylgruppe, einer Cyanogruppe, einer Nitrogruppe, einer C₃-C₆₀-carbocyclischen Gruppe, einer C₁-C₆₀-heterocyclischen Gruppe, einer C₆-C₆₀-Aryloxygruppe, einer C₆-C₆₀-Arylthiogruppe, -Si(Q₁₁)(Q₁₂)(Q₁₃), -N(Q₁₁)(Q₁₂), -B(Q₁₁)(Q₁₂), -C(=O)(Qn), -S(=O)₂(Q₁₁), -P(=O)(Q₁₁)(Q₁₂) oder einer Kombination davon;
eine C₃-C₆₀-carbocyclische Gruppe, eine C₁-C₆₀-heterocyclische Gruppe, eine C₆-C₆₀-Aryloxygruppe oder eine C₆-C₆₀-Arylthiogruppe, jeweils unsubstituiert oder substituiert mit Deuterium, -F, -Cl, -Br, -I, einer Hydroxylgruppe, einer Cyanogruppe, einer Nitrogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₆₀-carbocyclischen Gruppe, einer C₁-C₆₀-heterocyclischen Gruppe, einer C₆-C₆₀-Aryloxygruppe, einer C₆-C₆₀-Arylthiogruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂) oder einer Kombination davon; oder
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) oder -P(=O)(Q₃₁)(Q₃₂), und
wobei Q₁ bis Q₃, Qn bis Q₁₃, Q₂₁ bis Q₂₃ und Q₃₁ bis Q₃₃ jeweils unabhängig Wasserstoff; Deuterium; -F; -Cl; -Br; -I; eine Hydroxylgruppe; eine Cyanogruppe; eine Nitrogruppe; eine C₁-C₆₀-Alkylgruppe; eine C₂-C₆₀-Alkenylgruppe; eine C₂-C₆₀-Alkinylgruppe; eine C₁-C₆₀-Alkoxygruppe oder eine C₃-C₆₀-carbocyclische Gruppe oder eine C₁-C₆₀-heterocyclische Gruppe sind, jeweils unsubstituiert oder substituiert mit Deuterium, -F, einer Cyanogruppe, einer C₁-C₆₀-Alkylgruppe, einer C₁-C₆₀-Alkoxygruppe, einer Phenylgruppe, einer Biphenylgruppe oder einer Kombination davon.

2. Lichtemittierende Vorrichtung nach Anspruch 1, wobei die erste Elektrode eine Anode ist,
die zweite Elektrode eine Kathode ist,
die Zwischenschicht ferner eine Lochtransportregion zwischen der ersten Elektrode und der Emissionsschicht und eine Elektronentransportregion zwischen der Emissionsschicht und der zweiten Elektrode umfasst,
die Lochtransportregion eine Lochinjektionsschicht, eine Lochtransportschicht, eine Emissionshilfsschicht, eine Elektronensperrschicht oder eine Kombination davon umfasst, und
die Elektronentransportregion eine Pufferschicht, eine Lochsperrschicht, eine Elektronensteuerungsschicht, eine Elektronentransportschicht, eine Elektroneninjektionsschicht oder eine Kombination davon umfasst.

3. Lichtemittierende Vorrichtung nach Anspruch 1 oder Anspruch 2, wobei
die Emissionsschicht die durch Formel 1 dargestellte organometallische Verbindung umfasst.

4. Lichtemittierende Vorrichtung nach einem der Ansprüche 1 bis 3, wobei
die Emissionsschicht einen Wirt und ein Dotierungsmittel umfasst und
das Dotierungsmittel die durch Formel 1 dargestellte organometallische Verbindung umfasst.

5. Lichtemittierende Vorrichtung nach Anspruch 4, wobei
der Wirt einen lochtransportierenden Wirt und einen elektronentransportierenden Wirt umfasst.

6. Lichtemittierende Vorrichtung nach Anspruch 4, wobei
der Wirt einen elektronentransportierenden Wirt, dargestellt durch Formel 2, und einen lochtransportierenden Wirt, dargestellt durch Formel 3, umfasst: 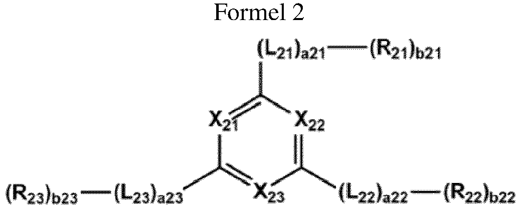 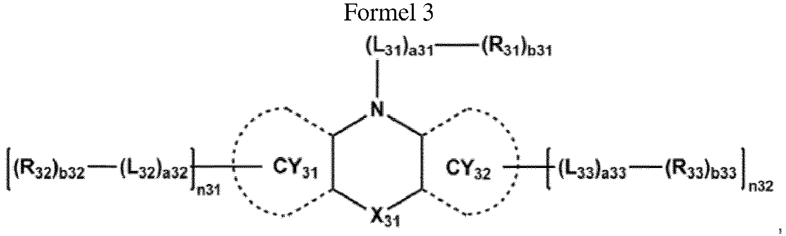 und
wobei in Formel 2 und Formel 3,
X₂₁ N oder C-(L₂₄)ₐ₂₄-(R₂₄)_{b24} ist, X₂₂ N oder C-(L₂₅)ₐ₂₅-(R₂₅)_{b25} ist und X₂₃ N oder C-(L₂₆)ₐ₂₆-(R₂₆)_{b26} ist,
X₃₁ ausgewählt ist aus einer Einfachbindung, O, S, N(R₃₄), C(R₃₄)(R₃₅) und Si(R₃₄)(R₃₅),
CY₃₁ und CY₃₂ jeweils unabhängig eine C₃-C₆₀-carbocyclische Gruppe oder eine C₁-C₆₀-heterocyclische Gruppe sind,
L₂₁ bis L₂₆ und L₃₁ bis L₃₃ jeweils unabhängig eine C₃-C₆₀-carbocyclische Gruppe, unsubstituiert oder substituiert mit mindestens einem R₁₀ₐ, oder eine C₁-C₆₀-heterocyclische Gruppe, unsubstituiert oder substituiert mit mindestens einem R₁₀ₐ sind,
a21 bis a26 und a31 bis a33 jeweils unabhängig eine ganze Zahl von 0 bis 5 sind,
R₂₁ bis R₂₆ und R₃₁ bis R₃₅ jeweils unabhängig Wasserstoff, Deuterium, -F, -Cl, - Br, -I, eine Hydroxylgruppe, eine Cyanogruppe, eine Nitrogruppe, eine C₁-C₆₀-Alkylgruppe, unsubstituiert oder substituiert mit mindestens einem R₁₀ₐ, eine C₂-C₆₀-Alkenylgruppe, unsubstituiert oder substituiert mit mindestens einem R₁₀ₐ, eine C₂-C₆₀-Alkinylgruppe, unsubstituiert oder substituiert mit mindestens einem R₁₀ₐ, eine C₁-C₆₀-Alkoxygruppe, unsubstituiert oder substituiert mit mindestens einem R₁₀ₐ, eine C₃-C₆₀-carbocyclische Gruppe, unsubstituiert oder substituiert mit mindestens einem R₁₀ₐ, eine C₁-C₆₀-heterocyclische Gruppe, unsubstituiert oder substituiert mit mindestens einem R₁₀ₐ, eine C₆-C₆₀-Aryloxygruppe, unsubstituiert oder substituiert mit mindestens einem R₁₀ₐ, eine C₆-C₆₀-Arylthiogruppe, unsubstituiert oder substituiert mit mindestens einem R₁₀ₐ, -Si(Q₁)(Q₂)(Q₃), -N(Q₁)(Q₂), -B(Q₁)(Q₂), -C(=O)(Q₁), -S(=O)₂(Q₁) oder - P(=O)(Q₁)(Q₂),
b21 bis b26, b31 bis b33, n31 und n32 jeweils unabhängig eine ganze Zahl von 1 bis 5 sind, und
R₁₀ₐ ist:
Deuterium, -F, -Cl, -Br, -I, eine Hydroxylgruppe, eine Cyanogruppe oder eine Nitrogruppe;
eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils unsubstituiert oder substituiert mit Deuterium, - F, -Cl, -Br, -I, einer Hydroxylgruppe, einer Cyanogruppe, einer Nitrogruppe, einer C₃-C₆₀-carbocyclischen Gruppe, einer C₁-C₆₀-heterocyclischen Gruppe, einer C₆-C₆₀-Aryloxygruppe, einer C₆-C₆₀-Arylthiogruppe, -Si(Q₁₁)(Q₁₂)(Q₁₃), -N(Q₁₁)(Q₁₂), -B(Q₁₁)(Q₁₂), -C(=O)(Qn), -S(=O)₂(Q₁₁), -P(=O)(Q₁₁)(Q₁₂) oder einer Kombination davon;
eine C₃-C₆₀-carbocyclische Gruppe, eine C₁-C₆₀-heterocyclische Gruppe, eine C₆-C₆₀-Aryloxygruppe oder eine C₆-C₆₀-Arylthiogruppe, jeweils unsubstituiert oder substituiert mit Deuterium, -F, -Cl, -Br, -I, einer Hydroxylgruppe, einer Cyanogruppe, einer Nitrogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₆₀-carbocyclischen Gruppe, einer C₁-C₆₀-heterocyclischen Gruppe, einer C₆-C₆₀-Aryloxygruppe, einer C₆-C₆₀-Arylthiogruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂) oder einer Kombination davon; oder
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) oder -P(=O)(Q₃₁)(Q₃₂), und
wobei Q₁ bis Q₃, Q₁₁ bis Q₁₃, Q₂₁ bis Q₂₃ und Q₃₁ bis Q₃₃ jeweils unabhängig Wasserstoff; Deuterium; -F; -Cl; -Br; -I; eine Hydroxylgruppe; eine Cyanogruppe; eine Nitrogruppe; eine C₁-C₆₀-Alkylgruppe; eine C₂-C₆₀-Alkenylgruppe; eine C₂-C₆₀-Alkinylgruppe; eine C₁-C₆₀-Alkoxygruppe oder eine C₃-C₆₀-carbocyclische Gruppe oder eine C₁-C₆₀-heterocyclische Gruppe, jeweils unsubstituiert oder substituiert mit Deuterium, -F, einer Cyanogruppe, einer C₁-C₆₀-Alkylgruppe, einer C₁-C₆₀-Alkoxygruppe, einer Phenylgruppe, einer Biphenylgruppe oder einer Kombination davon.

7. Lichtemittierende Vorrichtung nach einem der Ansprüche 1 bis 6, wobei
die lichtemittierende Vorrichtung ferner mindestens eine, ausgewählt aus einer ersten Deckschicht außerhalb der ersten Elektrode und einer zweiten Deckschicht außerhalb der zweiten Elektrode, umfasst und die mindestens eine, ausgewählt aus der ersten Deckschicht und der zweiten Deckschicht, einen Brechungsindex von etwa 1,6 oder höher bei einer Wellenlänge von 589 Nanometern (nm) aufweist.

8. Elektronisches Gerät, umfassend die lichtemittierende Vorrichtung nach einem der Ansprüche 1 bis 7, optional, wobei das elektronische Gerät ferner einen Farbfilter, eine Farbumwandlungsschicht, eine Touchscreen-Schicht, eine Polarisationsschicht oder eine Kombination davon umfasst.

9. Organometallische Verbindung, dargestellt durch Formel 1: 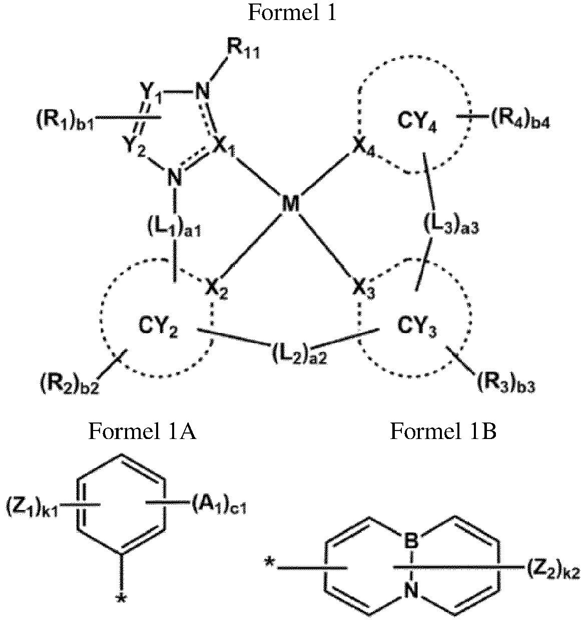 wobei in Formeln 1, 1A und 1B,
M Platin (Pt), Palladium (Pd), Nickel (Ni), Kupfer (Cu), Silber (Ag), Gold (Au), Rhodium (Rh), Iridium (Ir), Ruthenium (Ru), Osmium (Os), Titan (Ti), Zirkonium (Zr), Hafnium (Hf), Europium (Eu), Terbium (Tb) oder Thulium (Tm) ist,
X₁ C ist, und eine Bindung zwischen X₁ und M eine koordinative Bindung ist,
X₂ bis X₄, Y₁ und Y₂ jeweils unabhängig C oder N sind,
eine von einer Bindung zwischen X₂ und M, einer Bindung zwischen X₃ und M und einer Bindung zwischen X₄ und M eine koordinative Bindung ist und die anderen zwei Bindungen jeweils eine kovalente Bindung sind,
CY₂ bis CY₄ jeweils unabhängig eine C₃-C₆₀-carbocyclische Gruppe oder eine C₁-C₆₀-heterocyclische Gruppe sind,
L₁ bis L₃ jeweils unabhängig eine Einfachbindung, *-O-*', *-S-*', *-Se-*', *-S(=O)₂-^{∗}', *-C(R₅)(R₆)-*', ^{∗}-C(R₅)=^{∗}', *=C(R₅)-*', *-C(R₅)=C(R₆)-*', *-C(=O)-*', ^{∗}-C(=S)-^{∗}', *-C≡C-*', *-B(R₅)-*', *-N(R₅)-*', *-P(R₅)-*', ^{∗}-Si(R₅)(R₆)-^{∗}', ^{∗}-P(=O)(R₅)-^{∗}' oder ^{∗}-Ge(R₅)(R₆)-^{∗}' sind,
a1 bis a3 jeweils unabhängig eine ganze Zahl von 1 bis 3 sind,
R₁ bis R₆ und R₁₁ jeweils unabhängig eine durch Formel 1A dargestellte Gruppe, Wasserstoff, Deuterium, -F, -Cl, -Br, -I, eine Hydroxylgruppe, eine Cyanogruppe, eine Nitrogruppe, eine C₁-C₆₀-Alkylgruppe, unsubstituiert oder substituiert mit mindestens einem R₁₀ₐ, eine C₂-C₆₀-Alkenylgruppe, unsubstituiert oder substituiert mit mindestens einem R₁₀ₐ, eine C₂-C₆₀-Alkinylgruppe, unsubstituiert oder substituiert mit mindestens einem R₁₀ₐ, eine C₁-C₆₀-Alkoxygruppe, unsubstituiert oder substituiert mit mindestens einem R₁₀ₐ, eine C₃-C₆₀-carbocyclische Gruppe, unsubstituiert oder substituiert mit mindestens einem R₁₀ₐ, eine C₁-C₆₀-heterocyclische Gruppe, unsubstituiert oder substituiert mit mindestens einem R₁₀ₐ, eine C₆-C₆₀-Aryloxygruppe, unsubstituiert oder substituiert mit mindestens einem R₁₀ₐ, eine C₆-C₆₀-Arylthiogruppe, unsubstituiert oder substituiert mit mindestens einem R₁₀ₐ, -Si(Q₁)(Q₂)(Q₃), -N(Q₁)(Q₂), -B(Q₁)(Q₂), - C(=O)(Q₁), -S(=O)₂(Q₁) oder -P(=O)(Q₁)(Q₂) sind,
mindestens zwei Gruppen von R₁ in einer Anzahl von b1, R₂ in einer Anzahl von b2, R₃ in einer Anzahl von b3, R₄ in einer Anzahl von b4, R₅ und R₆ optional aneinander gebunden sind, um eine C₃-C₆₀-carbocyclische Gruppe, unsubstituiert oder substituiert mit mindestens einem R₁₀ₐ, oder eine C₁-C₆₀-heterocyclische Gruppe, unsubstituiert oder substituiert mit mindestens einem R₁₀ₐ, zu bilden,
mindestens einer von R₁₁, R₁ in einer Anzahl von b1, R₂ in einer Anzahl von b2, R₃ in einer Anzahl von b3 und R₄ in einer Anzahl von b4 eine durch Formel 1A dargestellte Gruppe ist,
b1 1 oder 2 ist,
b2 bis b4 jeweils unabhängig eine ganze Zahl von 1 bis 10 sind,
A₁ eine durch Formel 1B dargestellte Gruppe ist,
c1 eine ganze Zahl von 1 bis 5 ist,
Z₁ und Z₂ jeweils unabhängig Wasserstoff, Deuterium, -F, -Cl, -Br, -I, eine Hydroxylgruppe, eine Cyanogruppe, eine Nitrogruppe, eine C₁-C₆₀-Alkylgruppe, unsubstituiert oder substituiert mit mindestens einem R₁₀ₐ, eine C₂-C₆₀-Alkenylgruppe, unsubstituiert oder substituiert mit mindestens einem R₁₀ₐ, eine C₂-C₆₀-Alkinylgruppe, unsubstituiert oder substituiert mit mindestens einem R₁₀ₐ, eine C₁-C₆₀-Alkoxygruppe, unsubstituiert oder substituiert mit mindestens einem R₁₀ₐ, eine C₃-C₆₀-carbocyclische Gruppe, unsubstituiert oder substituiert mit mindestens einem R₁₀ₐ, eine C₁-C₆₀-heterocyclische Gruppe, unsubstituiert oder substituiert mit mindestens einem R₁₀ₐ, eine C₆-C₆₀-Aryloxygruppe, unsubstituiert oder substituiert mit mindestens einem R₁₀ₐ, eine C₆-C₆₀-Arylthiogruppe, unsubstituiert oder substituiert mit mindestens einem R₁₀ₐ, -Si(Q₁)(Q₂)(Q₃), -N(Q₁)(Q₂), -B(Q₁)(Q₂), -C(=O)(Q₁), -S(=O)₂(Q₁) oder -P(=O)(Q₁)(Q₂) sind,
k1 eine ganze Zahl von 0 bis 4 ist,
k2 eine ganze Zahl von 1 bis 7 ist,
*und*' jeweils eine Bindungsstelle zu einem benachbarten Atom bezeichnen, und
R₁₀ₐ ist:
Deuterium, -F, -Cl, -Br, -I, eine Hydroxylgruppe, eine Cyanogruppe oder eine Nitrogruppe;
eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils unsubstituiert oder substituiert mit Deuterium, - F, -Cl, -Br, -I, einer Hydroxylgruppe, einer Cyanogruppe, einer Nitrogruppe, einer C₃-C₆₀-carbocyclischen Gruppe, einer C₁-C₆₀-heterocyclischen Gruppe, einer C₆-C₆₀-Aryloxygruppe, einer C₆-C₆₀-Arylthiogruppe, -Si(Q₁₁)(Q₁₂)(Q₁₃), -N(Q₁₁)(Q₁₂), -B(Q₁₁)(Q₁₂), -C(=O)(Qn), -S(=O)₂(Q₁₁), -P(=O)(Q₁₁)(Q₁₂) oder einer Kombination davon;
eine C₃-C₆₀-carbocyclische Gruppe, eine C₁-C₆₀-heterocyclische Gruppe, eine C₆-C₆₀-Aryloxygruppe oder eine C₆-C₆₀-Arylthiogruppe, jeweils unsubstituiert oder substituiert mit Deuterium, -F, -Cl, -Br, -I, einer Hydroxylgruppe, einer Cyanogruppe einer Nitrogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₆₀-carbocyclischen Gruppe, einer C₁-C₆₀-heterocyclischen Gruppe, einer C₆-C₆₀-Aryloxygruppe, einer C₆-C₆₀-Arylthiogruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂) oder einer Kombination davon; oder
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) oder -P(=O)(Q₃₁)(Q₃₂), und
wobei Q₁ bis Q₃, Q₁₁ bis Q₁₃, Q₂₁ bis Q₂₃ und Q₃₁ bis Q₃₃ jeweils unabhängig Wasserstoff; Deuterium; -F; -Cl; -Br; -I; eine Hydroxylgruppe; eine Cyanogruppe; eine Nitrogruppe; eine C₁-C₆₀-Alkylgruppe; eine C₂-C₆₀-Alkenylgruppe; eine C₂-C₆₀-Alkinylgruppe; eine C₁-C₆₀-Alkoxygruppe oder eine C₃-C₆₀-carbocyclische Gruppe oder eine C₁-C₆₀-heterocyclische Gruppe sind, jeweils unsubstituiert oder substituiert mit Deuterium, -F, einer Cyanogruppe, einer C₁-C₆₀-Alkylgruppe, einer C₁-C₆₀-Alkoxygruppe, einer Phenylgruppe, einer Biphenylgruppe oder einer Kombination davon.

10. Organometallische Verbindung nach Anspruch 9, wobei
CY₂ eine Gruppe ist, die durch eine der Formeln CY2-1 bis CY2-9 dargestellt wird,
CY₃ eine Gruppe ist, die durch eine der Formeln CY3-1 bis CY3-10 dargestellt wird, und/oder
CY₄ eine Gruppe ist, die durch eine der Formeln CY4-1 bis CY4-9 dargestellt wird. 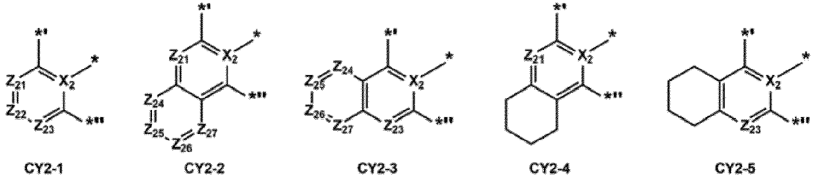 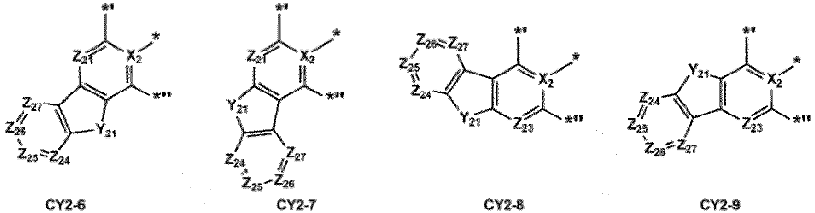 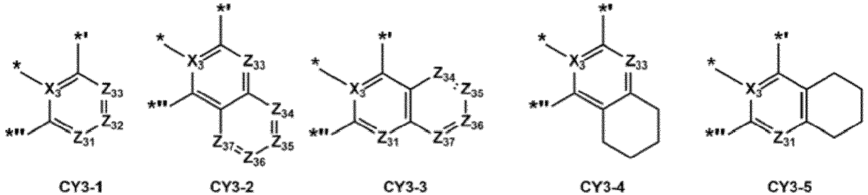 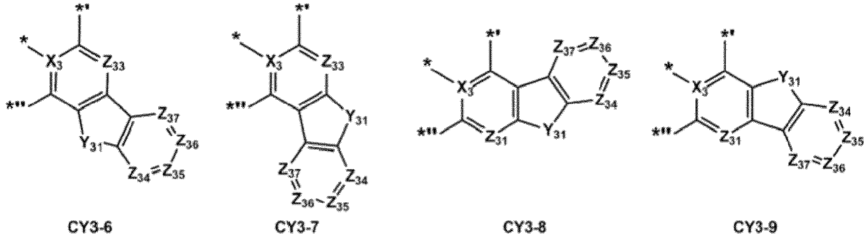 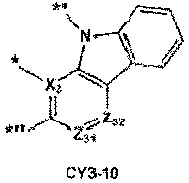 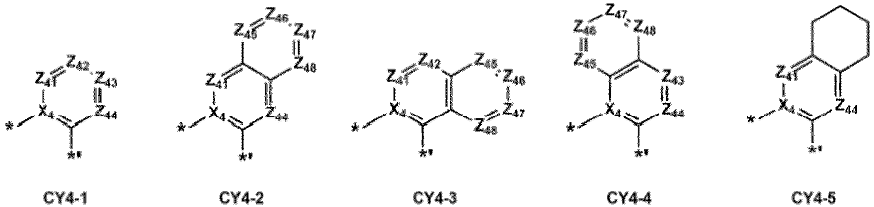 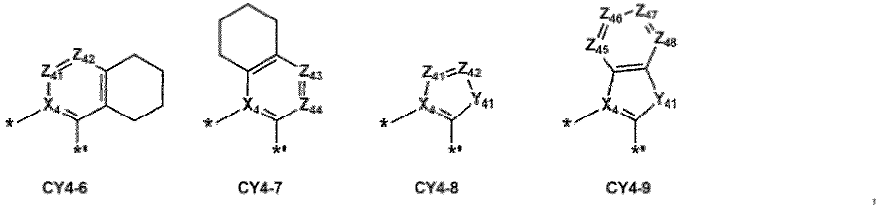 und wobei in Formeln CY2-1 bis CY2-9, CY3-1 bis CY3-10 und CY4-1 bis CY4-9,
Z₂₁ bis Z₂₇, Z₃₁ bis Z₃₇ und Z₄₁ bis Z₄₈ jeweils unabhängig C oder N sind,
Y₂₁, Y₃₁ und Y₄₁ jeweils unabhängig N, O, S, C oder Si sind,
X₂ bis X₄ jeweils unter Bezugnahme auf die Beschreibungen von X₂ bis X₄ in Formel 1 zu verstehen sind,
* eine Bindungsstelle zu M bezeichnet, und
*'und*" jeweils eine Bindungsstelle zu einem benachbarten Atom bezeichnen.

11. Organometallische Verbindung nach Anspruch 9 oder Anspruch 10, wobei:
(i) L₁ eine Einfachbindung ist, L₂ *-O-*' oder *-S-*' ist, und L₃ ^{∗}-N(R₅)-^{∗}' ist; und/oder
(ii) die durch Formel 1A dargestellte Gruppe durch eine der Formeln 1A-1 bis 1A-14 dargestellt wird: 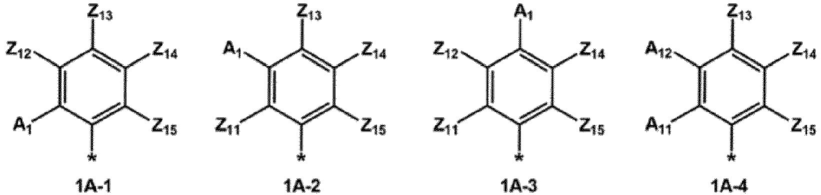 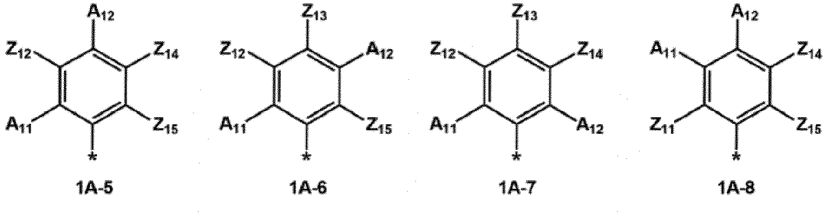 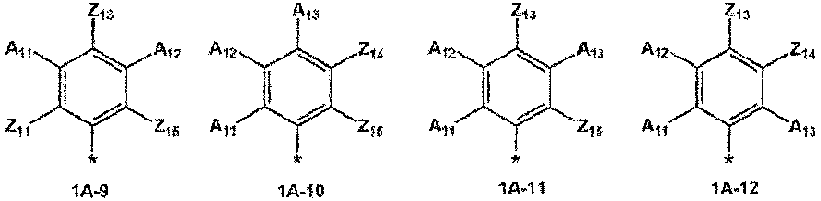 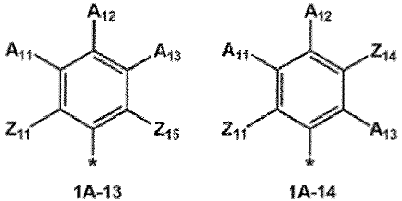 und wobei in den Formeln 1A-1 bis 1A-14,
Z₁₁ bis Z₁₅ jeweils unabhängig durch Bezugnahme auf die Beschreibung von Z₁ in Formel 1A zu verstehen sind,
An bis A₁₃ jeweils unabhängig unter Bezugnahme auf die Beschreibung von A₁ in Formel 1A zu verstehen sind,
A₁ unter Bezugnahme auf die Beschreibung von A₁ in Formel 1A zu verstehen ist, und
* eine Bindungsstelle zu einem benachbarten Atom bezeichnet.

12. Organometallische Verbindung nach einem der Ansprüche 9 bis 11, wobei die durch Formel 1A dargestellte Gruppe durch Formel 1A-7-1 dargestellt wird: 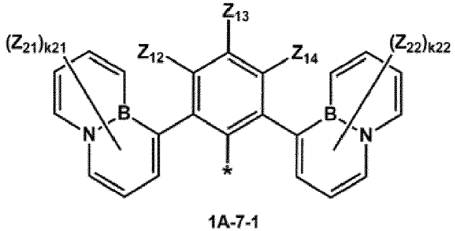 und
wobei in Formel 1A-7-1,
Z₁₂ bis Z₁₄ jeweils unabhängig unter Bezugnahme auf die Beschreibung von Z₁ in Formel 1A zu verstehen sind,
Z₂₁ und Z₂₂ jeweils unabhängig unter Bezugnahme auf die Beschreibung von Z₂ in Formel 1B zu verstehen sind,
k21 und k22 jeweils unabhängig eine ganze Zahl von 1 bis 7 sind, und
* eine Bindungsstelle zu einem benachbarten Atom bezeichnet.

13. Organometallische Verbindung nach einem der Ansprüche 9 bis 12, wobei:
(i) mindestens einer von R₁ in einer Anzahl von b1, R₂ in einer Anzahl von b2, R₃ in einer Anzahl von b3, R₄ in einer Anzahl von b4, R₅, R₆ und R₁₁ Deuterium, - CH₂D, -CHD₂, -CD₃, eine mit mindestens einem Deuterium substituierte Phenylgruppe oder eine durch eine der Formeln 10-2 bis 10-7 dargestellte Gruppe ist: 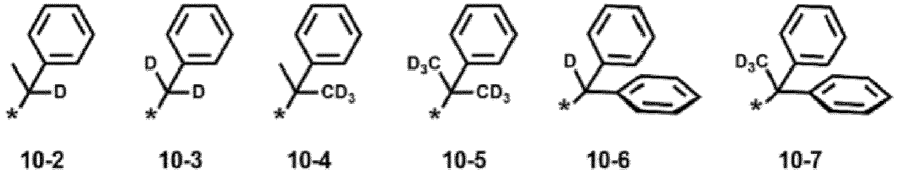 und
wobei in Formeln 10-2 bis 10-7,
"D" Deuterium darstellt, und
* eine Bindungsstelle zu einem benachbarten Atom bezeichnet; und/oder
(ii) eine Einheit, dargestellt durch 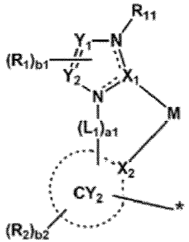 in Formel 1, eine Gruppe ist, die durch die Formel L1-1 oder L1-2 dargestellt wird: 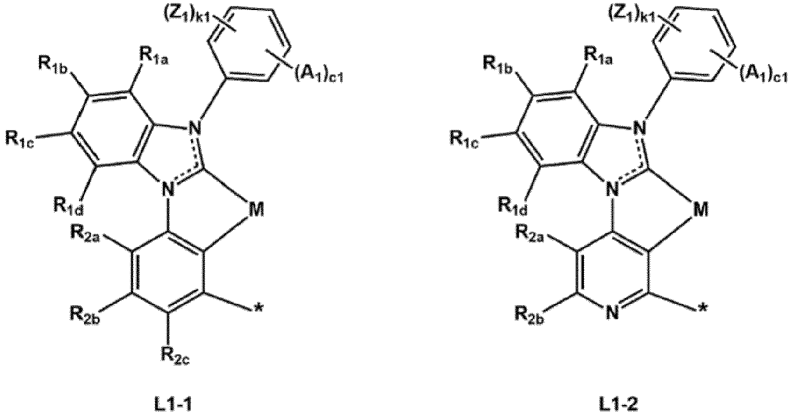 und
wobei in Formeln L1-1 und L1-2,
R₁ₐ bis R_{1d} jeweils unabhängig unter Bezugnahme auf die Beschreibung von R₁ in Formel 1 zu verstehen sind,
R₂ₐ bis R_{2c} jeweils unabhängig unter Bezugnahme auf die Beschreibung von R₂ in Formel 1 zu verstehen sind,
M, A₁, c1, Z₁ und k1 jeweils unter Bezugnahme auf die Beschreibungen von M, A₁, c1, Z₁ und k1 in Formel 1 und 1A zu verstehen sind, und
* eine Bindungsstelle zu L₂ bezeichnet; und/oder
(iii) eine Einheit, dargestellt durch 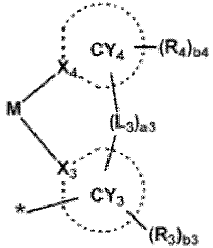 in Formel 1, eine Gruppe ist, die durch die Formel L2-1 oder die Formel L2-2 dargestellt wird: 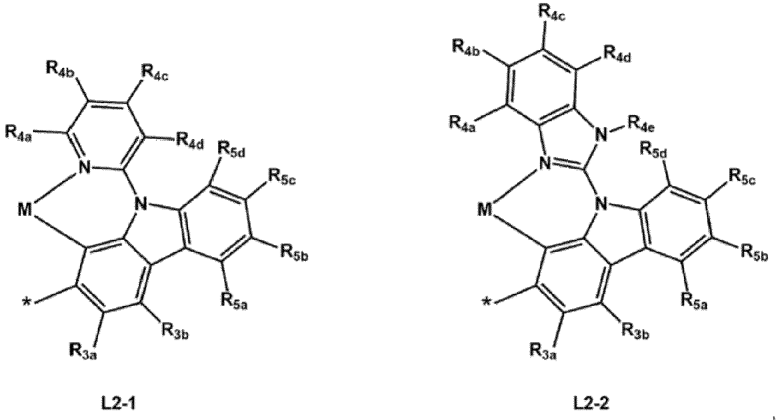 und
wobei in Formeln L2-1 und L2-2,
R₃ₐ und R_{3b} jeweils unabhängig unter Bezugnahme auf die Beschreibung von R₃ in Formel 1 zu verstehen sind,
R₄ₐ bis R₄ₑ jeweils unabhängig unter Bezugnahme auf die Beschreibung von R₄ in Formel 1 zu verstehen sind,
R₅ₐ bis R_{5d} jeweils unabhängig unter Bezugnahme auf die Beschreibung von R₁₀ₐ in Formel 1 zu verstehen sind,
unter M die Beschreibung von M in Formel 1 zu verstehen ist, und
* eine Bindungsstelle zu L₂ anzeigt.

14. Organometallische Verbindung nach einem der Ansprüche 9 bis 13, wobei die organometallische Verbindung durch eine, ausgewählt aus den Formeln 1-1 bis 1-4, dargestellt wird: 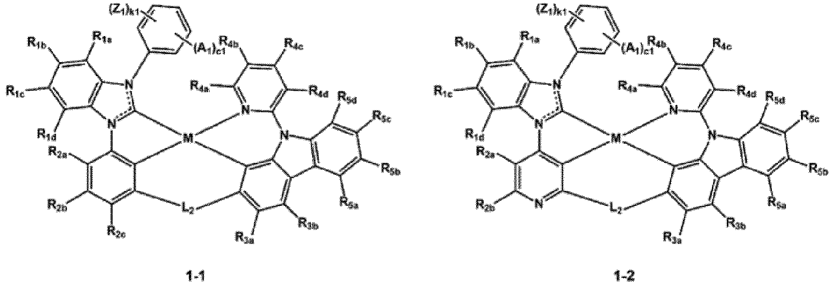 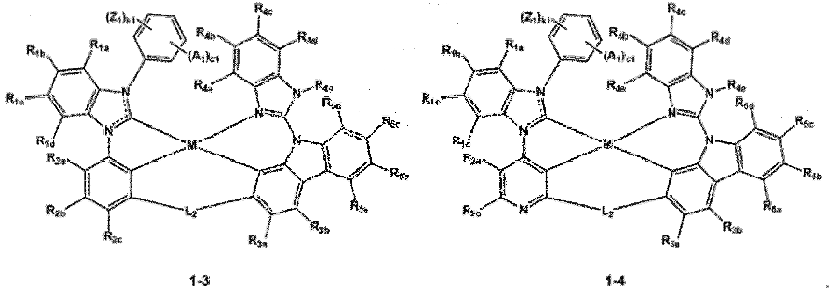 wobei in den Formeln 1-1 bis 1-4,
M, L₂, A₁, c1, Z₁ und k1 jeweils unter Bezugnahme auf die Beschreibungen von M, L₂, A₁, c1, Z₁ und k1 in Formeln 1 und 1A zu verstehen sind,
R₁ₐ bis R_{1d}, R₂ₐ bis R_{2c}, R₃ₐ, R_{3b}, R₄ₐ bis R₄ₑ und R₅ₐ bis R_{5d} jeweils unabhängig Wasserstoff, Deuterium, -F, -Cl, -Br, -I, -CH₂D, -CHD₂, -CD₃, -CH₂F, -CHF₂, -CF₃, eine Hydroxylgruppe, eine Cyanogruppe, eine Nitrogruppe, eine Methylgruppe, eine Ethylgruppe, eine Propylgruppe, eine Isopropylgruppe, eine n-Butylgruppe, eine Isobutylgruppe, eine sec-Butylgruppe, eine tert-Butylgruppe, eine n-Pentylgruppe, eine tert-Pentylgruppe, eine neo-Pentylgruppe, eine iso-Pentylgruppe, eine sec-Pentylgruppe, eine 3-Pentylgruppe, eine sec-Isopentylgruppe, eine n-Hexylgruppe, eine iso-Hexylgruppe, eine sec-Hexylgruppe, eine tert-Hexylgruppe oder eine Gruppe sind, die durch eine dargestellt wird, ausgewählt aus der Gruppe, bestehend aus Formeln 9-1 bis 9-31 und 10-1 bis 10-7: 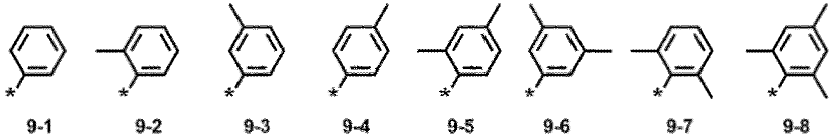 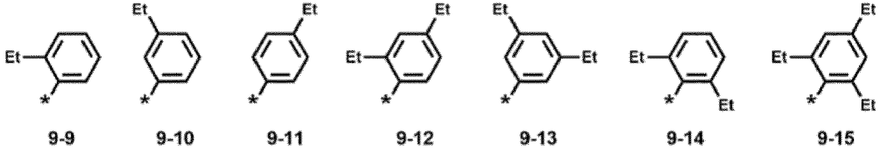 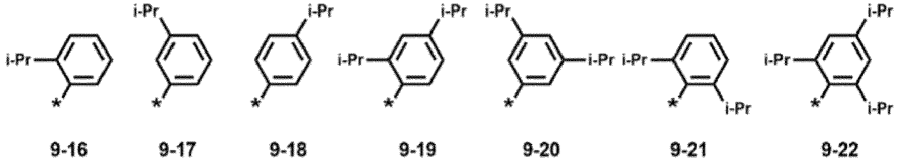 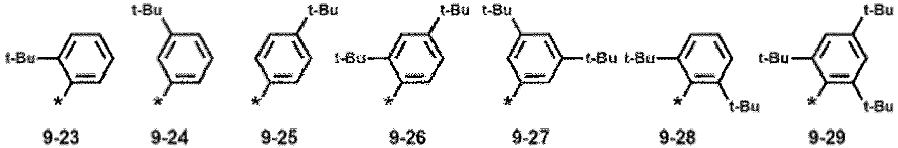 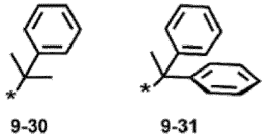 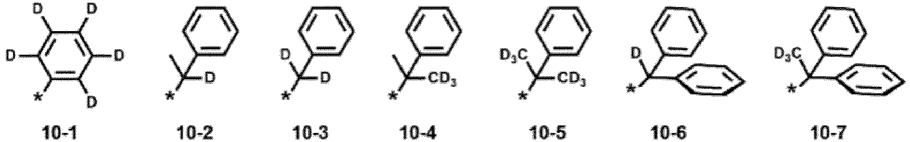 und
wobei in den Formeln 9-1 bis 9-31 und 10-1 bis 10-7
"Et" eine Ethylgruppe darstellt,
"i-Pr" eine iso-Propylgruppe darstellt,
"t-Bu" eine tert.-Butylgruppe darstellt,
"D" Deuterium darstellt, und
* eine Bindungsstelle zu einem benachbarten Atom bezeichnet, optional, wobei in den Formeln 1-1 bis 1-4 mindestens einer von R₁ₐ bis R_{1d}, R₂ₐ bis R_{2c}, R₃ₐ, R_{3b}, R₄ₐ bis R₄ₑ und R₅ₐ bis R_{5d} Deuterium, -CH₂D, -CHD₂, -CD₃ oder eine durch eine der Formeln 10-1 bis 10-7 dargestellte Gruppe ist: 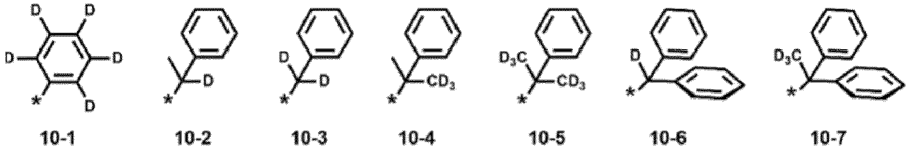 und
wobei in Formeln 10-1 bis 10-7,
"D" Deuterium darstellt, und
* eine Bindungsstelle zu einem benachbarten Atom bezeichnet.

15. Organometallische Verbindung nach Anspruch 9, wobei die organometallische Verbindung durch eine der Verbindungen BD01 bis BD210 dargestellt wird: 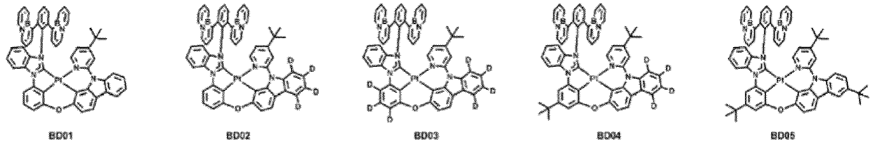 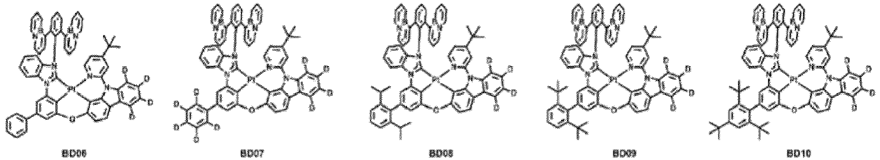 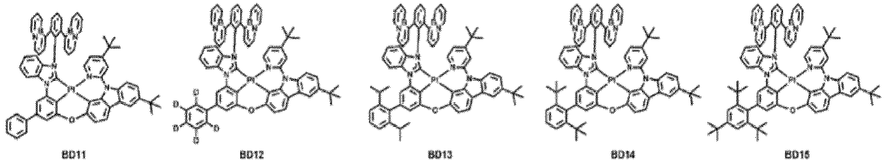 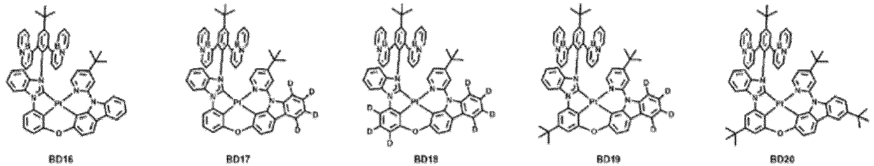 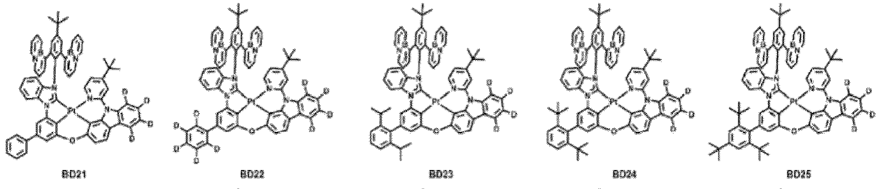 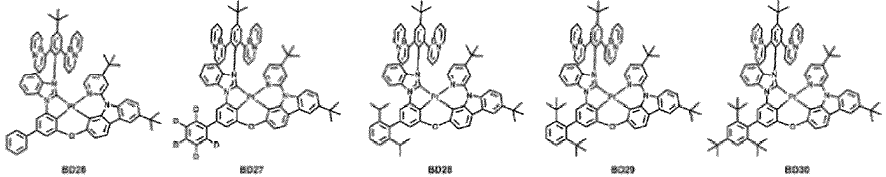 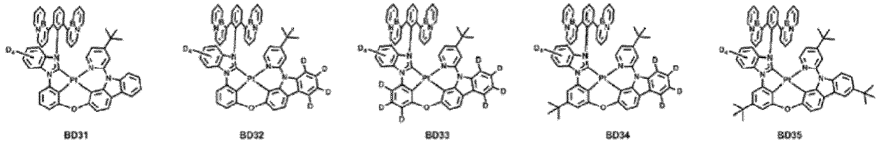 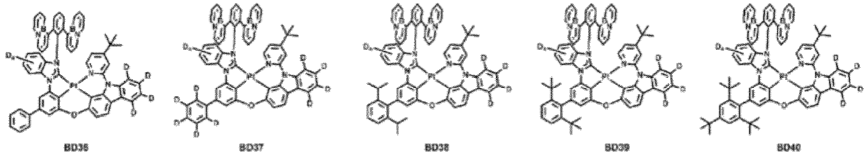 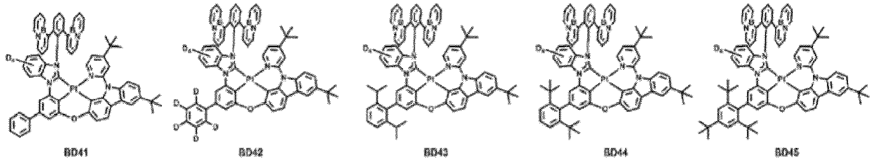 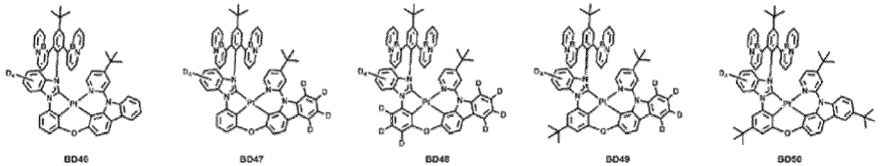 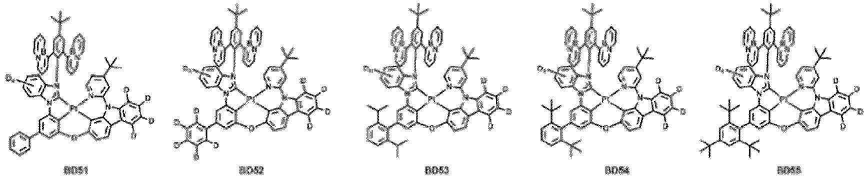 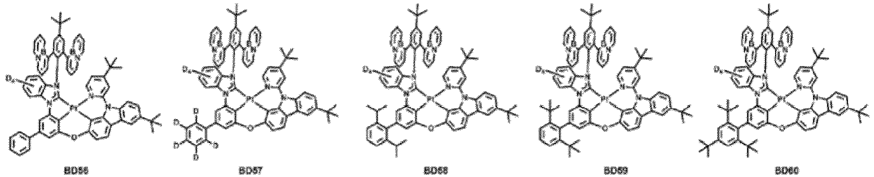 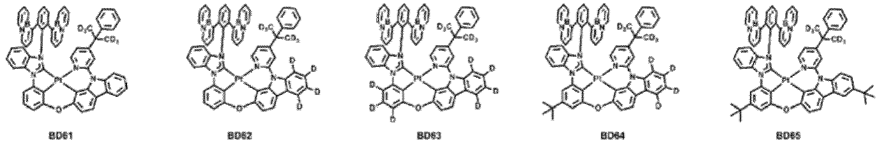 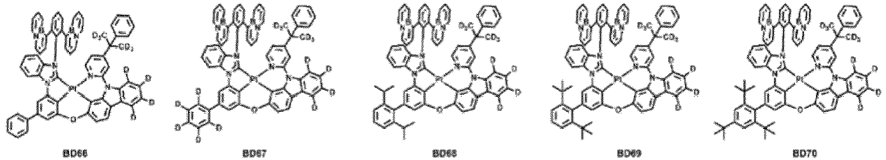 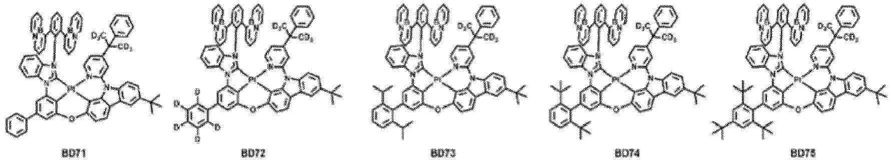 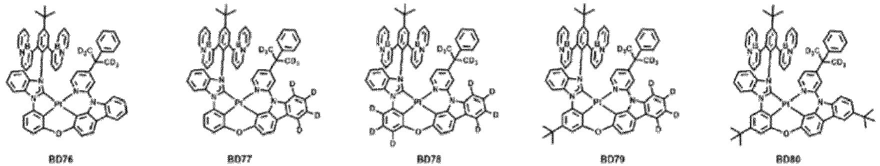 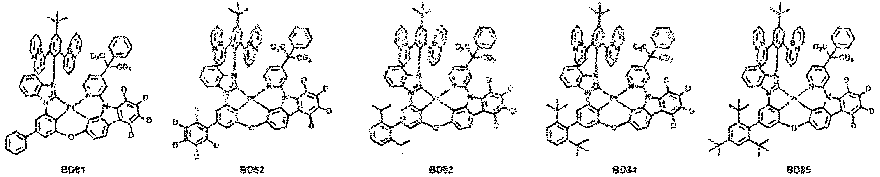 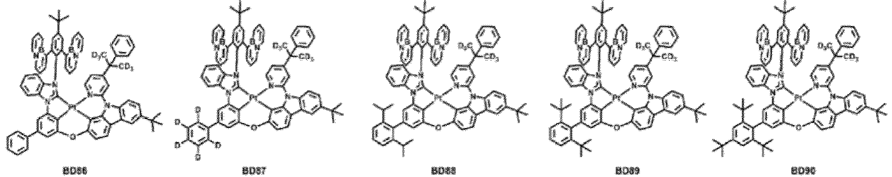 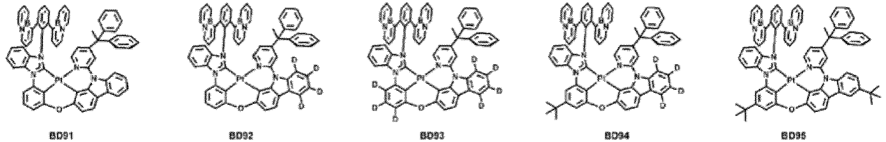 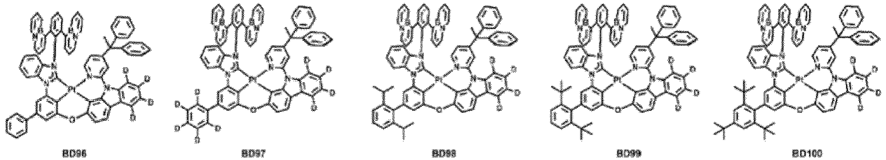 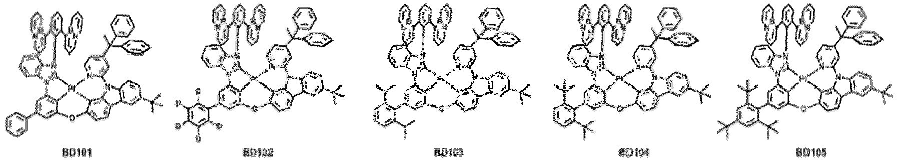 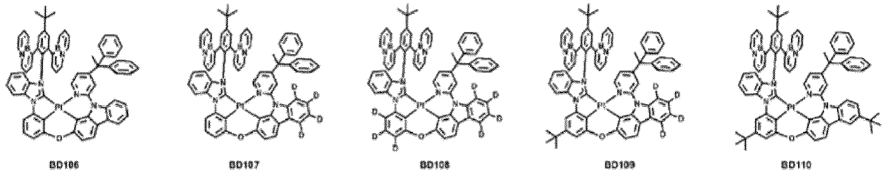 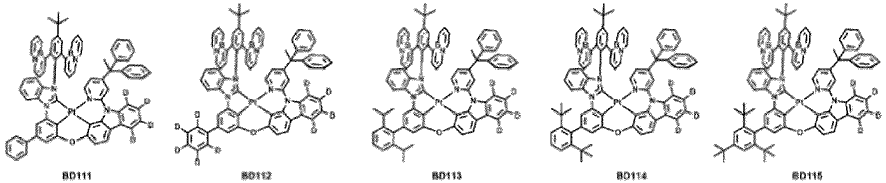 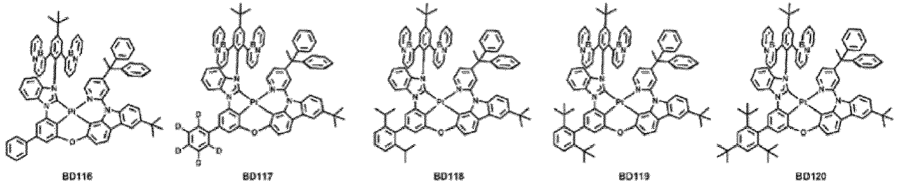 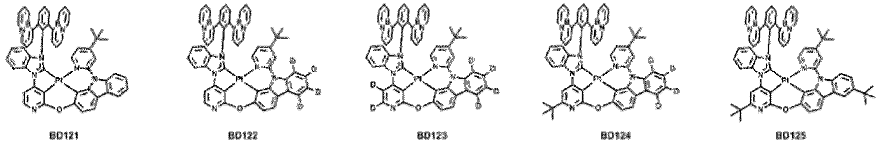 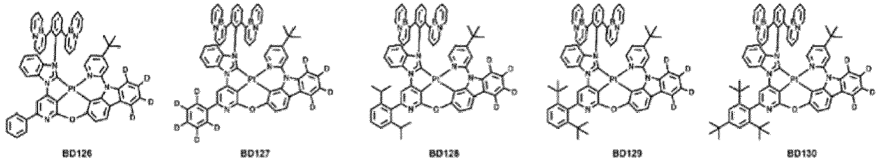 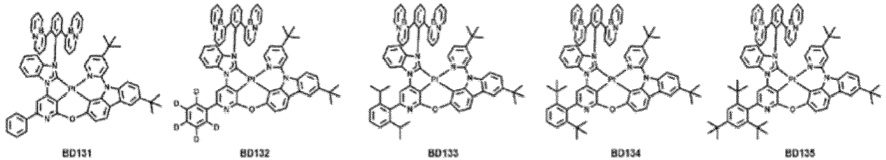 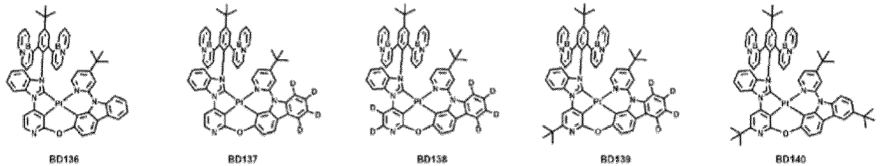 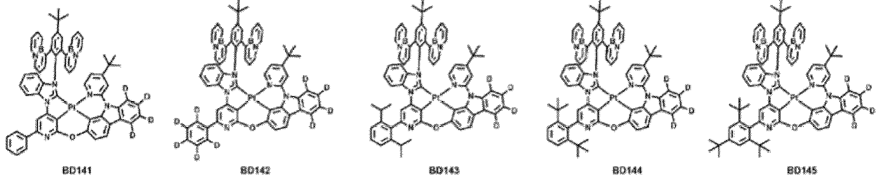 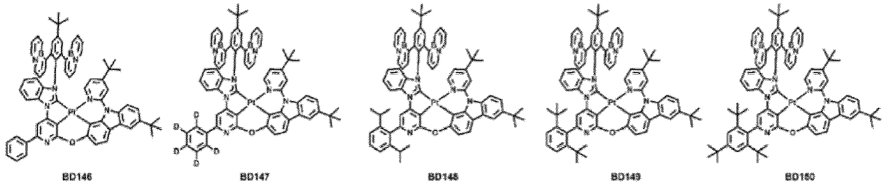 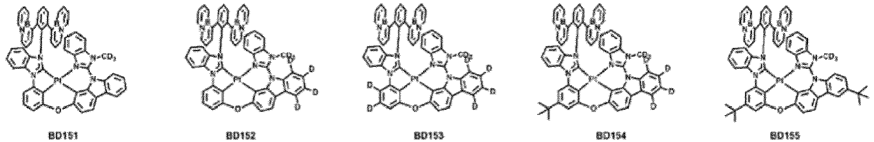 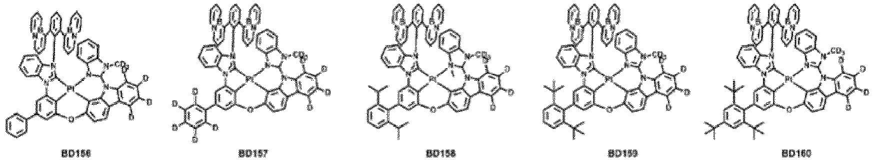 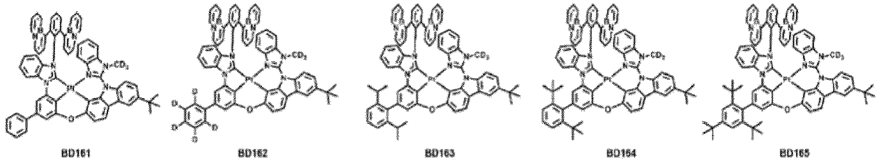 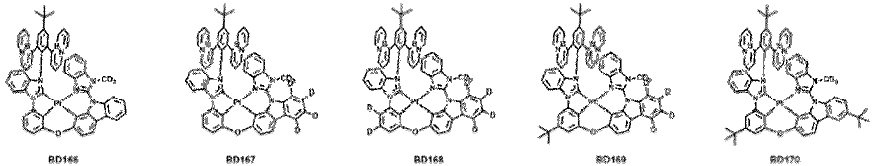 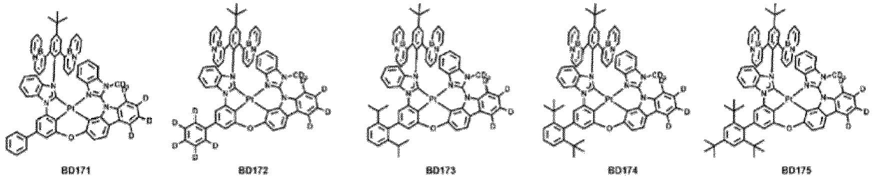 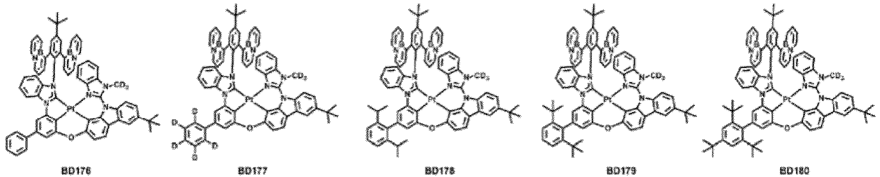 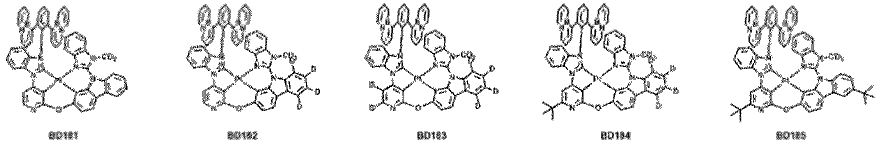 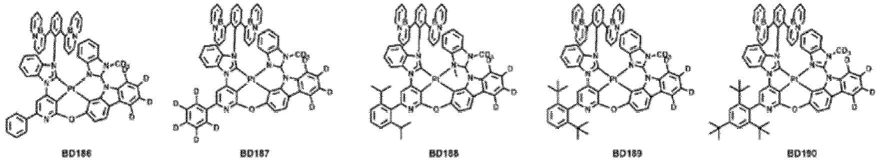 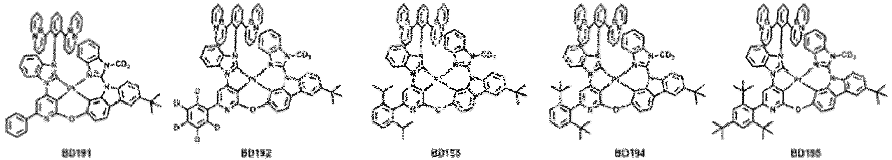 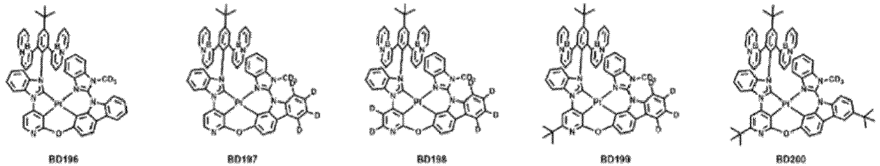 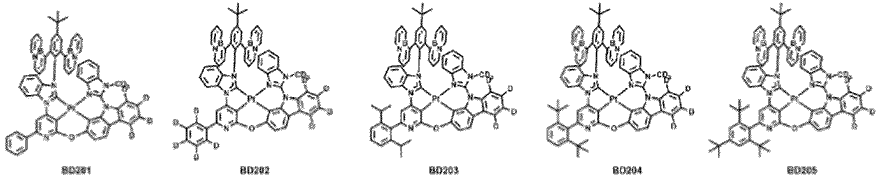 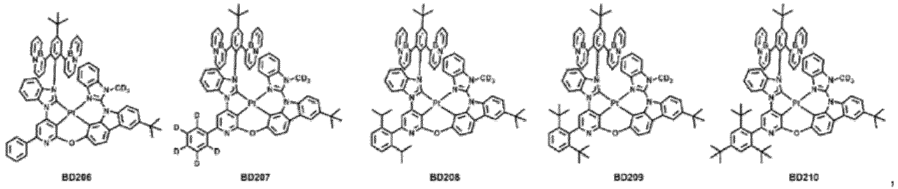 und wobei in den Verbindungen BD01 bis BD210 D₄ eine Substitution mit vier Deuterium (D) bezeichnet.

## Revendications

1. Dispositif électroluminescent comprenant:
une première électrode;
une deuxième électrode faisant face à la première électrode; et
une couche intermédiaire entre la première électrode et la deuxième électrode, la couche intermédiaire comprenant une couche d'émission,
où le dispositif électroluminescent comprend un composé organométallique représenté par la Formule 1: 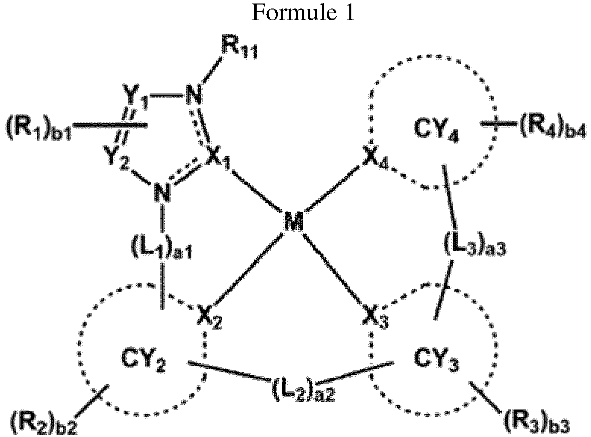 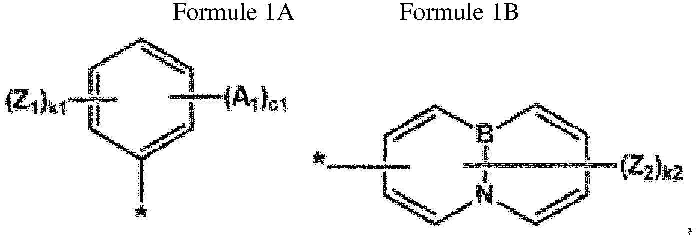 dans lequel, dans les Formules 1, 1A et 1B,
M est: platine (Pt), palladium (Pd), cuivre (Cu), nickel (Ni), argent (Ag), or (Au), rhodium (Rh), iridium (Ir), ruthénium (Ru), osmium (Os), titane (Ti), zirconium (Zr), hafnium (Hf), europium (Eu), terbium (Tb) ou thulium (Tm),
X₁ est C, et une liaison entre X₁ et M est une liaison de coordination,
X₂ à X₄, Y₁ et Y₂ sont chacun indépendamment C ou N,
une parmi une liaison entre X₂ et M, une liaison entre X₃ et M et une liaison entre X₄ et M est une liaison de coordination et les deux autres liaisons sont chacune une liaison covalente,
CY₂ à CY₄ sont chacun indépendamment un groupe C₃-C₆₀ carbocyclique ou un groupe C₁-C₆₀ hétérocyclique,
L₁ à L₃ sont chacun indépendamment une liaison simple, *-O-*', ^{∗}-S-^{∗}', *-Se-*', ^{∗}-S(=O)₂-^{∗}', ^{∗}-C(R₅)(R₆)-^{∗}', ^{∗}-C(R₅)=^{∗}', ^{∗}=C(R₅)-^{∗}', *-C(R₅)=C(R₆)-*', ^{∗}-C(=O)-^{∗}', ^{∗}-C(=S)-^{∗}', ^{∗}-C=C-^{∗}', ^{∗}-B(R₅)-^{∗}', ^{∗}-N(R₅)-^{∗}', ^{∗}-P(R₅)-^{∗}', ^{∗}-Si(R₅)(R₆)-^{∗}', ^{∗}-P(=O)(R₅)-^{∗}' ou ^{∗}-Ge(R₅)(R₆)-^{∗}',
a1 à a3 sont chacun indépendamment un nombre entier de 1 à 3,
R₁ à R₆ et R₁₁ sont chacun indépendamment: un groupe représenté par la Formule 1A, hydrogène, deutérium, -F, -Cl, -Br, -I, un groupe hydroxyle, un groupe cyano, un groupe nitro, un groupe C₁-C₆₀ alkyle non substitué ou substitué avec au moins un R₁₀ₐ, un groupe C₂-C₆₀ alcényle non substitué ou substitué avec au moins un R₁₀ₐ, un groupe C₂-C₆₀ alcynyle non substitué ou substitué avec au moins un R₁₀ₐ, un groupe C₁-C₆₀ alcoxy non substitué ou substitué avec au moins un R₁₀ₐ, un groupe C₃-C₆₀ carbocyclique non substitué ou substitué avec au moins un R₁₀ₐ, un groupe C₁-C₆₀ hétérocyclique non substitué ou substitué avec au moins un R₁₀ₐ, un groupe C₆-C₆₀ aryloxy non substitué ou substitué avec au moins un R₁₀ₐ, un groupe C₆-C₆₀ arylthio non substitué ou substitué avec au moins un R₁₀ₐ, -Si(Q₁)(Q₂)(Q₃), -N(Q₁)(Q₂), -B(Q₁)(Q₂), -C(=O)(Q₁), - S(=O)₂(Q₁) ou -P(=O)(Q₁)(Q₂),
au moins deux groupes parmi R₁ au nombre de b1, R₂ au nombre de b2, R₃ au nombre de b3, R₄ au nombre de b4, R₅ et R₆ sont optionnellement liés l'un à l'autre pour former un groupe C₃-C₆₀ carbocyclique non substitué ou substitué avec au moins un R₁₀ₐ ou un groupe C₁-C₆₀ hétérocyclique non substitué ou substitué avec au moins un R₁₀ₐ,
au moins un parmi R₁₁, R₁ au nombre de b1, R₂ au nombre de b2, R₃ au nombre de b3 et R₄ au nombre de b4 est un groupe représenté par la Formule 1A,
b1 est 1 ou 2,
b2 à b4 sont chacun indépendamment un nombre entier de 1 à 10,
A₁ est un groupe représenté par la Formule 1B,
c1 est un nombrer entier de 1 à 5,
Z₁ et Z₂ sont chacun indépendamment: hydrogène, deutérium, -F, -Cl, -Br, -I, un groupe hydroxyle, un groupe cyano, un groupe nitro, un groupe C₁-C₆₀ alkyle non substitué ou substitué avec au moins un R₁₀ₐ, un groupe C₂-C₆₀ alcényle non substitué ou substitué avec au moins un R₁₀ₐ, un groupe C₂-C₆₀ alcynyle non substitué ou substitué avec au moins un R₁₀ₐ, un groupe C₁-C₆₀ alcoxy non substitué ou substitué avec au moins un R₁₀ₐ, un groupe C₃-C₆₀ carbocyclique non substitué ou substitué avec au moins un R₁₀ₐ, un groupe C₁-C₆₀ hétérocyclique non substitué ou substitué avec au moins un R₁₀ₐ, un groupe C₆-C₆₀ aryloxy non substitué ou substitué avec au moins un R₁₀ₐ, un groupe C₆-C₆₀ arylthio non substitué ou substitué avec au moins un R₁₀ₐ, -Si(Q₁)(Q₂)(Q₃), - N(Q₁)(Q₂), -B(Q₁)(Q₂), -C(=O)(Q₁), -S(=O)₂(Q₁) ou -P(=O)(Q₁)(Q₂),
k1 est un nombre entier de 0 à 4,
k2 est un nombre entier de 1 à 7,
* et *' indiquent chacun un site de liaison à un atome adjacent, et
R₁₀ₐ est:
deutérium, -F, -Cl, -Br, -I, un groupe hydroxyle, un groupe cyano ou un groupe nitro;
un groupe C₁-C₆₀ alkyle, un groupe C₂-C₆₀ alcényle, un groupe C₂-C₆₀ alcynyle ou un groupe C₁-C₆₀ alcoxy, chacun étant non substitué ou substitué avec un deutérium, -F, - Cl, -Br, -I, un groupe hydroxyle, un groupe cyano, un groupe nitro, un groupe C₃-C₆₀ carbocyclique, un groupe C₁-C₆₀ hétérocyclique, un groupe C₆-C₆₀ aryloxy, un groupe C₆-C₆₀ arylthio, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), ou toute combinaison de ceux-ci;
un groupe C₃-C₆₀ carbocyclique, un groupe C₁-C₆₀ hétérocyclique, un groupe C₆-C₆₀ aryloxy ou un groupe C₆-C₆₀ arylthio, chacun étant non substitué ou substitué avec un deutérium, -F, -Cl, -Br, -I, un groupe hydroxyle, un groupe cyano, un groupe nitro, un groupe C₁-C₆₀ alkyle, un groupe C₂-C₆₀ alcényle, un groupe C₂-C₆₀ alcynyle, un groupe C₁-C₆₀ alcoxy, un groupe C₃-C₆₀ carbocyclique, un groupe C₁-C₆₀ hétérocyclique, un groupe C₆-C₆₀ aryloxy, un groupe C₆-C₆₀ arylthio, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), ou toute combinaison de ceux-ci; ou
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) ou - P(=O)(Q₃₁)(Q₃₂), et
dans lequel Q₁ à Q₃, Q₁₁ à Q₁₃, Q₂₁ à Q₂₃ et Q₃₁ à Q₃₃ sont chacun indépendamment: hydrogène; deutérium; -F; -Cl; -Br; -I; un groupe hydroxyle; un groupe cyano; un groupe nitro; un groupe C₁-C₆₀ alkyle; un groupe C₂-C₆₀ alcényle; un groupe C₂-C₆₀ alcynyle; un groupe C₁-C₆₀ alcoxy; ou un groupe C₃-C₆₀ carbocyclique ou un groupe C₁-C₆₀ hétérocyclique, chacun étant non substitué ou substitué avec un deutérium, -F, un groupe cyano, un groupe C₁-C₆₀ alkyle, un groupe C₁-C₆₀ alcoxy, un groupe phényle, un groupe biphényle, ou toute combinaison de ceux-ci.

2. Dispositif électroluminescent selon la revendication 1, dans lequel la première électrode est une anode,
la deuxième électrode est une cathode,
la couche intermédiaire comprend en outre une région de transport de trous entre la première électrode et la couche d'émission et une région de transport d'électrons entre la couche d'émission et la deuxième électrode,
la région de transport de trous comprend une couche d'injection de trous, une couche de transport de trous, une couche auxiliaire d'émission, une couche de blocage d'électrons, ou toute combinaison de celles-ci, et
la région de transport d'électrons comprend une couche tampon, une couche de blocage de trous, une couche de contrôle d'électrons, une couche de transport d'électrons, une couche d'injection d'électrons, ou une combinaison de celles-ci.

3. Dispositif électroluminescent selon la revendication 1 ou la revendication 2, dans lequel:
la couche d'émission comprend le composé organométallique représenté par la Formule 1.

4. Dispositif électroluminescent selon l'une quelconque des revendications 1 à 3, dans lequel:
la couche d'émission comprend un hôte et un dopant, et
le dopant comprend le composé organométallique représenté par la Formule 1.

5. Dispositif électroluminescent selon la revendication 4, dans lequel:
l'hôte comprend un hôte transportant des trous et un hôte transportant des électrons.

6. Dispositif électroluminescent selon la revendication 4, dans lequel:
l'hôte comprend un hôte transportant des électrons représenté par la Formule 2 et un hôte transportant des trous représenté par la Formule 3: 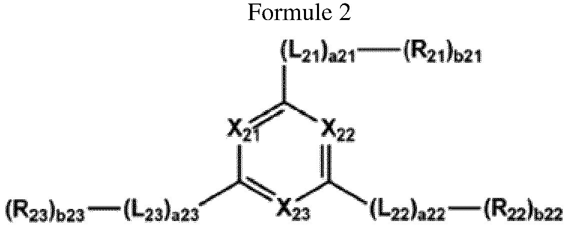 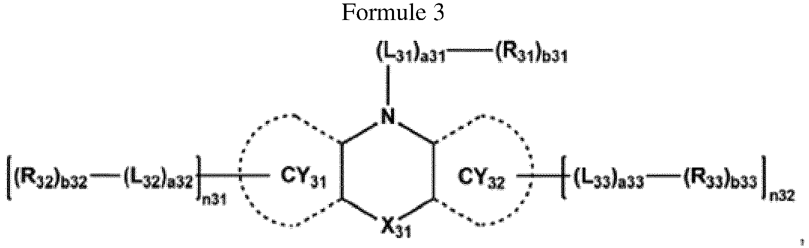 et
dans lequel, dans la Formule 2 et la Formule 3,
X₂₁ est N ou C-(L₂₄)ₐ₂₄-(R₂₄)_{b24}, X₂₂ est N ou C-(L₂₅)ₐ₂₅-(R₂₅)_{b25} et X₂₃ est N ou C-(L₂₆)ₐ₂₆-(R₂₆)_{b26},
X₃₁ est choisi parmi une liaison simple, O, S, N(R₃₄), C(R₃₄)(R₃₅) et Si(R₃₄)(R₃₅),
CY₃₁ et CY₃₂ sont chacun indépendamment un groupe C₃-C₆₀ carbocyclique ou un groupe C₁-C₆₀ hétérocyclique,
L₂₁ à L₂₆ et L₃₁ à L₃₃ sont chacun indépendamment un groupe C₃-C₆₀ carbocyclique non substitué ou substitué avec au moins un R₁₀ₐ ou un groupe C₁-C₆₀ hétérocyclique non substitué ou substitué avec au moins un R₁₀ₐ,
a21 à a26 et a31 à a33 sont chacun indépendamment un nombre entier de 0 à 5,
R₂₁ à R₂₆ et R₃₁ à R₃₅ sont chacun indépendamment: hydrogène, deutérium, -F, - Cl, -Br, -I, un groupe hydroxyle, un groupe cyano, un groupe nitro, un groupe C₁-C₆₀ alkyle non substitué ou substitué avec au moins un R₁₀ₐ, un groupe C₂-C₆₀ alcényle non substitué ou substitué avec au moins un R₁₀ₐ, un groupe C₂-C₆₀ alcynyle non substitué ou substitué avec au moins un R₁₀ₐ, un groupe C₁-C₆₀ alcoxy non substitué ou substitué avec au moins un R₁₀ₐ, un groupe C₃-C₆₀ carbocyclique non substitué ou substitué avec au moins un R₁₀ₐ, un groupe C₁-C₆₀ hétérocyclique non substitué ou substitué avec au moins un R₁₀ₐ, un groupe C₆-C₆₀ aryloxy non substitué ou substitué avec au moins un R₁₀ₐ, un groupe C₆-C₆₀ arylthio non substitué ou substitué avec au moins un R₁₀ₐ, -Si(Q₁)(Q₂)(Q₃), -N(Q₁)(Q₂), -B(Q₁)(Q₂), -C(=O)(Q₁), -S(=O)₂(Q₁) ou -P(=O)(Q₁)(Q₂),
b21 à b26, b31 à b33, n31 et n32 sont chacun indépendamment un nombre entier de 1 à 5, et
R₁₀ₐ est:
deutérium, -F, -Cl, -Br, -I, un groupe hydroxyle, un groupe cyano ou un groupe nitro;
un groupe C₁-C₆₀ alkyle, un groupe C₂-C₆₀ alcényle, un groupe C₂-C₆₀ alcynyle ou un groupe C₁-C₆₀ alcoxy, chacun étant non substitué ou substitué avec un deutérium, -F, - Cl, -Br, -I, un groupe hydroxyle, un groupe cyano, un groupe nitro, un groupe C₃-C₆₀ carbocyclique, un groupe C₁-C₆₀ hétérocyclique, un groupe C₆-C₆₀ aryloxy, un groupe C₆-C₆₀ arylthio, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), ou toute combinaison de ceux-ci;
un groupe C₃-C₆₀ carbocyclique, un groupe C₁-C₆₀ hétérocyclique, un groupe C₆-C₆₀ aryloxy ou un groupe C₆-C₆₀ arylthio, chacun étant non substitué ou substitué avec un deutérium, -F, -Cl, -Br, -I, un groupe hydroxyle, un groupe cyano, un groupe nitro, un groupe C₁-C₆₀ alkyle, un groupe C₂-C₆₀ alcényle, un groupe C₂-C₆₀ alcynyle, un groupe C₁-C₆₀ alcoxy, un groupe C₃-C₆₀ carbocyclique, un groupe C₁-C₆₀ hétérocyclique, un groupe C₆-C₆₀ aryloxy, un groupe C₆-C₆₀ arylthio, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), ou toute combinaison de ceux-ci; ou
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) ou - P(=O)(Q₃₁)(Q₃₂), et
dans lequel Q₁ à Q₃, Q₁₁ à Q₁₃, Q₂₁ à Q₂₃ et Q₃₁ à Q₃₃ sont chacun indépendamment: hydrogène; deutérium; -F; -Cl; -Br; -I; un groupe hydroxyle; un groupe cyano; un groupe nitro; un groupe C₁-C₆₀ alkyle; un groupe C₂-C₆₀ alcényle; un groupe C₂-C₆₀ alcynyle; un groupe C₁-C₆₀ alcoxy; ou un groupe C₃-C₆₀ carbocyclique ou un groupe C₁-C₆₀ hétérocyclique, chacun étant non substitué ou substitué avec un deutérium, -F, un groupe cyano, un groupe C₁-C₆₀ alkyle, un groupe C₁-C₆₀ alcoxy, un groupe phényle, un groupe biphényle, ou toute combinaison de ceux-ci.

7. Dispositif électroluminescent selon l'une quelconque des revendications 1 à 6, où:
le dispositif électroluminescent comprend en outre au moins une choisie parmi une première couche de coiffe hors de la première électrode et une deuxième couche de coiffe hors de la deuxième électrode, et l'au moins une choisie parmi la première couche de coiffe et la deuxième couche de coiffe a un indice de réfraction d'environ 1,6 ou plus à une longueur d'onde de 589 nanomètres (nm).

8. Appareil électronique comprenant le dispositif électroluminescent selon l'une quelconque des revendications 1 à 7, optionnellement où l'appareil électronique comprend en outre un filtre coloré, une couche de conversion de couleur, une couche d'écran tactile, une couche de polarisation ou toute combinaison de ceux-ci.

9. Composé organométallique représenté par la Formule 1: 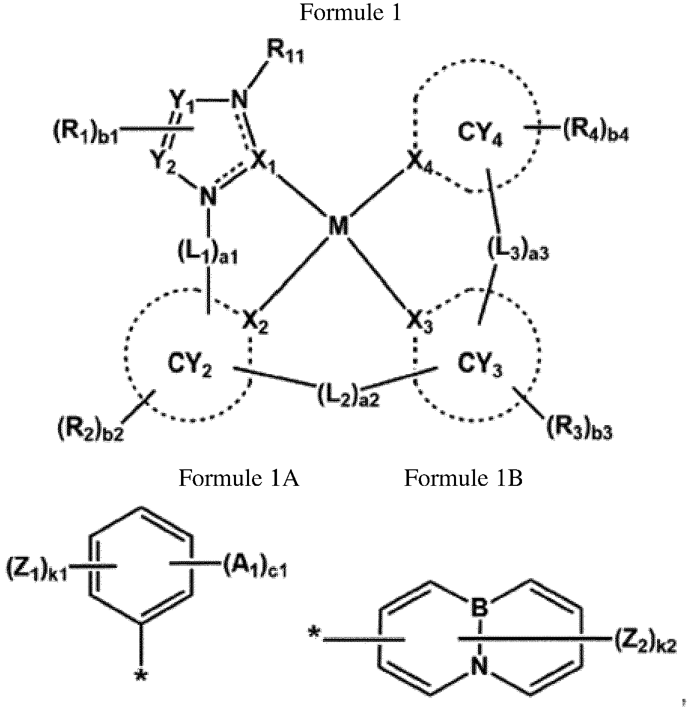 dans lequel, dans les Formules 1, 1A et 1B,
M est: platine (Pt), palladium (Pd), nickel (Ni), cuivre (Cu), argent (Ag), or (Au), rhodium (Rh), iridium (Ir), ruthénium (Ru), osmium (Os), titane (Ti), zirconium (Zr), hafnium (Hf), europium (Eu), terbium (Tb) ou thulium (Tm),
X₁ est C, et une liaison entre X₁ et M est une liaison de coordination,
X₂ à X₄, Y₁ et Y₂ sont chacun indépendamment C ou N,
une parmi une liaison entre X₂ et M, une liaison entre X₃ et M et une liaison entre X₄ et M est une liaison de coordination et les deux autres liaisons sont chacune une liaison covalente,
CY₂ à CY₄ sont chacun indépendamment un groupe C₃-C₆₀ carbocyclique ou un groupe C₁-C₆₀ hétérocyclique,
L₁ à L₃ sont chacun indépendamment une liaison simple, *-O-*', ^{∗}-S-^{∗}', *-Se-*', ^{∗}-S(=O)₂-^{∗}', ^{∗}-C(R₅)(R₆)-^{∗}', ^{∗}-C(R₅)=^{∗}', ^{∗}=C(R₅)-^{∗}', ^{∗}-C(R₅)=C(R₆)-^{∗}', ^{∗}-C(=O)-^{∗}', ^{∗}-C(=S)-^{∗}', ^{∗}-C=C-^{∗}', ^{∗}-B(R₅)-^{∗}', ^{∗}-N(R₅)-^{∗}', ^{∗}-P(R₅)-^{∗}', ^{∗}-Si(R₅)(R₆)-^{∗}', ^{∗}-P(=O)(R₅)-^{∗}' ou ^{∗}-Ge(R₅)(R₆)-^{∗}',
a1 à a3 sont chacun indépendamment un nombre entier de 1 à 3,
R₁ à R₆ et R₁₁ sont chacun indépendamment: un groupe représenté par la Formule 1A, hydrogène, deutérium, -F, -Cl, -Br, -I, un groupe hydroxyle, un groupe cyano, un groupe nitro, un groupe C₁-C₆₀ alkyle non substitué ou substitué avec au moins un R₁₀ₐ, un groupe C₂-C₆₀ alcényle non substitué ou substitué avec au moins un R₁₀ₐ, un groupe C₂-C₆₀ alcynyle non substitué ou substitué avec au moins un R₁₀ₐ, un groupe C₁-C₆₀ alcoxy non substitué ou substitué avec au moins un R₁₀ₐ, un groupe C₃-C₆₀ carbocyclique non substitué ou substitué avec au moins un R₁₀ₐ, un groupe C₁-C₆₀ hétérocyclique non substitué ou substitué avec au moins un R₁₀ₐ, un groupe C₆-C₆₀ aryloxy non substitué ou substitué avec au moins un R₁₀ₐ, un groupe C₆-C₆₀ arylthio non substitué ou substitué avec au moins un R₁₀ₐ, -Si(Q₁)(Q₂)(Q₃), -N(Q₁)(Q₂), -B(Q₁)(Q₂), -C(=O)(Q₁), - S(=O)₂(Q₁) ou -P(=O)(Q₁)(Q₂),
au moins deux groupes parmi R₁ au nombre de b1, R₂ au nombre de b2, R₃ au nombre de b3, R₄ au nombre de b4, R₅ et R₆ sont optionnellement liés l'un à l'autre pour former un groupe C₃-C₆₀ carbocyclique non substitué ou substitué avec au moins un R₁₀ₐ ou un groupe C₁-C₆₀ hétérocyclique non substitué ou substitué avec au moins un R₁₀ₐ,
au moins un parmi R₁₁, R₁ au nombre de b1, R₂ au nombre de b2, R₃ au nombre de b3 et R₄ au nombre de b4 est un groupe représenté par la Formule 1A,
b1 est 1 ou 2,
b2 à b4 sont chacun indépendamment un nombre entier de 1 à 10,
A₁ est un groupe représenté par la Formule 1B,
c1 est un nombrer entier de 1 à 5,
Z₁ et Z₂ sont chacun indépendamment: hydrogène, deutérium, -F, -Cl, -Br, -I, un groupe hydroxyle, un groupe cyano, un groupe nitro, un groupe C₁-C₆₀ alkyle non substitué ou substitué avec au moins un R₁₀ₐ, un groupe C₂-C₆₀ alcényle non substitué ou substitué avec au moins un R₁₀ₐ, un groupe C₂-C₆₀ alcynyle non substitué ou substitué avec au moins un R₁₀ₐ, un groupe C₁-C₆₀ alcoxy non substitué ou substitué avec au moins un R₁₀ₐ, un groupe C₃-C₆₀ carbocyclique non substitué ou substitué avec au moins un R₁₀ₐ, un groupe C₁-C₆₀ hétérocyclique non substitué ou substitué avec au moins un R₁₀ₐ, un groupe C₆-C₆₀ aryloxy non substitué ou substitué avec au moins un R₁₀ₐ, un groupe C₆-C₆₀ arylthio non substitué ou substitué avec au moins un R₁₀ₐ, -Si(Q₁)(Q₂)(Q₃), - N(Q₁)(Q₂), -B(Q₁)(Q₂), -C(=O)(Q₁), -S(=O)₂(Q₁) ou -P(=O)(Q₁)(Q₂),
k1 est un nombre entier de 0 à 4,
k2 est un nombre entier de 1 à 7,
* et *' indiquent chacun un site de liaison à un atome adjacent, et
R₁₀ₐ est:
deutérium, -F, -Cl, -Br, -I, un groupe hydroxyle, un groupe cyano ou un groupe nitro;
un groupe C₁-C₆₀ alkyle, un groupe C₂-C₆₀ alcényle, un groupe C₂-C₆₀ alcynyle ou un groupe C₁-C₆₀ alcoxy, chacun étant non substitué ou substitué avec un deutérium, -F, - Cl, -Br, -I, un groupe hydroxyle, un groupe cyano, un groupe nitro, un groupe C₃-C₆₀ carbocyclique, un groupe C₁-C₆₀ hétérocyclique, un groupe C₆-C₆₀ aryloxy, un groupe C₆-C₆₀ arylthio, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), ou toute combinaison de ceux-ci;
un groupe C₃-C₆₀ carbocyclique, un groupe C₁-C₆₀ hétérocyclique, un groupe C₆-C₆₀ aryloxy ou un groupe C₆-C₆₀ arylthio, chacun étant non substitué ou substitué avec un deutérium, -F, -Cl, -Br, -I, un groupe hydroxyle, un groupe cyano, un groupe nitro, un groupe C₁-C₆₀ alkyle, un groupe C₂-C₆₀ alcényle, un groupe C₂-C₆₀ alcynyle, un groupe C₁-C₆₀ alcoxy, un groupe C₃-C₆₀ carbocyclique, un groupe C₁-C₆₀ hétérocyclique, un groupe C₆-C₆₀ aryloxy, un groupe C₆-C₆₀ arylthio, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), ou toute combinaison de ceux-ci; ou
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) ou - P(=O)(Q₃₁)(Q₃₂), et
dans lequel Q₁ à Q₃, Q₁₁ à Q₁₃, Q₂₁ à Q₂₃ et Q₃₁ à Q₃₃ sont chacun indépendamment: hydrogène; deutérium; -F; -Cl; -Br; -I; un groupe hydroxyle; un groupe cyano; un groupe nitro; un groupe C₁-C₆₀ alkyle; un groupe C₂-C₆₀ alcényle; un groupe C₂-C₆₀ alcynyle; un groupe C₁-C₆₀ alcoxy; ou un groupe C₃-C₆₀ carbocyclique ou un groupe C₁-C₆₀ hétérocyclique, chacun étant non substitué ou substitué avec un deutérium, -F, un groupe cyano, un groupe C₁-C₆₀ alkyle, un groupe C₁-C₆₀ alcoxy, un groupe phényle, un groupe biphényle, ou toute combinaison de ceux-ci.

10. Composé organométallique selon la revendication 9, dans lequel:
CY₂ est un groupe représenté par l'une des Formules CY2-1 à CY2-9,
CY₃ est un groupe représenté par l'une des Formules CY3-1 à CY3-10, et/ou
CY₄ est un groupe représenté par l'une des Formules CY4-1 à CY4-9; 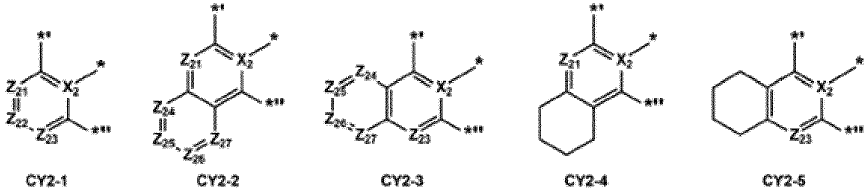 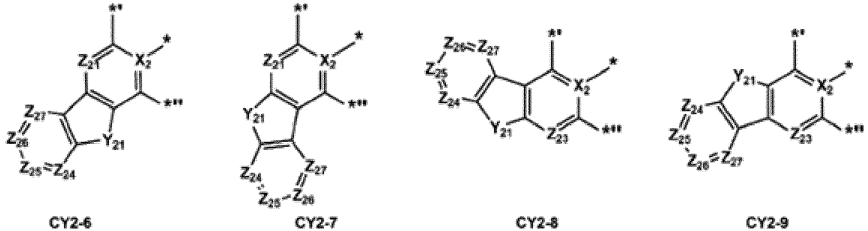 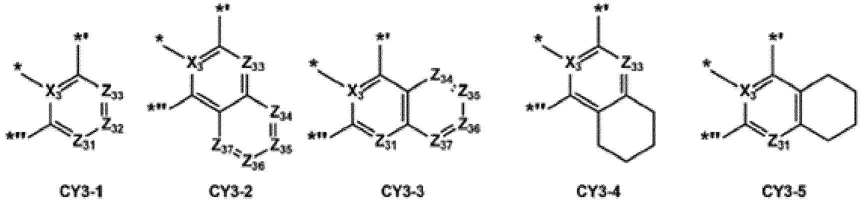 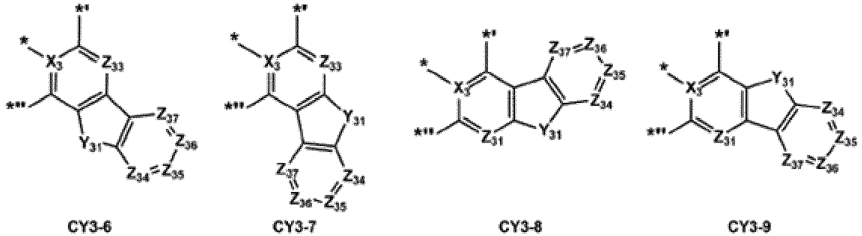 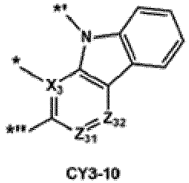 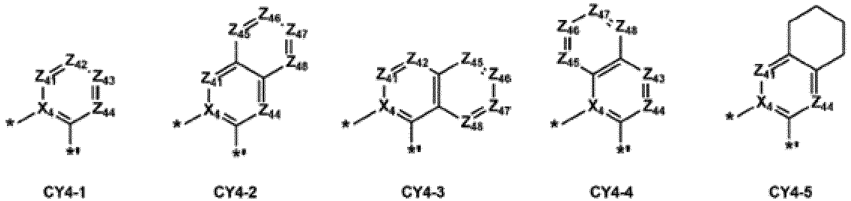 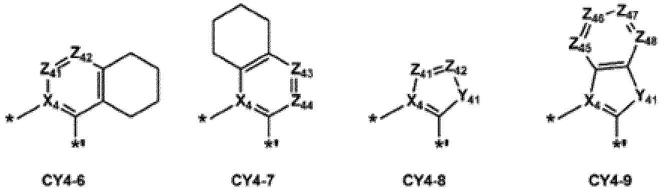
et dans lequel, dans les Formules CY2-1 à CY2-9, CY3-1 à CY3-10 et CY4-1 à CY4-9,
Z₂₁ à Z₂₇, Z₃₁ à Z₃₇ et Z₄₁ à Z₄₈ sont chacun indépendamment C ou N,
Y₂₁, Y₃₁ et Y₄₁ sont chacun indépendamment N, O, S, C ou Si,
X₂ à X₄ sont respectivement compris en se référant aux descriptions de X₂ à X₄ dans la Formule 1,
* indique un site de liaison à M, et
*' et *" indiquent chacun un site de liaison à un atome adjacent.

11. Composé organométallique selon la revendication 9 ou la revendication 10, dans lequel:
(i) L₁ est une liaison simple, L₂ est *-O-*' ou *-S-*' et L₃ est ^{∗}-N(R₅)-^{∗}'; et/ou
(ii) le groupe représenté par la Formule 1A est représenté par l'une des Formules 1A-1 à 1A-14: 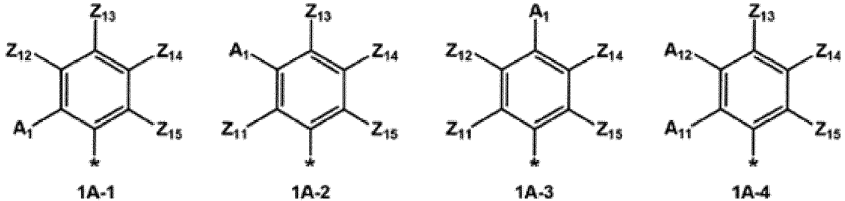 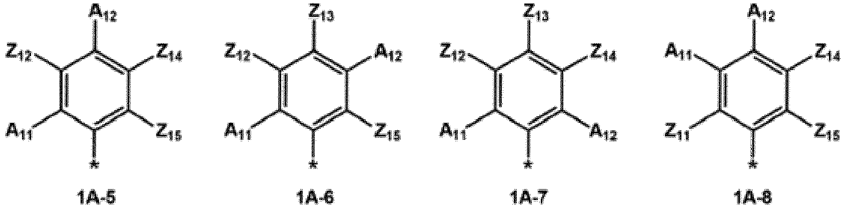 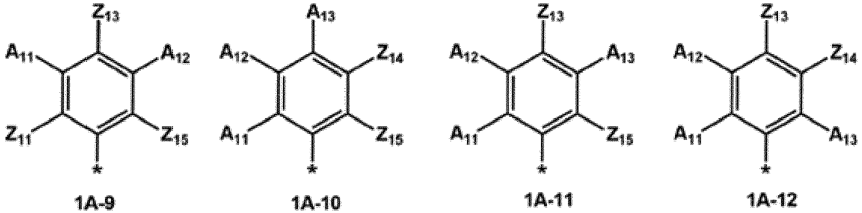 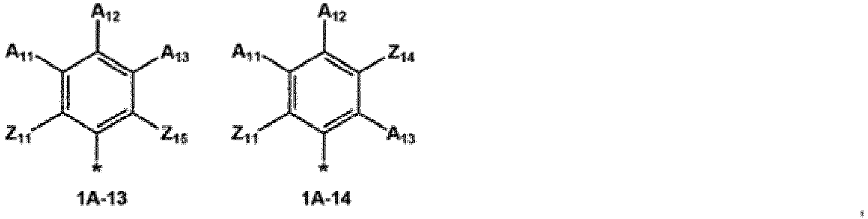 et dans lequel, dans les Formules 1A-1 à 1A-14,
Z₁₁ à Z₁₅ sont chacun indépendamment compris en se référant à la description de Z₁ dans la Formule 1A,
A₁₁ à A₁₃ sont chacun indépendamment compris en se référant à la description de A₁ dans la Formule 1A,
A₁ est compris en se référant à la description de A₁ dans la Formule 1A, et
* indique un site de liaison à un atome adjacent.

12. Composé organométallique selon l'une quelconque des revendications 9 à 11, dans lequel le groupe représenté par la Formule 1A est représenté par la Formule 1A-7-1: 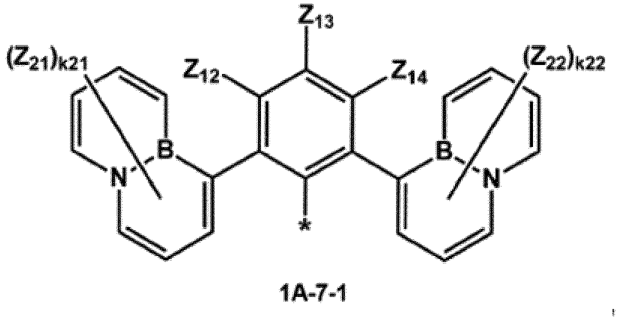 et
dans lequel, dans la Formule 1A-7-1,
Z₁₂ à Z₁₄ sont chacun indépendamment compris en se référant à la description de Z₁ dans la Formule 1A,
Z₂₁ et Z₂₂ sont chacun indépendamment compris en se référant à la description de Z₂ dans la Formule 1B,
k21 et k22 sont chacun indépendamment un nombre entier de 1 à 7, et
* indique un site de liaison à un atome adjacent.

13. Composé organométallique selon l'une quelconque des revendications 9 à 12, dans lequel:
(i) au moins un parmi R₁ au nombre de b1, R₂ au nombre de b2, R₃ au nombre de b3, R₄ au nombre de b4, R₅, R₆ et R₁₁ est: deutérium, -CH₂D, -CHD₂, -CD₃, un groupe phényle substitué avec au moins un deutérium, ou un groupe représenté par l'une des Formules 10-2 à 10-7: 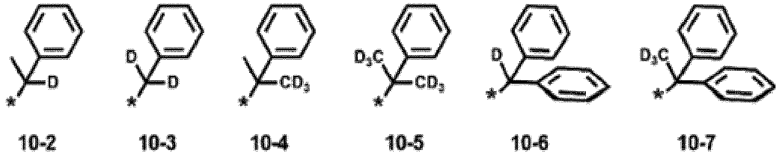 et
dans lequel, dans les Formules 10-2 à 10-7,
« D » représente un deutérium, et
* indique un site de liaison à un atome adjacent; et/ou
(ii) une fraction représentée par 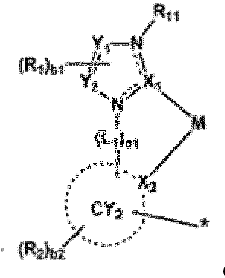 dans la Formule 1 est un groupe représenté par la Formule L1-1 ou L1-2: 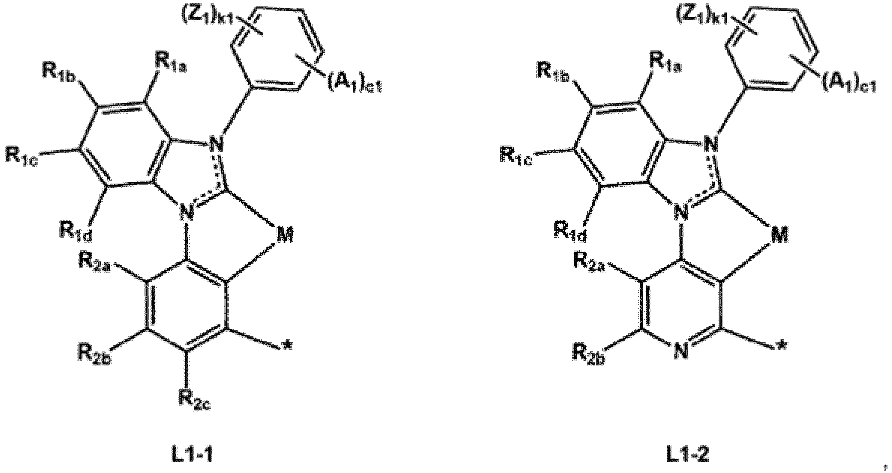 et
dans lequel, dans les Formules L1-1 et L1-2,
R₁ₐ à R_{1d} sont chacun indépendamment compris en se référant à la description de R₁ dans la Formule 1,
R₂ₐ à R_{2c} sont chacun indépendamment compris en se référant à la description de R₂ dans la Formule 1,
M, A₁, c1, Z₁ et k1 sont respectivement compris en se référant aux descriptions de M, A₁, c1, Z₁ et k1 dans les Formules 1 et 1A, et
* indique un site de liaison à L₂; et/ou
(iii) une fraction représentée par 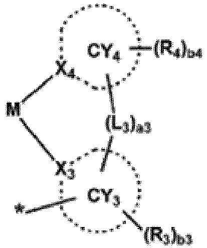 dans la Formule 1 est un groupe représenté par la Formule L2-1 ou la Formule L2-2: 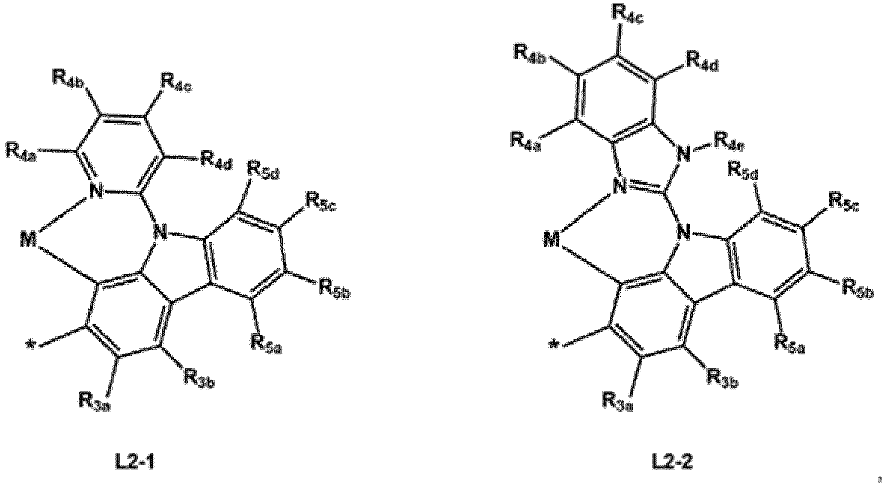 et
dans lequel, dans les Formules L2-1 et L2-2,
R₃ₐ et R_{3b} sont chacun indépendamment compris en se référant à la description de R₃ dans la Formule 1,
R₄ₐ à R₄ₑ sont chacun indépendamment compris en se référant à la description de R₄ dans la Formule 1,
R₅ₐ à R_{5d} sont chacun indépendamment compris en se référant à la description de R₁₀ₐ dans la Formule 1,
M est compris en se référant à la description de M dans la Formule 1, et
* indique un site de liaison à L₂.

14. Composé organométallique selon l'une quelconque des revendications 9 à 13, où le composé organométallique est représenté par l'une quelconque choisie parmi les Formules 1-1 à 1-4: 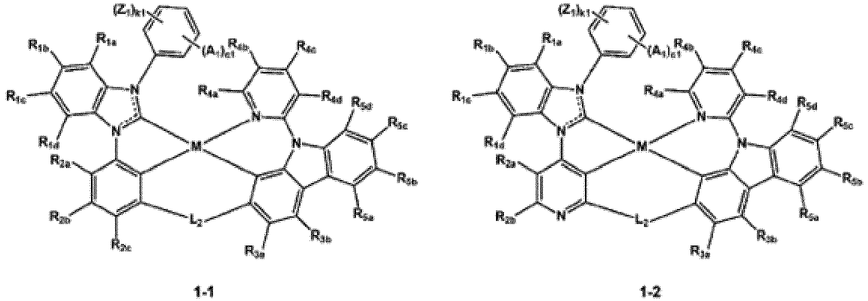 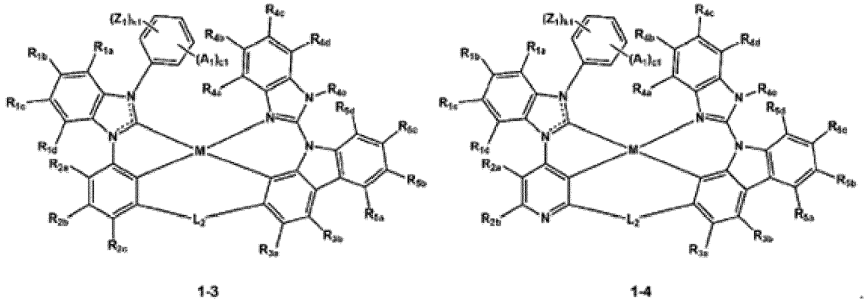 dans lequel, dans les Formules 1-1 à 1-4,
M, L₂, A₁, c1, Z₁ et k1 sont respectivement compris en se référant aux descriptions de M, L₂, A₁, c1, Z₁ et k1 dans les Formules 1 et 1A,
R₁ₐ à R_{1d}, R₂ₐ à R_{2c}, R₃ₐ, R_{3b}, R₄ₐ à R₄ₑ et R₅ₐ à R_{5d} sont chacun indépendamment: hydrogène, deutérium, -F, -Cl, -Br, -I, -CH₂D, -CHD₂, -CD₃, -CH₂F, -CHF₂, -CF₃, un groupe hydroxyle, un groupe cyano, un groupe nitro, un groupe méthyle, un groupe éthyle, un groupe propyle, un groupe iso-propyle, un groupe n-butyle, un groupe iso-butyle, un groupe sec-butyle, un groupe tert-butyle, un groupe n-pentyle, un groupe tert-pentyle, un groupe néo-pentyle, un groupe iso-pentyle, un groupe sec-pentyle, un groupe 3-pentyle, un groupe sec-isopentyle, un groupe n-hexyle, un groupe iso-hexyle, un groupe sec-hexyle, un groupe tert-hexyle, ou un groupe représenté par l'une choisie dans le groupe constitué des Formules 9-1 à 9-31 et 10-1 à 10-7: 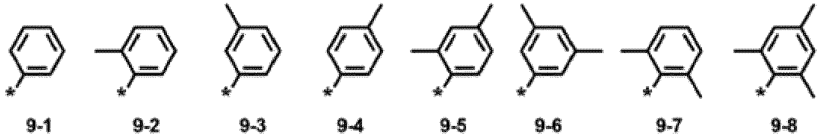 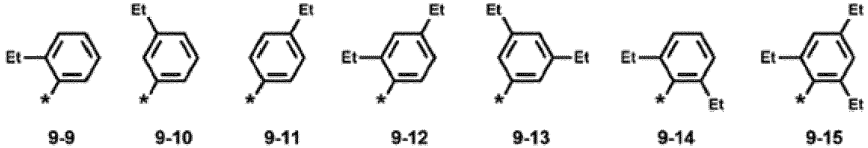 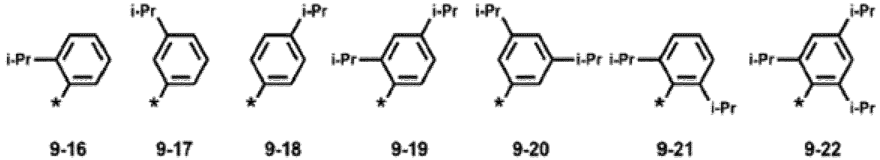 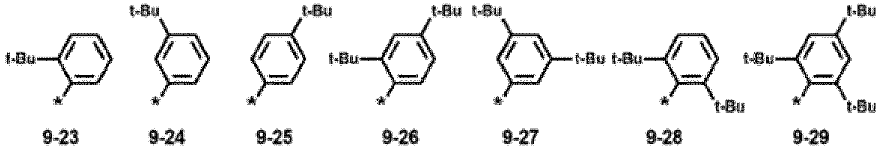 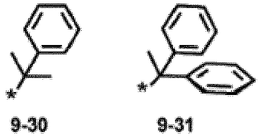 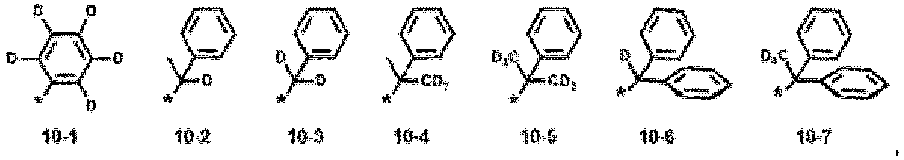 et
dans lequel, dans les Formules 9-1 à 9-31 et 10-1 à 10-7,
« Et » représente un groupe éthyle,
« i-Pr » représente un groupe iso-propyle,
« t-Bu » représente un groupe tert-butyle,
« D » représente un deutérium, et
* indique un site de liaison à un atome adjacent, optionnellement dans lequel, dans les Formules 1-1 à 1-4, au moins un de R₁ₐ à R_{1d}, R₂ₐ à R_{2c}, R₃ₐ, R_{3b}, R₄ₐ à R₄ₑ et R₅ₐ à R_{5d} est: deutérium, -CH₂D, -CHD₂, -CD₃, ou un groupe représenté par l'une des Formules 10-1 à 10-7: 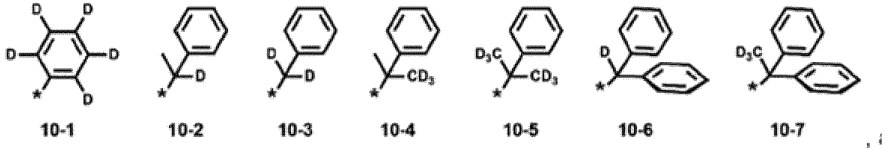 et
dans lequel, dans les Formules 10-1 à 10-7,
« D » représente un deutérium, et
* indique un site de liaison à un atome adjacent.

15. Composé organométallique selon la revendication 9, où le composé organométallique est représenté par l'un des Composés BD01 à BD210: 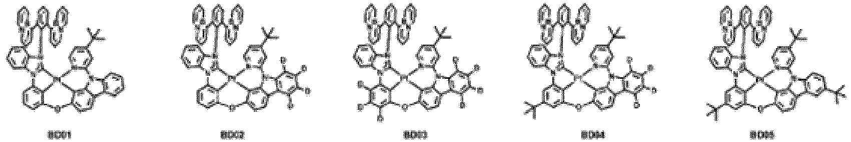 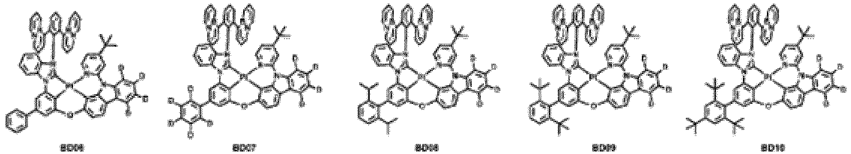 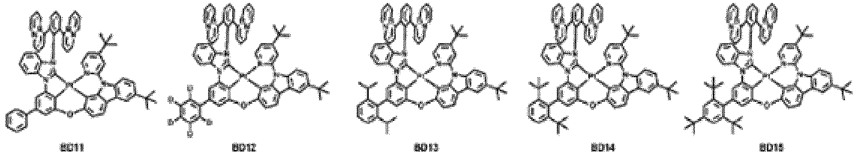 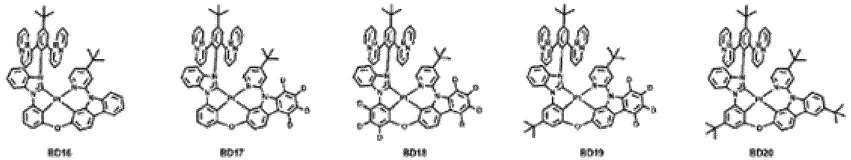 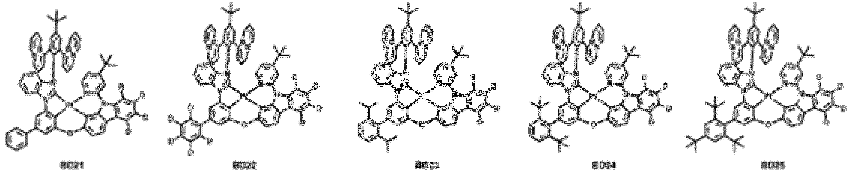 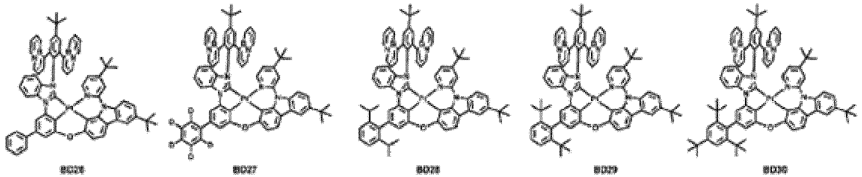 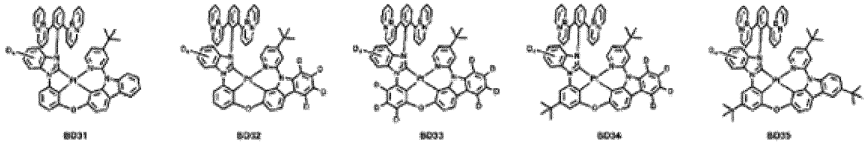 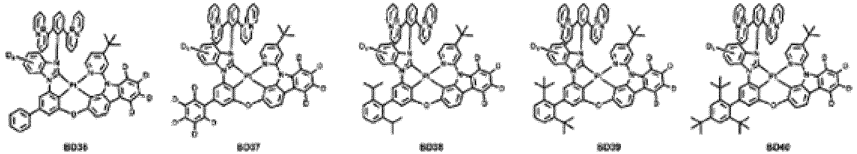 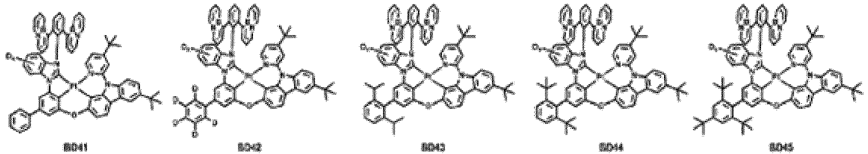 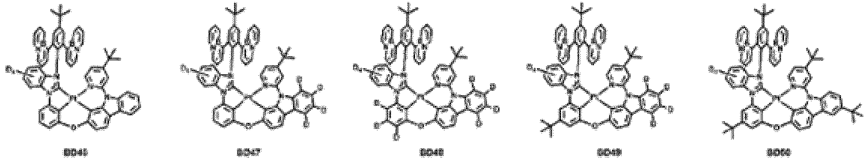 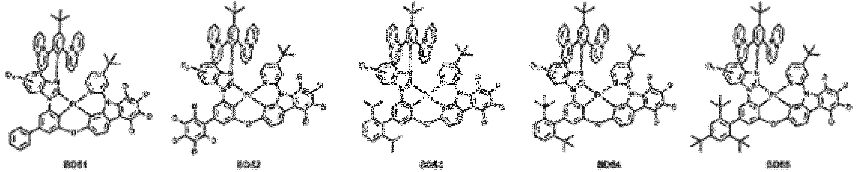 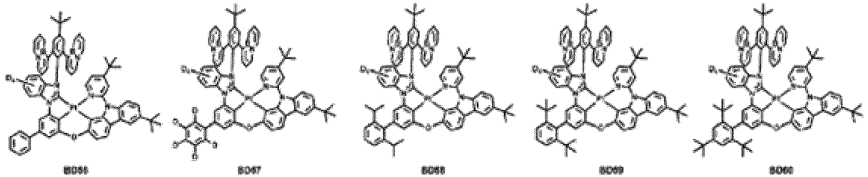 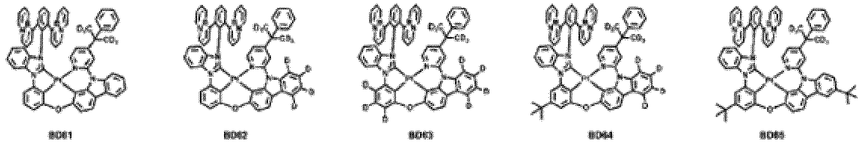 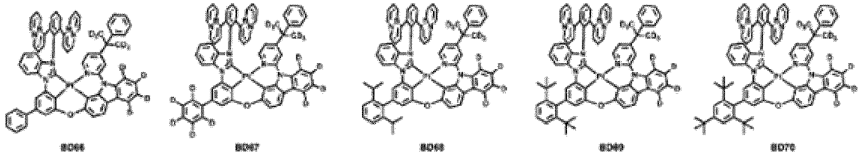 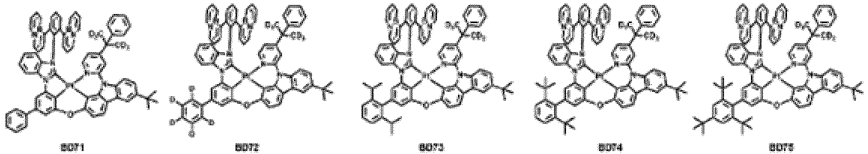 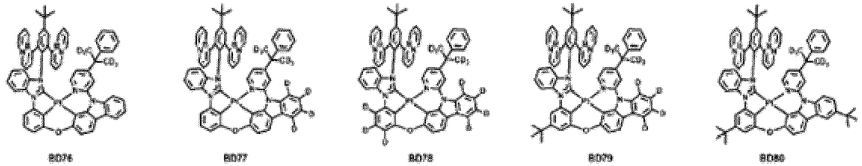 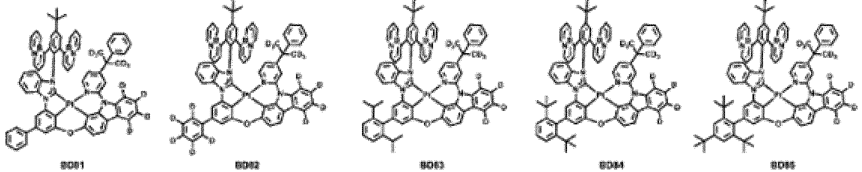 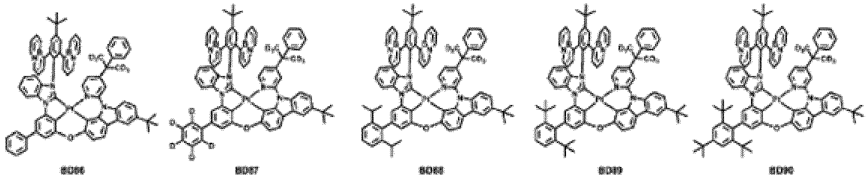 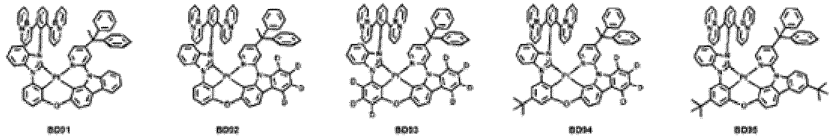 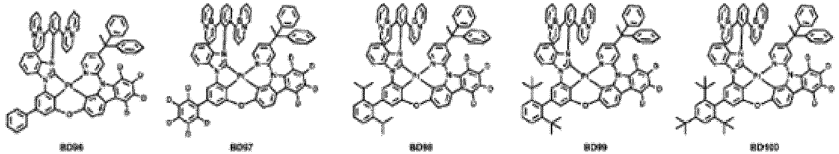 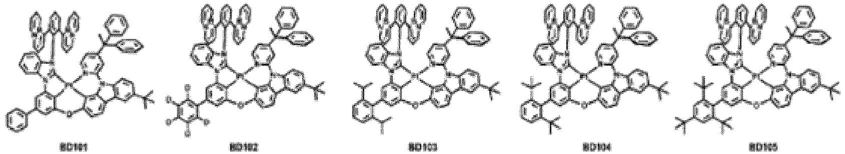 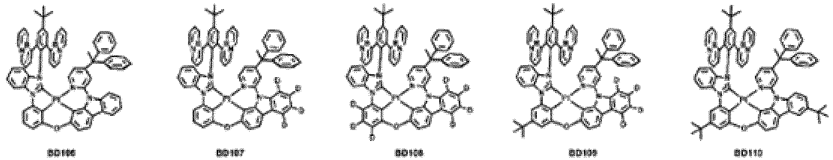 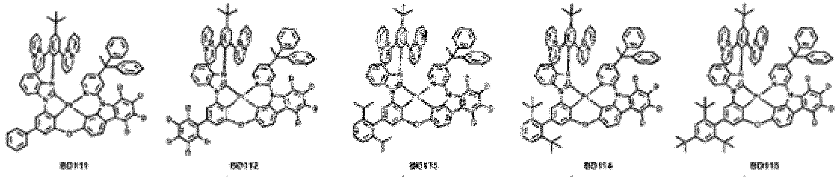 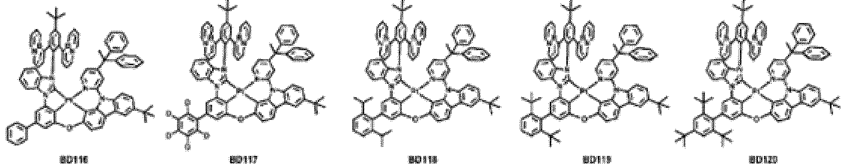 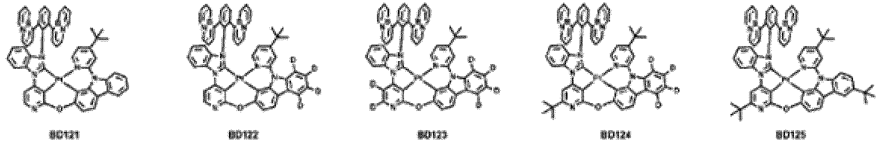 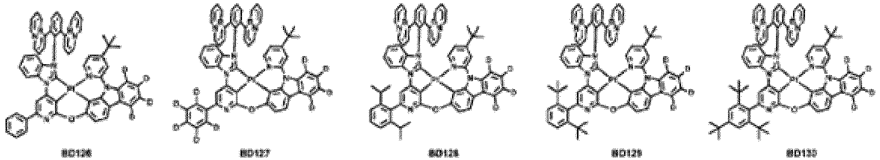 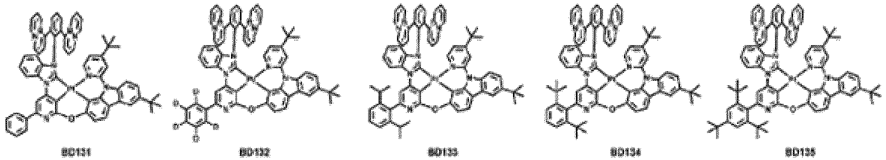 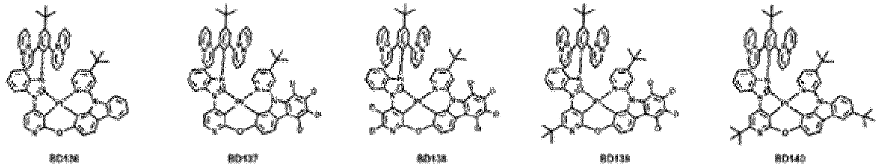 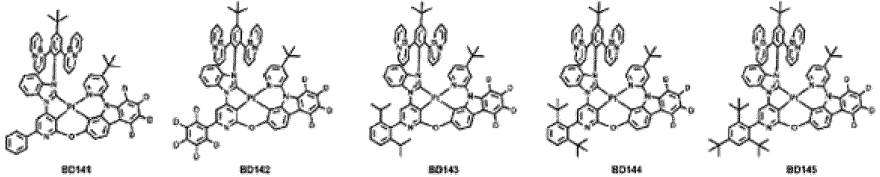 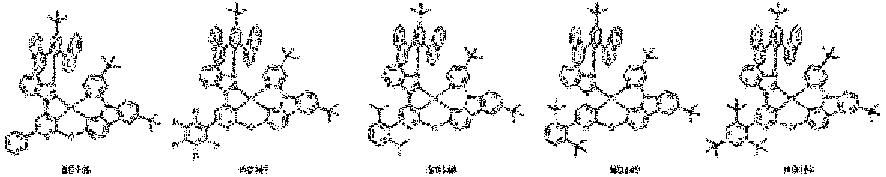 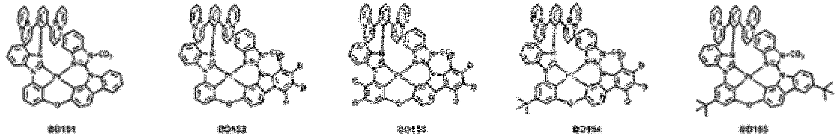 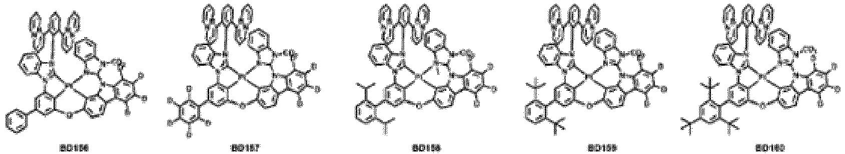 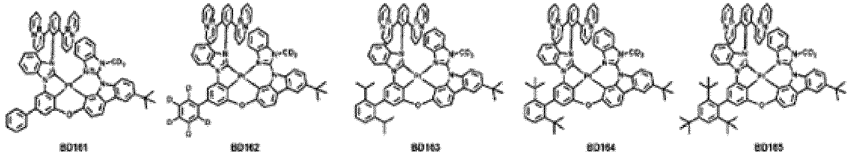 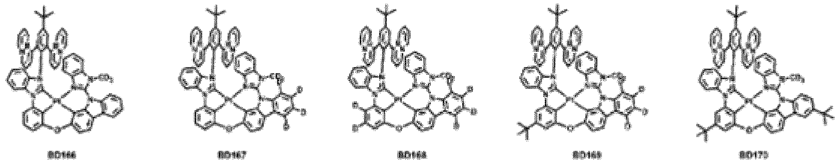 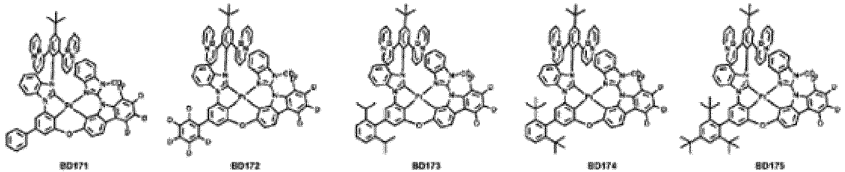 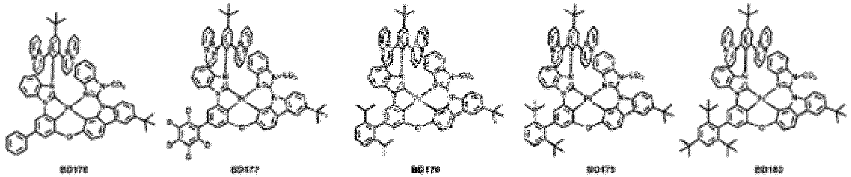 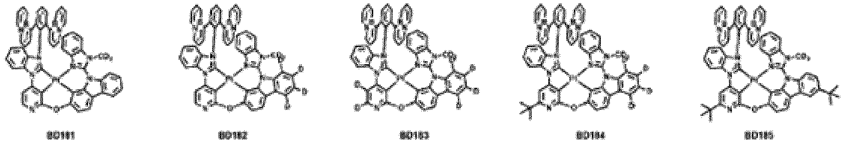 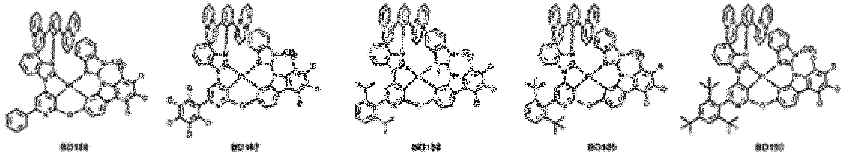 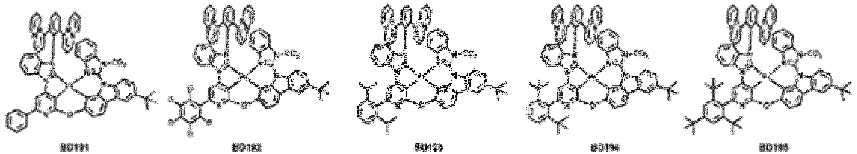 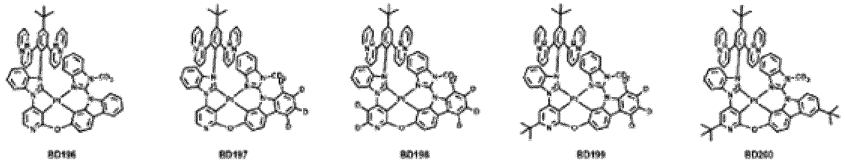 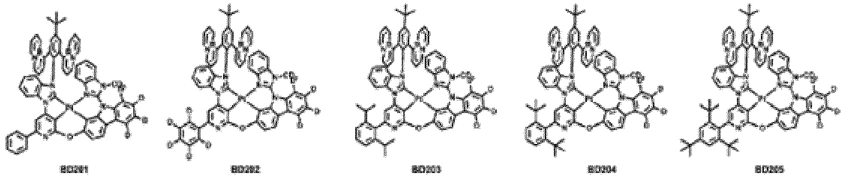 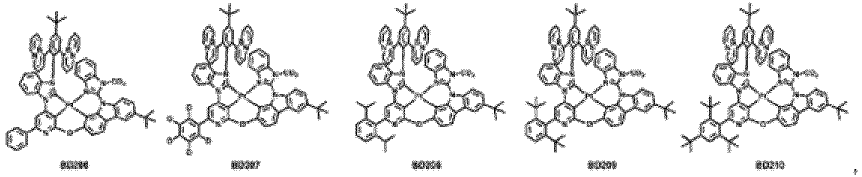 et dans lequel, dans les Composés BD01 à BD210, D₄ indique une substitution avec quatre deutériums (D).
